(19) Europäisches Patentamt
European Patent Office
Office européen des brevets

(11) **EP 2 474 843 A1**

(12) **EUROPEAN PATENT APPLICATION**
published in accordance with Art. 153(4) EPC

(43) Date of publication:
**11.07.2012 Bulletin 2012/28**

(51) Int Cl.:
**G02B 1/11** (2006.01)   **B32B 3/30** (2006.01)
**G02B 1/10** (2006.01)   **G06F 3/041** (2006.01)
**G06F 3/045** (2006.01)   **H01B 5/14** (2006.01)

(21) Application number: **10813854.6**

(22) Date of filing: **02.09.2010**

(86) International application number:
**PCT/JP2010/065454**

(87) International publication number:
**WO 2011/027909 (10.03.2011 Gazette 2011/10)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **02.09.2009   JP 2009203180**
**28.12.2009   JP 2009299004**
**28.04.2010   JP 2010104620**

(71) Applicant: **Sony Corporation**
**Tokyo 108-0075 (JP)**

(72) Inventors:
• **KAJIYA, Shunichi**
**Tokyo 141-0032 (JP)**

• **HAYASHIBE, Kazuya**
**Tokyo 108-0075 (JP)**
• **MURAMOTO, Yutaka**
**Tokyo 108-0075 (JP)**
• **ENDOH, Sohmei**
**Tokyo 108-0075 (JP)**
• **KIMURA, Kiyohiro**
**Tokyo 108-0075 (JP)**
• **TAKENOUCHI, Masaki**
**Tokyo 108-0075 (JP)**

(74) Representative: **Müller - Hoffmann & Partner**
**Patentanwälte**
**Innere Wiener Strasse 17**
**81667 München (DE)**

(54) **CONDUCTIVE OPTICAL ELEMENT, TOUCH PANEL, INFORMATION INPUT DEVICE, DISPLAY DEVICE, SOLAR CELL, AND MASTER FOR PRODUCTION OF CONDUCTIVE OPTICAL ELEMENT**

(57)   An electrically conductive optical element is provided with a substrate having a surface, structures which are convex portions or concave portions in the shape of a cone and which are arranged in large numbers on the surface of the substrate with a minute pitch less than or equal to the wavelength of the visible light, and a transparent, electrically conductive layer disposed on the structures. The aspect ratio of the structure is 0.2 or more, and 1.3 or less, the transparent, electrically conductive layer has a surface following the structures, the average layer thickness $D_m1$ of the transparent, electrically conductive layer at the top portion of the structure is 80 nm or less, and the surface resistance of the transparent, electrically conductive layer is within the range of 50 $\Omega$/□ or more, and 500 $\Omega$/□ or less.

FIG. 1

## Description

Technical Field

The present invention relates to an electrically conductive optical element, a touch panel, an information input device, a display device, a solar cell, and a stamper for producing an electrically conductive optical element. In particular, it relates to an electrically conductive optical element provided with a transparent, electrically conductive film on one principal surface of a substrate.

Background Art

In recent years, resistive touch panels to input information have become disposed on display devices, e.g., liquid crystal display element, included in mobile apparatuses and cellular phone apparatuses.

The resistive touch panel has a structure in which two transparent, electrically conductive films are disposed oppositely with a spacer formed from an insulating material, e.g., an acrylic resin, therebetween. The transparent, electrically conductive film functions as an electrode for the touch panel and includes a base member, e.g., a polymer film, having the transparency and a transparent, electrically conductive layer which is disposed on this base member and which is formed from a high-refractive index material (for example, about 1.9 to 2.1), e.g., ITO (Indium Tin Oxide).

The transparent, electrically conductive film serving as the resistive touch panel is required to have a desired surface resistance value of, for example, about 300 $\Omega/\square$ to 500 $\Omega/\square$. Furthermore, the transparent, electrically conductive film is required to have a high transmittance in order to avoid degradation in display quality of a display device, e.g., a liquid crystal display device, in which the resistive touch panel is disposed.

For the purpose of realizing the desired surface resistance value, it is necessary that the thickness of the transparent, electrically conductive layer constituting the transparent, electrically conductive film is increased to, for example, about 20 nm to 30 nm. However, if the thickness of the transparent, electrically conductive layer formed from a high refractive index material increases, reflection of external light at the interface between the transparent, electrically conductive layer and the base member increases and, thereby, the transmittance of the transparent, electrically conductive film is reduced. Consequently, there is a problem in that degradation may occur in the quality of the display device.

In order to solve this problem, for example, Japanese Unexamined Patent Application Publication No. 2003-136625 has proposed a transparent, electrically conductive film for a touch panel, wherein an antireflection layer is disposed between a base member and a transparent, electrically conductive layer. This antireflection layer is formed by laminating a plurality of dielectric layers having different refractive indices sequentially.

Disclosure of Invention

Technical Problem

However, regarding the transparent, electrically conductive film described in the above-described patent document, chromatic dispersion occurs in the transmittance of the transparent, electrically conductive film because of wavelength dependence of a reflection function of the antireflection layer. Consequently, it is difficult to realize a high transmittance in a wide range of wavelength.

Accordingly, it is an object of the present invention to provide an electrically conductive optical element, a touch panel, an information input device, a display device, a solar cell, and a stamper for producing an electrically conductive optical element.

Technical Solution

In order to solve the above-described problems, the present invention is an electrically conductive optical element provided with

a substrate having a surface,

structures which are convex portions or concave portions in the shape of a cone and which are arranged in large numbers on the surface of the substrate with a minute pitch less than or equal to the wavelength of the visible light, and

a transparent, electrically conductive layer disposed on the structures,

wherein the aspect ratio of the structure is 0.2 or more, and 1.3 or less,

the transparent, electrically conductive layer has a surface following the structures,

the average layer thickness $D_m1$ of the transparent, electrically conductive layer at the top portion of the structure is 80 nm or less, and

the surface resistance of the transparent, electrically conductive layer is within the range of 50 $\Omega/\square$ or more, and 500 Q/□ or less.

In the present invention, it is preferable that main structures are periodically arranged in the shape of a tetragonal lattice or the shape of a quasi-tetragonal lattice. Here, the tetragonal lattice refers to a lattice in the shape of a square. The quasi-tetragonal lattice refers to a lattice in the shape of a distorted square different from the lattice in the shape of a square.

For example, in the case where the structures are arranged on a straight line, the quasi-tetragonal lattice refers to a tetragonal lattice obtained by stretching a lattice in the shape of a square in the direction of the arrangement in the shape of the straight line (track direction), so as to distort. In the case where the structures are arranged meanderingly, the quasi-tetragonal lattice refers to a tetragonal lattice obtained by distorting a lattice in the shape of a square on the basis of the meandering arrangement of the structures. Alternatively, the quasi-tetragonal lattice refers to a tetragonal lattice obtained by stretching a lattice in the shape of a square in the direction of the arrangement in the shape of the straight line (track direction), so as to distort and, in addition, distorting on the basis of the meandering arrangement of the structures.

In the present invention, it is preferable that the structures are periodically arranged in the shape of a hexagonal lattice or the shape of a quasi-hexagonal lattice. Here, the hexagonal lattice refers to a lattice in the shape of a regular hexagon. The quasi-hexagonal lattice refers to a lattice in the shape of a distorted regular hexagon different from the lattice in the shape of a regular hexagon.

For example, in the case where the structures are arranged on a straight line, the quasi-hexagonal lattice refers to a hexagonal lattice obtained by stretching a lattice in the shape of a regular hexagon in the direction of the arrangement in the shape of the straight line (track direction), so as to distort. In the case where the structures are arranged meanderingly, the quasi-hexagonal lattice refers to a hexagonal lattice obtained by distorting a lattice in the shape of a regular hexagon on the basis of the meandering arrangement of the structures. Alternatively, the quasi-hexagonal lattice refers to a hexagonal lattice obtained by stretching a lattice in the shape of a regular hexagon in the direction of the arrangement in the shape of the straight line (track direction), so as to distort and, in addition, distorting on the basis of the meandering arrangement of the structures.

In the present invention, an ellipse includes not only a perfect ellipse defined mathematically, but also ellipses provided with distortion to some extent. A circle includes not only a perfect circle (complete round) defined mathematically, but also circles provided with distortion to some extent.

In the present invention, it is preferable that the arrangement pitch P1 of the structures in the same track is larger than the arrangement pitch P2 of the structures between adjacent two tracks. Consequently, the filling factor of the structures having the shape of an elliptical cone or an elliptical truncated cone can be improved and, thereby, the antireflection characteristic can be improved.

In the present invention, in the case where the individual structures form a hexagonal lattice pattern or a quasi-hexagonal lattice pattern on the surface of the substrate, the ratio P1/P2 satisfies the relationship represented by preferably $1.00 \leqq P1/P2 \leqq 1.2$ or $1.00 < P1/P2 \leq 1.2$, and more preferably $1.00 \leq P1/P2 \leq 1.1$ or $1.00 < P1/P2 \leq 1.1$, where the arrangement pitch of the structures in the same track is assumed to be P1 and the arrangement pitch of the structures between adjacent two tracks is assumed to be P2. In the case where the above-described numerical range is employed, the filling factor of the structures having the shape of an elliptical cone or an elliptical truncated cone can be improved and, thereby, the antireflection characteristic can be improved.

In the present invention, in the case where the individual structures form a hexagonal lattice pattern or a quasi-hexagonal lattice pattern on the substrate surface, it is preferable that the individual structures are in the shape of an elliptical cone or an elliptical truncated cone, which has a major axis direction in the extension direction of the track and which is formed in such a way that the inclination of the central portion is steeper than the inclinations of the top portion and the bottom portion. In the case where such a shape is employed, the antireflection characteristic and the transmission characteristic can be improved.

In the present invention, in the case where the individual structures form a hexagonal lattice pattern or a quasi-hexagonal lattice pattern on the substrate surface, it is preferable that the height or the depth of the structures in the extension direction of the track is smaller than the height or the depth of the structures in the direction of lines of the tracks. In the case where such a relationship is not satisfied, it becomes necessary to increase the arrangement pitch in the extension direction of the track, so that the filling factor of the structures in the extension direction of the track is reduced. If the filling factor is reduced, as described above, degradation in antireflection characteristic is invited.

In the present invention, in the case where the structures form a tetragonal lattice pattern or a quasi-tetragonal lattice pattern on the substrate surface, it is preferable that the arrangement pitch P1 of the structures in the same track is larger than the arrangement pitch P2 of the structures between adjacent two tracks. Consequently, the filling factor of the structures having the shape of an elliptical cone or an elliptical truncated cone can be improved and, thereby, the antireflection characteristic can be improved.

In the case where the structures form a tetragonal lattice pattern or a quasi-tetragonal lattice pattern on the substrate surface, it is preferable that the ratio P1/P2 satisfies the relationship represented by $1.4 < P1/P2 \leq 1.5$, where

the arrangement pitch of the structures in the same track is assumed to be P1 and the arrangement pitch of the structures between adjacent two tracks is assumed to be P2. In the case where the above-described numerical range is employed, the filling factor of the structures having the shape of an elliptical cone or an elliptical truncated cone can be improved and, thereby, the antireflection characteristic can be improved.

In the case where the structures form a tetragonal lattice pattern or a quasi-tetragonal lattice pattern on the substrate surface, it is preferable that the individual structures are in the shape of an elliptical cone or an elliptical truncated cone, which has a major axis direction in the extension direction of the track and which is formed in such a way that the inclination of the central portion is steeper than the inclinations of the top portion and the bottom portion. In the case where such a shape is employed, the antireflection characteristic and the transmission characteristic can be improved.

In the case where the structures form a tetragonal lattice pattern or a quasi-tetragonal lattice pattern on the substrate surface, it is preferable that the height or the depth of the structures in the direction at 45 degrees or the direction at about 45 degrees with respect to the track is smaller than the height or the depth of the structures in the direction of lines of the tracks. In the case where such a relationship is not satisfied, it becomes necessary to increase the arrangement pitch in the direction at 45 degrees or the direction at about 45 degrees with respect to the track, so that the filling factor of the structures in the direction at 45 degrees or the direction at about 45 degrees with respect to the track is reduced. If the filling factor is reduced, as described above, degradation in antireflection characteristic is invited.

The electrically conductive optical element according to the present invention is suitable for application to information input elements, e.g., resistive touch panels or capacitive touch panels, display elements, e.g., electronic paper, electro luminescence (Electro Luminescence: EL) display elements, and liquid crystal display elements, solar cells, electromagnetic noise removal sheets, light sources, and the like. In the case where the electrically conductive base member according to the present invention is applied to the solar cell, specifically, it is possible to apply to, for example, an electrically conductive base member used for a photoelectrode or a counter electrode of a dye-sensitized solar cell. However, the examples of application of the electrically conductive base member according to the present invention are not limited to this, and it is possible to apply to various solar cells by using the electrically conductive base member and the like.

In the present invention, it is preferable that structures disposed in large numbers on the substrate surface with a minute pitch constitute a plurality of lines of tracks and form a hexagonal lattice pattern, a quasi-hexagonal lattice pattern, a tetragonal lattice pattern, or a quasi-tetragonal lattice pattern between adjacent three lines of tracks. Consequently, the packing density of the structures on the surface can be increased and, thereby, an antireflection efficiency with respect to the visible light and the like is increased, so that an electrically conductive optical element having an excellent antireflection characteristic and a high transmittance can be obtained.

Furthermore, in the case where the optical element is produced by using a method based on combination of an optical disk stamper producing process and an etching process, a stamper for producing an optical element can be produced in a short time with efficiency and, in addition, it is possible to respond to upsizing of the substrate. Consequently, the productivity of the optical element can be improved. Moreover, in the case where the fine arrangement of the structures are disposed on not only a light incident surface, but also a light emitting surface, the transmission characteristic can be further improved.

Advantageous Effects

As described above, according to the present invention, an electrically conductive optical element having excellent antireflection performance can be realized.

Brief Description of Drawings

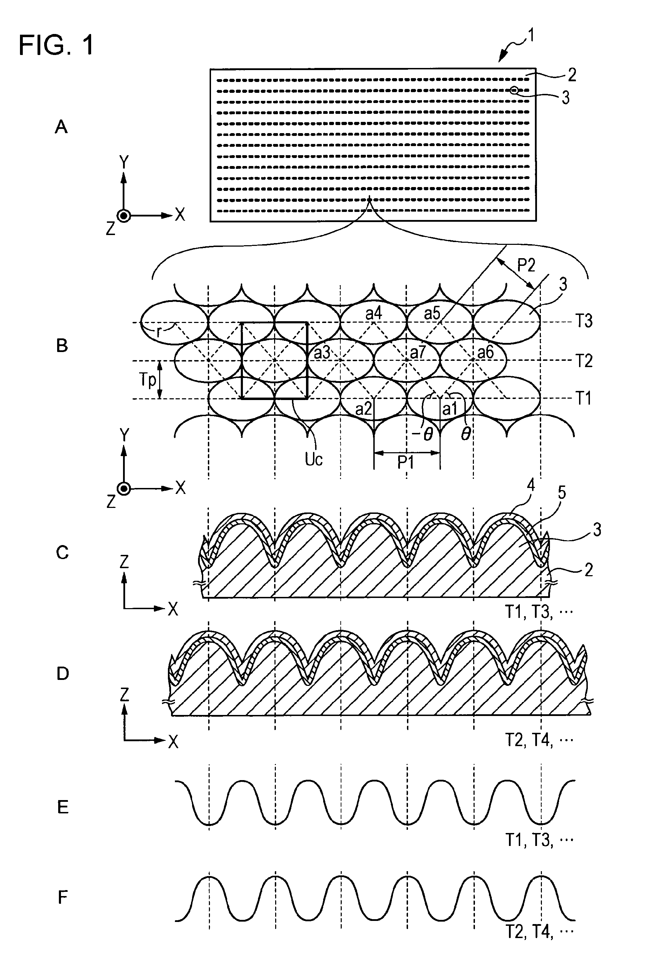

Fig. 1A is a schematic plan view showing an example of the configuration of an electrically conductive optical element according to a first embodiment of the present invention. Fig. 1B is a magnified plan view illustrating a part of the electrically conductive optical element shown in Fig. 1A. Fig. 1C is a sectional view along a track T1, T3, ··· shown in Fig. 1B. Fig. 1D is a sectional view along a track T2, T4, ··· shown in Fig. 1B. Fig. 1E is a schematic diagram showing a modulated waveform of the laser light used for forming a latent image corresponding to the tracks T1, T3, ··· shown in Fig. 1B. Fig. 1F is a schematic diagram showing a modulated waveform of the laser light used for forming a latent image corresponding to the tracks T2, T4, ··· shown in Fig. 1B.

Fig. 2 is a magnified perspective view illustrating a part of the electrically conductive optical element shown in Fig. 1A. Fig. 3A is a sectional view of the electrically conductive optical element shown in Fig. 1A in the track extension direction. Fig. 3B is a sectional view of the electrically conductive optical element 1 shown in Fig. 1A in the θ direction.

Fig. 4 is a magnified perspective view illustrating a part of the electrically conductive optical element shown in Fig. 1A.

Fig. 5 is a magnified perspective view illustrating a part of the electrically conductive optical element shown in Fig. 1A.

Fig. 6 is a magnified perspective view illustrating a part of the optical element shown in Fig. 1A.

Fig. 7 is a diagram for explaining a method for setting a structure bottom in the case where boundaries of structures are not clear.

Fig. 8A to Fig. 8D are diagrams showing the bottom shapes, where the ellipticity of the bottom of the structure is changed.

Fig. 9A is a diagram showing an example of the arrangement of structures having the shape of a circular cone or the shape of a circular truncated cone. Fig. 9B is a diagram showing an example of the arrangement of structures having the shape of an elliptical cone or the shape of an elliptical truncated cone.

Fig. 10A is a perspective view showing an example of the configuration of a roll master for producing an electrically conductive optical element. Fig. 10B is a magnified plan view showing a part of the roll master shown in Fig. 10A.

Fig. 11 is a schematic diagram showing an example of the configuration of a roll stamper exposing apparatus.

Fig. 12A to Fig. 12C are step diagrams for explaining a method for manufacturing an electrically conductive optical element according to the first embodiment of the present invention.

Fig. 13A to Fig. 13C are step diagrams for explaining the method for manufacturing an electrically conductive optical element according to the first embodiment of the present invention.

Fig. 14A and Fig. 14B are step diagrams for explaining the method for manufacturing an electrically conductive optical element according to the first embodiment of the present invention.

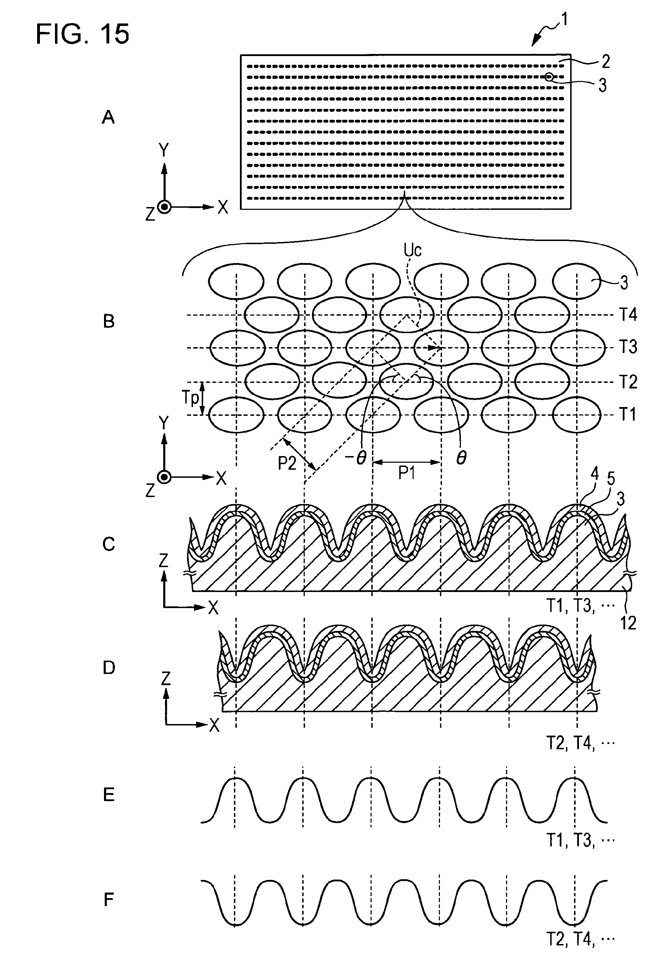

Fig. 15A is a schematic plan view showing an example of the configuration of an electrically conductive optical element according to a second embodiment of the present invention. Fig. 15B is a magnified plan view illustrating a part of the electrically conductive optical element shown in Fig. 15A. Fig. 15C is a sectional view along a track T1, T3, ⋯ shown in Fig. 15B. Fig. 15D is a sectional view along a track T2, T4, ⋯ shown in Fig. 15B. Fig. 15E is a schematic diagram showing a modulated waveform of the laser light used for forming a latent image corresponding to the tracks T1, T3, ⋯ shown in Fig. 15B. Fig. 15 F is a schematic diagram showing a modulated waveform of the laser light used for forming a latent image corresponding to the tracks T2, T4, ⋯ shown in Fig. 15B.

Fig. 16 is a diagram showing the bottom shapes, where the ellipticity of the bottom of the structure is changed.

Fig. 17A is a perspective view showing an example of the configuration of a roll master for producing an electrically conductive optical element. Fig. 17B is a magnified plan view illustrating a part of the roll master shown in Fig. 17A.

Fig. 18A is a schematic plan view showing an example of the configuration of an electrically conductive optical element according to a third embodiment of the present invention. Fig. 18B is a magnified plan view illustrating a part of the electrically conductive optical element shown in Fig. 18A. Fig. 18C is a sectional view along a track T1, T3, ⋯ shown in Fig. 18B. Fig. 18D is a sectional view along a track T2, T4, ⋯ shown in Fig. 18B.

Fig. 19A is a plan view showing an example of the configuration of a disk master for producing an electrically conductive optical element. Fig. 19B is a magnified plan view illustrating a part of the disk master shown in Fig. 19A.

Fig. 20 is a schematic diagram showing an example of the configuration of a disk stamper exposing apparatus.

Fig. 21A is a schematic plan view showing an example of the configuration of an electrically conductive optical element according to a fourth embodiment of the present invention. Fig. 21B is a magnified plan view illustrating a part of the electrically conductive optical element shown in Fig. 21A.

Fig. 22A is a schematic plan view showing an example of the configuration of an electrically conductive optical element according to a fifth embodiment of the present invention. Fig. 22B is a magnified plan view illustrating a part of the electrically conductive optical element shown in Fig. 22A. Fig. 22C is a sectional view along a track T1, T3, ⋯ shown in Fig. 22B. Fig. 22D is a sectional view along a track T2, T4, ⋯ shown in Fig. 22B.

Fig. 23 is a magnified perspective view illustrating a part of the electrically conductive optical element shown in Fig. 22A.

Fig. 24A is a schematic plan view showing an example of the configuration of an electrically conductive optical element according to a sixth embodiment of the present invention. Fig. 24B is a magnified plan view illustrating a part of the electrically conductive optical element shown in Fig. 24A. Fig. 24C is a sectional view along a track T1, T3, ⋯ shown in Fig. 24B. Fig. 24D is a sectional view along a track T2, T4, ⋯ shown in Fig. 24B.

Fig. 25 is a magnified perspective view illustrating a part of the electrically conductive optical element shown in Fig. 24A.

Fig. 26 is a graph showing an example of the refractive index profile of the electrically conductive optical element according to the sixth embodiment of the present invention.

Fig. 27 is a sectional view showing an example of the shape of a structure.

Fig. 28A to Fig. 28C are diagrams for explaining the definition of a turning point.

Fig. 29 is a sectional view showing an example of the configuration of an electrically conductive optical element according to a seventh embodiment of the present invention.

Fig. 30 is a schematic diagram showing a configuration example of a thermal transfer forming apparatus used for a method for manufacturing an electrically conductive optical element according to an eighth embodiment.

Fig. 31A is a sectional view showing an example of the configuration of a touch panel according to a ninth embodiment of the present invention. Fig. 31B is a sectional view showing a modified example of the configuration of the touch panel according to the ninth embodiment of the present invention.

Fig. 32A is a perspective view showing an example of the configuration of a touch panel according to a tenth embodiment of the present invention. Fig. 32B is a sectional view showing an example of the configuration of the touch panel according to the tenth embodiment of the present invention.

Fig. 33 is a sectional view showing an example of the configuration of a liquid crystal display device according to an eleventh embodiment of the present invention.

Fig. 34A is a perspective view showing a first example of the configuration of a touch panel according to a twelfth embodiment of the present invention. Fig. 34B is a sectional view showing a second example of the configuration of the touch panel according to the twelfth embodiment of the present invention.

Fig. 35A is a graph showing the reflection characteristics in Comparative examples 1 to 5. Fig. 35B is a graph showing the transmission characteristics in Comparative examples 1 to 5.

Fig. 36A is a graph showing the relationship between the aspect ratio and the surface resistance in Examples 1 and 2 and Comparative examples 6 and 7. Fig. 36B is a graph showing the relationship between the structure height and the surface resistance in Examples 1 and 2 and Comparative examples 6 and 7.

Fig. 37A is a graph showing the transmission characteristics in Examples 1 and 2 and Comparative examples 6 and 7. Fig. 37B is a graph showing the reflection characteristics in Examples 1 and 2 and Comparative examples 6 and 7.

Fig. 38A is a graph showing the transmission characteristics in Example 1 and Comparative example 9. Fig. 38B is a graph showing the reflection characteristics in Examples 1 and Comparative example 9.

Fig. 39A is a graph showing the transmission characteristics in Comparative examples 6 and 8. Fig. 39B is a graph showing the reflection characteristics in Comparative examples 6 and 8.

Fig. 40A is a graph showing the transmission characteristics in Examples 3 and 4 and Comparative examples 11 and 12. Fig. 40B is a graph showing the reflection characteristics in Examples 3 and 4 and Comparative examples 11 and 12.

Fig. 41 is a graph showing the transmission characteristics in Example 5 and Comparative examples 13 to 16.

Fig. 42A is a graph showing the transmission characteristics of electrically conductive optical sheets in Comparative examples 17 and 18. Fig. 42B is a graph showing the reflection characteristics of the electrically conductive optical sheets in Comparative examples 17 and 18.

Fig. 43A is a graph showing the reflection characteristics in Comparative examples 19 and 20. Fig. 43B is a graph showing the reflection characteristics in Example 6 and Comparative example 21.

Fig. 44A is a graph showing the reflection characteristics in Example 7 and Comparative example 22. Fig. 44B is a graph showing the reflection characteristics in Example 8 and Comparative example 23.

Fig. 45A is a diagram for explaining the filling factor in the case where structures are arranged in the shape of a hexagonal lattice. Fig. 45B is a diagram for explaining the filling factor in the case where structures are arranged in the shape of a tetragonal lattice.

Fig. 46 is a graph showing the simulation result in Test examples 3.

Fig. 47 is a schematic diagram for explaining the method for determining the average layer thicknesses Dm1, Dm2, and Dm3 of a transparent, electrically conductive layer disposed on structures which are convex portions.

Fig. 48A is a sectional view showing an example of the configuration of a touch panel according to a thirteenth embodiment of the present invention. Fig. 48B is a magnified sectional view illustrating a wiring region R1 shown in Fig. 48A, under magnification. Fig. 48C is a magnified sectional view illustrating a non-wiring region R2 shown in Fig. 48A, under magnification.

Fig. 49A is a perspective view showing a more specific configuration example of the touch panel according to the thirteenth embodiment of the present invention. Fig. 49B is an exploded perspective view showing a configuration example of a first base member.

Fig. 50A is a schematic plan view showing an example of the configuration of a first optical layer provided with convex-shaped structures in large numbers on both principal surfaces. Fig. 50B is a magnified plan view illustrating a part of the first optical layer shown in Fig. 50A. Fig. 50C is a sectional view along a track T1, T3, ⋯ shown in Fig. 50B. Fig. 50D is a sectional view along a track T2, T4, ⋯ shown in Fig. 50B.

Fig. 51A is a sectional view of the first optical layer shown in Fig. 50B in the track extension direction. Fig. 51B is a sectional view of the first optical layer shown in Fig. 50B in the θ direction.

Fig. 52A is a perspective view illustrating a first shape example of structures shown in Fig. 50B. Fig. 52B is a perspective view illustrating a second shape example of the structures shown in Fig. 50B.

Fig. 53A is a perspective view illustrating a third shape example of the structures shown in Fig. 50B. Fig. 53B is a perspective view illustrating a fourth shape example of the structures shown in Fig. 50B.

Fig. 54A is a diagram showing an example of the arrangement of structures having the shape of a circular cone or the shape of a circular truncated cone. Fig. 54B is a diagram showing an example of the arrangement of structures having the shape of an elliptical cone or the shape of an elliptical truncated cone.

Fig. 55A is a schematic plan view showing an example of the configuration of the first optical layer provided with concave-shaped structures in large numbers on both principal surfaces. Fig. 55B is a magnified plan view illustrating a part of the electrically conductive element shown in Fig. 55A. Fig. 55C is a sectional view along a track T1, T3, ··· shown in Fig. 55B. Fig. 55D is a sectional view along a track T2, T4, ··· shown in Fig. 55B.

Fig. 56 is a magnified perspective view illustrating a part of the electrically conductive element shown in Fig. 55B.

Fig. 57A is a perspective view showing an example of the configuration of a roll stamper for producing the first optical layer. Fig. 57B is a magnified plan view illustrating a part of the roll stamper shown in Fig. 57A.

Fig. 58 is a schematic diagram showing an example of the configuration of a roll stamper exposing apparatus.

Fig. 59A to Fig. 59C are step diagrams for explaining an example of a method for manufacturing the electrically conductive element according to the thirteenth embodiment of the present invention.

Fig. 60A to Fig. 60C are step diagrams for explaining an example of the method for manufacturing an electrically conductive element according to the thirteenth embodiment of the present invention.

Fig. 61A and Fig. 61B are step diagrams for explaining an example of the method for manufacturing an electrically conductive element according to the thirteenth embodiment of the present invention.

Fig. 62A is a plan view showing a first modified example of tracks of the electrically conductive element according to the thirteenth embodiment. Fig. 62B is a plan view showing a second modified example of the tracks of the electrically conductive optical element according to the thirteenth embodiment.

Fig. 63 is a sectional view showing a modified example of a transparent, electrically conductive layer and an uneven shape of the electrically conductive element according to the thirteenth embodiment.

Fig. 64A is a magnified sectional view illustrating a wiring region R1 of an electrically conductive element according to the fourteenth embodiment of the present invention, under magnification. Fig. 64B is a magnified sectional view illustrating a non-wiring region R2 of an electrically conductive element according to the fourteenth embodiment of the present invention, under magnification.

Fig. 65A is a schematic plan view showing an example of the configuration of an electrically conductive element according to a fifteenth embodiment of the present invention. Fig. 65B is a magnified plan view illustrating a part of the electrically conductive element shown in Fig. 65A. Fig. 65C is a sectional view along a track T1, T3, ··· shown in Fig. 65B. Fig. 65D is a sectional view along a track T2, T4, ··· shown in Fig. 65B.

Fig. 66A is a schematic plan view showing an example of a first optical layer of an electrically conductive element according to a sixteenth embodiment. Fig. 66B is a magnified plan view illustrating a part of the first optical layer shown in Fig. 66A.

Fig. 67A is a schematic plan view showing an example of the configuration of a first optical layer of an electrically conductive element according to a seventeenth embodiment of the present invention. Fig. 67B is a magnified plan view illustrating a part of the first optical layer shown in Fig. 67A. Fig. 67C is a sectional view along a line C-C shown in Fig. 67B.

Fig. 68 is a sectional view showing an example of the configuration of a touch panel according to an eighteenth embodiment of the present invention.

Fig. 69A is a sectional view showing an example of the configuration of a touch panel according to a nineteenth embodiment of the present invention. Fig. 69B is a magnified sectional view illustrating a wiring region shown in Fig. 69A, under magnification. Fig. 69C is a magnified sectional view illustrating a non-wiring region shown in Fig. 69A, under magnification.

Fig. 70 is a sectional view showing an example of the configuration of a display device according to a twentieth embodiment of the present invention. Fig. 70B is a magnified sectional view illustrating a wiring region shown in Fig. 70A, under magnification. Fig. 70C is a magnified sectional view illustrating a non-wiring region shown in Fig. 70A, under magnification.

Fig. 71 is a graph showing the reflection characteristics of electrically conductive elements according to Examples 1-1 to 1-3 and Comparative example 1-1.

Fig. 72 is a graph showing the reflection characteristics of electrically conductive elements according to Examples 2-1 to 2-3 and Comparative example 2-1.

Fig. 73 is a graph showing the reflection characteristics of electrically conductive elements according to Examples 3-1 and 3-2 and an optical element according to Comparative example 3-1.

Fig. 74 is a graph showing the reflection characteristics of electrically conductive elements according to Reference examples 1-1 to 1-3 and an optical element according to Reference example 1-4.

Fig. 75 is a graph showing the reflection characteristics of electrically conductive sheets according to Example 4-1 and Comparative examples 4-1 and 4-3 and an optical sheet according to Comparative example 4-2.

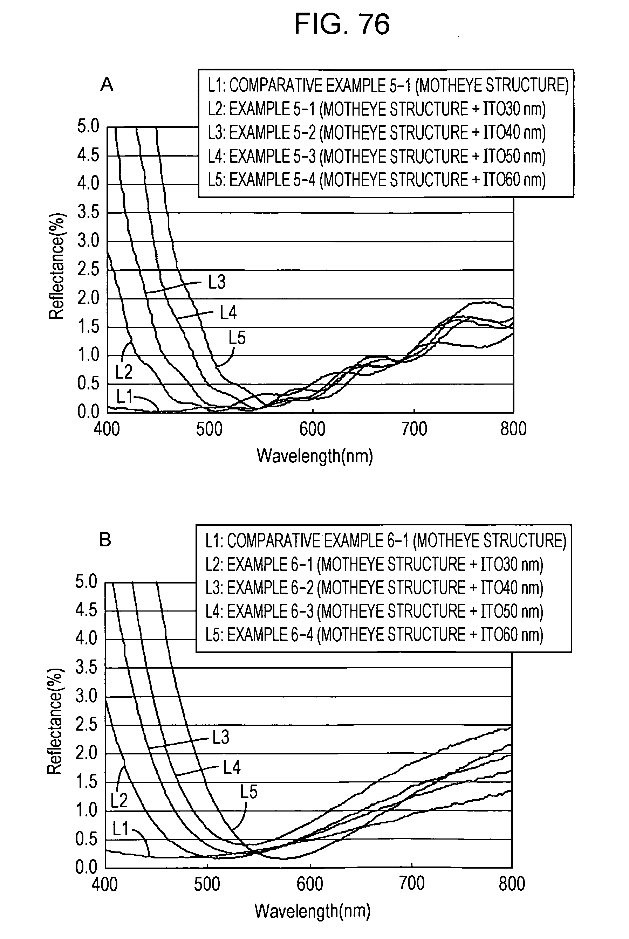

Fig. 76A is a graph showing the reflection characteristics of electrically conductive sheets according to Examples 5-1 to 5-4 and an optical sheet according to Comparative example 5-1. Fig. 76B is a graph showing the reflection characteristics of electrically conductive sheets according to Examples 6-1 to 6-4 and an optical sheet according to Comparative example 6-1.

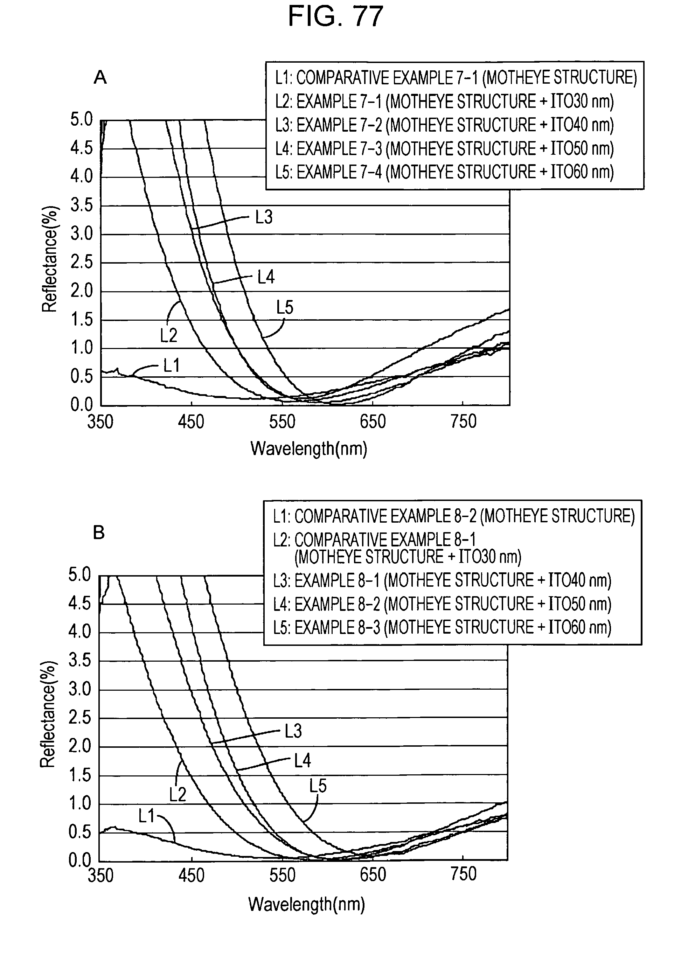

Fig. 77A is a graph showing the reflection characteristics of electrically conductive sheets according to Examples 7-1 to 7-4 and an optical sheet according to Comparative example 7-1. Fig. 77B is a graph showing the reflection characteristics of electrically conductive sheets according to Examples 8-1 to 8-3 and Comparative example 8-1 and an optical sheet according to Comparative example 8-2.

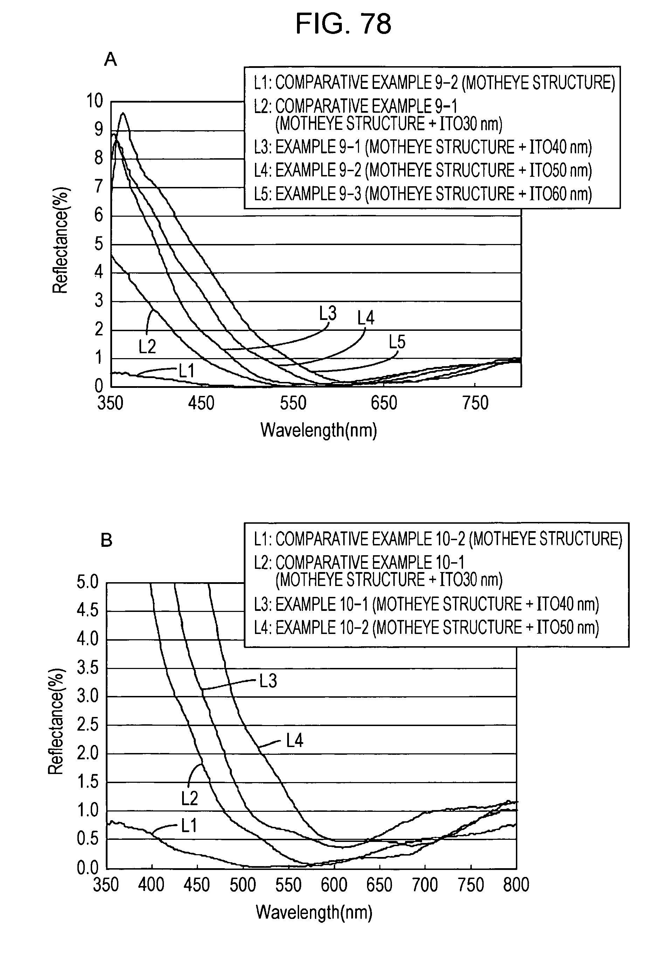

Fig. 78A is a graph showing the reflection characteristics of electrically conductive sheets according to Examples 9-1 to 9-3 and Comparative example 9-1 and an optical sheet according to Comparative example 9-2. Fig. 78B is a graph showing the reflection characteristics of electrically conductive sheets according to Examples 10-1 and 10-2 and Comparative example 10-1 and an optical sheet according to Comparative example 10-2.

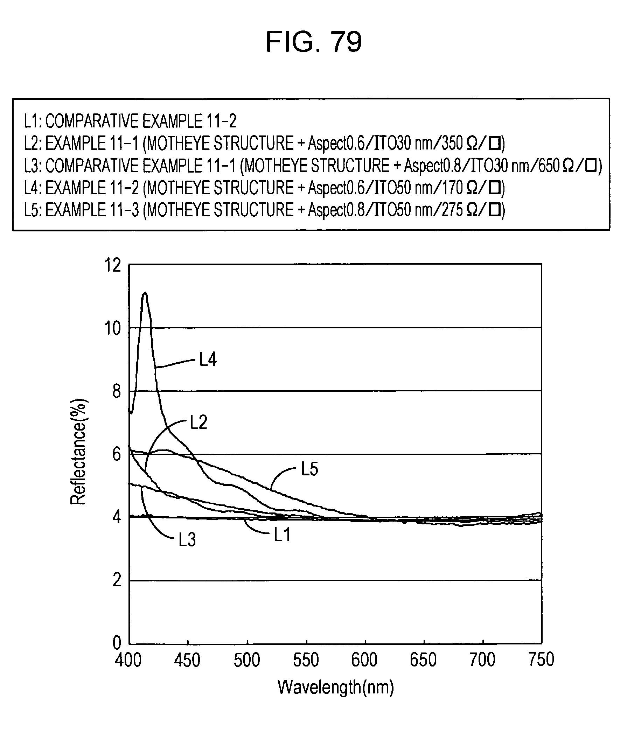

Fig. 79 is a graph showing the reflection characteristics of electrically conductive sheets according to Examples 11-1 to 11-3 and Comparative example 11-1 and an optical sheet according to Comparative example 11-2.

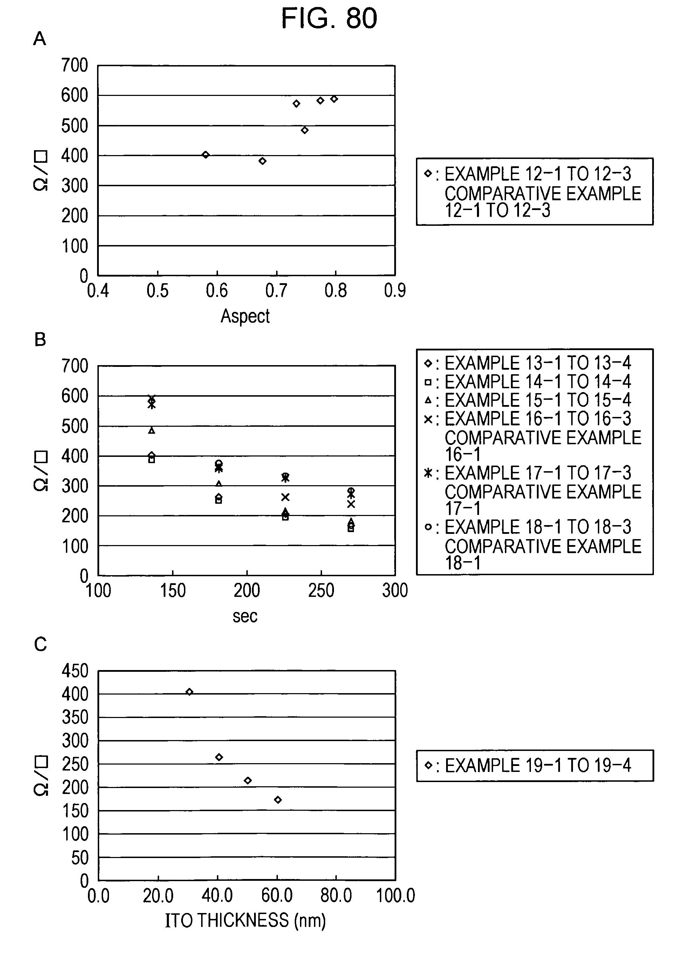

Fig. 80A is a graph showing the surface resistance characteristics of electrically conductive sheets according to Examples 12-1 to 12-3 and comparative examples 12-1 to 12-3. Fig. 80B is a graph showing the surface resistance characteristics of electrically conductive sheets according to Examples 13-1 to 18-3 and comparative examples 16-1 to 18-1. Fig. 80C is a graph showing the surface resistance characteristics of electrically conductive sheets according to Examples 19-1 to 19-4.

Fig. 81A is a graph showing the reflection characteristics of electrically conductive sheets according to Examples 20-1, 20-5, and 20-7 and Comparative example 20-1. Fig. 81B is a graph showing the reflection characteristics of electrically conductive sheets according to Example 20-2, Example 20-4, and Comparative example 20-2.

Fig. 82A is a graph showing the reflection characteristics of electrically conductive sheets according to Examples 20-8 and Comparative example 20-1. Fig. 82B is a graph showing the transmission characteristics of electrically conductive sheets according to Example 20-8 and Comparative example 20-1.

Fig. 83 is a graph showing XRD spectra of electrically conductive sheets according to Examples 20-7 and 20-9 and Comparative example 20-1.

Best Modes for Carrying Out the Invention

The embodiments according to the present invention will be described in the following order with reference to the drawings.

1. First embodiment (example of two-dimensional arrangement of structures into the shape of a straight line and, in addition, the shape of a hexagonal lattice: refer to Fig. 1)

2. Second embodiment (example of two-dimensional arrangement of structures into the shape of a straight line and, in addition, the shape of a tetragonal lattice: refer to Fig. 15)

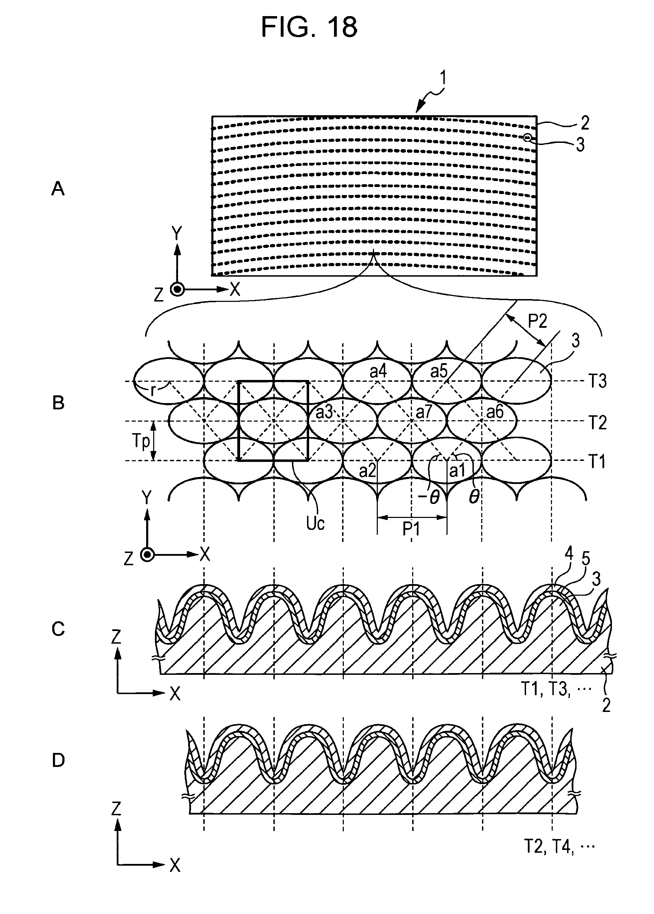

3. Third embodiment (example of two-dimensional arrangement of structures into the shape of an arc and, in addition, the shape of a hexagonal lattice: refer to Fig. 18)

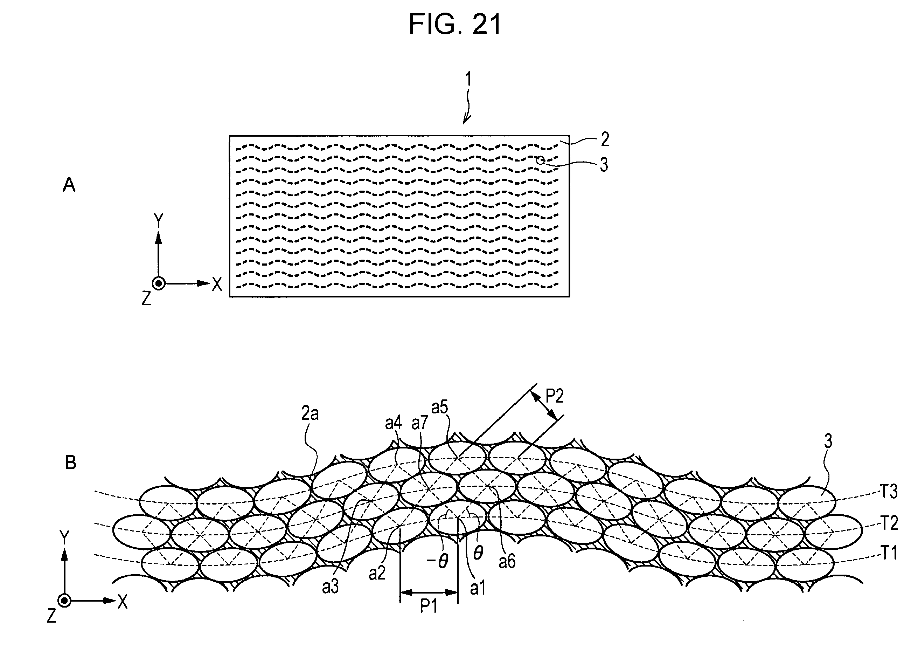

4. Fourth embodiment (example of meandering arrangement of structures: refer to Fig. 21)

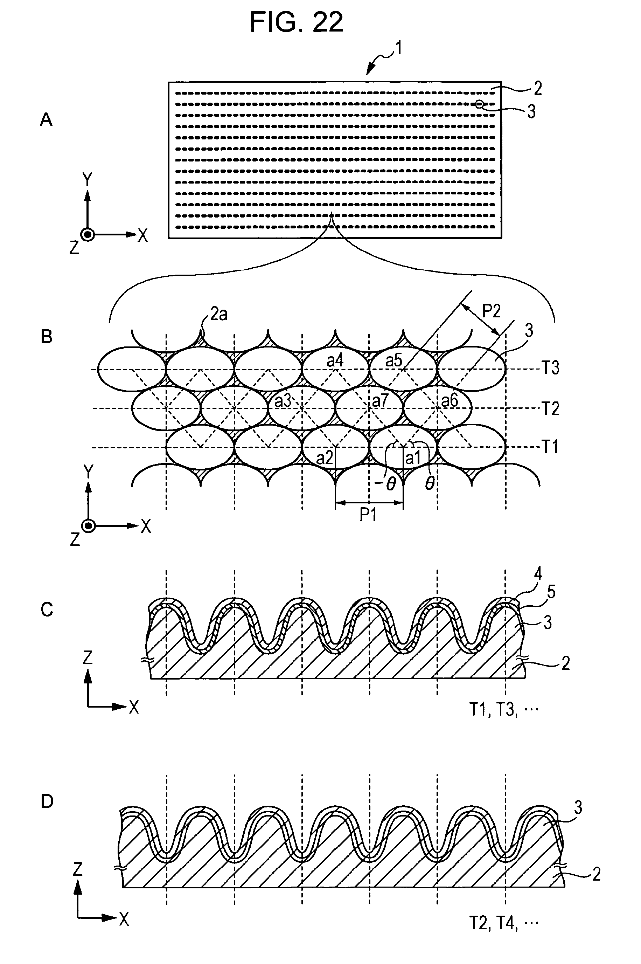

5. Fifth embodiment (example of formation of concave-shaped structures on substrate surface: refer to Fig. 22)

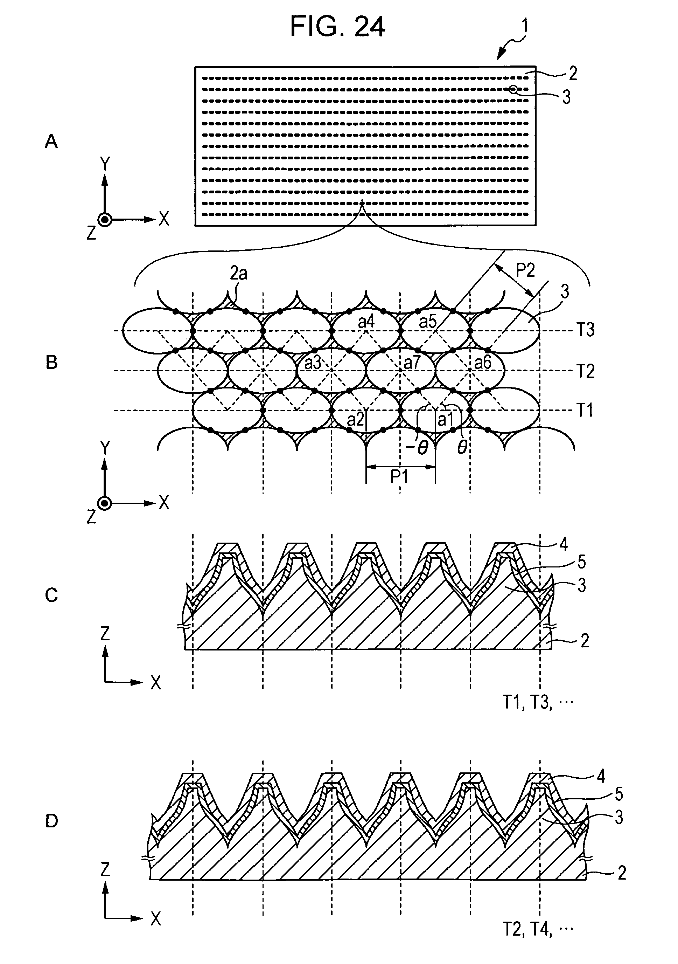

6. Sixth embodiment (example of refractive index profile in the shape of the letter S: refer to Fig. 24)

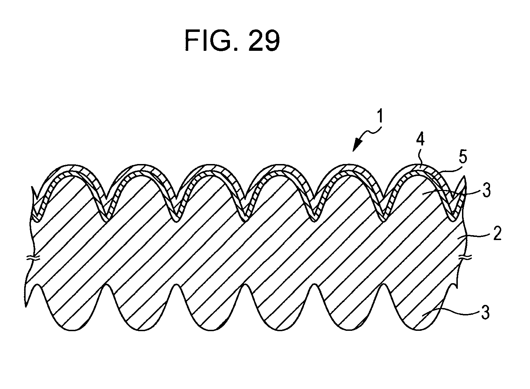

7. Seventh embodiment (example of formation of structures on both principal surfaces of electrically conductive optical element: refer to Fig. 29)

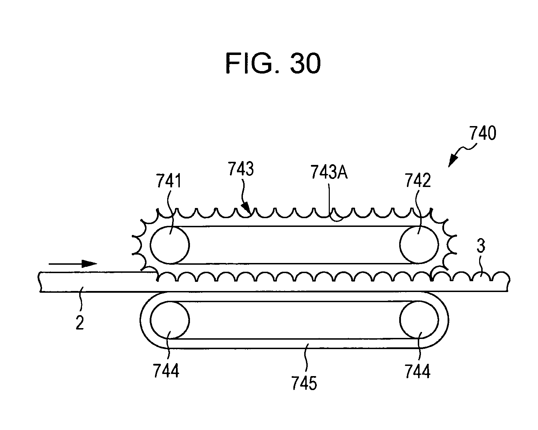

8. Eighth embodiment (example of formation of structures through thermal transfer: Fig. 30)

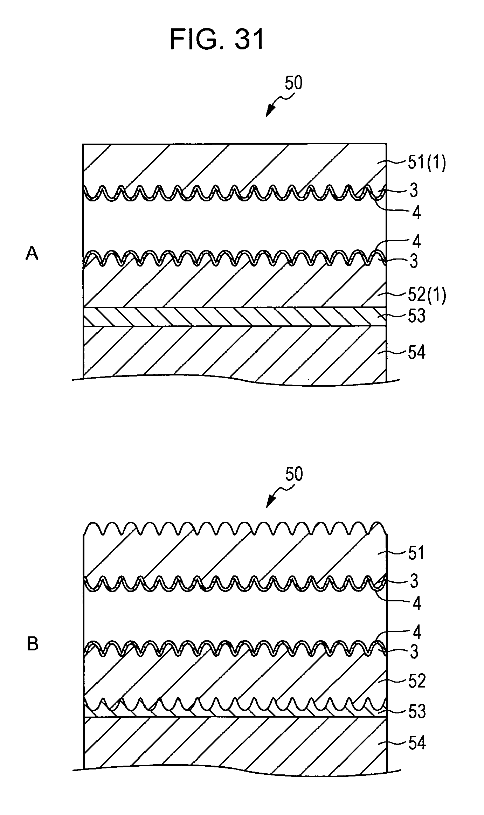

9. Ninth embodiment (example of application to resistive touch panel: refer to Fig. 31A and Fig. 31B)

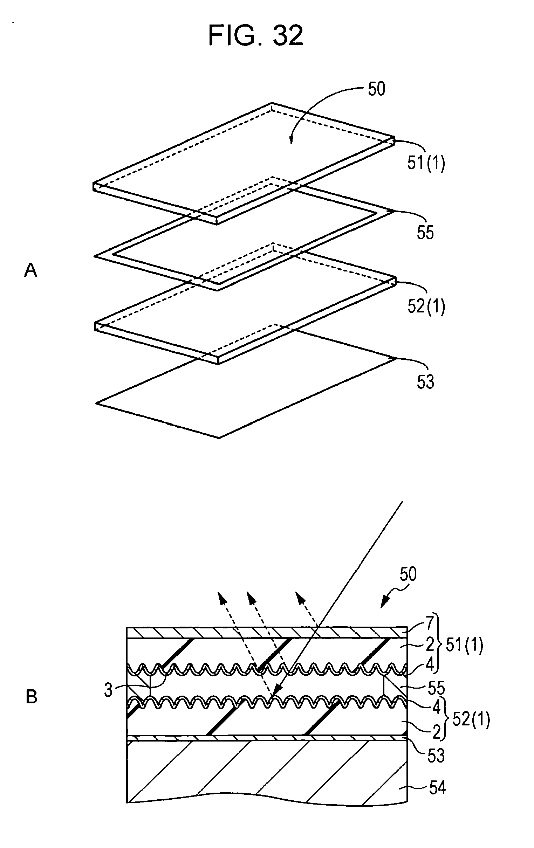

10. Tenth embodiment (example of formation of hard coat layer on touch surface of touch panel: refer to Fig. 32A and Fig. 32B)

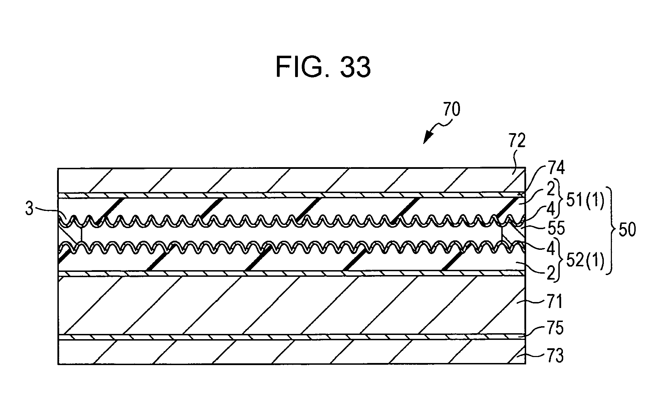

11. Eleventh embodiment (example of inner touch panel: refer to Fig. 33)

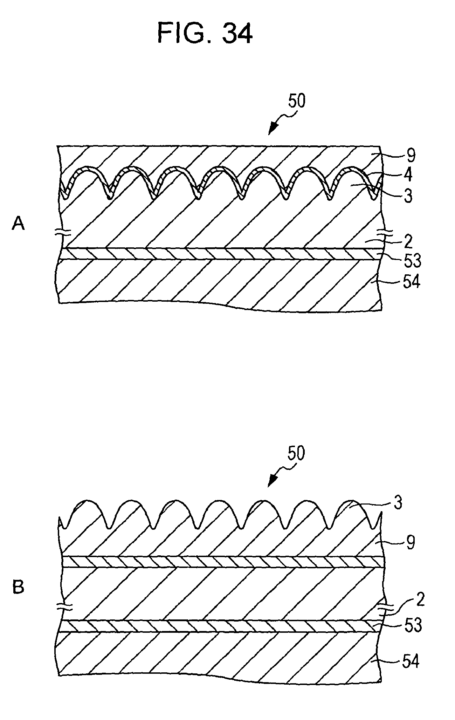

12. Twelfth embodiment (example of application to capacitive touch panel: refer to Fig. 34A and 34B)

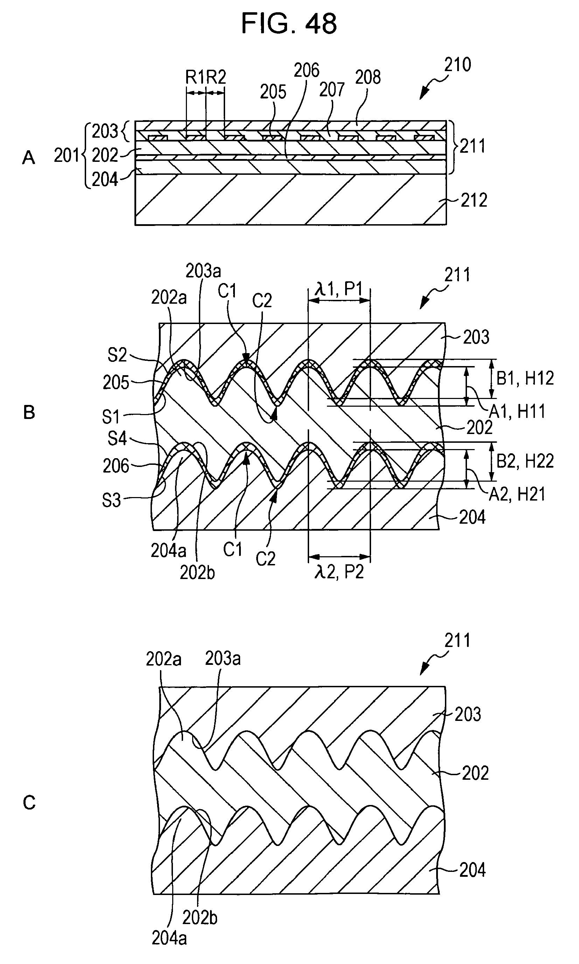

13. Thirteenth embodiment (example of inclusion of two transparent, electrically conductive layers in optical layer: refer to Fig. 48)

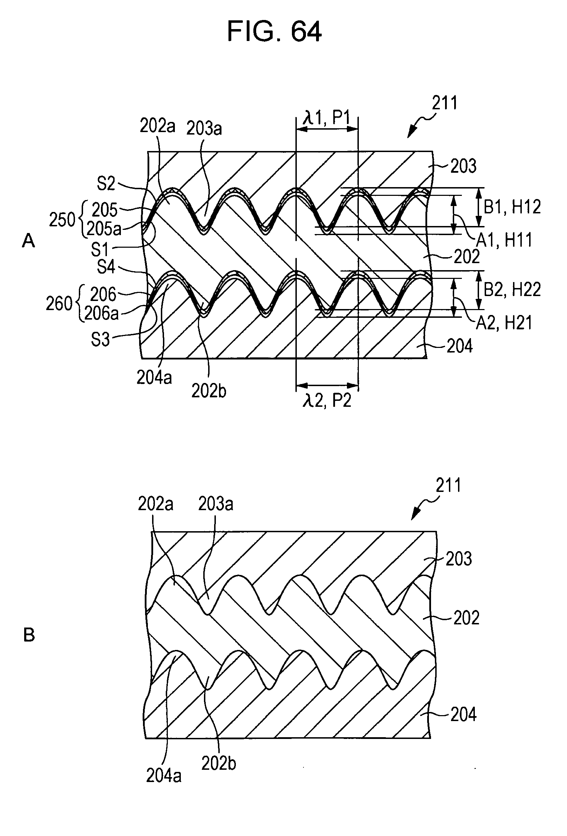

14. Fourteenth embodiment (example of further inclusion of metal layer in optical layer: refer to Fig. 64)

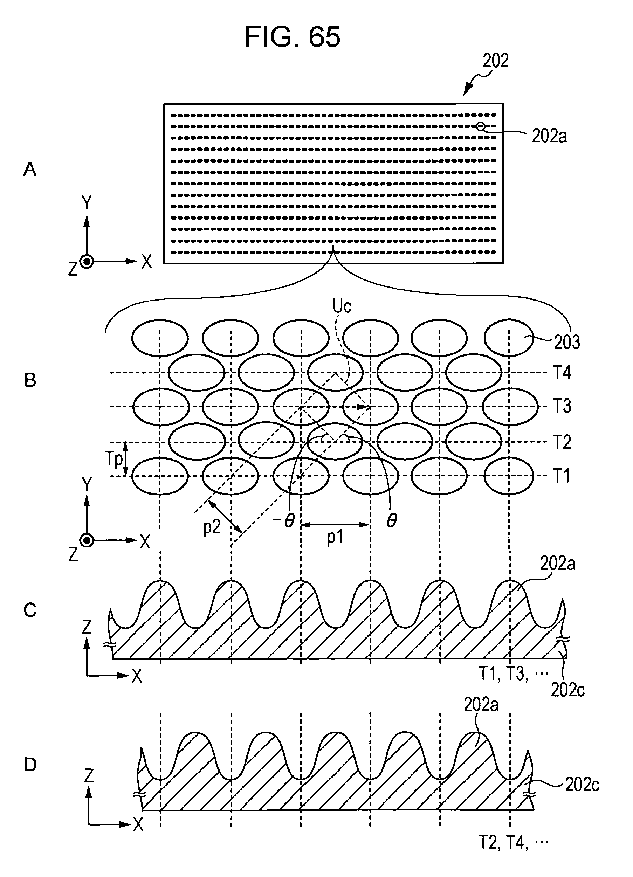

15. Fifteenth embodiment (example of two-dimensional arrangement of structures into the shape of a tetragonal lattice: refer to Fig. 65)

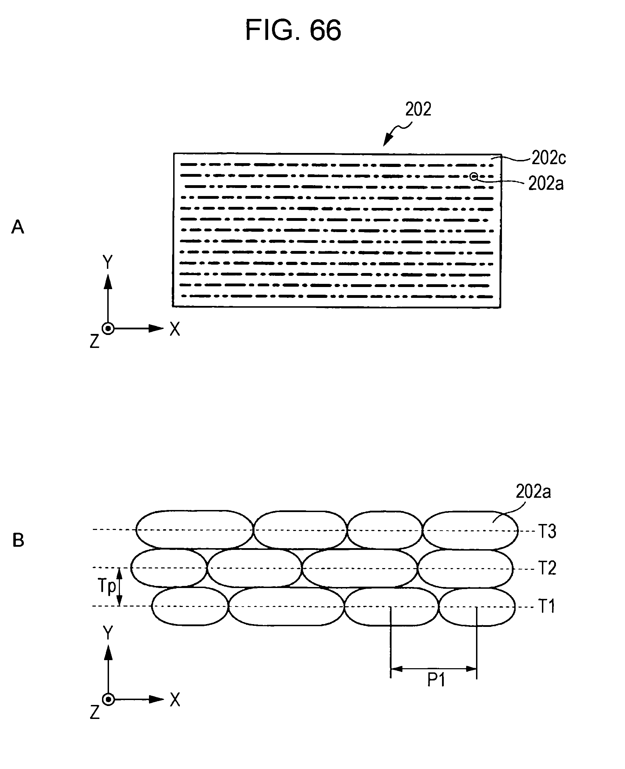

16. Sixteenth embodiment (example of two-dimensional arrangement of at least two types of structures: refer to Fig. 66)

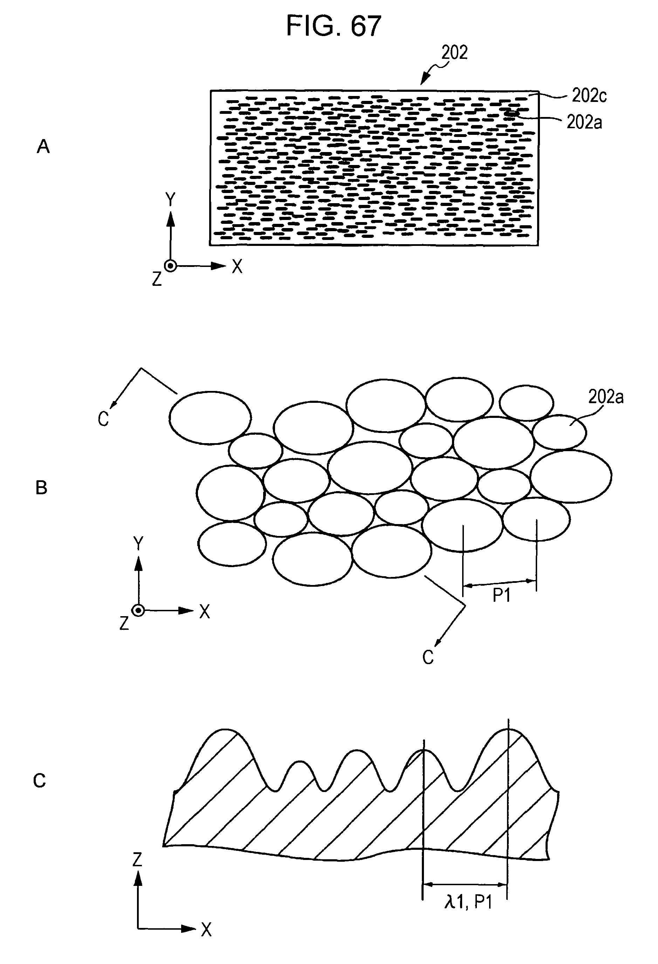

17. Seventeenth embodiment (example of random arrangement of structures: refer to Fig. 67)

18. Eighteenth embodiment (example of inclusion of single transparent, electrically conductive layer in optical layer:

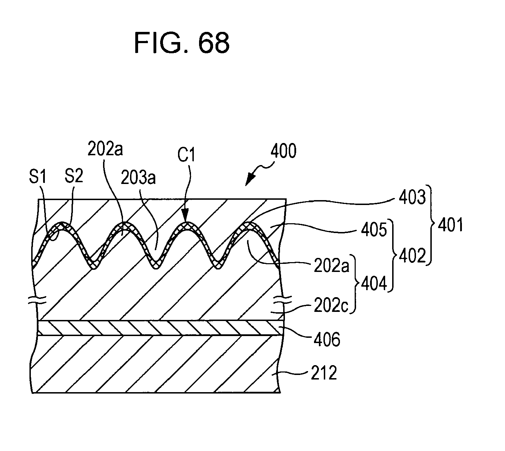

refer to Fig. 68)

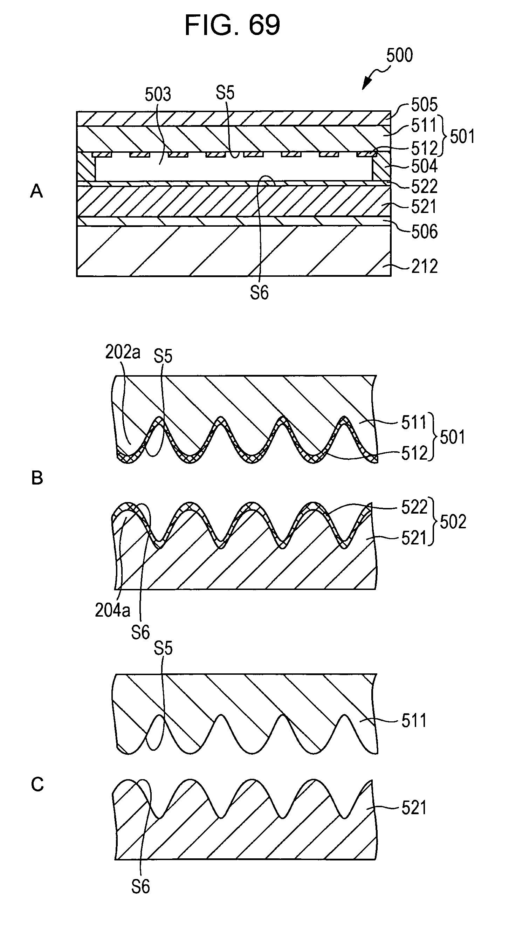

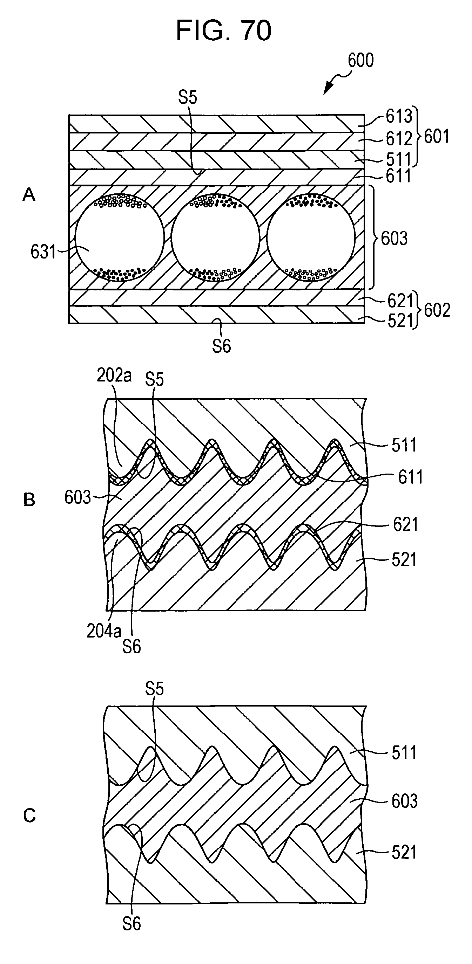

19. Nineteenth embodiment (example of application to resistive touch panel: refer to Fig. 69)
20. Twentieth embodiment (example of application to display device: refer to Fig. 70)

<1. First embodiment>

[Configuration of electrically conductive optical element]

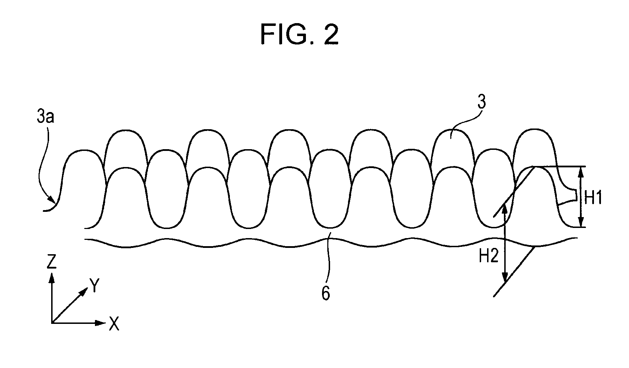

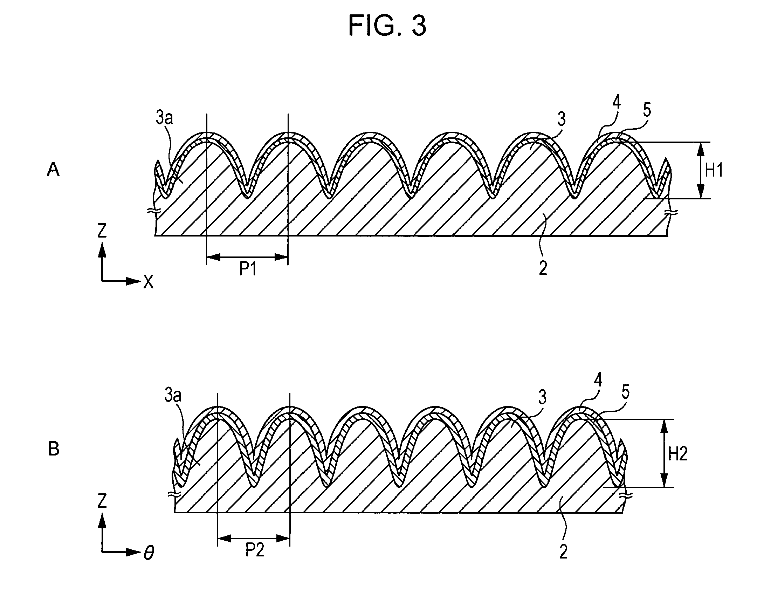

Fig. 1A is a schematic plan view showing an example of the configuration of an electrically conductive optical element according to a first embodiment of the present invention. Fig. 1B is a magnified plan view illustrating a part of the electrically conductive optical element shown in Fig. 1A. Fig. 1C is a sectional view along a track T1, T3, ··· shown in Fig. 1B. Fig. 1D is a sectional view along a track T2, T4, ··· shown in Fig. 1B. Fig. 1E is a schematic diagram showing a modulated waveform of the laser light used for forming a latent image corresponding to the tracks T1, T3, ··· shown in Fig. 1B. Fig. 1F is a schematic diagram showing a modulated waveform of the laser light used for forming a latent image corresponding to the tracks T2, T4, ··· shown in Fig. 1B. Fig. 2 and Fig. 4 to Fig. 6 are magnified perspective views illustrating a part of the electrically conductive optical element 1 shown in Fig. 1A. Fig. 3A is a sectional view of the electrically conductive optical element shown in Fig. 1A in the track extension direction (X direction (hereafter may be referred to as a track direction appropriately)). Fig. 3B is a sectional view of the electrically conductive optical element shown in Fig. 1A in the θ direction.

An electrically conductive optical element 1 is provided with a substrate 2 having both principal surfaces opposite to each other, a plurality of structures 3, which are convex portions and which are disposed on one principal surface with a minute pitch smaller than or equal to the wavelength of the light, where reduction in reflection is intended, and a transparent, electrically conductive layer 4 disposed on these structures 3. In this regard, a metal layer (electrically conductive layer) 5 may be further disposed between the structures 3 and the transparent, electrically conductive layer 4. This electrically conductive optical element 1 has a function to prevent reflection of light passing through the substrate 2 in the -Z direction shown in Fig. 2 at the interface between the structures 3 and the surrounding air.

The substrate 2, the structures 3, the transparent, electrically conductive layer 4, and the metal layer 5, which are provided in the optical element 1, will be sequentially described below.

The aspect ratio (height H/average arrangement pitch P) of the structure 3 is within the range of preferably 0.2 or more, and 1.3 or less, and more preferably 0.2 or more, and 1.0 or less. The average layer thickness of the transparent, electrically conductive layer 4 is preferably within the range of 9 nm or more, and 80 nm or less. If the aspect ratio of the structure 3 is less than 0.2 and the average layer thickness of the transparent, electrically conductive layer 4 exceeds 80 nm, the antireflection characteristic and the transmission characteristic tend to be degraded. On the other hand, if the aspect ratio of the structure 3 exceeds 1.3 and the average layer thickness of the transparent, electrically conductive layer 4 is less than 9 nm, the surface resistance tends to increase because the slope of the structure 3 becomes steep and the average layer thickness of the transparent, electrically conductive layer 4 is reduced. That is, the aspect ratio and the average layer thickness satisfy the above-described numerical range and, thereby, a wide range of surface resistance (for example, 50 Ω/□ or more, and 500 Ω/□ or less) can be obtained and, in addition, excellent antireflection characteristic and transmission characteristic can be obtained. Here, the average layer thickness of the transparent, electrically conductive layer 4 is the average layer thickness $Dm1$ of the transparent, electrically conductive layer 4 at the top portion of the structure 3.

Furthermore, the aspect ratio of the structure 3 is preferably 0.2 or more, and 1.3 or less, and more preferably 0.2 or more, and 1.0 or less. If the aspect ratio is less than 0.2, the antireflection characteristic tends to be degraded, and if 1.3 is exceeded, the electrical conductivity tends to be degraded with respect to environmental durability and the like because the inclination of the slope portion becomes steep and the layer thickness is reduced.

It is preferable that the relationship represented by $Dm1 > Dm3 > Dm2$ is satisfied, where the average layer thickness of the transparent, electrically conductive layer 4 at the top portion of the structure 3 is assumed to be $Dm1$, the average layer thickness of the transparent, electrically conductive layer 4 at the inclined surface of the structure 3 is assumed to be $Dm2$, and the average layer thickness of the transparent, electrically conductive layer 4 in between the structures is assumed to be $Dm3$. The average layer thickness $D2$ of the inclined surfaces of the structures 3 is preferably within the range of 9 nm or more, and 80 nm or less. In the case where the average layer thicknesses $Dm1$, $Dm2$, and $Dm3$ of the transparent, electrically conductive layer 4 satisfy the above-described relationship and, in addition, the average layer thickness $Dm2$ of the transparent, electrically conductive layer 4 satisfy the above-described numerical range, a wide range of surface resistance can be obtained and, in addition, excellent antireflection characteristic and transmission characteristic can be obtained. In this regard, it is possible to ascertain whether the average layer thicknesses $Dm1$, $Dm2$, and $Dm3$ satisfy the above-described relationship or not by determining each of the average layer thicknesses $Dm1$, $Dm2$, and $Dm3$, as described later.

It is preferable that the transparent, electrically conductive layer 4 has the surface following the shape of the structures 3 and the average layer thickness D1 of the transparent, electrically conductive layer 4 at the top portions of the structures 3 is within the range of 80 nm or less. It is preferable that the transparent, electrically conductive layer 4 has the surface following the shape of the structures 3 and the average layer thickness D1 of the transparent, electrically conductive layer 4 at the top portions of the structures 3 is within the range of 10 nm or more, and 80 nm or less. If 80 nm is exceeded, the antireflection characteristic tends to be degraded. If the average layer thickness is less than 10 nm, realization of a predetermined resistance tends to become difficult. Moreover, the environmental durability tends to be degraded.

From the viewpoint of obtainment of a wide range of surface resistance and, in addition, obtainment of excellent antireflection characteristic and transmission characteristic, it is preferable that the average layer thickness Dm1 of the transparent, electrically conductive layer 4 at the top portion of the structure 3 is within the range of 10 nm or more, and 80 nm or less, the average layer thickness Dm2 of the transparent, electrically conductive layer 4 at the inclined surface of the structure 3 is within the range of 9 nm or more, and 80 nm or less, and the average layer thickness Dm3 of the transparent, electrically conductive layer 4 in between the structures is within the range of 9 nm or more, and 80 nm or less.

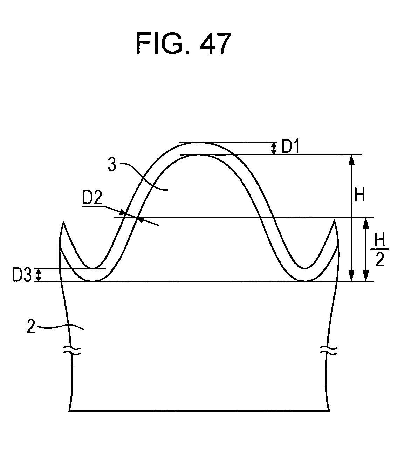

Fig. 47 is a schematic diagram for explaining the method for determining the average layer thicknesses Dm1, Dm2, and Dm3 of a transparent, electrically conductive layer disposed on structures which are convex portions. The method for determining the average layer thicknesses Dm1, Dm2, and Dm3 will be described below with reference to Fig. 47.

Initially, the electrically conductive optical element 1 is cut in the extension direction of the track in such a way as to include the top portion of the structure 3, and the resulting cross-section is photographed with TEM. Thereafter, on the basis of the resulting TEM photograph, the layer thickness D1 of the transparent, electrically conductive layer 4 at the top portion of the structure 3 is measured. Subsequently, the layer thickness D2 of the position at half the height of the structure 3 (H/2) is measured among the positions of the inclined surface of the structure 3. Then, the layer thickness D3 of the position, at which the depth of the concave portion is the largest among the positions of the concave portion between the structures, is measured. Next, the measurements of these layer thicknesses D1, D2, and D3 are repeated with respect to 10 places selected from the electrically conductive optical element 1 at random, and measurement values D1, D2, and D3 are simply averaged (arithmetically averaged), so as to determine the average layer thicknesses Dm1, Dm2, and Dm3.

The surface resistance of the transparent, electrically conductive layer 4 is preferably within the range of 50 $\Omega/\square$ or more, and 4,000 $\Omega/\square$ or less, and is more preferably within the range of 50 $\Omega/\square$ or more, and 500 $\Omega/\square$ or less. This is because the transparent, electrically conductive optical element 1 can be used as upper electrodes or lower electrodes of various types of touch panels by specifying the surface resistance within the above-described range. Here, the surface resistance of the transparent, electrically conductive layer 4 is determined on the basis of four-terminal measurement (JIS K 7194).

The resistivity of the transparent, electrically conductive layer 4 is preferably $1 \times 10^{-3}$ $\Omega\cdot$cm or less, and is more preferably $6 \times 10^{-4}$ $\Omega\cdot$cm or less. This is because in the case where the resistivity is $1 \times 10^{-3}$ $\Omega\cdot$cm or less, the above-described range of the surface resistance can be realized.

The average arrangement pitch P of the structures 3 is within the range of preferably 100 nm or more, and 350 nm or less, and more preferably 150 nm or more, and 320 nm or less. If the average arrangement pitch is less than 100 nm, the electrical conductivity tends to be degraded with respect to environmental durability and the like because the inclination of the slope portion becomes steep and the layer thickness is reduced. On the other hand, if the average arrangement pitch exceeds 350 nm, diffraction of the visible light tends to occur.

The height (depth) H of the structure 3 is within the range of preferably 30 nm or more, and 320 nm or less, and more preferably 70 nm or more, and 320 nm or less. If the height H of the structure 3 is less than 30 nm, the reflectance tends to increase. If the height H of the structure 3 exceeds 320 nm, realization of a predetermined resistance tends to become difficult.

(Substrate)

The substrate 2 is, for example, a transparent substrate having transparency. Examples of materials for the substrate 2 include plastic materials having transparency and materials containing glass and the like as primary components, although not specifically limited to these materials.

As for the glass, for example, soda lime glass, lead glass, hard glass, quartz glass, and liquid crystal glass (refer to "Kagaku Binran (Handbook of Chemistry)", Pure Chemistry, P. I-537, edited by THE CHEMICAL SOCIETY OF JAPAN) are used. As for the plastic materials, (meth)acrylic resins, e.g., polymethyl methacrylate and copolymers of methyl methacrylate and vinyl monomers, such as, other alkyl (meth)acrylate and styrene; polycarbonate based resins, e.g., polycarbonates and diethylene glycol bis allylcarbonate (CR-39); thermosetting (meth)acrylic resins, e.g., homopolymers or copolymers of (brominated) bisphenol A type di(meth)acrylate and polymers and copolymers of urethane-modified monomer of (brominated) bisphenol A mono(meth)acrylate; polyesters, in particular polyethylene terephthalates, polyethylene naphthalates, and unsaturated polyesters, acrylonitrile-styrene copolymers, polyvinyl chlorides, polyurethanes, epoxy resins, polyacrylates, polyether sulfones, polyether ketones, cycloolefin polymers (trade name: ARTON, ZEONOR), and cycloolefin copolymers are preferable from the viewpoint of optical characteristics, e.g., the transparency, the refractive index, and dispersion, and, in addition, various characteristics, e.g., the impact resistance, the heat resistance, and the durability. Furthermore, aramid based resins in consideration of the heat resistance can also be used.

In the case where the plastic material is used as the substrate 2, in order to further improve the surface energy, the paintability, the sliding property, the flatness, and the like of the plastic surface, an under coat may be disposed as a surface treatment. Examples of the under coats include organoalkoxy metal compounds, polyesters, acryl-modified polyesters, and polyurethanes. Moreover, in order to obtain the same effect as that of disposition of the under coat, the surface of the substrate 2 may be subjected to corona discharge or a UV irradiation treatment.

In the case where the substrate 2 is a plastic film, the substrate 2 can be obtained by, for example, a method in which the above-described resin is stretched or is diluted with a solvent and, thereafter, formed into the shape of a film, followed by drying. In this regard, the thickness of the substrate 2 is, for example, about 25 $\mu$m to 500 $\mu$m.

Examples of shapes of the substrate 2 include the shape of a sheet, the shape of a plate, and the shape of a block, although not specifically limited to these shapes. Here, it is defined that the sheet includes a film. It is preferable that the shape of the substrate 2 is selected appropriately in accordance with the shapes of portions which have to have a predetermined antireflection function in optical apparatuses, e.g., cameras.

(Structure)

Structures 3, which are convex portions, are arranged in large numbers on a surface of the substrate 2. These structures 3 are periodically two-dimensionally arranged with a short arrangement pitch smaller than or equal to the wavelength band of the light, where reduction in reflection is intended, for example, with the same level of arrangement pitch as the wavelength of the visible light. Here, the arrangement pitch refers to an arrangement pitch P1 and an arrangement pitch P2. The wavelength band of the light, where reduction in reflection is intended, is the wavelength band of ultraviolet light, the wavelength band of visible light, the wavelength band of infrared light, or the like. Here, the wavelength band of ultraviolet light refers to the wavelength band of 10 nm to 360 nm, the wavelength band of visible light refers to the wavelength band of 360 nm to 830 nm, and the wavelength band of infrared light refers to the wavelength band of 830 nm to 1 mm. Specifically, the arrangement pitch is 100 nm or more, and 350 nm or less, and more preferably 150 nm or more, and 320 nm or less. If the average arrangement pitch is less than 100 nm, the electrical conductivity tends to be degraded with respect to environmental durability and the like because the inclination of the slope portion becomes steep and the layer thickness is reduced. On the other hand, if the arrangement pitch exceeds 350 nm, diffraction of the visible light tends to occur.

The individual structures 3 of the electrically conductive optical element 1 have an arrangement form constituting a plurality of lines of tracks T1, T2, T3, ⋯ (hereafter may be generically referred to as "track T") on the surface of the substrate 2. In the present invention, the track refers to a portion, in which the structures 3 are lined up while being aligned into the shape of a straight line. Furthermore, the direction of lines refers to a direction orthogonal to the extension direction of the track (X direction) on a forming surface of the substrate 2.

The structures 3 are arranged in such a way that positions in adjacent two tracks T are displaced a half pitch with respect to each other. Specifically, regarding the adjacent two tracks T, the structures 3 of one track (for example, T2) are arranged at midpoint positions (positions displaced a half pitch) of the structures 3 arranged in the other track (for example, T1). As a result, as shown in Fig. 1B, regarding the adjacent three lines of tracks (T1 to T3), the structures 3 are arranged in such a way as to form a hexagonal lattice pattern or a quasi-hexagonal lattice pattern, in which the centers of the structures 3 are located at individual points a1 to a7. In the present first embodiment, the hexagonal lattice pattern refers to a lattice pattern in the shape of a regular hexagon. Furthermore, the quasi-hexagonal lattice pattern is different from the lattice pattern in the shape of a regular hexagon and refers to a hexagonal lattice pattern stretched in an extension direction of the track (X axis direction), so as to distort.

In the case where the structures 3 are arranged in such a way as to form a quasi-hexagonal lattice pattern, as shown in Fig. 1B, it is preferable that the arrangement pitch P1 (the distance between a1 and a2) of the structures 3 in the same track (for example, T1) is larger than the arrangement pitch of the structures 3 in adjacent two tracks (for example, T1 and T2), that is, the arrangement pitch P2 (for example, the distance between a1 and a7, a2 and a7) of the structures 3 in $\pm\theta$ directions with respect to the extension direction of the track. It becomes possible to further improve the packing density of the structures 3 by arranging the structures 3 as described above.

It is preferable that the structure 3 has the shape of a cone or the shape of a cone, in which the shape of a cone is stretched or contracted in the track direction, from the viewpoint of ease in formation. It is preferable that these shapes of a cone have convexly curved surfaces at the top portions. It is preferable that the structure 3 has the shape of an axisymmetric cone or the shape of a cone, in which the shape of a cone is stretched or contracted in the track direction. In the case where adjacent structures 3 are joined, it is preferable that the structure 3 has the shape of an axisymmetric cone or the shape of a cone, in which the shape of a cone is stretched or contracted in the track direction, except the lower portion joined to the adjacent structure 3. Examples of the shapes of a cone can include the shape of a circular cone, the shape of a circular truncated cone, the shape of an elliptical cone, and the shape of an elliptical truncated cone. Here, as described above, the shape of a cone is a concept including the shape of an elliptical cone and the shape of an elliptical truncated cone besides the shape of a circular cone and the shape of a circular truncated cone. In this regard, the shape of a circular truncated cone refers to the shape, in which the top portion of the shape of a circular cone has been cut off, and the shape of an elliptical truncated cone refers to the shape, in which the top portion of the shape of an elliptical cone has been cut off.

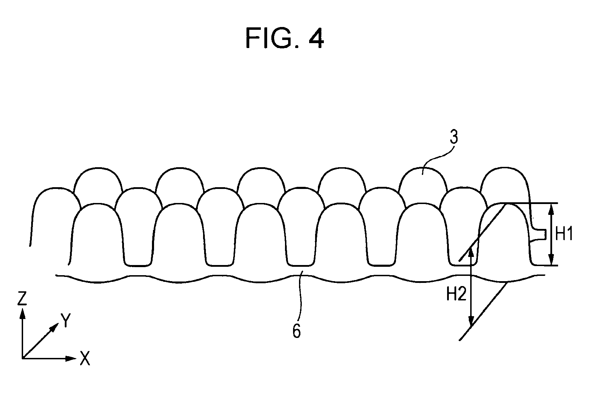

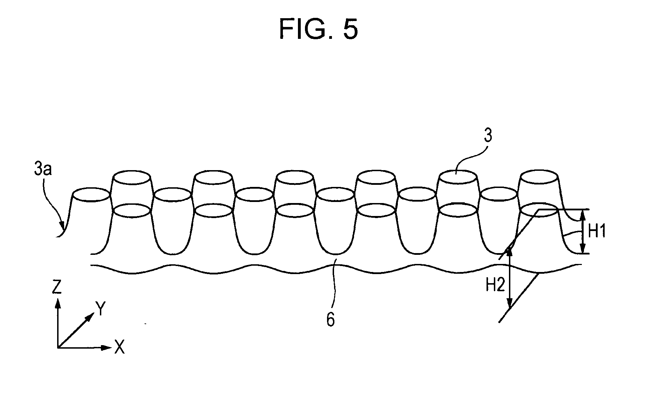

It is preferable that the structure 3 is in the shape of a cone having a bottom, in which the width in the extension direction of the track is larger than the width in the direction of lines orthogonal to this extension direction. Specifically, as shown in Fig. 2 and Fig. 4, it is preferable that the structure 3 has a cone structure in the shape of an elliptical cone, in which the bottom is in the shape of an ellipse, an oval, or an egg having a major axis and a minor axis and the top portion is a curved surface. Alternatively, as shown in Fig. 5, a cone structure in the shape of an elliptical truncated cone, in which the bottom is in the shape of an ellipse, an oval, or an egg having a major axis and a minor axis and the top portion is flat, is preferable. This is because in the case where the above-described shapes are employed, the filling factor in the direction of lines can be improved.

From the viewpoint of an improvement of the reflection characteristic, the shape of a cone, in which the inclination of the top portion is moderate and the inclination becomes steep gradually from the central portion toward the bottom portion (refer to Fig. 4), is preferable. Alternatively, from the viewpoint of improvements of the reflection characteristic and the transmission characteristic, a cone shape, in which the inclination of the central portion is steeper than the inclinations of the bottom portion and the top portion (refer to Fig. 2) or the shape of a cone, in which the top portion is flat (refer to Fig. 5), is preferable. In the case where the structure 3 has the shape of an elliptical cone or the elliptical truncated cone, it is preferable that the major axis direction of the bottom thereof becomes parallel to the extension direction of the track. In Fig. 2 and the like, the individual structures 3 have the same shape. However, the shape of the structure 3 is not limited to this. The structures 3 in at least two types of shapes may be formed on the substrate surface. Furthermore, the structures 3 may be formed integrally with the substrate 2. Moreover, the shape of the structure 3 may have the top portion and the bottom portion which are different in shape.

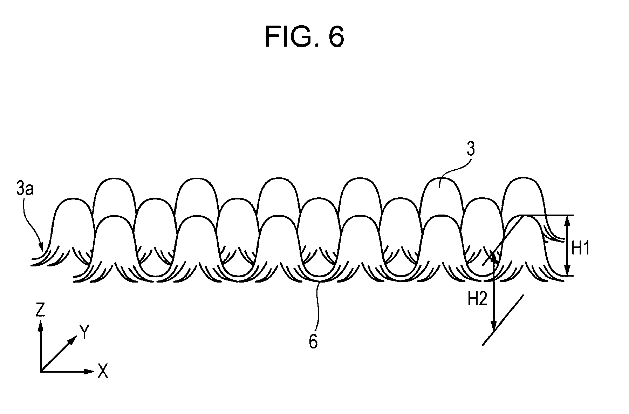

In addition, as shown in Fig. 2 and Fig. 4 to Fig. 6, it is preferable that protruded portions 6 are disposed as a part of or all of the circumference of the structures 3. This is because the reflectance can be controlled at a low level by employing the above-described manner even in the case where the filling factor of the structures 3 is low. Specifically, as shown in Fig. 2, Fig. 4, and Fig. 5, the protruded portions 6 are disposed between adjacent structures 3, for example. Alternatively, as shown in Fig. 6, slender protruded portions 6 may be disposed as all of or a part of the circumference of the structures 3. The slender protruded portion 6 is extended, for example, from the top portion of the structure 3 toward the lower portion. Examples of cross-sectional shapes of the protruded portion 6 can include the shape of a triangle and the shape of a tetragon, although not specifically limited to these shapes. The shape can be selected in consideration of ease of formation and the like. Furthermore, the surfaces of a part of or all of the circumference of the structures 3 may be roughened, so as to form fine unevenness. Specifically, for example, the surfaces between adjacent structures 3 may be roughened, so as to form fine unevenness. Alternatively, small holes may be formed in the surfaces, for example, the top portions, of the structures 3.

The structures 3 are not limited to convex shapes shown in the drawing, and may be formed from concave portions disposed on the surface of the substrate 2.

In this regard, the aspect ratios of the structures 3 are not always the same in all cases. The individual structures 3 may be configured to have certain height distribution (for example, the aspect ratio within the range of about 0.2 to 1.3). The wavelength dependence of the reflection characteristic can be reduced by disposing the structures 3 having the height distribution. Consequently, the electrically conductive optical element 1 having an excellent antireflection characteristic can be realized.

Here, the height distribution refers to that the structures 3 having at least two types of heights (depths) are disposed on the surface of the substrate 2. That is, it is referred to that the structures 3 having the height serving as the reference and structures 3 having the heights different from the height of the above-described structures 3 are disposed on the surface of the substrate 2. For example, the structures 3 having the heights different from the reference are periodically or aperiodically (randomly) disposed on the surface of the substrate 2. Examples of directions of the periodicity include the extension direction of the track and the direction of lines.

It is preferable that a tail portion 3a is disposed on the circumference portion of the structure 3. This is because in the manufacturing step of the electrically conductive optical element, the structures 3 can be easily pealed off a mold or the like. Here, the tail portion 3a refers to a protruded portion disposed on the circumference portion of the bottom portion of the structure 3. From the viewpoint of the above-described peeling characteristic, it is preferable that the tail portion 3a has a curved surface, the height of which is reduced gradually from the top portion of the structure 3 toward the lower portion. In this regard, the tail portion 3a may be disposed on merely a part of the circumference portion of the structure 3. However, from the viewpoint of improvement in the above-described peeling characteristic, it is preferable that the tail portion 3a is disposed on all circumference portion of the structure 3. Furthermore, in the case where the structure 3 is a concave portion, the tail portion is a curved surface disposed on opening perimeter of the concave portion serving as the structure 3.

The height (depth) of the structure 3 is not specifically limited and is set appropriately in accordance with the wavelength region of the light to be transmitted. The height (depth) H of the structure 3 is preferably 30 nm or more, and 320 nm or less, and more preferably 70 nm or more, and 320 nm or less. If the height H of the structure 3 is less than 30 nm, the reflectance tends to increase. If the height H of the structure 3 exceeds 320 nm, realization of a predetermined resistance tends to become difficult. Moreover, the aspect ratio of the structure 3 is preferably 0.2 or more, and 1.3 or less, and more preferably 0.2 or more, and 1.0 or less. If the aspect ratio is less than 0.2, the antireflection characteristic tends to be degraded, and if 1.3 is exceeded, the inclination of the slope portion becomes steep and the layer thickness is reduced, so that the electrical conductivity tends to be degraded with respect to environmental durability and the like and, in addition, the peeling characteristic is degraded in production of a replica.

By the way, the aspect ratio in the present invention is defined by the following formula (1).

$$\texttt{aspect ratio = H/P} \qquad (1)$$

where, H: height of structure, P: average arrangement pitch (average period)

Here, the average arrangement pitch P is defined by the following formula (2).

$$\texttt{average arrangement pitch P = (P1 + P2 + P2)/3} \qquad (2)$$

where, P1: arrangement pitch in extension direction of track (period in track extension direction), P2: arrangement pitch in $\pm\theta$ direction (where, $\theta = 60° - \delta$, here, $\delta$ is preferably $0° < \delta \leq 11°$, and more preferably $3° \leq \delta \leq 6°$) with respect to extension direction of track (period in $\theta$ direction)

In this regard, the height H of the structures 3 is assumed to be the height in the direction of lines of the structures 3. The height of the structures 3 in the track extension direction (X direction) is smaller than the height in the direction of lines (Y direction) and the heights of the structures 3 in portions other than the track extension direction are nearly the same as the height in the direction of lines. Therefore, the height of the sub-wavelength structure is represented by the height in the direction of lines. However, in the case where the structures 3 are concave portions, the height H of the structure in the above-described formula (1) is specified to be the depth H of the structure.

It is preferable that the ratio P1/P2 satisfies the relationship represented by $1.00 \leq P1/P2 \leq 1.1$ or $1.00 < P1/P2$ s 1.1, where the arrangement pitch of the structures 3 in the same track is assumed to be P1 and the arrangement pitch of the structures 3 between adjacent two tracks is assumed to be P2. In the case where the above-described numerical range is employed, the filling factor of the structures 3 having the shape of an elliptical cone or an elliptical truncated cone can be improved and, thereby, the antireflection characteristic can be improved.

The filling factor of the structures 3 on the substrate surface is within the range of 65% or more, preferably 73% or more, and more preferably 86% or more, where the upper limit is 100%. In the case where the filling factor is specified to be within the above-described range, the antireflection characteristic can be improved. In order to improve the filling factor, it is preferable that lower portions of adjacent structures 3 are mutually joined or distortion is given to the structures 3 through, for example, adjustment of the ellipticity of the structure bottom.

Here, the filling factor (average filling factor) of the structures 3 is a value determined as described below.

Initially, the surface of the electrically conductive optical element 1 is photographed by using a scanning electron microscope (SEM: Scanning Electron Microscope) at Top View. Subsequently, a unit lattice Uc is selected at random from the resulting SEM photograph, and the arrangement pitch P1 of the unit lattice Uc and the track pitch Tp are measured (refer to Fig. 1B). Furthermore, the area S of the bottom of the structure 3 located at the center of the unit lattice Uc is measured on the basis of image processing. Next, the filling factor is determined by using the measured arrangement pitch P1, the track pitch Tp, and the area S of the bottom on the basis of the following formula (3).

$$\texttt{filling factor = (S(hex.)/S(unit)) × 100} \qquad (3)$$

$$\text{unit lattice area: S(unit) = P1} \times \text{2Tp}$$

area of bottom of structure present in unit lattice: S(hex.) = 2S

The above-described processing for calculating the filling factor is performed with respect to 10 unit lattices selected at random from the resulting SEM photograph. Then, the measurement values are simply averaged (arithmetically averaged), so as to determine the average factor of the filling factors, and this is assumed to be the filling factor of the structures 3 on the substrate surface.

Regarding the filling factor in the case where the structures 3 are overlapped or auxiliary structures, e.g., protruded portions 6, are present between the structures 3, the filling factor can be determined by a method, in which a portion corresponding to 5% of height relative to the height of the structure 3 is assumed to be a threshold value and, thereby, the area ratio is decided.

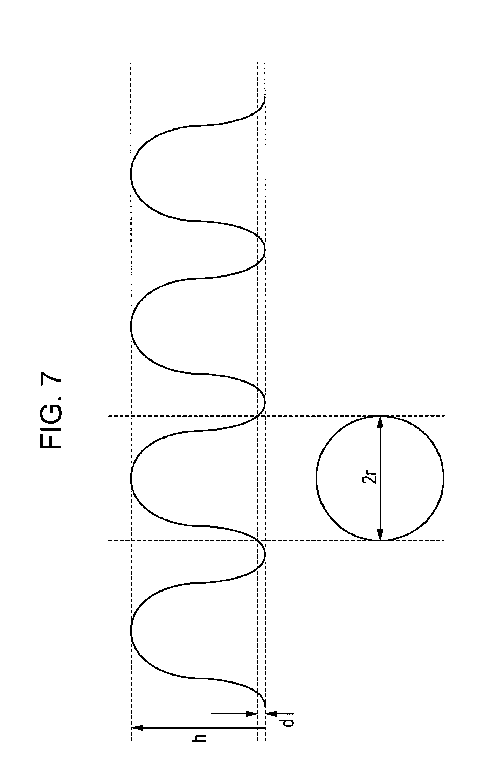

Fig. 7 is a diagram for explaining a method for calculating a filling factor in the case where boundaries of structures 3 are not clear. In the case where boundaries of structures 3 are not clear, as shown in Fig. 7, a portion corresponding to 5% (= (d/h) $\times$ 100) of height h of the structure 3 is assumed to be a threshold value on the basis of SEM observation of a cross-section, the diameter of the structure 3 is converted at that height d, and the filling factor is determined. In the case where the bottom of the structure 3 is elliptical, the same processing is performed with respect to the major axis and the minor axis.

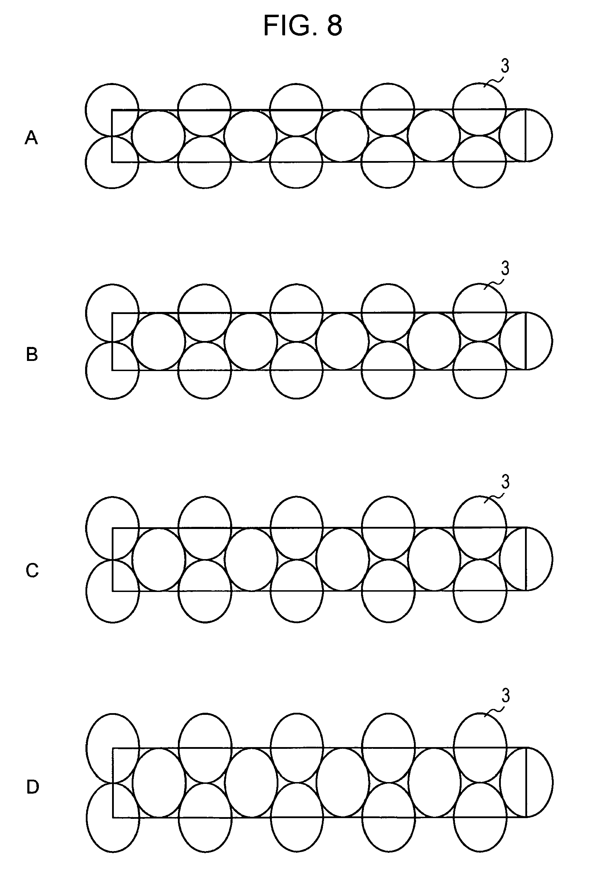

Fig. 8 is a diagram showing the bottom shapes, where the ellipticity of the bottom of the structure 3 is changed. The ellipticities of ellipses shown in Fig. 8A to Fig. 8D are 100%, 110%, 120%, and 141%, respectively. The filling factor of the structures 3 on the substrate surface can be changed by changing the ellipticity, as described above. In the case where the structures 3 constitute a quasi-hexagonal lattice pattern, it is preferable that the ellipticity e of the structure bottom satisfies 100% < e < 150% or less. This is because the filling factor of the structures 3 is improved and an excellent antireflection characteristic can be obtained by employing the above-described range.

Here, the ellipticity e is defined as (a/b) $\times$ 100, where the diameter of the structure bottom in the track direction (X direction) is assumed to be a and the diameter in the direction of lines (Y direction), which is orthogonal thereto, is assumed to be b. In this regard, the diameters a and b of the structure 3 are values determined as described below. The surface of the electrically conductive optical element 1 is photographed by using a scanning electron microscope (SEM: Scanning Electron Microscope) at Top View, and 10 structures 3 are picked out at random from the resulting SEM photograph. Subsequently, the diameters a and b of the bottoms of the individual picked out structures 3 are measured. Then, the individual measurement values a and b are simply averaged (arithmetically averaged), so as to determine the average values of the diameters a and b. These are assumed to be the diameters a and b of the structures 3.

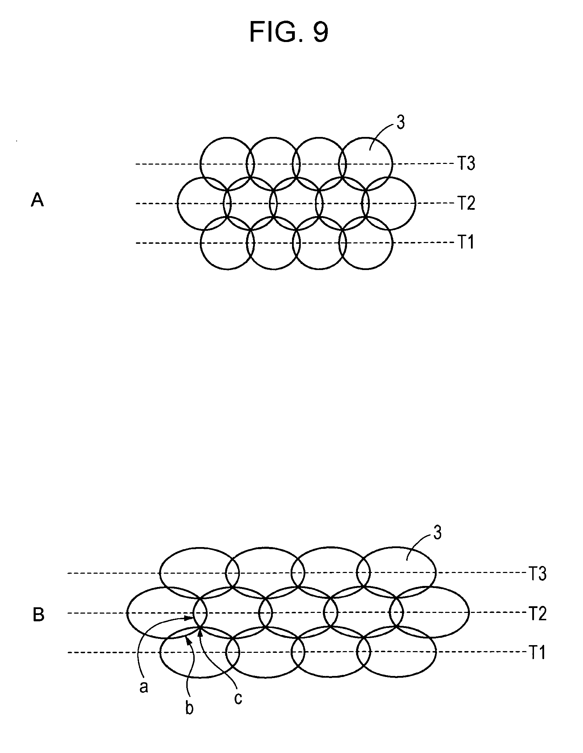

Fig. 9A shows an example of the arrangement of structures 3 having the shape of a circular cone or the shape of a circular truncated cone. Fig. 9B shows an example of the arrangement of structures 3 having the shape of an elliptical cone or the shape of an elliptical truncated cone. As shown in Fig. 9A and Fig. 9B, it is preferable that the structures 3 are joined in such a way that the lower portions thereof are overlapped with each other. Specifically, it is preferable that a lower portion of a structure 3 is joined to a part of or all of the lower portions of the structures 3 in the relationship of being adjacent to each other. More specifically, it is preferable that lower portions of the structures 3 are mutually joined in the track direction, in the θ direction, or in both of those directions. More specifically, it is preferable that lower portions of the structures 3 are mutually joined in the track direction, in the θ direction, or in both of those directions. In Fig. 9A and Fig. 9B, examples, in which all of the lower portions of the structures 3 in the relationship of being adjacent to each other are joined, are shown. The filling factor of the structures 3 can be improved by joining the structures 3, as described above. It is preferable that portions one-quarter or less of the structures, on a maximum value of optical path length in consideration of the refractive index in the wavelength band of the light in a use environment basis, are mutually joined. Consequently, an excellent antireflection characteristic can be obtained.

As shown in Fig. 9B, in the case where lower portions of the structures 3 having the shape of an elliptical cone or the shape of an elliptical truncated cone are mutually joined, for example, the height of the joint portion is reduced in the order of the joint portions a, b, and c. Specifically, a first joint portion a is formed by overlapping lower portions of the adjacent structures 3 in the same track with each other and, in addition, a second joint portion 2 is formed by overlapping lower portions of the adjacent structures 3 in adjacent tracks with each other. An intersection portion c is formed at the point of intersection of the first joint portion a and the second joint portion b. The position of the intersection portion c is lower than, for example, the positions of the first joint portion a and the second joint portion b. In the case where lower portions of structures 3 having the shape of an elliptical cone or the shape of an elliptical truncated cone are mutually joined, the heights thereof are reduced in the order of, for example, the joint portion a, the joint portion b, and the intersection portion c.

The ratio ((2r/P1) $\times$ 100) of the diameter 2r to the arrangement pitch P1 is 85% or more, preferably 90% or more, and more preferably 95% or more. This is because the filling factor of the structures 3 is improved and an antireflection characteristic can be improved by employing the above-described range. If the ratio (($2r/P1$) × 100) increases and overlapping of the structures 3 increases excessively, the antireflection characteristic tends to be degraded. Therefore, it is preferable to set the upper limit value of the ratio (($2r/P1$) × 100) in such a way that portions one-quarter or less of the maximum value of optical path length in consideration of the refractive index in the wavelength band of the light in a use environment are mutually joined. Here, the arrangement pitch $P1$ is the arrangement pitch of the structures 3 in the track direction and the diameter $2r$ is the diameter of the structure bottom in the track direction. In this regard, in the case where the structure bottom is in the shape of a circle, the diameter $2r$ refers to a diameter and in the case where the structure bottom is in the shape of an ellipse, the diameter $2r$ refers to a major axis.

(Transparent, electrically conductive layer)

It is preferable that the transparent, electrically conductive layer 4 contains a transparent oxide semiconductor as a primary component. As for the transparent oxide semiconductor, for example, binary compounds, e.g., $SnO_2$, $InO_2$, ZnO, and CdO, ternary compounds containing at least one element of Sn, In, Zn, and Cd, which are constituent elements of the binary compounds, and multi-component (complex) oxides can be used. Examples of materials constituting the transparent, electrically conductive layer 4 include ITO ($In_2O_3$, $SnO_2$: indium tin oxide), AZO ($Al_2O_3$, ZnO: aluminum-doped zinc oxide), SZO, FTO (fluorine-doped tin oxide), $SnO_2$ (tin oxide), GZO (gallium-doped zinc oxide), and IZO ($In_2O_3$, ZnO: indium zinc oxide), and ITO is preferable from the viewpoint of high reliability, low resistivity, and the like. It is preferable that the material constituting the transparent, electrically conductive layer 4 has the crystallinity from the viewpoint of an improvement of the electrical conductivity. Specifically, it is preferable that the material constituting the transparent, electrically conductive layer 4 is in the mixed state of amorphous and polycrystal from the viewpoint of an improvement of the electrical conductivity. It is possible to ascertain whether the material constituting the transparent, electrically conductive layer 4 has the crystallinity by, for example, an X-ray diffraction method (X-ray diffraction: XRD). It is preferable that the transparent, electrically conductive layer 4 is formed following the surface shape of the structures 3, and the surface shapes of the structures 3 and the transparent, electrically conductive layer 4 are almost analogous shapes. This is because changes in a refractive index profile due to formation of the transparent, electrically conductive layer 4 is suppressed and, thereby, an excellent antireflection characteristic and/or transmission characteristic can be maintained.

(Metal layer)

It is preferable that the metal layer (electrically conductive layer) 5 is disposed as an underlying layer of the transparent, electrically conductive layer 4. This is because the resistivity can be reduced and the thickness of the transparent, electrically conductive layer 4 can be reduced or in the case where the electrical conductivity does not reach a sufficient value by only the transparent, electrically conductive layer 4, the electrical conductivity can be supplemented. The layer thickness of the metal layer 5 is not specifically limited and is selected to become, for example, on the order of several nanometers. The metal layer 5 has a high electrical conductivity and, therefore, sufficient surface resistance can be obtained with several nanometers of layer thickness. Furthermore, in the case where the layer thickness is on the order of several nanometers, optical influences, e.g., absorption and reflection, due to the metal layer 5 are hardly exerted. As for the material constituting the metal layer 5, it is preferable that a metal based material having high electrical conductivity is used. Examples of such materials include Ag, Al, Cu, Ti, Nb, and impurity-containing Si, and in consideration of the degree of electrical conductivity, the track record of use, and the like, Ag is preferable. The surface resistance can be ensured by only the metal layer 5. However, in the case where the thickness is very small, the structure of the metal layer 5 takes on the shape of islands, and it becomes difficult to ensure the continuity. In that case, formation of the transparent, electrically conductive layer 4 serving as a layer on the metal layer 5 is important to electrically connecting the island-shaped metal layer 5.

[Configuration of roll master]

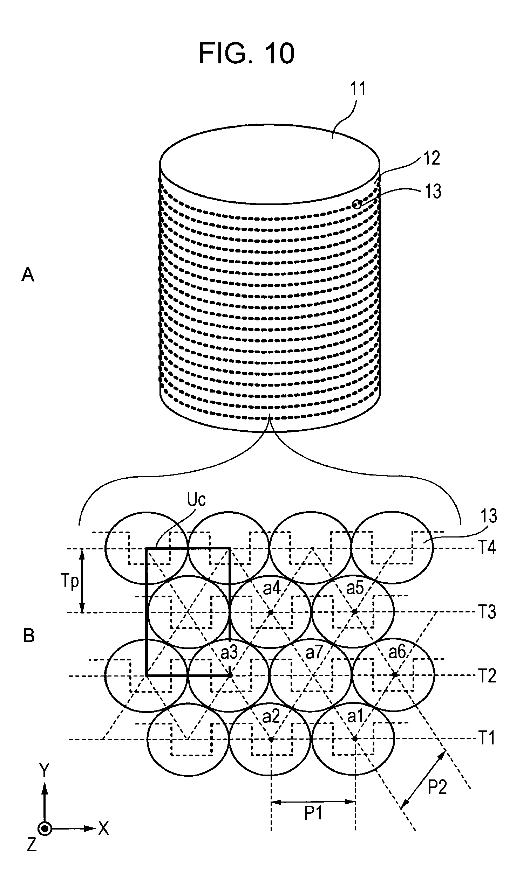

Fig. 10 shows an example of the configuration of a roll master for producing an electrically conductive optical element having the above-described configuration. As shown in Fig. 10, a roll master 11 has a configuration, in which, for example, structures 13 formed from concave portions are arranged in large numbers on the surface of a stamper 12 with the same level of pitch as the wavelength of light, e.g., the visible light. The stamper 12 has the shape of a circular column or a circular cylinder. As for the material for the stamper 12, for example, glass can be used, although not specifically limited to this material. A roll stamper exposing apparatus, as described later, is used, the two-dimensional patterns are linked spatially, a polarity inversion formatter signal and a rotation controller of a recording apparatus are synchronized to generate a signal on a track basis, and patterning is performed at CAV with an appropriate feed pitch. Consequently, a hexagonal lattice pattern or a quasi-hexagonal lattice pattern can be recorded. A lattice pattern with a uniform spatial frequency is formed in a desired recording region by setting the frequency of the polarity inversion formatter signal and the number of revolutions of the roll appropriately.

[Method for manufacturing electrically conductive optical element]

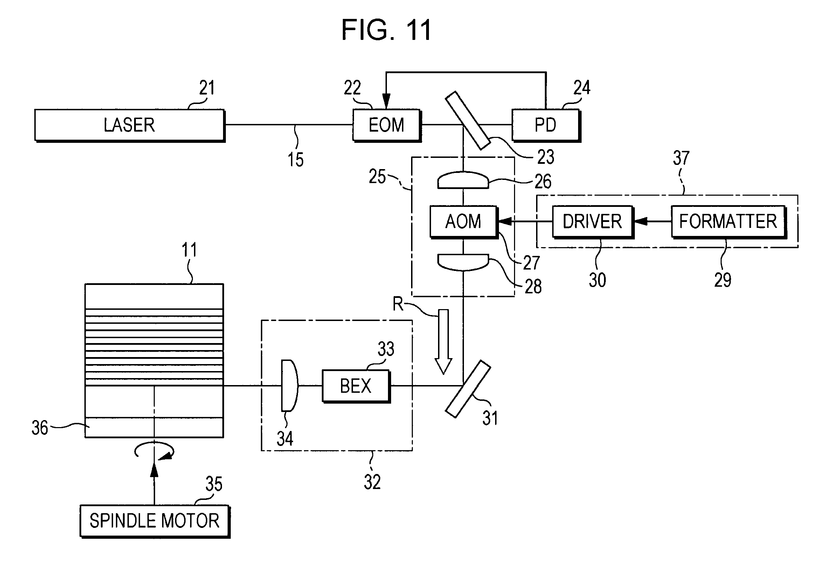

Next, a method for manufacturing an electrically conductive optical element 1 having the above-described configuration will be described with reference to Fig. 11 to Fig. 14.

The method for manufacturing an electrically conductive optical element according to the first embodiment includes a resist formation step to form a resist layer on a stamper, an exposure step to form a latent image of a motheye pattern on the resist layer by using a roll stamper exposing apparatus, and a development step to develop the resist layer provided with the latent image. Furthermore, an etching step to produce a roll master by using plasma etching, a duplicate step to produce a duplicate substrate from an ultraviolet curable resin, and a layer formation step to form a transparent, electrically conductive layer on the duplicate substrate are included.

(Configuration of exposing apparatus)

Initially, the configuration of a roll stamper exposing apparatus used for the exposure step of the motheye pattern will be described with reference to Fig. 11. This roll stamper exposing apparatus is formed on the basis of an optical disk recording apparatus.

A laser light source 21 is a light source to expose a resist applied as a layer to the surface of the stamper 12 serving as a recording medium and is to lase the recording laser light 15 with a wavelength $\lambda = 266$ nm, for example. The laser light 15 emitted from the laser light source 21 moves in a straight line while being in the state of a collimated beam and enters an electro optical modulator (EOM: Electro Optical Modulator) 22. The laser light 15 passed through the electro optical modulator 22 is reflected at a mirror 23, and is led to a modulation optical system 25.

The mirror 23 is formed from a polarizing beam splitter, and has a function of reflecting one polarized component and transmitting the other polarized component. The polarized component passed through the mirror 23 is received with a photodiode 24, and the electro optical modulator 22 is controlled on the basis of the received light signal, so that phase modulation of the laser light 15 is performed.

In the modulation optical system 25, the laser light 15 is condensed on an acoust-optic modulator (AOM: Acoust-Optic Modulator) 27 composed of glass ($SiO_2$) or the like with a condenser lens 26. The laser light 15 is subjected to intensity modulation with the acoust-optic modulator 27, so as to diverge and, thereafter, is converted to a collimated beam with a lens 28. The laser light 15 emitted from the modulation optical system 25 is reflected at a mirror 31 and is led on a moving optical table 32 horizontally and in parallel.

The moving optical table 32 is provided with a beam expander 33 and an objective lens 34. The laser light 15 led to the moving optical table 32 is shaped into a desired beam shape with the beam expander 33 and, thereafter, is applied to the resist layer on the stamper 12 through the objective lens 34. The stamper 12 is placed on a turn table 36 connected to a spindle motor 35. Then, the laser light 15 is applied to the resist layer intermittently while the stamper 12 is rotated and, in addition, the laser light 15 is moved in the height direction of the stamper 12, so that an exposure step of the resist layer is performed. The formed latent image takes the shape of nearly an ellipse having a major axis in the circumferential direction. The movement of the laser light 15 is performed by movement of the moving optical table 32 in the direction indicated by an arrow R.

The exposing apparatus is provided with a control mechanism 37 to form a latent image corresponding to the two-dimensional pattern of the hexagonal lattice or the quasi-hexagonal lattice shown in Fig. 1B on the resist layer. The control mechanism 37 is provided with a formatter 29 and a driver 30. The formatter 29 is provided with a polarity inversion portion. This polarity inversion portion controls the application timing of the laser light 15 to the resist layer. The driver 30 receives the output from the polarity inversion portion and controls the acoust-optic modulator 27.

In this roll stamper exposing apparatus, a polarity inversion formatter signal and a rotation controller of the recording apparatus are synchronized to generate a signal and intensity modulation is performed with the acoust-optic modulator 27 on a track basis in such a way that the two-dimensional patterns are linked spatially. The hexagonal lattice or quasi-hexagonal lattice pattern can be recorded by performing patterning at a constant angular velocity (CAV) and the appropriate number of revolutions with an appropriate modulation frequency and an appropriate feed pitch. For example, as shown in Fig. 10B, in order to specify the period in the circumferential direction to be 315 nm and the period in an about 60 degree direction (about -60 degree direction) with respect to the circumferential direction to be 300 nm, it is enough that the feed pitch is specified to be 251 nm (Pythagorean theorem). The frequency of the polarity inversion formatter signal is changed by the number of revolutions of the roll (for example, 1,800 rpm, 900 rpm, 450 rpm, and 225 rpm). For example, the frequencies of the polarity inversion formatter signal corresponding to the number of revolutions of the roll of 1,800 rpm, 900 rpm, 450 rpm, and 225 rpm are 37.70 MHz, 18.85 MHz, 9.34 MHz, and 4.71 MHz, respectively. A quasi-hexagonal lattice pattern with a uniform spatial frequency (circumference 315 nm period, about 60 degree direction (about -60 degree direction) with respect to the circumferential direction 300 nm period) in a desired recording region is obtained by enlarging the beam diameter of the far-ultraviolet laser light by a factor of 5 with the beam expander (BEX) 33 on the moving optical table 32, and applying the laser light to the resist layer on the stamper 12 through the objective lens 34 having a numerical aperture (NA) of 0.9, so as to form a fine latent image.

(Resist layer formation step)

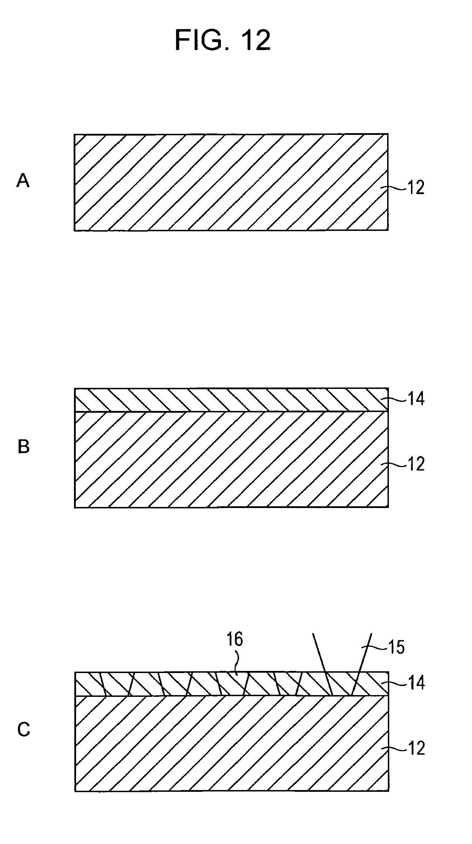

Initially, as shown in Fig. 12A, a stamper 12 in the shape of a circular column is prepared. This stamper 12 is, for example, a glass stamper. Subsequently, as shown in Fig. 12B, a resist layer 14 is formed on the surface of the stamper 12. As for the material for the resist layer 14, for example, any one of organic resists and inorganic resists may be used. As for the organic resist, for example, a novolac resist and a chemically amplified resist can be used. Moreover, as for the inorganic resist, for example, a metal compound formed from one type or at least two types of transition metals can be used.

(Exposure step)

Then, as shown in Fig. 12C, the above-described roll stamper exposing apparatus is used, the stamper 12 is rotated and, in addition, the laser light (exposure beam) 15 is applied to the resist layer 14. At this time, the laser light 15 is applied intermittently while the laser light 15 is moved in the height direction of the stamper 12 (direction parallel to the center axis of the stamper 12 in the shape of a circular column or the shape of a circular cylinder) and, thereby, all over the surface of the resist layer 14 is exposed. In this manner, a latent image 16 in accordance with the locus of the laser light 15 is formed all over the resist layer 14 with the same level of pitch as the wavelength of the visible light.

For example, the latent image 16 is arranged in such a way as to constitute a plurality of lines of tracks on the stamper surface and, in addition, form a hexagonal lattice pattern or a quasi-hexagonal lattice pattern. For example, the latent image 16 is in the shape of an ellipse having a major axis direction in the extension direction of the track.

(Development step)

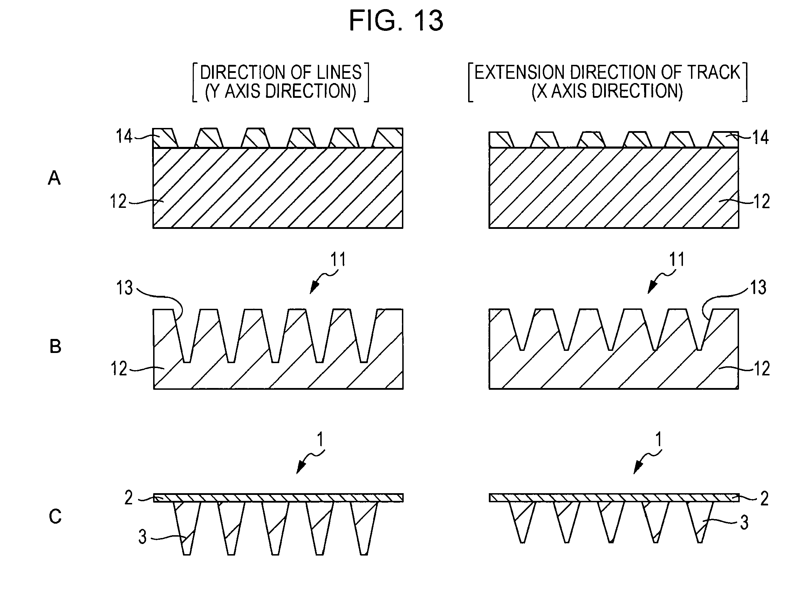

Next, a developing solution is dropped on the resist layer 14 while the stamper 12 is rotated, so that the resist layer 14 is subjected to a developing treatment, as shown in Fig. 13A. As shown in the drawing, in the case where the resist layer 14 is formed from a positive type resist, the exposed portion exposed with the laser light 15 has an increased dissolution rate with respect to the developing solution as compared with that of the non-exposed portion. Therefore, a pattern in accordance with the latent image (exposed portion) 16 is formed on the resist layer 14.

(Etching step)

Subsequently, the surface of the stamper 12 is subjected to a roll etching treatment while the pattern (resist pattern) of the resist layer 14 formed on the stamper 12 serves as a mask. In this manner, as shown in Fig. 13B, concave portions in the shape of an elliptical cone or the shape of an elliptical truncated cone having a major axis direction in the extension direction of the track, that is, structures 13, can be obtained. As for the etching method, for example, dry etching is performed. At this time, for example, a pattern of the structures 13 in the shape of a cone can be formed by performing the etching treatment and an ashing treatment alternately. Furthermore, a glass master having a depth 3 times or more of the resist layer 14 (selection ratio of 3 or more) can be produced. As for the dry etching, plasma etching by using an etching apparatus is preferable.

Consequently, a roll master 11 having a hexagonal lattice pattern or a quasi-hexagonal lattice pattern in the concave shape having a depth of about 30 nm to about 320 nm is obtained.

(Duplicate step)

Then, the roll master 11 and the substrate 2, e.g., a sheet coated with a transfer material, are closely adhered. Peeling is performed while ultraviolet rays are applied, so as to cure. In this manner, as shown in Fig. 13C, a plurality of structures, which are convex portions, are formed on one principal surface of the substrate 2 and, thereby, an electrically conductive optical element 1 composed of a motheye ultraviolet cured duplicate sheet or the like is produced.

The transfer material is formed from, for example, an ultraviolet curable material and an initiator and contains fillers, functional additives, and the like, as necessary.

The ultraviolet curable material is formed from, for example, a monofunctional monomer, a difunctional monomer, or a polyfunctional monomer and, specifically, is composed of the following materials alone or a plurality of them in combination.

Examples of monofunctional monomers can include carboxylic acids (acrylic acid), hydroxy monomers (2-hydroxyethyl acrylate, 2-hydroxypropyl acrylate, and 4-hydroxybutyl acrylate), alkyl, alicyclic monomers (isobutyl acrylate, t-butyl acrylate, isooctyl acrylate, lauryl acrylate, stearyl acrylate, isobonyl acrylate, and cyclohexyl acrylate), other functional monomers (2-methoxyethyl acrylate, methoxyethylene glycol acrylate, 2-ethoxyethyl acrylate, tetrahydrofurfuryl acrylate, benzyl acrylate, ethylcarbitol acrylate, phenoxyethyl acrylate, N,N-dimethylaminoethyl acrylate, N,N-dimethylaminopropyl acrylamide, N,N-dimethyl acrylamide, acryloyl morpholine, N-isopropyl acrylamide, N,N-diethyl acrylamide, N-vinylpyrrolidone, 2-(perfluorooctyl)ethyl acrylate, 3-perfluorohexyl-2-hydroxypropyl acrylate, 3-perfluorooctyl-2-hydroxypropyl acrylate, 2-(perfluorodecyl)ethyl acrylate, 2-(perfluoro-3-methylbutyl)ethyl acrylate), 2,4,6-tribromophenol acrylate, 2,4,6-tribromophenol methacrylate, 2-(2,4,6-tribromophenoxy)ethyl acrylate), and 2-ethylhexyl acrylate.

Examples of difunctional monomers can include tri(propylene glycol) diacrylate, trimethylolpropane diallyl ether, and urethane acrylate.

Examples of polyfunctional monomers can include trimethylolpropane triacrylate, dipentaerythritol penta and hexaacrylate, and ditrimethylolpropane tetraacrylate.

Examples of initiators can include 2,2-dimethoxy-1,2-diphenylethan-1-one, 1-hydroxy-cyclohexyl phenyl ketone, and 2-hydroxy-2-methyl-l-phenylpropan-l-one.

As for the filler, for example, any one of inorganic fine particles and organic fine particles can be used. Examples of inorganic fine particles can include metal oxide fine particles of $SiO_2$, $TiO_2$, $ZrO_2$, $SnO_2$, $Al_2O_3$, and the like.

Examples of functional additives can include leveling agents, surface regulators, and antifoaming agents. Examples of materials for the substrate 2 include methyl methacrylate (co)polymer, polycarbonate, styrene (co)polymer, methyl methacrylate-styrene copolymer, cellulose diacetate, cellulose triacetate, cellulose acetate butyrate, polyester, polyamide, polyimide, polyether sulfone, polysulfone, polypropylene, polymethylpentene, polyvinyl chloride, polyvinyl acetal, polyether ketone, polyurethane, and glass.

The method for molding the substrate 2 is not specifically limited. An injection-molded body, an extruded body, or a cast body may be employed. As necessary, the substrate surface may be subjected to a surface treatment, e.g., a corona treatment.

(Metal layer formation step)

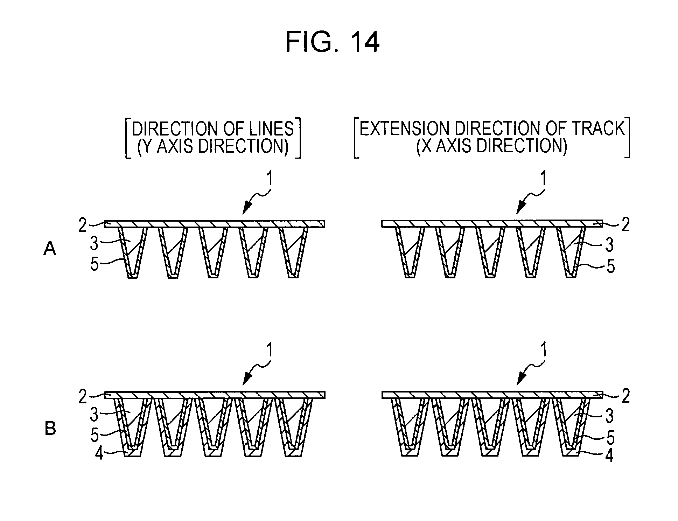

Next, as shown in Fig. 14A, a metal layer is formed on an uneven surface of the substrate 2 provided with the structures 3, as necessary. As for a method for forming the metal layer, for example, PVD methods (Physical Vapor Deposition (physical vapor deposition method): technology to form a thin layer by aggregating a physically vaporized material on a substrate in a vacuum), e.g., vacuum evaporation, plasma-assisted evaporation, sputtering, and ion plating, can be used besides CVD methods (Chemical Vapor Deposition (chemical vapor deposition method): technology to deposit a thin layer from a gas phase through the use of a chemical reaction), e.g., thermal CVD, plasma CVD, and photo CVD.

(Electrically conductive layer formation step)

Next, as shown in Fig. 14B, a transparent, electrically conductive layer is formed on the uneven surface of the substrate 2 provided with the structures 3. As for a method for forming the electrically conductive layer, for example, PVD methods (Physical Vapor Deposition (physical vapor deposition method): technology to form a thin layer by aggregating a physically vaporized material on a substrate in a vacuum), e.g., vacuum evaporation, plasma-assisted evaporation, sputtering, and ion plating, can be used besides CVD methods (Chemical Vapor Deposition (chemical vapor deposition method): technology to deposit a thin layer from a gas phase through the use of a chemical reaction), e.g., thermal CVD, plasma CVD, and photo CVD.

According to the first embodiment, an electrically conductive optical element 1 can be provided, wherein the transmittance is very high, reflected light is reduced, and reflection is reduced. The antireflection function is realized through formation of the plurality of structures 3 on the surface and, therefore, the wavelength dependence is reduced. The angle dependence is less than that of a transparent, electrically conductive layer of optical layer type. A multilayer optical layer is not used, a nanoimprinting technology is used, and a high-throughput layer configuration is adopted, so that excellent mass productivity and a low cost can be realized.

<2. Second embodiment>

[Configuration of electrically conductive optical element]

Fig. 15A is a schematic plan view showing an example of the configuration of an electrically conductive optical element according to a second embodiment of the present invention. Fig. 15B is a magnified plan view illustrating a part of the electrically conductive optical element shown in Fig. 15A. Fig. 15C is a sectional view along a track T1, T3, ··· shown in Fig. 15B. Fig. 15D is a sectional view along a track T2, T4, ··· shown in Fig. 15B. Fig. 15E is a schematic diagram showing a modulated waveform of the laser light used for forming a latent image corresponding to the tracks T1, T3, ··· shown in Fig. 15B. Fig. 15F is a schematic diagram showing a modulated waveform of the laser light used for forming a latent image corresponding to the tracks T2, T4, ··· shown in Fig. 15B.

An electrically conductive optical element 1 according to the second embodiment is different from the electrically conductive optical element 1 of the first embodiment in that regarding the adjacent three lines of tracks, the individual structures 3 constitute a tetragonal lattice pattern or a quasi-tetragonal lattice pattern. In the present invention, the quasi-tetragonal lattice pattern is different from the regular tetragonal lattice pattern and refers to a tetragonal lattice pattern stretched in the extension direction of the track (X direction), so as to distort.

The height (depth) H of the structure 3 is preferably 30 nm or more, and 320 nm or less, and more preferably 70 nm or more, and 320 nm or less. If the height H of the structure 3 is less than 30 nm, the reflectance tends to increase. If the height H of the structure 3 exceeds 320 nm, realization of a predetermined resistance tends to become difficult. Furthermore, the aspect ratio of the structure 3 is preferably 0.2 or more, and 1.3 or less, and more preferably 0.2 or more, and 1.0 or less. If the aspect ratio is less than 0.2, the antireflection characteristic tends to be degraded, and if 1.3 is exceeded, the inclination of the slope portion becomes steep and the layer thickness is reduced, so that the electrical conductivity tends to be degraded with respect to environmental durability and the like and, in addition, the peeling characteristic is degraded in production of a replica. Moreover, the aspect ratios of the individual structures 3 are not always the same in all cases. The individual structures 3 may be configured to have certain height distribution.

It is preferable that the arrangement pitch P1 of the structures 3 in the same track is larger than the arrangement pitch P2 of the structures 3 between adjacent two tracks. Moreover, it is preferable that P1/P2 satisfies the relationship represented by 1.0 < P1/P2 ≤ 1.5, where the arrangement pitch of the structures 3 in the same track is assumed to be P1 and the arrangement pitch of the structures 3 between adjacent two tracks is assumed to be P2. In the case where the above-described numerical range is employed, the filling factor of the structures 3 having the shape of an elliptical cone or an elliptical truncated cone can be improved and, thereby, the antireflection characteristic can be improved. In addition, it is preferable that the height or the depth of the structures 3 in a 45 degree direction or an about 45 degree direction with respect to the track is smaller than the height or the depth of the structures 3 in the extension direction of the track.

It is preferable that the height H2 in the arrangement direction of the structures 3 (θ direction) slanting with respect to the extension direction of the track is smaller than the height H1 of the structures 3 in the extension direction of the track. That is, it is preferable that the heights H1 and H2 of the structures 3 satisfy the relationship represented by H1 > H2.

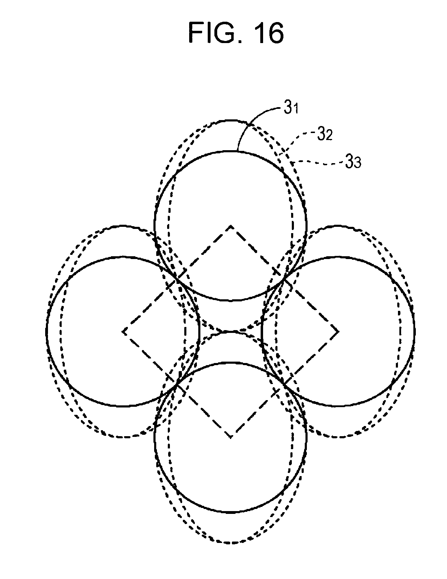

Fig. 16 is a diagram showing the bottom shapes, where the ellipticity of the bottom of the structure 3 is changed. The ellipticities of ellipses $3_1$, $3_2$, and $3_3$ are 100%, 163.3%, and 141%, respectively. The filling factor of the structures 3 on the substrate surface can be changed by changing the ellipticity, as described above. In the case where the structures 3 constitute a tetragonal lattice or quasi-tetragonal lattice pattern, it is preferable that the ellipticity e of the structure bottom satisfies 150% ≤ e s 180%. This is because the filling factor of the structures 3 is improved and an excellent antireflection characteristic can be obtained by employing this range.

The filling factor of the structures 3 on the substrate surface is within the range of 65% or more, preferably 73% or more, and more preferably 86% or more, where the upper limit is 100%. In the case where the filling factor is specified to be within the above-described range, the antireflection characteristic can be improved.

Here, the filling factor (average filling factor) of the structures 3 is a value determined as described below.

Initially, the surface of the electrically conductive optical element 1 is photographed by using a scanning electron microscope (SEM: Scanning Electron Microscope) at Top View. Subsequently, a unit lattice Uc is selected at random from the resulting SEM photograph, and the arrangement pitch P1 of the unit lattice Uc and the track pitch Tp are measured (refer to Fig. 15B). Furthermore, the area S of the bottom of any one of four structures 3 included in the unit lattice Uc is measured on the basis of image processing. Next, the filling factor is determined by using the measured arrangement pitch P1, the track pitch Tp, and the area S of the bottom on the basis of the following formula (4).

```
filling factor = (S(tetra)/S(unit)) × 100        (2)
```

```
    unit lattice area: S(unit) = 2 × ((P1 × Tp) × (1/2)) = P1
```
```
× Tp
```

area of bottom of structure present in unit lattice: S(tetra) = S

The above-described processing for calculating the filling factor is performed with respect to 10 unit lattices selected at random from the resulting SEM photograph. Then, the measurement values are simply averaged (arithmetically averaged), so as to determine the average factor of the filling factors, and this is assumed to be the filling factor of the structures 3 on the substrate surface.

The ratio (($2r/P1$) $\times$ 100) of the diameter $2r$ to the arrangement pitch $P1$ is 64% or more, preferably 69% or more, and more preferably 73% or more. This is because the filling factor of the structures 3 is improved and an antireflection characteristic can be improved by employing the above-described range. Here, the arrangement pitch $P1$ is the arrangement pitch of the structures 3 in the track direction and the diameter $2r$ is the diameter of the structure bottom in the track direction. In this regard, in the case where the structure bottom is in the shape of a circle, the diameter $2r$ refers to a diameter and in the case where the structure bottom is in the shape of an ellipse, the diameter $2r$ refers to a major axis.

[Configuration of roll master]

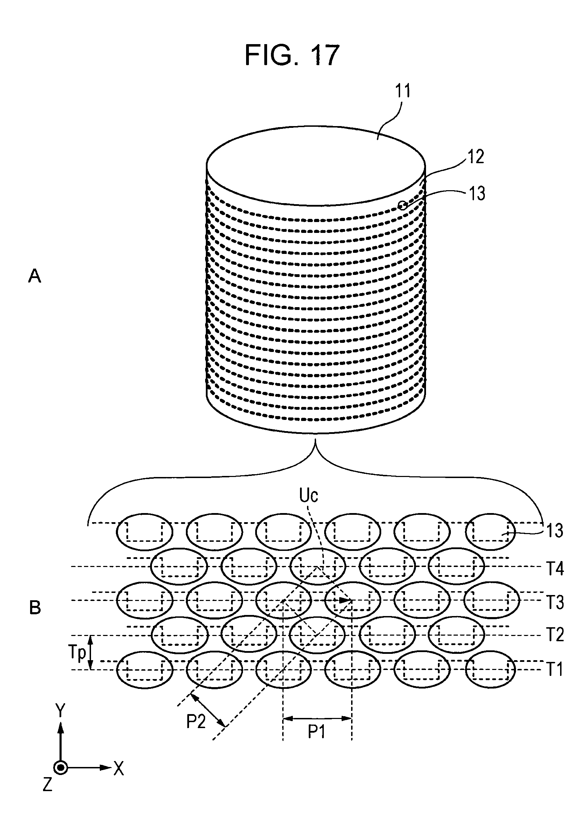

Fig. 17 shows an example of the configuration of a roll master for producing an electrically conductive optical element having the above-described configuration. This roll master is different from the master of the first embodiment in that concave-shaped structures 13 constitute a tetragonal lattice pattern or a quasi-tetragonal lattice pattern on the surface thereof.

A roll stamper exposing apparatus is used, the two-dimensional patterns are linked spatially, a polarity inversion formatter signal and a rotation controller of a recording apparatus are synchronized to generate a signal on a track basis, and patterning is performed at CAV with an appropriate feed pitch. Consequently, a tetragonal lattice pattern or a quasi-tetragonal lattice pattern can be recorded. It is preferable that a lattice pattern with a uniform spatial frequency is formed in a desired recording region on the resist on the stamper 12 through application of the laser light by setting the frequency of the polarity inversion formatter signal and the number of revolutions of the roll appropriately.

<3. Third embodiment>

[Configuration of electrically conductive optical element]

Fig. 18A is a schematic plan view showing an example of the configuration of an electrically conductive optical element according to a third embodiment of the present invention. Fig. 18B is a magnified plan view illustrating a part of the electrically conductive optical element shown in Fig. 18A. Fig. 18C is a sectional view along a track T1, T3, ·· shown in Fig. 18B. Fig. 18D is a sectional view along a track T2, T4, ... shown in Fig. 18B.

An electrically conductive optical element 1 according to the third embodiment is different from the electrically conductive optical element 1 of the first embodiment in that the track T has the shape of an arc and the structures 3 are arranged in the shape of an arc. As shown in Fig. 18B, regarding the adjacent three lines of tracks (T1 to T3), the structures 3 are arranged in such a way as to form a quasi-hexagonal lattice pattern, in which the centers of the structures 3 are located at individual points a1 to a7. Here, the quasi-hexagonal lattice pattern is different from the regular hexagonal lattice pattern and refers to a hexagonal lattice pattern distorted along the shape of an arc of the track T. Alternatively, it is different from the regular hexagonal lattice pattern and refers to a hexagonal lattice pattern distorted along the shape of an arc of the track T and, in addition, stretched in the extension direction of the track (X axis direction), so as to distort.

The configurations of the electrically conductive optical element 1 other than those described above are the same as the configurations in the first embodiment and, therefore, the explanations will be omitted.

[Configuration of disk master]

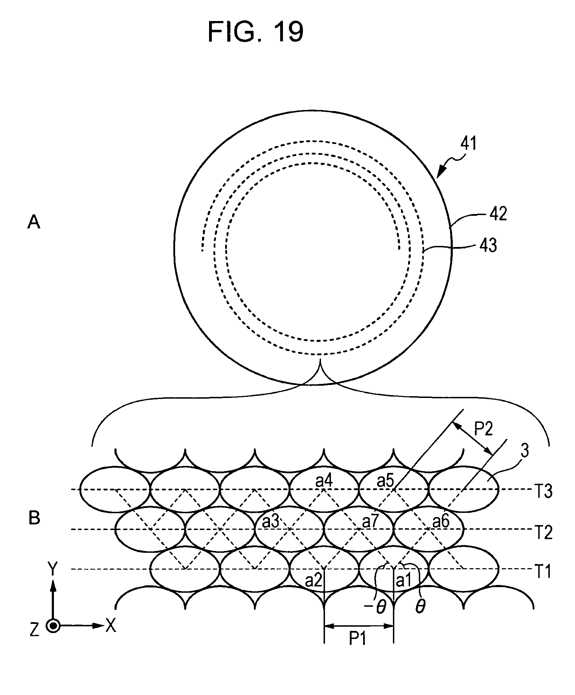

Fig. 19A and Fig. 19B show an example of the configuration of a disk master for producing an electrically conductive optical element having the above-described configuration. As shown in Fig. 19A and Fig. 19B, a disk master 41 has a configuration, in which structures 43 formed from concave portions are arranged in large numbers on the surface of a stamper 42 in the shape of a disk. These structures 13 are periodically two-dimensionally arranged with a pitch smaller than or equal to the wavelength band of the light in a use environment of the electrically conductive optical element 1, for example, with the same level of pitch as the wavelength of the visible light. The structures 43 are arranged on the track in the shape of concentric circles or the shape of a spiral.

The configurations of the disk master 41 other than those described above are the same as the configurations of the roll master 11 in the first embodiment and, therefore, the explanations will be omitted.

[Method for manufacturing electrically conductive optical element]

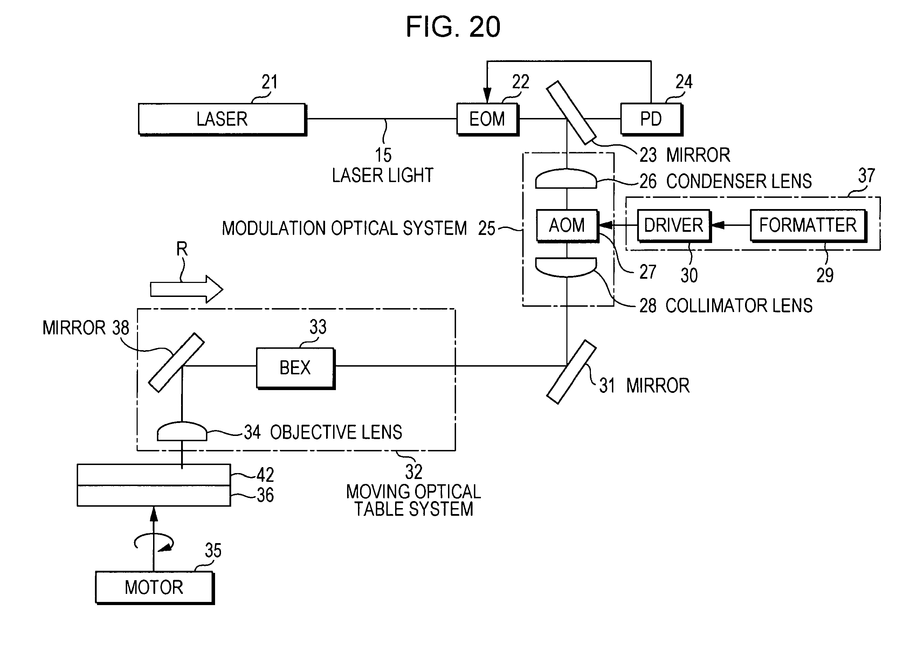

Initially, an exposing apparatus for producing the disk master 41 having the above-described configuration will be described with reference to Fig. 20.

The moving optical table 32 is provided with a beam expander 33, a mirror 38, and an objective lens 34. The laser light 15 led to the moving optical table 32 is shaped into a desired beam shape with the beam expander 33 and, thereafter, is applied to the resist layer on the stamper 42 in the shape of a disk through the mirror 38 and the objective lens 34. The stamper 42 is placed on a turn table (not shown in the drawing) connected to a spindle motor 35. Then, the laser light is applied to the resist layer on the stamper 42 intermittently while the stamper 42 is rotated and, in addition, the laser light 15 is moved in the rotation radius direction of the stamper 42, so that an exposure step of the resist layer is performed. The formed latent image takes the shape of nearly an ellipse having a major axis in the circumferential direction. The movement of the laser light 15 is performed by movement of the moving optical table 32 in the direction indicated by an arrow R.

The exposing apparatus shown in Fig. 20 is provided with a control mechanism 37 to form a latent image composed of the two-dimensional pattern of the hexagonal lattice or the quasi-hexagonal lattice shown in Fig. 18B on the resist layer. The control mechanism 37 is provided with a formatter 29 and a driver 30. The formatter 29 is provided with a polarity inversion portion. This polarity inversion portion controls the application timing of the laser light 15 to the resist layer. The driver 30 receives the output from the polarity inversion portion and controls the acoust-optic modulator 27.

The control mechanism 37 synchronizes the intensity modulation of the laser light 15 with the AOM 27, the driving rotation speed of the spindle motor 35, and the moving speed of the moving optical table 32 with each other on a track basis. The stamper 42 is subjected to rotation control at a constant angular velocity (CAV). Then, patterning is performed at the appropriate number of revolutions of the stamper 42 with the spindle motor 35, appropriate frequency modulation of the laser intensity with the AOM 27, and an appropriate feed pitch of the laser light 15 with the moving optical table 32. Consequently, a latent image of a hexagonal lattice pattern or a quasi-hexagonal lattice pattern is formed on the resist layer.

Furthermore, the control signal of the polarity inversion portion is changed gradually in such a way that the spatial frequency (which is a pattern density of a latent image, and P1: 330, P2: 300 nm, or P1: 315 nm, P2: 275 nm, or P1: 300 nm, P2: 265 nm) becomes uniform. More specifically, exposure is performed while an application period of the laser light 15 to the resist layer is changed on a track basis, and the frequency modulation of the laser light 15 is performed with the control mechanism 37 in such a way that P1 becomes about 330 nm (or 315 nm, 300 nm) in the individual tracks T. That is, modulation control is performed in such a way that the application period of the laser light is reduced as the track location moves away the center of the stamper 42 in the shape of a disk. Consequently, a nanopattern with a uniform special frequency can be formed all over the substrate.

An example of a method for manufacturing the electrically conductive optical element according to the third embodiment of the present invention will be described below.

Initially, a disk master 41 is produced in a manner similar to that in the first embodiment except that a resist layer formed on a stamper in the shape of a disk is exposed by using an exposure apparatus having the above-described configuration. Subsequently, this disk master 41 and a substrate 2, e.g., an acrylic sheet coated with an ultraviolet curable resin, are closely adhered, and ultraviolet rays are applied, so as to cure the ultraviolet curable resin. Thereafter, the substrate 2 is peeled off the disk master 41. In this manner, an optical element in the shape of a disk is obtained, wherein a plurality of structures 3 are arranged on the surface. Then, a transparent, electrically conductive layer 4 is formed on the uneven surface of the optical element provided with the plurality of structures 3. In this manner, an electrically conductive optical element 1 in the shape of a disk is obtained. Next, an electrically conductive optical element 1 in the predetermined shape, e.g., a rectangle, is cut from this electrically conductive optical element 1 in the shape of a disk. Consequently, a desired electrically conductive optical element 1 is produced.

According to the present third embodiment, as in the case where the structures 3 are arranged in the shape of a straight line, an electrically conductive optical element 1 exhibiting high productivity and having an excellent antireflection characteristic can be obtained.

<4. Fourth embodiment>

Fig. 21A is a schematic plan view showing an example of the configuration of an electrically conductive optical element according to a fourth embodiment of the present invention. Fig. 21B is a magnified plan view illustrating a part of the electrically conductive optical element shown in Fig. 21A.

An electrically conductive optical element 1 according to the fourth embodiment is different from the electrically conductive optical element 1 of the first embodiment in that the structures 3 are arranged on a meandering track (hereafter referred to as a wobble track). It is preferable that wobbles of the individual tracks on the substrate 2 are synchronized. That is, it is preferable that the wobbles are synchronized wobbles. In the case where the wobbles are synchronized, as described above, the unit lattice shape of a hexagonal lattice or a quasi-hexagonal lattice is maintained and the filling factor can be kept at a high level. Examples of waveforms of the wobble track can include a sign wave and a triangular wave. The waveform of the wobble track is not limited to a periodic waveform, but may be an aperiodic waveform. For example, about $\pm 10$ $\mu$m is selected as the wobble amplitude of the wobble track.

Regarding the fourth embodiment, the items other than the above description are the same as those in the first embodiment.

According to the fourth embodiment, an occurrence of variations in outward appearance can be suppressed because the structures 3 are arranged on the wobble tracks.

<5. Fifth embodiment>

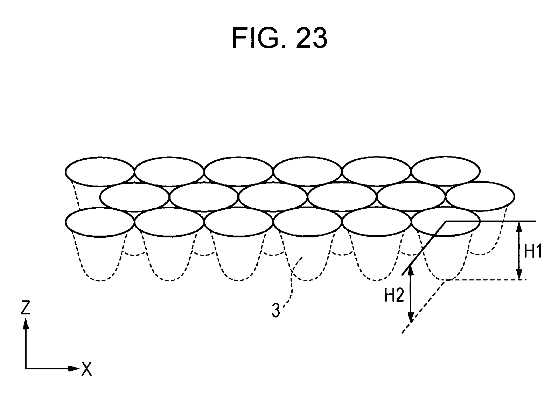

Fig. 22A is a schematic plan view showing an example of the configuration of an electrically conductive optical element according to a fifth embodiment of the present invention. Fig. 22B is a magnified plan view illustrating a part of the electrically conductive optical element shown in Fig. 22A. Fig. 22C is a sectional view along a track T1, T3, ··· shown in Fig. 22B. Fig. 22D is a sectional view along a track T2, T4, ··· shown in Fig. 22B. Fig. 23 is a magnified perspective view illustrating a part of the electrically conductive optical element shown in Fig. 22A.

An electrically conductive optical element 1 according to the fifth embodiment is different from the electrically conductive optical element 1 of the first embodiment in that structures 3 formed from concave portions are arranged in large numbers on the substrate surface. The shape of this structure 3 is a concave shape corresponding to inversion of the convex shape of the structure 3 in the first embodiment. In this regard, in the case where the structure 3 is specified to be a concave portion, as described above, the opening portion (inlet portion of the concave portion) of the structure 3 composed of the concave portion is defined as a lower portion and the lowermost portion (the deepest portion of the concave portion) of the substrate 2 in the depth direction is defined as a top portion. That is, the top portion and the lower portion are defined on the basis of the structure 3 which is an unrealistic space. Furthermore, in the fifth embodiment, the structure 3 is a concave portion and, therefore, the height of the structure 3 in the formula (1) and the like is the depth H of the structure 3.

Regarding the present fifth embodiment, the items other than the above description are the same as those in the first embodiment.

In the present fifth embodiment, the convex shape of the structure 3 in the first embodiment is inverted, so as to form a concave shape. Consequently, the same effects as those in the first embodiment can be obtained.

<6. Sixth embodiment>

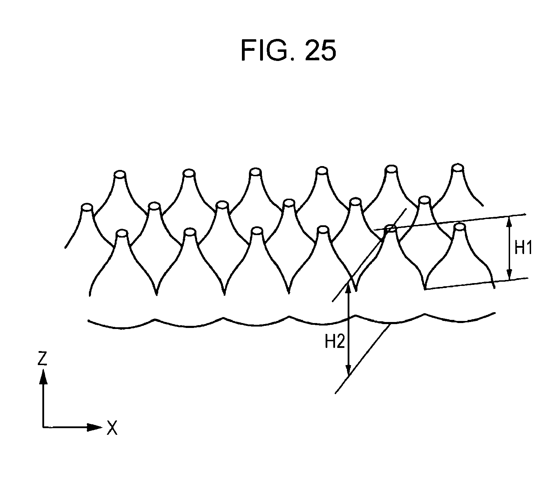

Fig. 24A is a schematic plan view showing an example of the configuration of an electrically conductive optical element according to a sixth embodiment of the present invention. Fig. 24B is a magnified plan view illustrating a part of the electrically conductive optical element shown in Fig. 24A. Fig. 24C is a sectional view along a track T1, T3, ··· shown in Fig. 24B. Fig. 24D is a sectional view along a track T2, T4, ... shown in Fig. 24B. Fig. 25 is a magnified perspective view illustrating a part of the electrically conductive optical element shown in Fig. 24A.

An electrically conductive optical element 1 is provided with a substrate 2, a plurality of structures 3 disposed on the surface of this substrate 2, and a transparent, electrically conductive layer 4 disposed on these structures 3. This structure 3 is a convex portion in the shape of a cone. Lower portions of adjacent structures 3 are mutually joined in such a way that the lower portions thereof are overlapped with each other. It is preferable that among adjacent structures 3, the nearest structures 3 adjacent to each other are arranged in a track direction. This is because it is easy to arrange the nearest structures 3 adjacent to each other at such locations in a manufacturing method described later. This electrically conductive optical element 1 has a function of preventing reflection of light incident on the substrate surface provided with the structures 3. Hereafter, as shown in Fig. 24A, two axes orthogonal to each other in one principal surface of the substrate 2 are referred to as X axis and Y axis, and an axis perpendicular to the one principal surface of the substrate 2 is referred to as Z axis. Moreover, in the case where there is a gap portion 2a between structures 3, it is preferable that a fine uneven shape is disposed in this gap portion 2a. This is because the reflectance of the electrically conductive optical element 1 can be further reduced by disposing such a fine uneven shape.

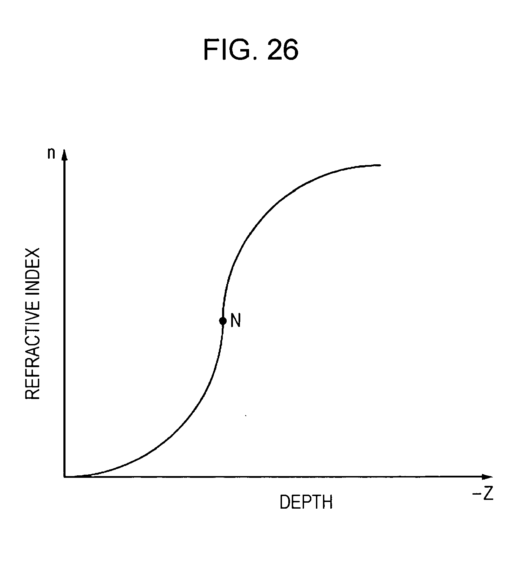

Fig. 26 shows an example of the refractive index profile of the electrically conductive optical element according to the first embodiment of the present invention. As shown in Fig. 26, the effective refractive index of the structure 3 in the depth direction (-Z axis direction in Fig. 24A) increases gradually toward the substrate 2 and, in addition, changes in such a way as to draw a curve in the shape of the letter S. That is, the refractive index profile has one inflection point. This inflection point corresponds to the shape of the side surface of the structure 3. The boundary becomes unclear to the light by changing the effective refractive index as described above. Therefore, reflected light is reduced and the antireflection characteristic of the electrically conductive optical element 1 can be improved. It is preferable that the change in effective refractive index in the depth direction is monotonic increase. Here, the shape of the letter S include the reverse shape of the letter S, that is, the shape of the letter Z.

Furthermore, it is preferable that the change in effective refractive index in the depth direction in at least one of the top portion side and the substrate side of the structure 3 is steeper than an average value of the inclination of the effective refractive index, and it is more preferable that the changes in both the top portion side and the substrate side of the structure 3 are steeper than the above-described average value. Consequently, excellent antireflection characteristic can be obtained.

The lower portion of the structure 3 is joined to a part of or all of the lower portions of the structures 3 in the relationship of being adjacent to each other. The change in effective refractive index in the depth direction of the structure 3 can be smoothened by joining lower portions of the structures to each other as described above. As a result, the refractive index profile can have the shape of the letter S. In addition, the filling factor of the structures can be increased by joining lower portions of the structures to each other. By the way, in Fig. 24B, positions of the joint portions when all adjacent structures 3 are joined are indicated by a mark of black circle "●". Specifically, the joint portions are formed between all adjacent structures 3, between adjacent structures 3 in the same track (for example, between a1 and a2), or between structures 3 in adjacent tracks (for example, between a1 and a7, between a2 and a7). In order to realize a smooth refractive index profile and obtain an excellent antireflection characteristic, it is preferable that joint portions are formed between all adjacent structures 3. In order to form joint portions easily by a manufacturing method described later, it is preferable that joint portions are formed between structures 3 adjacent to each other in the same track. In the case where structures 3 are periodically arranged in a hexagonal lattice pattern or a quasi-hexagonal lattice pattern, for example, the structures 3 are joined in the azimuths in accordance with 6-fold symmetry.

It is preferable that the structures 3 are joined in such a way that the lower portions thereof are overlapped with each other. In the case where the structures 3 are joined in such a manner, the refractive index profile in the shape of the letter S can be obtained and, in addition, the filling factor of the structure 3 can be improved. It is preferable that regarding the structures, portions one-quarter or less of the maximum value of optical path length in consideration of the refractive index in the wavelength band of the light in a use environment are mutually joined. Consequently, an excellent antireflection characteristic can be obtained.

As for the material for the structure 3, for example, a material containing an ionizing radiation curable resin, which is cured by ultraviolet rays or electron beams, or a thermosetting resin, which is cured by heat, as a primary component is preferable, and a material containing an ultraviolet curable resin, which can be cured by ultraviolet rays, as a primary component is most preferable.

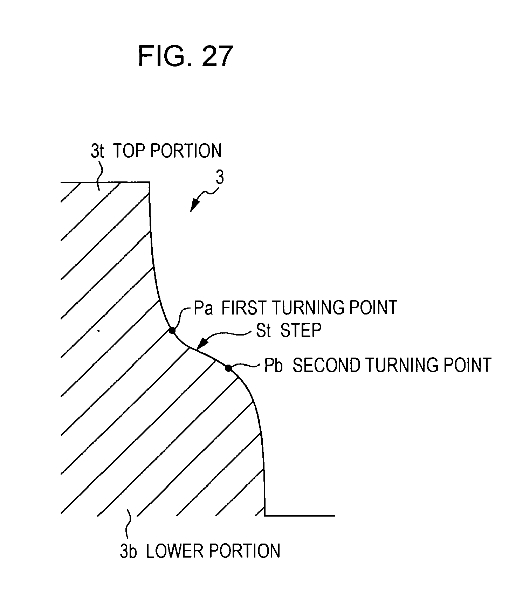

Fig. 27 is a magnified sectional view showing an example of the shape of a structure. It is preferable that the side surface of the structure 3 is enlarged gradually toward the substrate 2 and, in addition, changes in such a way as to draw the shape of a square root of the curve in the shape of the letter S shown in Fig. 26. In the case where such a side surface shape is employed, an excellent antireflection characteristic can be obtained and, in addition, the transferability of the structure 3 can be improved.

The top portion 3t of the structure 3 is in the shape of, for example, a flat surface or in the shape of a convex which becomes slim as the end is approached. In the case where the top portion 3t of the structure 3 is in the shape of a flat surface, it is preferable that the area ratio (St/S) of the area St of the flat surface of the structure top portion to the area S of a unit lattice decreases as the height of the structure 3 increases. Consequently, the antireflection characteristic of the electrically conductive optical element 1 can be improved. Here, the unit lattice is, for example, a hexagonal lattice or a quasi-hexagonal lattice. It is preferable that the area ratio of the structure bottom (the area ratio (Sb/S) of the area Sb of the structure bottom to the area S of the unit lattice) is close to the area ratio of the top portion 3t.

It is preferable that the side surface of the structure 3 excluding the top portion 3t and the lower portion 3b has one set of a first turning point Pa and a second turning point Pb in that order in the direction from the top portion 3t thereof toward the lower portion 3b. Consequently, the effective refractive index of the structure 3 in the depth direction (-Z axis direction in Fig. 24A) can have one inflection point.

Here, the first turning point Pa and the second turning point Pb are defined as described below.

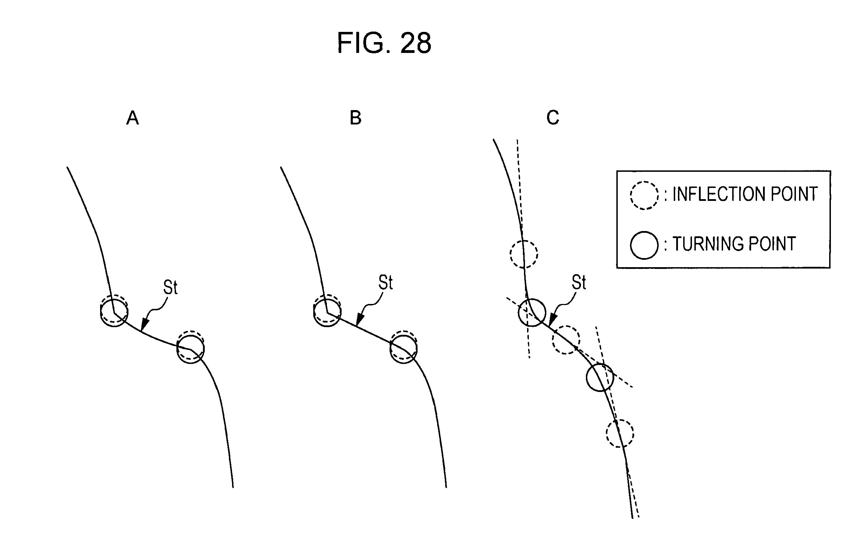

As shown in Fig. 28A and Fig. 28B, in the case where the side surface between the top portion 3t and the lower portion 3b of the structure 3 is formed by discontinuously joining a plurality of smooth curved surfaces from the top portion 3t of the structure 3 toward the lower portion 3b, the joint portions serve as turning points. These turning points agree with the inflection points. Properly speaking, differentiation is impossible at the joint portion. However, here, such an inflection point serving as a limit is also referred to as the inflection point. In the case where the structure 3 has the above-described curved surface, it is preferable that the inclination of the structure 3 from the top portion 3t toward the lower portion 3b becomes more moderate after passing the first turning point Pa, and subsequently becomes steeper after passing the second turning point Pb.

As shown in Fig. 28C, in the case where the side surface between the top portion 3t and the lower portion 3b of the structure 3 is formed by continuously joining a plurality of smooth curved surfaces from the top portion 3t of the structure 3 toward the lower portion 3b, the turning point is defined as described below. As shown in Fig. 28C, a point which is on the curve and which is nearest to the point of intersection of the individual tangent lines at two inflection points present on the side surface of the structure is referred to as a turning point.

It is preferable that the structure 3 has one step St on the side surface between the top portion 3t and the lower portion 3b thereof. In the case where such one step St is included, the above-described refractive index profile can be realized. That is, the effective refractive index of the structure 3 in the depth direction can be increased gradually toward the substrate 2 and, in addition, can be changed in such a way as to draw a curve in the shape of the letter S. Examples of steps include an inclined step and a parallel step, and the inclined step is preferable. This is because in the case where the step St is specified to be the inclined step, the transferability can become good as compared with that in the case where the step St is specified to be the parallel step.

The inclined step refers to a step which is not parallel to the substrate surface and which is inclined in such a way that the side surface is expanded as the lower portion is approached from the top portion of the structure 3. The parallel step refers to a step parallel to the substrate surface. Here, the step St is a section set by the above-described first turning point Pa and the second turning point Pb. In this regard, it is specified that the step St does not include the flat surface of the top portion 3t nor the curved surface or the flat surface between the structures.

It is preferable from the viewpoint of ease in formation that the structure 3 has the shape of an axisymmetric cone or the shape of a cone, in which the shape of a cone is stretched or contracted in the track direction, except the lower portion joined to adjacent structures 3. Examples of the shapes of a cone can include the shape of a circular cone, the shape of a circular truncated cone, the shape of an elliptical cone, and the shape of an elliptical truncated cone. Here, as described above, the shape of a cone is a concept including the shape of an elliptical cone and the shape of an elliptical truncated cone besides the shape of a circular cone and the shape of a circular truncated cone. In this regard, the shape of a circular truncated cone refers to the shape, in which the top portion of the shape of a circular cone has been cut off, and the shape of an elliptical truncated cone refers to the shape, in which the top portion of the shape of an elliptical cone has been cut off. In this connection, the whole shape of the structure 3 is not limited to these shapes. It is enough that the effective refractive index of the structure 3 in the depth direction increases gradually toward the substrate 2 and, in addition, changes in such a way as to have the shape of the letter S. Furthermore, the shape of a cone includes not only a complete shape of a cone, but also the shape of a cone having the step St on the side surface, as described above.

The structure 3 in the shape of an elliptical cone is a structure having a cone structure, in which the bottom is in the shape of an ellipse, an oval, or an egg having a major axis and a minor axis and the top portion is in the convex shape that becomes narrow and thin as the end is approached. The structure 3 in the shape of an elliptical truncated cone is a structure having a cone structure, in which the bottom is in the shape of an ellipse, an oval, or an egg having a major axis and a minor axis and the top portion is a flat surface. In the case where the structure 3 is specified to be in the shape of an elliptical cone or in the shape of an elliptical truncated cone, it is preferable that the structure 3 is formed on the substrate surface in such a way that the major axis direction of the bottom of the structure 3 corresponds to the extension direction (X axis direction) of the track.

The cross-sectional area of the structure 3 varies in the depth direction of the structure 3 in such a way as to correspond to the above-described refractive index profile. It is preferable that the cross-sectional area of the structure 3 increases monotonically in the depth direction of the structure 3. Here, the cross-sectional area of the structure 3 refers to the area of a cut surface parallel to the substrate surface on which the structures 3 are arranged. Preferably, the cross-sectional area of the structure is changed in the depth direction in such a way that the cross-sectional area ratios of the structure 3 at different depth positions correspond to the above-described effective refractive index profile at the positions concerned.

The above-described structure 3 having the step is obtained by using a stamper produced as described below through shape transfer. That is, in an etching step of the stamper production, treatment times of an etching treatment and an ashing treatment are adjusted appropriately and, thereby, a stamper in which a step is formed on the side surface of a structure (concave portion) is produced.

According to the present sixth embodiment, the structure 3 has the shape of a cone and the effective refractive index of this structure 3 in the depth direction increases gradually toward the substrate 2 and, in addition, changes in such a way as to draw a curve having the shape of the letter S. Consequently, the boundary becomes unclear to the light by a shape effect of the structures 3, so that reflected light can be reduced. Therefore, an excellent antireflection characteristic can be obtained. In particular, in the case where the height of the structure 3 is large, an excellent antireflection characteristic is obtained. Furthermore, since the lower portions of adjacent structures 3 are mutually joined in such a way that the lower portions are overlapped with each other, the filling factor of the structure 3 can be improved and, in addition, formation of the structures 3 becomes easy.

It is preferable that the effective refractive index profile of the structure 3 in the depth direction is changed in such a way as to become the shape of the letter S and, in addition, the structures are disposed in the arrangement of a (quasi)-hexagonal lattice or a (quasi)-tetragonal lattice. Moreover, it is preferable that each of the structures 3 has an axisymmetric structure or a structure which is produced by stretching or contracting an axisymmetric structure in the track direction. In addition, it is preferable that adjacent structures 3 are joined in the vicinity of the substrate. In the case where such a configuration is employed, high-performance antireflection structures, which are produced more easily, can be produced.

In the case where the electrically conductive optical element 1 is produced by using a method based on combination of an optical disk stamper producing process and an etching process, the time required for the stamper production process (exposure time) can be reduced significantly as compared with that in the case where the electrically conductive optical element 1 is produced by using electron beam exposure. Consequently, the productivity of the electrically conductive optical element 1 can be improved significantly.

In the case where the shape of the top portion of the structure 3 is not specified to be sharp, but specified to be in the shape of a flat surface, the durability of the electrically conductive optical element 1 can be improved. Furthermore, the peeling property of the structures 3 with respect to the roll master 11 can be improved. In the case where the step of the structure 3 is specified to be an inclined step, the transferability can be improved as compared with that in the case where a parallel step is employed.

<7. Seventh embodiment>

Fig. 29 is a sectional view showing an example of the configuration of an electrically conductive optical element according to a seventh embodiment of the present invention. As shown in Fig. 29, the electrically conductive optical element 1 according to the seventh embodiment is different from the electrically conductive optical element 1 of the first embodiment in that structures 3 are further disposed on the other principal surface (second principal surface) opposite to the one principal surface provided with the structures 3.

The arrangement patterns, the aspect ratios, and the like of the structures 3 on the two principal surfaces of the electrically conductive optical element 1 are not necessary the same, and different arrangement patterns and aspect ratios may be selected in accordance with desired characteristics. For example, the arrangement pattern of the one principal surface may be specified to be a quasi-hexagonal lattice pattern and the arrangement pattern of the other principal surface may be specified to be a quasi-tetragonal lattice pattern.

In the seventh embodiment, a plurality of structures 3 are disposed on both principal surfaces of the substrate 2 and, thereby, the function of preventing reflection of light can be given to both the light incident surface and the light emitting surface of the electrically conductive optical element 1. Consequently, a light transmission characteristic can be further improved.

<8. Eighth embodiment>

The eighth embodiment is different from the first embodiment except that a plurality of structures are formed on the substrate surface through thermal transfer. In this regard, in the eighth embodiment, the same places as those in the first embodiment are indicated by the same reference numerals and the explanations will be omitted.

Fig. 30 is a schematic diagram showing a configuration example of a thermal-transfer forming apparatus. As shown in Fig. 30, this laminate-transfer forming apparatus 740 is provided with an emboss belt 743 rotated by a heating roll 741 and a cooling roll 742 and a flat belt 745 rotated by two pressure rolls 744 disposed opposite to the heating roll 741 and the cooling roll 742. In this regard, a substrate 2 before provision of a shape can be inserted into a gap between the emboss belt 743 having a plurality of concave portions 743A on the surface and the flat belt 745 having no three-dimensional shape.

Next, the operation of the thermal-transfer forming apparatus having the above-described configuration will be described.

Initially, the emboss belt 743 and the flat belt 745 are rotated and the substrate 2 before provision of a shape is inserted into the gap between the two from the heating roll 741 side. Consequently, the one principal surface of the substrate 2 is melt for a moment due to the heat of the heating roll 741, and the shape of the concave portions 743A are transferred to the one principal surface of the substrate 2. Thereafter, the surface of the substrate 2, to which the shape of the concave portions 743A have been transferred, is cooled by the cooling roll 42, so that the surface shape is fixed. That is, a plurality of structures 12 are formed on the one principal surface of the substrate 2.

In this manner, the substrate 2 provided with a plurality of structures 3 on the substrate surface can be obtained.

<9. Ninth embodiment>

Fig. 31A is a sectional view showing an example of the configuration of a touch panel according to a ninth embodiment of the present invention. This touch panel is a so-called resistive touch panel. As for the resistive touch panel, either an analog resistive touch panel or a digital resistive touch panel is employed. As shown in Fig. 31A, a touch panel 50 serving as an information input device is provided with a first electrically conductive base member 51 having a touch surface (input surface) to input information and a second electrically conductive base member 52 opposite to this first electrically conductive base member 51. It is preferable that the touch panel 50 is further provided with a hard coat layer or an antifouling hard coat layer on a surface in the touch side of the first electrically conductive base member 51. Furthermore, as necessary, a front panel may be further disposed on the touch panel 50. This touch panel 50 is bonded to, for example, a display device 54 with an adhesive layer 53 therebetween.

As for the display device, various display devices, for example, a liquid crystal display, a CRT (Cathode Ray Tube) display, a plasma display (Plasma Display Panel: PDP), an electro luminescence (Electro Luminescence: EL) display, and a surface-conduction electron-emitter display (Surface-conduction Electron-emitter Display: SED) can be used.

Any one of the electrically conductive optical elements 1 according to the first to the sixth embodiments is used as at least one of the first electrically conductive base member 51 and the second electrically conductive base member 51. In the case where any of electrically conductive optical elements 1 according to the first to the sixth embodiments are used as both the first electrically conductive base member 51 and the second electrically conductive base member 51, the electrically conductive optical elements 1 according to the same embodiment or different embodiments can be used as the two electrically conductive base members.

The structures 3 are disposed at least one of the two surfaces, which are opposite to each other, of the first electrically conductive base member 51 and the second electrically conductive base member 51. From the viewpoint of the antireflection characteristic and the transmission characteristic, it is preferable that the structures 3 are disposed on both the surfaces.

It is preferable that a single-layer or multilayer antireflection layer is disposed on the surface in the touch side of the first electrically conductive base member 51. This is because the reflectance can be reduced and the visibility can be improved.

(Modified examples)

Fig. 31B is a sectional view showing a modified example of the touch panel according to the ninth embodiment of the present invention. As shown in Fig. 31B, the electrically conductive optical element 1 according to the seventh embodiment is used as at least one of the first electrically conductive base member 51 and the second electrically conductive base member 52.

A plurality of structures 3 are disposed at least one of the two surfaces, which are opposite to each other, of the first electrically conductive base member 51 and the second electrically conductive base member 51. Furthermore, a plurality of structures 3 are disposed at least one of the surface in the touch side of the first electrically conductive base member 51 and the surface in the display device 54 side of the second electrically conductive base member 52. From the viewpoint of the antireflection characteristic and the transmission characteristic, it is preferable that the structures 3 are disposed on both the surfaces.

In the ninth embodiment, the electrically conductive optical element 1 is used as at least one of the first electrically conductive base member 51 and the second electrically conductive base member 51, so that the touch panel 50 having excellent antireflection characteristic and transmission characteristic can be obtained. Therefore, the visibility of the touch panel 50 can be improved. In particular, the visibility of the touch panel 50 in the outdoors can be improved.

<10. Tenth embodiment>

Fig. 32A is a perspective view showing an example of the configuration of a touch panel according to a tenth embodiment of the present invention. Fig. 32B is a sectional view showing an example of the configuration of the touch panel according to the tenth embodiment of the present invention. The touch panel according to the tenth embodiment is different from the touch panel of the ninth embodiment in that a hard coat layer 7 disposed on a touch surface is further provided.

The touch panel 50 is provided with a first electrically conductive base member 51 having a touch surface (input surface) to input information and a second electrically conductive base member 52 opposite to this first electrically conductive base member 51. The first electrically conductive base member 51 and the second electrically conductive base member 52 are bonded to each other with a bonding layer 55, which is disposed between the perimeter portions thereof, therebetween. As for the bonding layer 55, for example, an adhesive paste and an adhesive tape are used. It is preferable that the antifouling property is given to the surface of the hard coat layer 7. This touch panel 50 is bonded to, for example, a display device 54 with a bonding layer 53 therebetween. As for the material for the bonding layer 53, for example, adhesives of acryl based, rubber based, or silicon based can be used. From the viewpoint of the transparency, the acrylic adhesives are preferable.

In the tenth embodiment, the hard coat layer 7 is disposed on the surface in the touch side of the first electrically conductive base member 51, so that the scratch resistance of the touch surface of the touch panel 50 can be improved.

<11. Eleventh embodiment>

Fig. 33 is a sectional view showing an example of the configuration of a liquid crystal display device according to an eleventh embodiment of the present invention. As shown in Fig. 33, a liquid crystal display device 70 according to the eleventh embodiment is provided with a liquid crystal panel (liquid crystal layer) 71 having first and second principal surfaces, a first polarizer 72 disposed on the first principal surface, a second polarizer 73 disposed on the second principal surface, and a touch panel 50 disposed between the liquid crystal panel 71 and the first polarizer 72. The touch panel 50 is a liquid crystal display-integrated touch panel (so-called inner touch panel). A plurality of structures 3 may be disposed directly on the surface of the first polarizer 72. In the case where the first polarizer 72 is provided with a protective layer, e.g., a TAC (triacetyl cellulose) film, on the surface, it is preferable that a plurality of structures 3 are disposed directly on the protective layer. In the case where the plurality of structures 3 are disposed on the polarizer 72, the thickness of the liquid crystal display device 70 can be further reduced.

(Liquid crystal panel)

As for the liquid crystal panel 71, those having a display mode of, for example, twisted nematic (Twisted Nematic: TN) mode, super twisted nematic (Super Twisted Nematic: STN) mode, vertically aligned (Vertically Aligned: VA) mode, in-plane switching (In-Plane Switching: IPS) mode, optically compensated birefringence (Optically Compensated Birefringence: OCB) mode, ferroelectric liquid crystal (Ferroelectric Liquid Crystal: FLC) mode, polymer dispersed liquid crystal (Polymer Dispersed Liquid Crystal: PDLC) mode, and phase change guest host (Phase Change Guest Host: PCGH) mode can be used.

(Polarizer)

The first polarizer 72 and the second polarizer 73 are bonded to the first and the second principal surfaces of the liquid crystal panel 71 with bonding layers 74 and 75 therebetween in such a way that transmission axes thereof become orthogonal to each other. The first polarizer 72 and the second polarizer 73 transmit merely one of orthogonal polarized components in the incident light and interrupt the other through absorption. As for the first polarizer 72 and the second polarizer 73, for example, those produced by arranging iodine complexes or dichroic dyes on polyvinyl alcohol (PVA) based films in a uniaxial direction can be used. It is preferable that protective layers, e.g., triacetyl cellulose (TAC) films, are disposed on both surfaces of the first polarizer 72 and the second polarizer 73.

(Touch panel)

The touch panel according to any one of the ninth to the twelfth embodiments can be used as the touch panel 50.
In the configuration of the eleventh embodiment, the polarizer 72 is shared by the liquid crystal panel 71 and the touch panel 50, so that the optical characteristic can be improved.

<12. Twelfth embodiment>

Fig. 34A is a perspective view showing an example of the configuration of a touch panel according to a twelfth embodiment of the present invention. Fig. 34B is a sectional view showing an example of the configuration of the touch panel according to the twelfth embodiment of the present invention. A touch panel 50 according to the present twelfth embodiment is a so-called capacitive touch panel, and a large number of structures 3 are disposed at least one of on the surface thereof and in the inside thereof. This touch panel 50 is bonded to, for example, a display device 54 with an adhesive layer 53 therebetween.

(First configuration example)

As shown in Fig. 34A, the touch panel 50 according to the first configuration example is provided with a substrate 2, a transparent, electrically conductive layer 4 disposed on this substrate 2, and a protective layer 9. Structures 3 are arranged in large numbers on at least one of the substrate 2 and the protective layer 9 with a minute pitch less than or equal to the wavelength of the visible light. In this regard, Fig. 34A shows an example in which the structures 3 are arranged in large numbers on the surface of the substrate 2. The capacitive touch panel may be any of a surface type capacitive touch panel, an inner type capacitive touch panel, and a projection type capacitive touch panel. In the case where circumference members, e.g., a wiring layer, are disposed in a circumference portion of the substrate 2, it is preferable that a large number of structures 3 are disposed in the circumference portion of the substrate 2, as in the above-described twelfth embodiment. This is because the adhesion between the circumference members, e.g., a wiring layer, and the substrate 2 can be improved.

The protective layer 9 is a dielectric layer containing a dielectric, e.g., $SiO_2$, as a primary component. The transparent, electrically conductive layer 4 has a different configuration depending on the system of the touch panel 50. For example, in the case where the touch panel 50 is the surface type capacitive touch panel or the inner type capacitive touch panel, the transparent, electrically conductive layer 4 is a thin film having a nearly uniform layer thickness. In the case where the touch panel 50 is the projection type capacitive touch panel, the electrically conductive layer 4 is a transparent electrode pattern in the shape of, for example, a lattice arranged with a predetermined pitch and is arranged oppositely. As for the material for the transparent, electrically conductive layer 4, the same materials as those in the above-described first embodiment can be used. The items other than the above description are the same as those in the ninth embodiment and, therefore, the explanations will be omitted.

(Second configuration example)

As shown in Fig. 34B, the touch panel 50 according to the second configuration example is different from the touch panel 50 in the first configuration example in that structures 3 are arranged in large numbers with a minute pitch less than or equal to the wavelength of the visible light on the surface of the protective layer 9, that is, the touch surface, in place of the inside of the touch panel 50. In this regard, a large number of structures 3 may be further disposed on the back surface of the side bonded to the display device 53.

In the twelfth embodiment, a large number of structures 3 are disposed at least on the surface and in the inside of the capacitive touch panel 50. Therefore, the same effects as in the eighth embodiment can be obtained.

<13. Thirteenth embodiment>

[Configuration of touch panel]

Fig. 48A is a sectional view showing an example of the configuration of a touch panel according to a thirteenth embodiment of the present invention. As shown in Fig. 48A, a touch panel 210 serving as an information input apparatus is disposed on the display surface of a display device 212. The display device 212, to which the touch panel 210 is applied, is not specifically limited. Examples include various display devices, e.g., a liquid crystal display, a CRT (Cathode Ray Tube) display, a plasma display (Plasma Display Panel: PDP), an electro luminescence (Electro Luminescence: EL) display, and a surface-conduction electron-emitter display (Surface-conduction Electron-emitter Display: SED).

The touch panel 210 is a so-called projection type capacitive touch panel and is provided with an electrically conductive element 11. The electrically conductive element 211 is provided with an optical layer 201 and a first transparent, electrically conductive layer 205 and a second transparent, electrically conductive layer 206, which are disposed at a predetermined distance from each other in this optical layer. The first transparent, electrically conductive layer 205 is, for example, an X electrode (first electrode) having a predetermined pattern. The second transparent, electrically conductive layer 206 is, for example, a Y electrode (second electrode) having a predetermined pattern. These X electrode and Y electrode are in the relationship of, for example, being orthogonal to each other. The refractive index n of the optical layer 201 is within the range of, for example, 1.2 or more, and 1.7 or less.

The surface resistance of the transparent, electrically conductive layer 4 is preferably within the range of 50 $\Omega/\square$ or more, and 4,000 $\Omega/\square$ or less and is more preferably within the range of 50 $\Omega/\square$ or more, and 500 $\Omega/\square$ or less. This is because the transparent, electrically conductive optical element 1 can be used as an upper electrode or a lower electrode of the capacitive touch panel by specifying the surface resistance within the above-described range. Here, the surface resistance of the transparent, electrically conductive layer 4 is determined on the basis of four-terminal measurement (JIS K 7194).

The resistivity of the transparent, electrically conductive layer 4 is preferably $1 \times 10^{-3}$ $\Omega \cdot cm$ or less. This is because in the case where the resistivity is $1 \times 10^{-3}$ $\Omega \cdot cm$ or less, the above-described range of the surface resistance can be realized.

Fig. 48B is a magnified sectional view illustrating a wiring region R1 shown in Fig. 48A, under magnification. Fig. 48C is a magnified sectional view illustrating a non-wiring region R2 shown in Fig. 48A, under magnification. The first transparent, electrically conductive layer 205 has a first wavefront S1 and a second wavefront S2 synchronized with each other. The average wavelength $\lambda 1$ of the first wavefront S1 and the second wavefront S2 is less than or equal to the wavelength of the visible light. It is preferable that the average widths of vibration of the first wavefront S1 and the second wavefront S2 are different. It is preferable that the average width A1 of vibration of the first wavefront S1 is smaller than the average width B1 of vibration of the second wavefront S2. The cross-sectional shape when the first wavefront S1 or the second wavefront S2 is cut in one direction in such a way that the position, at which the width of vibration becomes maximum, is included is, for example, the shape of a triangular waveform, the shape of a sign waveform, the shape of a waveform in which a quadratic curve or a part of the quadratic curve is repeated, or the shape analogous thereto. Examples of quadratic curves include a circle, an ellipse, and a parabola.

In the wiring region R1, the ratio (A1/λ1) of the average width A1 of vibration to the average wavelength λ1 of the first wavefront S1 is preferably 0.2 or more, and 1.3 or less, and more preferably 0.2 or more, and 1.0 or less. If the ratio is less than 0.2, the reflectance tends to increase. If 1.3 is exceeded, the surface resistance tends to become difficult to satisfy a predetermined value. The ratio (B1/λ1) of the average width B1 of vibration to the average wavelength λ1 of the second wavefront S2 is preferably 0.2 or more, and 1.3 or less, and more preferably 0.2 or more, and 1.0 or less. If the ratio is less than 0.2, the reflectance tends to increase. If 1.3 is exceeded, the surface resistance tends to become difficult to satisfy a predetermined value. The average layer thickness of the first transparent, electrically conductive layer 205 is 80 nm or less. If 80 nm is exceeded, the reflectance tends to increase.

Here, the average wavelength λ1, the average width A1 of vibration of the first wavefront S1, the average width B1 of vibration of the second wavefront S2, the ratio (A1/λ), and the ratio (B1/λ) are determined as described below. Initially, the electrically conductive element 211 is cut in one direction in such a way that the positions C1 and C2, at which the width of vibration of the first wavefront S1 or the second wavefront S2 of the first transparent, electrically conductive layer 205 becomes maximum, are included. The resulting cross-section is photographed with a transmission electron microscope (TEM: Transmission Electron Microscope). Subsequently, the wavelength λ1 of the first wavefront S1 or the second wavefront S2, the width A1 of vibration of the first wavefront S1, and the width B1 of vibration of the second wavefront S2 are determined from the resulting TEM photograph. These measurements are repeated with respect to 10 places selected from the electrically conductive element 211 at random, and measurement values are simply averaged (arithmetically averaged), so as to determine the average wavelength λ1, the average width A1 of vibration of the first wavefront S1, and the average width B1 of vibration of the second wavefront S2. Then, the ratio (A1/λ) and the ratio (B1/λ) are determined by using these average wavelength λ1, average width A1 of vibration, and the average width B1 of vibration.

The average layer thickness refers to an average value of maximum layer thicknesses and is determined as described below specifically. Initially, the electrically conductive element 211 is cut in one direction in such a way that the positions C11 and C12, at which the width of vibration of the first wavefront S1 or the second wavefront S2 of the first transparent, electrically conductive layer 205 becomes maximum, are included. The resulting cross-section is photographed with a transmission electron microscope (TEM). Subsequently, the layer thickness of the first transparent, electrically conductive layer 205 at the position, at which the layer thickness becomes the largest (for example, position C1), is measured on the basis of the resulting TEM photograph. This measurement is repeated with respect to 10 places selected from the first transparent, electrically conductive layer 205 at random, and measurement values are simply averaged (arithmetically averaged), so as to determine the average layer thickness.

The second transparent, electrically conductive layer 206 has a third wavefront S3 and a fourth wavefront S4 synchronized with each other. The average wavelength λ2 of the third wavefront S3 and the fourth wavefront S4 is less than or equal to the wavelength of the visible light. The cross-sectional shape when the third wavefront S3 or the fourth wavefront S4 is cut in one direction in such a way that the position, at which the width of vibration becomes maximum, is included is, for example, the shape of a triangular waveform, the shape of a sign waveform, the shape of a waveform in which a quadratic curve or a part of the quadratic curve is repeated, or the shape analogous thereto. Examples of quadratic curves include a circle, an ellipse, and a parabola.

In the wiring region R1, the ratio (A2/λ2) of the average width A2 of vibration to the average wavelength λ2 of the third wavefront S3 is preferably 0.2 or more, and 1.3 or less, and more preferably 0.2 or more, and 1.0 or less. If the ratio is less than 0.2, the reflectance tends to increase. If 1.3 is exceeded, the surface resistance tends to become difficult to satisfy a predetermined value. The ratio (B2/λ2) of the average width B2 of vibration to the average wavelength λ2 of the fourth wavefront S4 is preferably 0.2 or more, and 1.3 or less, and more preferably 0.2 or more, and 1.0 or less. If the ratio is less than 0.2, the reflectance tends to increase. If 1.3 is exceeded, the surface resistance tends to become difficult to satisfy a predetermined value. The average layer thickness of the second transparent, electrically conductive layer 206 is preferably 80 nm or less. If 80 nm is exceeded, the transmittance tends to be degraded.

Here, the average wavelength λ2 of the third wavefront S3 and the fourth wavefront S4 is determined in the same manner as that for the above-described average wavelength λ1 of the first wavefront S1 and the second wavefront S2. Furthermore, the average width A2 of vibration of the third wavefront S3 and the average width A2 of vibration of the fourth wavefront S4 are determined in the same manner as that for the above-described average width A1 of vibration of the first wavefront S1 and the average width B1 of vibration of the second wavefront. Moreover, the average layer thickness of the second transparent, electrically conductive layer 206 is determined in the same manner as that for the average layer thickness of the first transparent, electrically conductive layer 205.

The optical layer 201 is provided with a first optical layer 202 having a first uneven surface S1 and a fourth uneven surface S4, a second optical layer 203 having a second uneven surface S2, and a third optical layer 204 having a third uneven surface S3. The first transparent, electrically conductive layer 205 is disposed between the first uneven surface S1 and the second uneven surface S2. The second transparent, electrically conductive layer 206 is disposed between the third uneven surface S3 and the fourth uneven surface S4. Alternatively, the optical layer 1 may have a configuration in which only the first uneven surface S1 and the second uneven surface S2 are included as uneven surfaces and the first transparent, electrically conductive layer 205 is disposed between these first uneven surface S1 and second uneven surface S2.

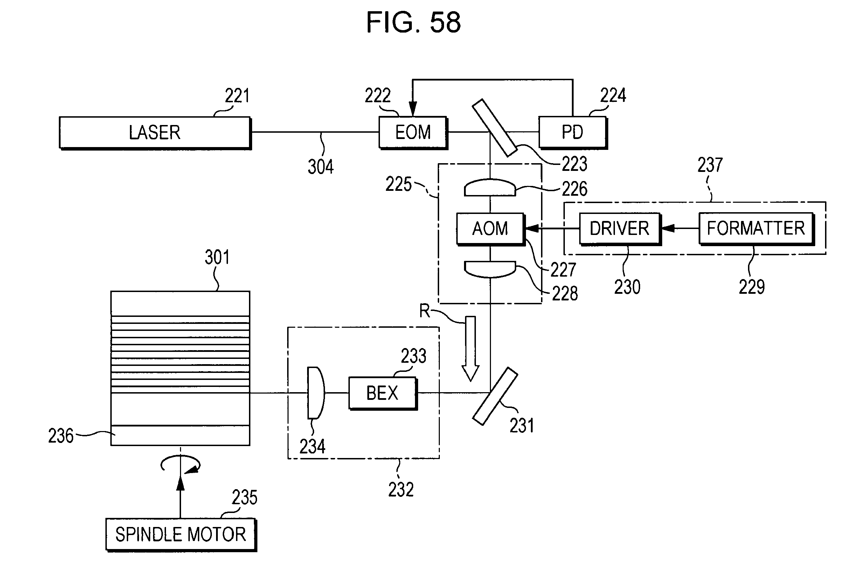

The first uneven surface S1 is formed by arranging a large number of first structures 202a with an average pitch less than or equal to the wavelength of the visible light. The second uneven surface S2 is formed by arranging a large number of second structures 203a with an average pitch less than or equal to the wavelength of the visible light. The first structures 202a and the second structures 203a are disposed at opposite positions in the in-plane direction of the electrically conductive element 211. The first structure 202a and the second structure 203a have, for example, a concave or convex shape. For example, one structure of the first structure 202a and the second structure 203a is formed into a convex shape, whereas the other structure is formed into a concave shape. Fig. 58B and Fig. 58C show an example in which the first structure 202a is formed into the convex shape, whereas the second structure 203a is formed into the concave shape. For example, the first structures 202a and the second structures 203a are formed at opposite positions in the in-plane direction of the electrically conductive element 211, and the first structures 202a are protruded toward concave portions, which are the second structures 203a. In this regard, the combination of the shapes of the first structures 202a and the second structures 203a is not limited to the above-described example, and it is also possible that both structures are specified to be convex shapes or concave shapes. In a wiring region R1, the aspect ratio (average height or average depth H11/average arrangement pitch P1) of the first structures 202a is preferably 0.2 or more, and 1.3 or less, and more preferably 0.2 or more, and 1.0 or less. In the wiring region R1, the aspect ratio (average height or average depth H12/average arrangement pitch P1) of the second structures 203a is preferably 0.2 or more, and 1.3 or less, and more preferably 0.2 or more, and 1.0 or less. The average layer thickness of the first transparent, electrically conductive layer 205 at the top portions of the first structures 202a is preferably 80 nm or less. If 80 nm is exceeded, the reflectance tends to increase. It is preferable that the relationship represented by D1 > D3 > D2 is satisfied, where the layer thickness of the first transparent, electrically conductive layer 205 at the top portion of the first structure 202a is assumed to be D1, the layer thickness of the first transparent, electrically conductive layer 205 at the inclined surface of the first structures 202a is assumed to be D2, and the layer thickness of the first transparent, electrically conductive layer 205 in between the first structure layers is assumed to be D3.

Here, the average arrangement pitch P1, the average height or the average depth H11, the average height or the average depth H12, the aspect ratio (H11/P1), and the aspect ratio (H12/P1) are determined as described below. Initially, the electrically conductive element 211 is cut in such a way as to include the top portion of the first structure 202a, and the resulting cross-section is photographed with a transmission electron microscope (TEM). Thereafter, on the basis of the resulting TEM photograph, the arrangement pitch P201 of the first structures 202a or the second structures 203a, the height or the depth H11 of the first structure 202a, and the height or the depth H12 of the second structure 203a are determined. These measurements are repeated with respect to 10 places selected from the electrically conductive element 211 at random, and measurement values are simply averaged (arithmetically averaged), so as to determine the average arrangement pitch P1, the average height or the average depth H11, and the average height or the average depth H12. Next, these average arrangement pitch P1, average height or the average depth H11, and average height or the average depth H12 are used and, thereby, the aspect ratio (H11/P1) and the aspect ratio (H12/P2) are determined.

The average layer thickness refers to an average value of maximum layer thicknesses and is determined as described below specifically. Initially, the electrically conductive element 211 is cut in such a way as to include the top portion of the first structure 202a. The resulting cross-section is photographed with a transmission electron microscope (TEM). Subsequently, on the basis of the resulting TEM photograph, the layer thickness of the first transparent, electrically conductive layer 205 at the top portion C1 of the first structure 202a is measured. These measurements are repeated with respect to 10 places selected from the electrically conductive element 211 at random, and measurement values are simply averaged (arithmetically averaged), so as to determine the average layer thickness.

The third uneven surface S3 is formed by arranging a large number of third structures 204a with a pitch less than or equal to the wavelength of the visible light. The fourth uneven surface S4 is formed by arranging a large number of fourth structures 202b with a pitch less than or equal to the wavelength of the visible light. The third structures 204a and the fourth structures 202b are disposed at opposite positions in the in-plane direction of the electrically conductive element 211. The third structure 204a and the fourth structure 202b have, for example, a concave or convex shape. For example, one structure of the third structure 204a and the fourth structure 202b is formed into a convex shape, while the other structure is formed into a convex shape. Fig. 58B and Fig. 58C show an example in which the third structure 204a is formed into the convex shape, whereas the fourth structure 202b is formed into the concave shape. For example, the first structures 202a and the second structures 203a are formed at opposite positions in the in-plane direction of the electrically conductive element 201, and the first structures 202a are protruded toward concave portions, which are the second structures 203a. In this regard, the combination of the shapes of the first structures 202a and the second structures 203a is not limited to the above-described example, and it is also possible that both structures are specified to be convex shapes or concave shapes. In the wiring region R1, the aspect ratio (average height or average depth H21/average arrangement pitch P2) of the third structures 204a is preferably 0.2 or more, and 1.3 or less, and more preferably 0.2 or more, and 1.0 or less. The aspect ratio (average height or average depth H22/average arrangement pitch P2) of the fourth structures 202b is preferably 0.2 or more, and 1.3 or less, and more preferably 0.2 or more, and 1.0 or less. In the wiring region R1, the average layer thickness of the second transparent, electrically conductive layer 206 at the top portions of the third structures 204a is preferably 80 nm or less. If 80 nm is exceeded, the reflectance tends to increase. It is preferable that the relationship represented by D1 > D3 > D2 is satisfied, where the layer thickness of the second transparent, electrically conductive layer 206 at the top portion of the third structure 204a is assumed to be D1, the layer thickness of the second transparent, electrically conductive layer 206 at the inclined surface of the third structures 204a is assumed to be D2, and the layer thickness of the second transparent, electrically conductive layer 206 in between the second structures is assumed to be D3.

Here, the average arrangement pitch P2 of the third structures 204a and the fourth structures 202b is determined in the same manner as that for the above-described average arrangement pitch P1 of the first structures 202a or the third structures 203a. Furthermore, the average height or average depth H21 of the third structures 204a and the average height or average depth H22 of the fourth structures 202b are determined in the same manner as that for the above-described average height or average depth H11 of the first structures 202a and the average height or average depth H12 of the second structures 203a. Moreover, the average layer thickness of the second transparent, electrically conductive layer 206 is determined in the same manner as that for the average layer thickness of the first transparent, electrically conductive layer 205.

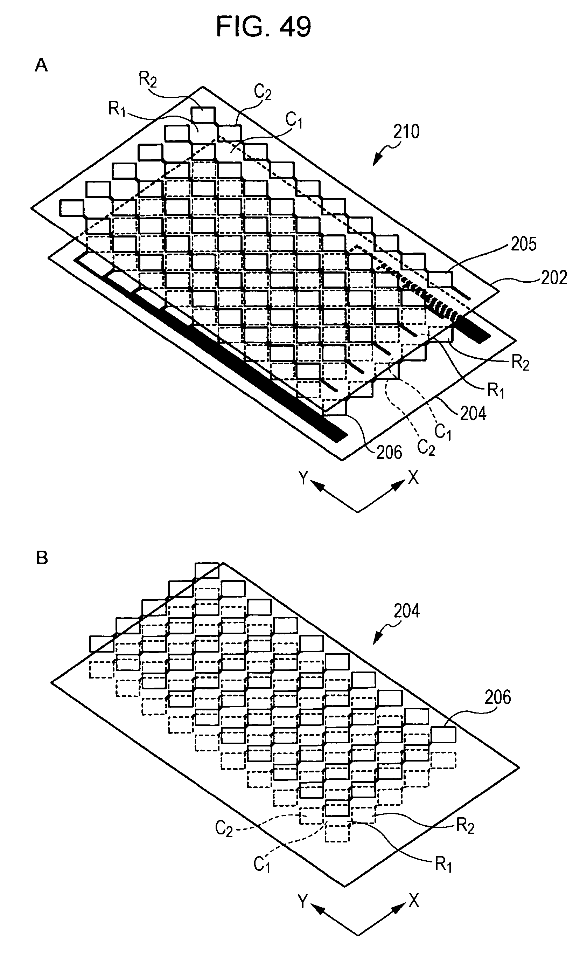

Fig. 49A is a perspective view showing a more specific configuration example of the touch panel according to the thirteenth embodiment of the present invention. This touch panel 210 is a projection type capacitive touch panel of ITO Grid system and is provided with a stacked first base member 204 and a first base member 202.

Fig. 49B is an exploded perspective view showing a configuration example of the first base member. In this regard, the first base member 202 has nearly the same configuration as that of the first base member 204 and, therefore, description of the exploded perspective view is omitted. On one principal surface, which is opposite to the first base member 202, among two principal surfaces of the first base member 204, first regions $R_1$ and second regions $R_2$ are alternately repeatedly set, and the second regions $R_2$ separates adjacent first regions $R_1$ from each other. On one principal surface, which is opposite to the second base member 231, among two principal surfaces of the first base member 202, first regions $R_1$ and second regions $R_2$ are alternately repeatedly set, and the second regions $R_2$ separates adjacent first regions $R_1$ from each other.

The first region $R_1$ of the first base member 204 is formed by coupling unit regions $C_1$ in a predetermined shape to each other in the X axis direction repeatedly, and the second region $R_2$ is formed by coupling unit regions $C_2$ in a predetermined shape to each other in the X axis direction repeatedly. The first region $R_1$ of the first base member 202 is formed by coupling unit regions $C_1$ in a predetermined shape to each other in the Y axis direction repeatedly, and the second region $R_2$ is formed by coupling unit regions $C_2$ in a predetermined shape to each other in the Y axis direction repeatedly. Examples of shapes of the unit region $C_1$ and the unit region $C_2$ include the shape of a diamond (shape of a rhombus), the shape of a triangle, and the shape of a tetragon, although not limited to these shapes.

In the first region $R_1$, for example, structures are arranged in large numbers with an arrangement pitch less than or equal to the wavelength of the visible light, and a transparent, electrically conductive layer is disposed discontinuously in the shape of islands or the like. On the other hand, the second regions $R_2$ is in the shape of a flat surface not provided with a structure and is provided with a transparent, electrically conductive layer continuously. Therefore, a plurality of horizontal (X) electrodes (first electrodes) 206 formed from a transparent, electrically conductive layer are arranged on one principal surface, which is opposite to the first base member 202, of the two principal surfaces of the first base member 204. Furthermore, a plurality of vertical (Y) electrodes (second electrodes) 205 formed from a transparent, electrically conductive layer are arranged on one principal surface, which is opposite to the first base member 204, of the two principal surfaces of the first base member 202. The horizontal electrodes 206 and the vertical electrodes 205 have the same shape as that of the second regions $R_2$.

The horizontal electrodes 206 of the first base member 204 and the vertical electrodes 205 of the first base member 202 are in the relationship of being orthogonal to each other. In the state in which the first base member 204 and the first base member 202 are stacked, the first regions $R_1$ of the first base member 204 and the second regions $R_2$ of the first base member 202 are stacked, and the second regions $R_2$ of the first base member 204 and the first regions $R_1$ of the first base member 202 are stacked.


(First optical layer)


(First example)


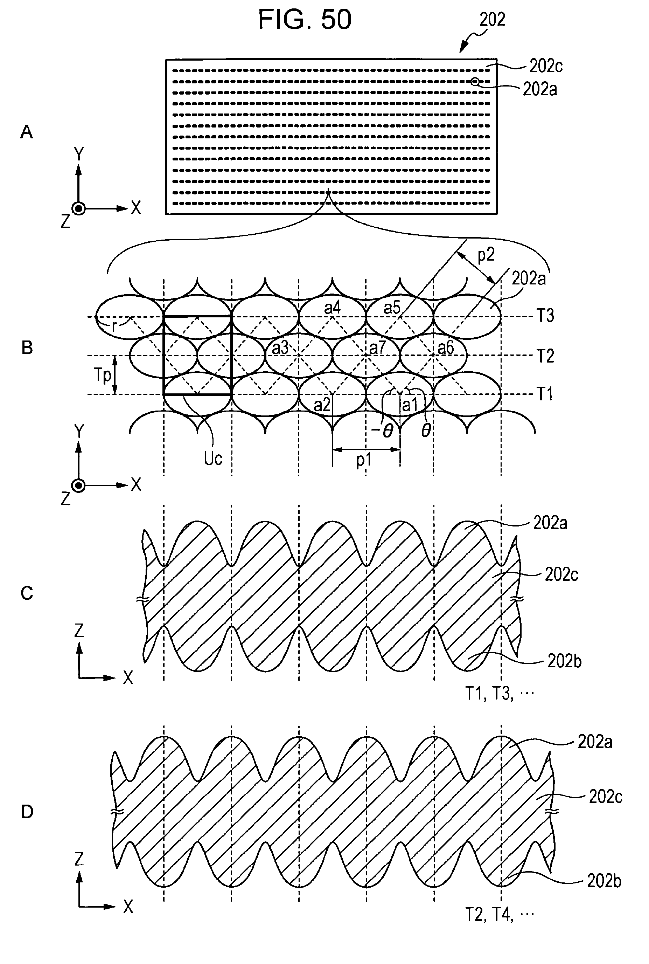

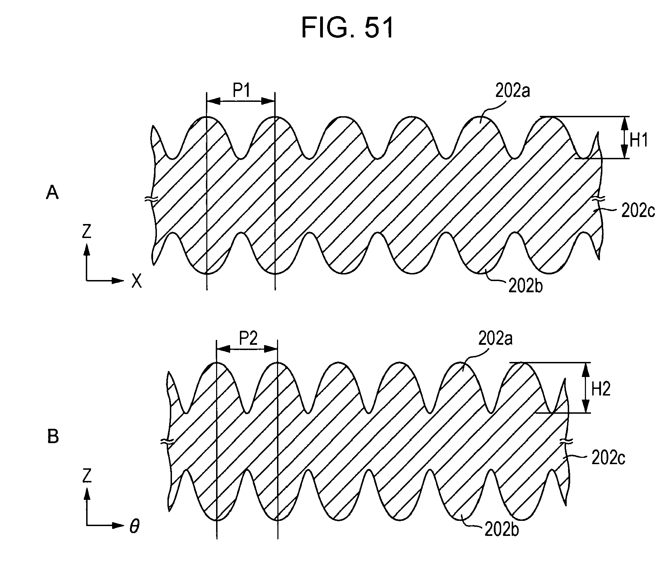

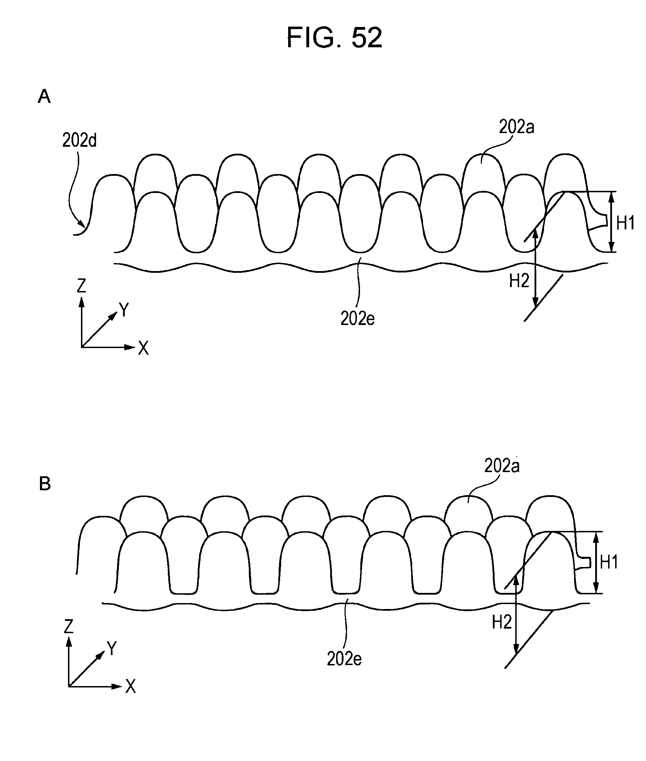

Fig. 50A is a schematic plan view showing an example of the configuration of a first optical layer provided with convex-shaped structures in large numbers on both principal surfaces. Fig. 50B is a magnified plan view illustrating a part of the first optical layer shown in Fig. 50A. Fig. 50C is a sectional view along a track T1, T3, ... shown in Fig. 50B. Fig. 50D is a sectional view along a track T2, T4, ... shown in Fig. 50B. Fig. 51A is a sectional view of the first optical layer shown in Fig. 50B in the track extension direction (X direction(hereafter may be referred to as a track direction appropriately)). Fig. 51B is a sectional view of the first optical layer shown in Fig. 50B in the θ direction. Fig. 52A to Fig. 53B are perspective views illustrating shape examples of structures shown in Fig. 50B.

The first optical layer 202 is provided with a substrate 202c having a first principal surface and a second principal surface, a large number of first structures 202a disposed on the first principal surface, and a large number of second structures 202b disposed on the second principal surface. The first structure 202a and the second structure 202b have, for example, the convex shape.

(Substrate)

The substrate 202c is, for example, a transparent substrate having transparency. Examples of materials for the substrate 202c include plastic materials having transparency and materials containing glass and the like as primary components, although not specifically limited to these materials.

As for the glass, for example, soda lime glass, lead glass, hard glass, quartz glass, and liquid crystal glass (refer to "Kagaku Binran (Handbook of Chemistry)", Pure Chemistry, P. I-537, edited by THE CHEMICAL SOCIETY OF JAPAN) are used. As for the plastic materials, (meth)acrylic resins, e.g., polymethyl methacrylate and copolymers of methyl methacrylate and vinyl monomers, such as, other alkyl (meth)acrylate and styrene; polycarbonate based resins, e.g., polycarbonates and diethylene glycol bis allylcarbonate (CR-39); thermosetting (meth)acrylic resins, e.g., homopolymers or copolymers of (brominated) bisphenol A type di(meth)acrylate and polymers and copolymers of urethane-modified monomer of (brominated) bisphenol A mono(meth)acrylate; polyesters, in particular polyethylene terephthalates, polyethylene naphthalates, and unsaturated polyesters, acrylonitrile-styrene copolymers, polyvinyl chlorides, polyurethanes, epoxy resins, polyacrylates, polyether sulfones, polyether ketones, cycloolefin polymers (trade name: ARTON, ZEONOR), and cycloolefin copolymers are preferable from the viewpoint of optical characteristics, e.g., the transparency, the refractive index, and dispersion, and, in addition, various characteristics, e.g., the impact resistance, the heat resistance, and the durability. Furthermore, aramid based resins in consideration of the heat resistance can also be used.

In the case where the plastic material is used as the substrate 202c, in order to further improve the surface energy, the paintability, the sliding property, the flatness, and the like of the plastic surface, an under coat may be disposed as a surface treatment. Examples of the under coats include organoalkoxy metal compounds, polyesters, acryl-modified polyesters, and polyurethanes. Moreover, in order to obtain the same effect as that of disposition of the under coat, the surface of the substrate 202c may be subjected to corona discharge or a UV irradiation treatment.

In the case where the substrate 202c is a plastic film, the substrate 202c can be obtained by, for example, a method in which the above-described resin is stretched or is diluted with a solvent and, thereafter, is formed into the shape of a film, followed by drying. In this regard, it is preferable that the thickness of the substrate 202c is selected appropriately in accordance with the use of the electrically conductive element 211 and is, for example, about 25 μm to 500 μm.

Examples of shapes of the substrate 202c include the shape of a sheet, the shape of a plate, and the shape of a block, although not specifically limited to these shapes. Here, it is defined that the sheet includes a film.

(Structure)

The first structures 202a having, for example, the convex shape are arranged in large numbers on the first principal surface of the substrate 202c. The first structures 202a having, for example, the convex shape are arranged in large numbers on the second principal surface of the substrate 202c. These first structures 202a and second structures 202b are periodically two-dimensionally arranged with a short average arrangement pitch smaller than or equal to the wavelength band of the light, where reduction in reflection is intended, for example, with the same level of average arrangement pitch as the wavelength of the visible light. The wavelength band of the light, where reduction in reflection is intended, is the wavelength band of ultraviolet light, the wavelength band of visible light, the wavelength band of infrared light, or the like. Here, the wavelength band of ultraviolet light refers to the wavelength band of 10 nm to 360 nm, the wavelength band of visible light refers to the wavelength band of 360 nm to 830 nm, and the wavelength band of infrared light refers to the wavelength band of 830 nm to 1 mm. Specifically, the average arrangement pitch of the first structures 2a is within the range of preferably 100 nm or more, and 320 nm or less, more preferably 100 nm or more, and 320 nm or less, and further preferably 110 nm or more, and 280 nm or less. If the arrangement pitch is less than 180 nm, production of the first structures 202a tends to become difficult. On the other hand, if the arrangement pitch exceeds 350 nm, diffraction of the visible light tends to occur.

The first structures 202a and the second structures 202b are the same except that the formation surfaces of the substrate 202c are different. Therefore, only the first structures 202a will be described below.

The individual first structures 202a of the first optical layer 202 have an arrangement form constituting a plurality of lines of tracks T1, T2, T3, ... (hereafter may be generically referred to as "track T") on the surface of the substrate 202c. In the present invention, the track refers to a portion, in which the first structures 202a are lined up while being aligned into the shape of a straight line. Furthermore, the direction of lines refers to a direction orthogonal to the extension direction of the track (X direction) on a forming surface of the substrate 202c.

The first structures 202a are arranged in such a way that positions in adjacent two tracks T are displaced a half pitch with respect to each other. Specifically, regarding the adjacent two tracks T, first structures 202a of one track (for example, T2) are arranged at midpoint positions (positions displaced a half pitch) of the first structures 202a arranged in the other track (for example, T1). As a result, as shown in Fig. SOB, regarding the adjacent three lines of tracks (T1 to T3), the first structures 202a are arranged in such a way as to form a hexagonal lattice pattern or a quasi-hexagonal lattice pattern, in which the centers of the first structures 202a are located at individual points a1 to a7. In the present embodiment, the hexagonal lattice pattern refers to a lattice pattern in the shape of a regular hexagon.

Furthermore, the quasi-hexagonal lattice pattern is different from the lattice pattern in the shape of a regular hexagon and refers to a hexagonal lattice pattern stretched in an extension direction of the track (X axis direction), so as to distort. Moreover, the structures are not limited to constitute the quasi-hexagonal lattice pattern and the hexagonal lattice pattern, and may constitute other patterns, e.g., a tetragonal lattice pattern and a random uneven surface.

In the case where the first structures 202a are arranged in such a way as to form a quasi-hexagonal lattice pattern, as shown in Fig. 50B, it is preferable that the arrangement pitch p1 (the distance between a1 and a2) of the first structures 202a in the same track (for example, T1) is larger than the arrangement pitch of the first structures 202a in adjacent two tracks (for example, T1 and T2), that is, the arrangement pitch p2 (for example, the distance between a1 and a7, a2 and a7) of the first structures 202a in $\pm\theta$ directions with respect to the extension direction of the track. It becomes possible to further improve the packing density of the first structures 202a by arranging the first structures 202a as described above.

It is preferable that the first structure 202a has the shape of a cone or the shape of a cone, in which the shape of a cone is stretched or contracted in the track direction, from the viewpoint of ease in formation. It is preferable that the first structure 202a has the shape of an axisymmetric cone or the shape of a cone, in which the shape of a cone is stretched or contracted in the track direction. In the case where adjacent first structures 202a are joined, it is preferable that the first structure 202a has the shape of an axisymmetric cone or the shape of a cone, in which the shape of a cone is stretched or contracted in the track direction, except the lower portion joined to the adjacent first structures 202a. Examples of the shapes of a cone can include the shape of a circular cone, the shape of a circular truncated cone, the shape of an elliptical cone, and the shape of an elliptical truncated cone. Here, as described above, the shape of a cone is a concept including the shape of an elliptical cone and the shape of an elliptical truncated cone besides the shape of a circular cone and the shape of a circular truncated cone. In this regard, the shape of a circular truncated cone refers to the shape, in which the top portion of the shape of a circular cone has been cut off, and the shape of an elliptical truncated cone refers to the shape, in which the top portion of the shape of an elliptical cone has been cut off.

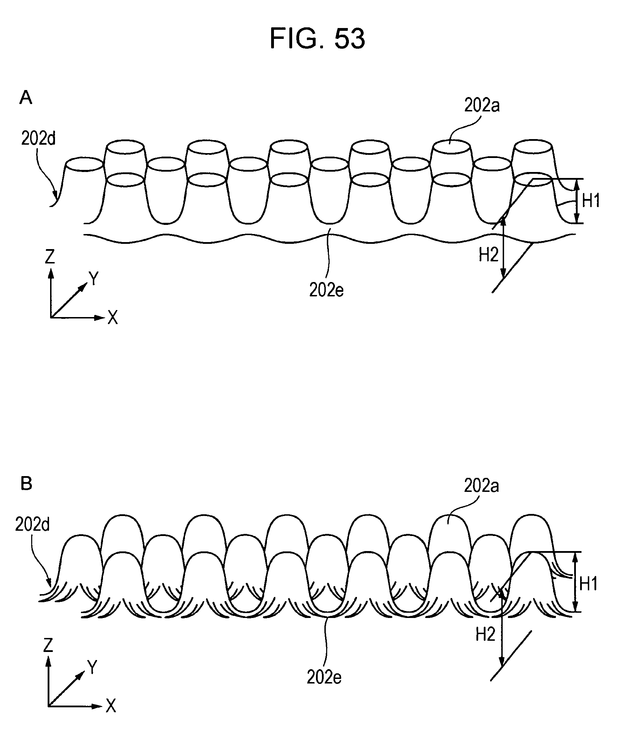

It is preferable that the first structure 202a is in the shape of a cone having a bottom, in which the width in the extension direction of the track is larger than the width in the direction of lines orthogonal to this extension direction. Specifically, as shown in Fig. 52A and Fig. 52B, it is preferable that the first structure 202a has a cone structure in the shape of an elliptical cone, in which the bottom is in the shape of an ellipse, an oval, or an egg having a major axis and a minor axis and the top portion is a curved surface. Alternatively, as shown in Fig. 53A, a cone structure in the shape of an elliptical truncated cone, in which the bottom is in the shape of an ellipse, an oval, or an egg having a major axis and a minor axis and the top portion is flat, is preferable. This is because in the case where the above-described shapes are employed, the filling factor in the direction of lines can be improved.

From the viewpoint of an improvement of the reflection characteristic, the shape of a cone, in which the inclination of the top portion is moderate and the inclination becomes steep gradually from the central portion toward the bottom portion (refer to Fig. 52B) is preferable. Alternatively, from the viewpoint of improvements of the reflection characteristic and the transmission characteristic, a cone shape, in which the inclination of the central portion is steeper than the inclinations of the bottom portion and the top portion (refer to Fig. 52A) or the shape of a cone, in which the top portion is flat (refer to Fig. 52A) is preferable. In the case where the first structure 202a has the shape of an elliptical cone or the elliptical truncated cone, it is preferable that the major axis direction of the bottom thereof becomes parallel to the extension direction of the track. In Fig. 52A to Fig. 53B, the individual first structures 202a have the same shape. However, the shape of the first structure 202a is not limited to this. The first structures 202a in at least two types of shapes may be disposed on the substrate surface. Furthermore, the first structures 202a may be disposed integrally with the substrate 202c.

In addition, as shown in Fig. 52A to Fig. 53B, it is preferable that protruded portions 202d are disposed as a part of or all of the circumference of the first structures 202a. This is because the reflectance can be controlled at a low level by employing the above-described manner even in the case where the filling factor of the first structures 202a is low. Specifically, as shown in Fig. 52A to Fig. 53B, the protruded portions 202d are disposed between adjacent first structures 202a, for example. Alternatively, as shown in Fig. 53B, slender protruded portions 202e may be disposed as all of or a part of the circumference of the first structures 202a. The slender protruded portion 202e is extended, for example, from the top portion of the first structure 202a toward the lower portion. Examples of cross-sectional shapes of the protruded portion 202e can include the shape of a triangle and the shape of a tetragon, although not specifically limited to these shapes. The shape can be selected in consideration of ease of formation and the like. Furthermore, the surfaces of a part of or all of the circumference of the first structures 202a may be roughened, so as to form fine unevenness. Specifically, for example, the surfaces between adjacent first structures 202a may be roughened, so as to form fine unevenness. Alternatively, small holes may be formed in the surfaces, for example, the top portions, of the first structures 202a.

It is preferable that the height H1 of the first structure 202a in the track extension direction is smaller than the height H2 of the first structure 202a in the direction of lines. That is, preferably, the heights H1 and H2 of the first structure 202a satisfy the relationship represented by H1 < H2. This is because if the first structures 202a are arranged in such a way as to satisfy the relationship represented by H1 ≤ H2, it becomes necessary to increase the arrangement pitch P201 in the track extension direction and, thereby, the filling factor of the first structures 202a in the track extension direction is reduced. If the filling factor is reduced as described above, reduction in reflection characteristic is invited.

In this regard, the aspect ratios of the first structures 202a are not always the same in all cases. The individual first structures 202a may be configured to have certain height distribution. The wavelength dependence of the reflection characteristic can be reduced by disposing the first structures 202a having the height distribution. Consequently, the electrically conductive element 211 having an excellent antireflection characteristic can be realized.

Here, the height distribution refers to that the first structures 202a having at least two types of heights (depths) are disposed on the surface of the substrate 202c. That is, it is referred to that the first structures 202a having the height serving as the reference and first structures 202a having the heights different from the height of the above-described first structures 202a are disposed on the surface of the substrate 202c. For example, the first structures 202a having the heights different from the reference are periodically or aperiodically (randomly) disposed on the surface of the substrate 202c. Examples of directions of the periodicity include the extension direction of the track and the direction of lines.

It is preferable that a tail portion 202d is disposed on the circumference portion of the first structure 202a. This is because in the manufacturing step of the electrically conductive element, the first structures 202d can be easily pealed off a mold or the like. Here, the tail portion 202d refers to a protruded portion disposed on the circumference portion of the bottom portion of the first structure 202a. From the viewpoint of the above-described peeling characteristic, it is preferable that the tail portion 202c has a curved surface, the height of which is reduced gradually from the top portion of the first structure 202a toward the lower portion. In this regard, the tail portion 202d may be disposed on merely a part of the circumference portion of the first structure 202a. However, from the viewpoint of improvement in the above-described peeling characteristic, it is preferable that the tail portion 202d is disposed on all circumference portion of the first structure 202a. Furthermore, in the case where the first structure 202a is a concave portion, the tail portion is a curved surface disposed on opening perimeter of the concave portion serving as the first structure 202a.

In the case where the first structures 202a are arranged in such a way as to form a hexagonal lattice pattern or a quasi-hexagonal lattice pattern, the height H of the first structure 202a is assumed to be the height in the direction of lines of the first structures 202a. The height of the first structure 202a in the track extension direction (X direction) is smaller than the height in the direction of lines (Y direction) and the heights of the first structure 202a in portions other than the track extension direction are nearly the same as the height in the direction of lines. Therefore, the height of the sub-wavelength structure is represented by the height in the direction of lines.

The ratio p1/p2 satisfies the relationship represented by preferably 1.00 ≤ p1/p2 ≤ 1.2 or 1.00 < p1/p2 ≤ 1.2, and more preferably 1.00 ≤ p1/p2 s 1.1 or 1.00 < pl/p2 ≤ 1.1, where the arrangement pitch of the first structures 202a in the same track is assumed to be p1 and the arrangement pitch of the first structures 202a between adjacent two tracks is assumed to be p2. In the case where the above-described numerical range is employed, the filling factor of the first structures 202a having the shape of an elliptical cone or an elliptical truncated cone can be improved and, thereby, the antireflection characteristic can be improved.

The filling factor of the first structures 202a on the substrate surface is within the range of 65% or more, preferably 73% or more, and more preferably 86% or more, where the upper limit is 100%. In the case where the filling factor is specified to be within the above-described range, the antireflection characteristic can be improved. In order to improve the filling factor, it is preferable that lower portions of adjacent first structures 202a are mutually joined or distortion is given to the first structures 202a through, for example, adjustment of the ellipticity of the structure bottom.

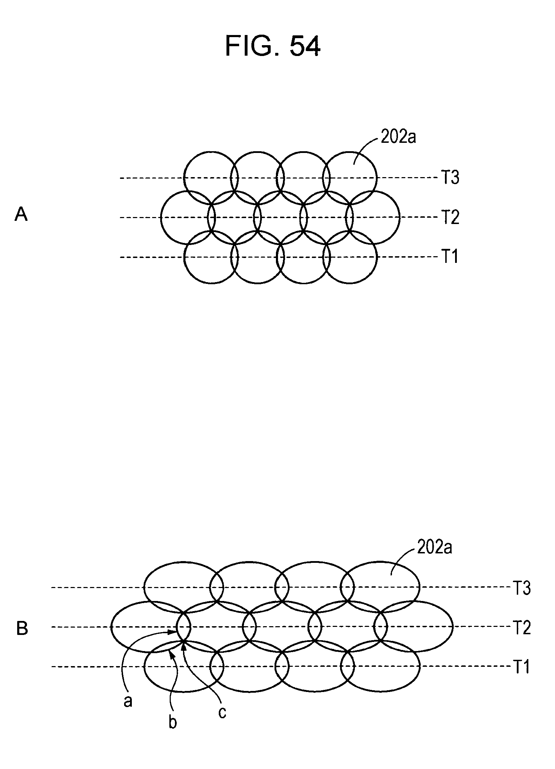

Fig. 54A shows an example of the arrangement of first structures 202a having the shape of a circular cone or the shape of a circular truncated cone. Fig. 54B shows an example of the arrangement of first structures 202a having the shape of an elliptical cone or the shape of an elliptical truncated cone. As shown in Fig. 54A and Fig. 54B, it is preferable that the first structures 202a are joined in such a way that the lower portions thereof are overlapped with each other. Specifically, it is preferable that a lower portion of a first structure 202a is joined to a part of or all of the lower portions of the first structures 202a in the relationship of being adjacent to each other. More specifically, it is preferable that lower portions of the first structures 202a are mutually joined in the track direction, in the θ direction, or in both of those directions. More specifically, it is preferable that lower portions of the first structures 202a are mutually joined in the track direction, in the θ direction, or in both of those directions. In Fig. 54A and Fig. 54B, examples, in which all of the lower portions of the first structures 202a in the relationship of being adjacent to each other are joined, are shown. The filling factor of the first structures 202a can be improved by joining the first structures 202a, as described above. It is preferable that portions one-quarter or less of the first structures, on a maximum value of optical path length in consideration of the refractive index in the wavelength band of the light in a use environment basis, are mutually joined. Consequently, an excellent antireflection characteristic can be obtained.

As shown in Fig. 54B, a first joint portion a is formed by overlapping lower portions of the adjacent first structures 202a in the same track with each other and, in addition, a second joint portion b is formed by overlapping lower portions of the adjacent first structures 202a in adjacent tracks with each other. An intersection portion c is formed at the point of intersection of the first joint portion a and the second joint portion b. The position of the intersection portion c is lower than, for example, the positions of the first joint portion a and the second joint portion b. In the case where lower portions of first structures 202a having the shape of a circular cone or the shape of a circular truncated cone are mutually joined, the heights thereof are reduced in the order of, for example, the joint portion a, the joint portion b, and the intersection portion c.

The ratio ($(2r/p1) \times 100$) of the diameter 2r to the arrangement pitch p1 is 85% or more, preferably 90% or more, and more preferably 95% or more. This is because the filling factor of the first structures 202a is improved and an antireflection characteristic can be improved by employing the above-described range. If the ratio ($(2r/p1) \times 100$) increases and overlapping of the first structures 202a increases excessively, the antireflection characteristic tends to be degraded. Therefore, it is preferable to set the upper limit value of the ratio ($(2r/p1) \times 100$) in such a way that portions one-quarter or less of the maximum value of optical path length in consideration of the refractive index in the wavelength band of the light in a use environment are mutually joined. Here, the arrangement pitch p1 is the arrangement pitch of the first structures 202a in the track direction and the diameter 2r is the diameter of the bottom of the first structure in the track direction. In this regard, in the case where the first structure bottom is in the shape of a circle, the diameter 2r refers to a diameter and in the case where the first structure bottom is in the shape of an ellipse, the diameter 2r refers to a major axis.

(Second example)

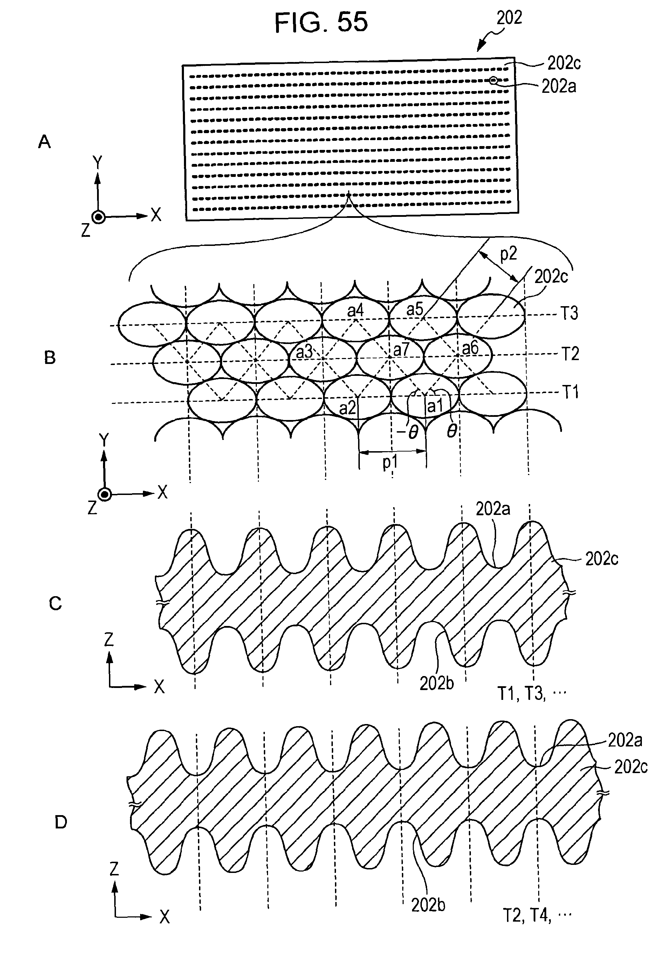

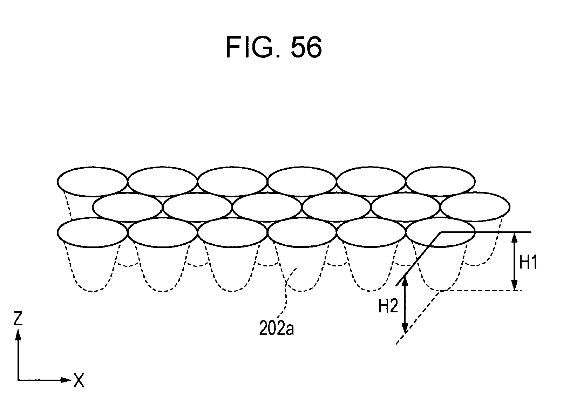

Fig. 55A is a schematic plan view showing an example of the configuration of the first optical layer provided with concave-shaped structures in large numbers on both principal surfaces. Fig. 55B is a magnified plan view illustrating a part of the electrically conductive element shown in Fig. 55A. Fig. 55C is a sectional view along a track T1, T3, ... shown in Fig. 55B. Fig. 55D is a sectional view along a track T2, T4, ... shown in Fig. 55B. Fig. 56 is a magnified perspective view illustrating a part of the electrically conductive element shown in Fig. 55B.

The second configuration example is different from the first configuration example in that the first structure 202a and the second structure 202b are in the concave shape. In the case where the first structure 202a and the second structure 202b are specified to be in the concave shape, as described above, the opening portions (inlet portions of the concave portions) of the first structure 202a and the second structure 202b having the concave shape are defined as lower portions and the lowermost portion (the deepest portion of the concave portion) of the substrate 202c in the depth direction is defined as a top portion. That is, the top portion and the lower portion are defined on the basis of the first structure 202a and the second structure 202b which are unrealistic spaces.

(Transparent, electrically conductive layer)

Examples of materials constituting the first transparent, electrically conductive layer 205 and the second transparent, electrically conductive layer 206 include indium tin oxide (ITO), zinc oxide (ZnO), aluminum-doped zinc oxide (AZO ($Al_2O_3$, ZnO)), SZO, fluorine-doped tin oxide (FTO), tin oxide ($SnO_2$), gallium-doped zinc oxide (GZO), indium zinc oxide (IZO ($In_2O_3$, ZnO)), and metal oxides. In particular, indium tin oxide (ITO) is preferable from the viewpoint of high reliability, low resistivity, and the like. It is preferable that the material constituting the first transparent, electrically conductive layer 205 and the second transparent, electrically conductive layer 206 is in the mixed state of amorphous and polycrystal.

The average layer thickness of the first transparent, electrically conductive layer 205 is preferably 80 nm or less. The average layer thickness of the second transparent, electrically conductive layer 206 is preferably 80 nm or less. In the present specification, the average layer thickness of the first transparent, electrically conductive layer 205 is the average layer thickness of the first transparent, electrically conductive layer 205 at top portions of the first structures 202a, as described above. Furthermore, the average layer thickness of the second transparent, electrically conductive layer 206 is the average layer thickness of the second transparent, electrically conductive layer 206 at top portions of the second structures 203a, as described above.

[Configuration of roll stamper]

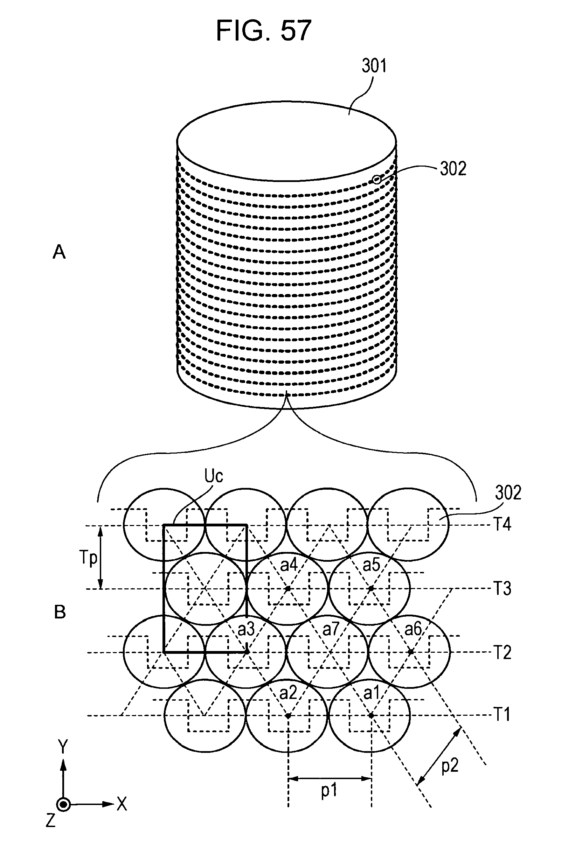

Fig. 57A shows an example of the configuration of a roll stamper for producing the first optical layer having the above-described configuration. Fig. 57B is a magnified perspective view illustrating a part of the roll stamper shown in Fig. 57A. A roll stamper 301 has a configuration, in which, for example, structures 302 formed from concave portions are arranged in large numbers on the roll surface with a pitch smaller than or equal to the wavelength of light, e.g., the visible light. The roll stamper 301 has the shape of a circular column or a circular cylinder. As for the material for the roll stamper 301, for example, glass can be used, although not specifically limited to this material. A roll stamper exposing apparatus, as described later, is used, the two-dimensional patterns are linked spatially, a polarity inversion formatter signal and a rotation controller of a recording apparatus are synchronized to generate a signal on a track basis, and patterning is performed at CAV with an appropriate feed pitch. Consequently, a hexagonal lattice pattern or a quasi-hexagonal lattice pattern can be recorded. A lattice pattern with a uniform spatial frequency is formed in a desired recording region by setting the frequency of the polarity inversion formatter signal and the number of revolutions of the roll appropriately.

[Configuration of exposing apparatus]

Fig. 58 is a schematic diagram showing an example of the configuration of a roll stamper exposing apparatus for producing a roll stamper. This roll stamper exposing apparatus is formed on the basis of an optical disk recording apparatus.

A laser light source 221 is a light source to expose a resist applied as a layer to the surface of the roll stamper 301 serving as a recording medium and is to lase the recording laser light 304 with a wavelength $\lambda = 266$ nm, for example. The laser light 304 emitted from the laser light source 221 moves in a straight line while being in the state of a collimated beam and enters an electro optical modulator (EOM: Electro Optical Modulator) 222. The laser light 304 passed through the electro optical modulator 222 is reflected at a mirror 223, and is led to a modulation optical system 225.

The mirror 223 is formed from a polarizing beam splitter, and has a function of reflecting one polarized component and transmitting the other polarized component. The polarized component passed through the mirror 223 is received with a photodiode 224, and the electro optical modulator 222 is controlled on the basis of the received light signal, so that phase modulation of the laser light 304 is performed.

In the modulation optical system 225, the laser light 304 is condensed on an acoust-optic modulator (AOM: Acoust-Optic Modulator) 227, composed of glass ($SiO_2$) or the like with a condenser lens 226. The laser light 304 is subjected to intensity modulation with the acoust-optic modulator 227, so as to diverge and, thereafter, is converted to a collimated beam with a lens 228. The laser light 304 emitted from the modulation optical system 225 is reflected at a mirror 231 and is led on a moving optical table 232 horizontally and in parallel.

The moving optical table 232 is provided with a beam expander 233 and an objective lens 234. The laser light 304 led to the moving optical table 232 is shaped into a desired beam shape with the beam expander 233 and, thereafter, is applied to the resist layer on the roll stamper 301 through the objective lens 234. The roll stamper 301 is placed on a turn table 236 connected to a spindle motor 235. Then, the laser light 304 is applied to the resist layer intermittently while the roll stamper 301 is rotated and, in addition, the laser light 304 is moved in the height direction of the roll stamper 301, so that an exposure step of the resist layer is performed. The formed latent image takes the shape of nearly an ellipse having a major axis in the circumferential direction. The movement of the laser light 304 is performed by movement of the moving optical table 232 in the direction indicated by an arrow R.

The exposing apparatus is provided with a control mechanism 237 to form a latent image corresponding to the two-dimensional pattern of the hexagonal lattice or the quasi-hexagonal lattice shown in Fig. 57B on the resist layer. The control mechanism 237 is provided with a formatter 229 and a driver 230. The formatter 229 is provided with a polarity inversion portion. This polarity inversion portion controls the application timing of the laser light 304 to the resist layer. The driver 230 receives the output from the polarity inversion portion and controls the acoust-optic modulator 227.

In this roll stamper exposing apparatus, a polarity inversion formatter signal and a rotation controller of the recording apparatus are synchronized to generate a signal and intensity modulation is performed with the acoust-optic modulator 227 on a track basis in such a way that the two-dimensional patterns are linked spatially. The hexagonal lattice or quasi-hexagonal lattice pattern can be recorded by performing patterning at a constant angular velocity (CAV) and the appropriate number of revolutions with an appropriate modulation frequency and an appropriate feed pitch. For example, in order to specify the period in the circumferential direction to be 315 nm and the period in an about 60 degree direction (about -60 degree direction) with respect to the circumferential direction to be 300 nm, it is enough that the feed pitch is specified to be 251 nm (Pythagorean theorem). The frequency of the polarity inversion formatter signal is changed by the number of revolutions of the roll (for example, 1,800 rpm, 900 rpm, 450 rpm, and 225 rpm). For example, the frequencies of the polarity inversion formatter signal corresponding to the number of revolutions of the roll of 1,800 rpm, 900 rpm, 450 rpm, and 225 rpm are 37.70 MHz, 18.85 MHz, 9.34 MHz, and 4.71 MHz, respectively. A quasi-hexagonal lattice pattern with a uniform spatial frequency (circumference 315 nm period, about 60 degree direction (about -60 degree direction) with respect to the circumferential direction 300 nm period) in a desired recording region is obtained by enlarging the beam diameter of the far-ultraviolet laser light by a factor of 5 with the beam expander (BEX) 233 on the moving optical table 232, and applying the laser light to the resist layer on the roll stamper 301 through the objective lens 234 having a numerical aperture (NA) of 0.9, so as to form a fine latent image.

[Method for manufacturing electrically conductive element]

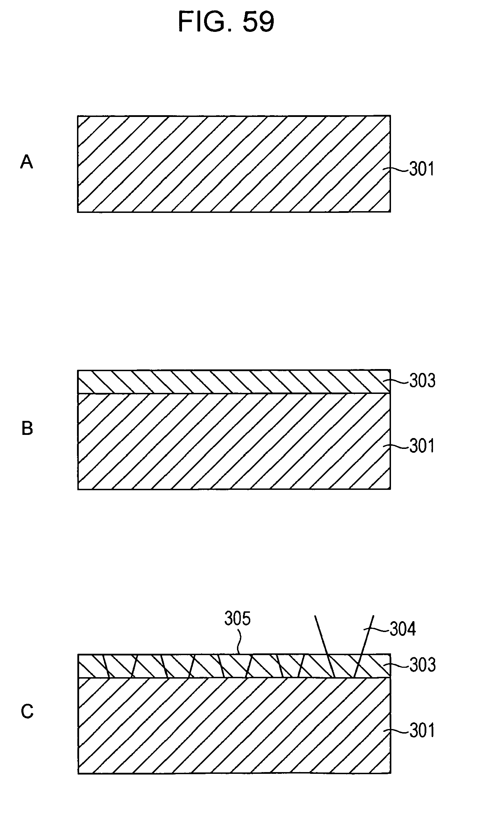

Next, a method for manufacturing the electrically conductive element 211 having the above-described configuration will be described with reference to Fig. 59A to Fig. 61C.

(Resist layer formation step)

Initially, as shown in Fig. 59A, a roll stamper 301 in the shape of a circular column is prepared. This roll stamper 301 is, for example, a glass stamper. Subsequently, as shown in Fig. 59B, a resist layer 303 is formed on the surface of the roll stamper 301. As for the material for the resist layer 303, for example, any one of organic resists and inorganic resists may be used. As for the organic resist, for example, a novolac resist and a chemically amplified resist can be used. Moreover, as for the inorganic resist, for example, a metal compound formed from one type or at least two types of transition metals can be used.

(Exposure step)

Then, as shown in Fig. 59C, the above-described roll stamper exposing apparatus is used, the roll stamper 301 is rotated and, in addition, the laser light (exposure beam) 304 is applied to the resist layer 303. At this time, the laser light 304 is applied intermittently while the laser light 304 is moved in the height direction of the roll stamper 301 (direction parallel to the center axis of the roll stamper 301 in the shape of a circular column or the shape of a circular cylinder) and, thereby, all over the surface of the resist layer 303 is exposed. In this manner, a latent image 305 in accordance with the locus of the laser light 304 is formed all over the resist layer 303 with the same level of pitch as the wavelength of the visible light.
For example, the latent image 305 is arranged in such a way as to constitute a plurality of lines of tracks on the stamper surface and, in addition, form a hexagonal lattice pattern or a quasi-hexagonal lattice pattern. For example, the latent image 305 is in the shape of an ellipse having a major axis direction in the extension direction of the track.

(Development step)

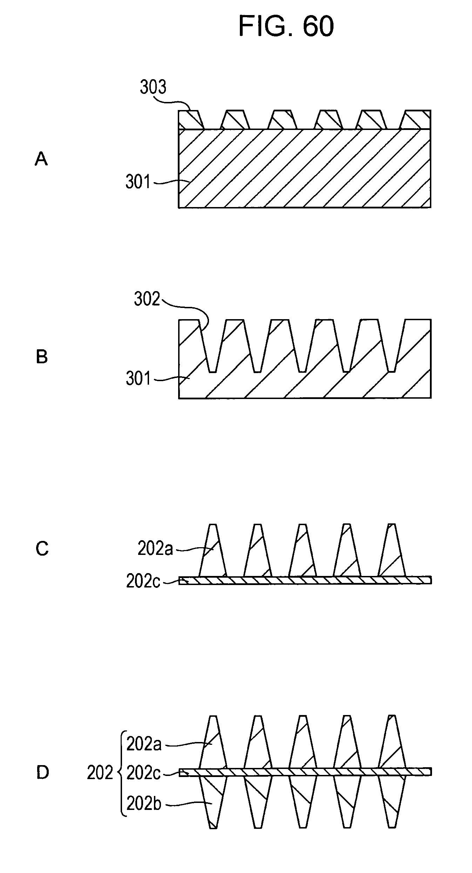

Next, a developing solution is dropped on the resist layer 303 while the roll stamper 301 is rotated, so that the resist layer 303 is subjected to a developing treatment, as shown in Fig. 60A. As shown in the drawing, in the case where the resist layer 303 is formed from a positive type resist, the exposed portion exposed with the laser light 304 has an increased dissolution rate with respect to the developing solution as compared with that of the non-exposed portion. Therefore, a pattern in accordance with the latent image (exposed portion) 305 is formed on the resist layer 303.

(Etching step)

Subsequently, the surface of the roll stamper 301 is subjected to a roll etching treatment while the pattern (resist pattern) of the resist layer 303 formed on the roll stamper 301 serves as a mask. In this manner, as shown in Fig. 60B, concave portions in the shape of an elliptical cone or the shape of an elliptical truncated cone having a major axis direction in the extension direction of the track, that is, structures 302, can be obtained. As for the etching method, for example, dry etching is performed. At this time, for example, a pattern of the structures 302 in the shape of a cone can be formed by performing the etching treatment and an ashing treatment alternately. Furthermore, for example, a roll stamper 301 having a depth 3 times or more of the resist layer 303 (selection ratio of 3 or more) can be produced and, thereby, the aspect ratio of the structure 302 can be increased.
Consequently, for example, the roll stamper 301 having a hexagonal lattice pattern or a quasi-hexagonal lattice pattern in the concave shape having a depth of about 30 nm to about 320 nm is obtained.

(First optical layer formation step)

Then, for example, a transfer paint is applied to one principal surface of the substrate 202c. Thereafter, the roll stamper 301 is pressed against the resulting transfer material and, in addition, the transfer material are cured through irradiation with ultraviolet rays or the like. Subsequently, the substrate 202c is peeled from the roll stamper 301. In this manner, as shown in Fig. 60C, first structures 202a composed of convex portions are formed in large numbers on the one principal surface of the substrate 202c.

Next, for example, a transfer paint is applied to the other principal surface (surface opposite to the side provided with a plurality of structures) of the substrate 202c. Thereafter, the roll stamper 301 is pressed against the resulting transfer material and, in addition, the transfer material are cured through irradiation with ultraviolet rays or the like. Subsequently, the substrate 202c is peeled from the roll stamper 301. In this manner, as shown in Fig. 60D, second structures 202b composed of convex portions are formed in large numbers on the other principal surface of the substrate 202c. In this regard, the order of formation of the first structures 202a and the second structures 202b is not limited to this example. The first structures 202a and the second structures 202b may be formed on both surfaces of the substrate 202c at the same time.

The transfer material is formed from, for example, an ultraviolet curable material and an initiator and contains fillers, functional additives, and the like, as necessary.

The ultraviolet curable material is formed from, for example, a monofunctional monomer, a difunctional monomer, or a polyfunctional monomer and, specifically, is composed of the following materials alone or a plurality of them in combination.

Examples of monofunctional monomers can include carboxylic acids (acrylic acid), hydroxy monomers (2-hydroxyethyl acrylate, 2-hydroxypropyl acrylate, and 4-hydroxybutyl acrylate), alkyl, alicyclic monomers (isobutyl acrylate, t-butyl acrylate, isooctyl acrylate, lauryl acrylate, stearyl acrylate, isobonyl acrylate, and cyclohexyl acrylate), other functional monomers (2-methoxyethyl acrylate, methoxyethylene glycol acrylate, 2-ethoxyethyl acrylate, tetrahydrofurfuryl acrylate, benzyl acrylate, ethylcarbitol acrylate, phenoxyethyl acrylate, N,N-dimethylaminoethyl acrylate, N,N-dimethylaminopropyl acrylamide, N,N-dimethyl acrylamide, acryloyl morpholine, N-isopropyl acrylamide, N,N-diethyl acrylamide, N-vinylpyrrolidone, 2-(perfluorooctyl)ethyl acrylate, 3-perfluorohexyl-2-hydroxypropyl acrylate, 3-perfluorooctyl-2-hydroxypropyl acrylate, 2-(perfluorodecyl) ethyl acrylate, 2-(perfluoro-3-methylbutyl)ethyl acrylate), 2,4,6-tribromophenol acrylate, 2,4,6-tribromophenol methacrylate, 2-(2,4,6-tribromophenoxy)ethyl acrylate), and 2-ethylhexyl acrylate.

Examples of difunctional monomers can include tri(propylene glycol) diacrylate, trimethylolpropane diallyl ether, and urethane acrylate.

Examples of polyfunctional monomers can include trimethylolpropane triacrylate, dipentaerythritol penta and hexaacrylate, and ditrimethylolpropane tetraacrylate.

Examples of initiators can include 2,2-dimethoxy-1,2-diphenylethan-1-one, 1-hydroxy-cyclohexyl phenyl ketone, and 2-hydroxy-2-methyl-1-phenylpropan-1-one.

As for the filler, for example, any of inorganic fine particles and organic fine particles can be used. Examples of inorganic fine particles can include metal oxide fine particles of $SiO_2$, $TiO_2$, $ZrO_2$, $SnO_2$ $Al_2O_3$, and the like.

Examples of functional additives can include leveling agents, surface regulators, and antifoaming agents. Examples of materials for the substrate 202c include methyl methacrylate (co)polymer, polycarbonate, styrene (co)polymer, methyl methacrylate-styrene copolymer, cellulose diacetate, cellulose triacetate, cellulose acetate butyrate, polyester, polyamide, polyimide, polyether sulfone, polysulfone, polypropylene, polymethylpentene, polyvinyl chloride, polyvinyl acetal, polyether ketone, polyurethane, and glass.

The method for molding the substrate 202c is not specifically limited. An injection-molded body, an extruded body, or a cast body may be employed. As necessary, the substrate surface may be subjected to a surface treatment, e.g., a corona treatment.

(Transparent, electrically conductive layer formation step)

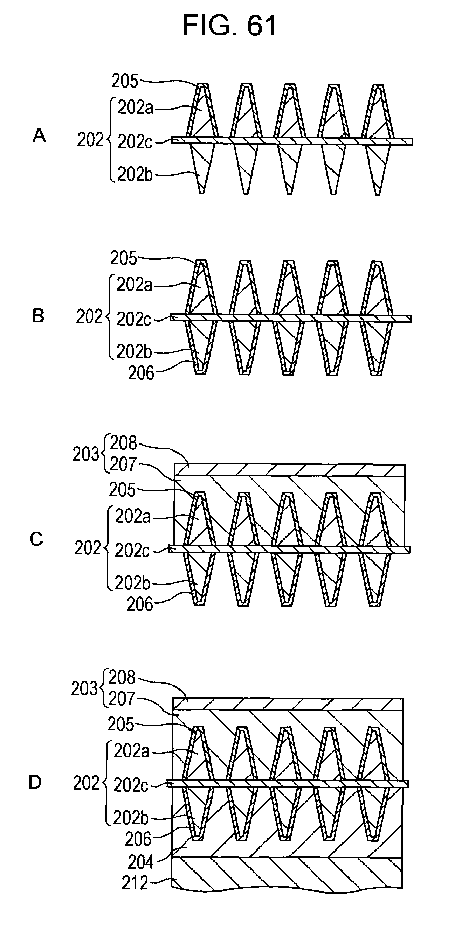

Next, as shown in Fig. 61A, the first transparent, electrically conductive layer 205 is formed on the one principal surface, on which the first structures 202a have been formed in large numbers, of the substrate 202c. Subsequently, as shown in Fig. 61B, the second transparent, electrically conductive layer 206 is formed on the other principal surface, on which the second structures 202b have been formed in large numbers, of the substrate 202c. In formation of the first transparent, electrically conductive layer 205 and/or the second transparent, electrically conductive layer 206, the layer formation may be performed while the substrate 202c is heated. As for a method for forming the first transparent, electrically conductive layer 205 and the second transparent, electrically conductive layer 206, for example, PVD methods (Physical Vapor Deposition (physical vapor deposition method): technology to form a thin layer by aggregating a physically vaporized material on a substrate in a vacuum), e.g., vacuum evaporation, plasma-assisted evaporation, sputtering, and ion plating, can be used besides CVD methods (Chemical Vapor Deposition (chemical vapor deposition method): technology to deposit a thin layer from a gas phase through the use of a chemical reaction), e.g., thermal CVD, plasma CVD, and photo CVD. Then, as necessary, the first transparent, electrically conductive layer 205 and/or the second transparent, electrically conductive layer 206 is subjected to an annealing treatment. Consequently, the first transparent, electrically conductive layer 205 and/or the second transparent, electrically conductive layer 206 comes into the mixed state of, for example, amorphous and polycrystal.

(Transparent, electrically conductive layer patterning step)

Subsequently, the first transparent, electrically conductive layer 205 and the second transparent, electrically conductive layer 206 are patterned through, for example, photoetching and, thereby, a predetermined electrode pattern, e.g., an X electrode and Y electrode pattern, is formed.

(Second optical layer formation step)

Then, an optical sheet 208 is bonded to the uneven surface of the first optical layer 2 provided with the first transparent, electrically conductive layer 205 with a bonding layer 207 formed from an adhesive or the like therebetween. In this manner, as shown in Fig. 61C, a second optical layer 203 is formed on the first transparent, electrically conductive layer of the first optical layer 202.

(Third optical layer formation step)

Next, as necessary, the uneven surface of the first optical layer 202 provided with the second transparent, electrically conductive layer 206 is bonded to a display device 212 with an adhesive or the like therebetween. In this manner, a third optical layer 204 is formed between the uneven surface of the first optical layer 202 and the display device 212.

Consequently, the desired electrically conductive element 211 is obtained.

According to the thirteenth embodiment, the electrically conductive element 211 is provided with the first optical layer 202 having a first uneven surface S1 and a fourth uneven surface S4, the second optical layer 203 having a second uneven surface S2, and the third optical layer 204 having a third uneven surface S3. The first transparent, electrically conductive layer 205 having a predetermined electrode pattern is disposed between the first uneven surface S1 and the second uneven surface S2. The second transparent, electrically conductive layer 206 having a predetermined electrode pattern is disposed between the third uneven surface S3 and the fourth uneven surface S4. In this manner, regarding the first transparent, electrically conductive layer 205 and the second transparent, electrically conductive layer 206, differences in reflectance between portions with the wiring pattern and portions with no wiring pattern can be reduced. Consequently, visual recognition of the wiring patterns can be suppressed. Furthermore, a multilayer optical layer is not used, a nanoimprinting technology is used, and a high-throughput layer configuration is adopted, so that excellent mass productivity and a low cost can be realized.

In the case where the electrically conductive element 211 is produced by using a method based on combination of an optical disk stamper producing process and an etching process, the productivity of the electrically conductive element 211 can be improved and, in addition, it is possible to respond to upsizing of the electrically conductive element 211.

[Modified examples]

(First modified example)

In the above-described thirteenth embodiment, the case where the track has the shape of a straight line is explained. However, the shape of the track is not limited to this example. Although only the track shape of the first structures 202a is explained below, the same track shape can be employed regarding the second structures 202b, the third structures 204a, and the fourth structures 202b.

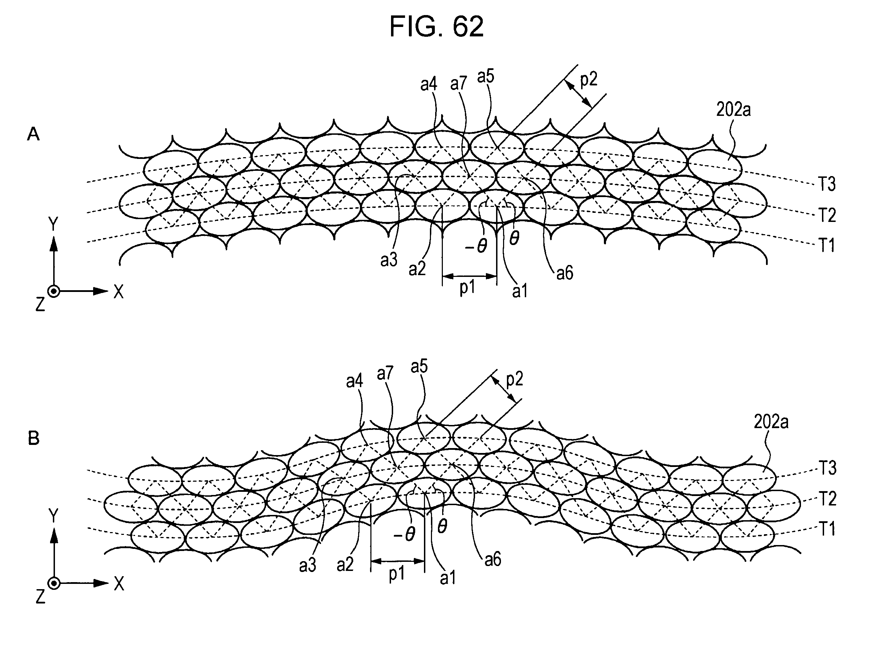

Fig. 62A is a plan view showing a first modified example of tracks of the electrically conductive element according to the thirteenth embodiment. This first example is different from the thirteenth embodiment in that a large number of first structures 202a are arranged in the shape of an arc.

Regarding the adjacent three lines of tracks (T1 to T3), the structures 202a are arranged in such a way as to form a hexagonal lattice pattern or a quasi-hexagonal lattice pattern, in which the centers of the structures 202a are located at individual points a1 to a7.

Fig. 62B is a plan view showing a second modified example of the tracks of the electrically conductive element according to the thirteenth embodiment. This second modified example is different from the thirteenth embodiment in that a large number of first structures 202a are arranged on a meandering track (hereafter referred to as a wobble track). An occurrence of variations in appearance can be suppressed by arranging the first structures 202a on the wobble track as described above. It is preferable that wobbles of the individual tracks on the substrate 202c are synchronized. That is, it is preferable that the wobbles are synchronized wobbles. In the case where the wobbles are synchronized, as described above, the unit lattice shape of a hexagonal lattice or a quasi-hexagonal lattice is maintained and the filling factor can be kept at a high level. Examples of waveforms of the wobble track include a sign wave and a triangular wave. The waveform of the wobble track is not limited to a periodic waveform, but may be an aperiodic waveform. For example, about $\pm 0.1$ $\mu$m is selected as the wobble amplitude of the wobble track.

(Second modified example)

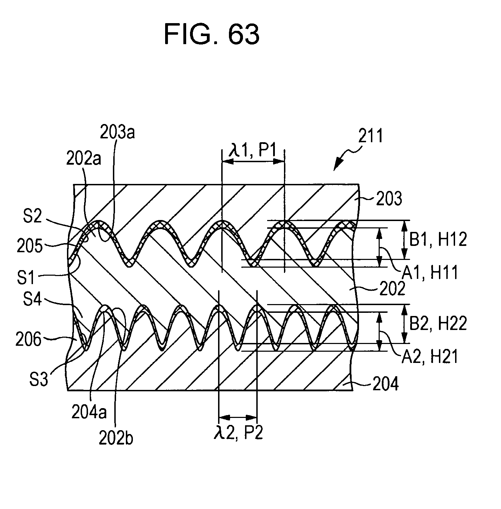

Fig. 63 is a sectional view showing a modified example of a transparent, electrically conductive layer and an uneven shape of the electrically conductive element according to the thirteenth embodiment. The wavefront S1 (or wavefront S2) of the first transparent, electrically conductive layer 205 and the wavefront S3 (or wavefront S4) of the second transparent, electrically conductive layer 206 may not be synchronized with each other in the in-plane direction of the electrically conductive element 211, and the positions, at which vibration becomes a maximum, of the two may be different from each other. That is, the first structures 202a and the second structures 204a may not be disposed at the same position in the in-plane direction of the electrically conductive element 211, but be disposed at different positions. Furthermore, the wavelength $\lambda 1$ of the wavefront S1 of the first transparent, electrically conductive layer 205 and the wavelength $\lambda 2$ of the wavefront S3 of the second transparent, electrically conductive layer 206 are not necessary the same, and the two layers may take on different values. Moreover, the width A1 of vibration of the wavefront S1 of the first transparent, electrically conductive layer 205 and the width A2 of vibration of the wavefront S3 of the second transparent, electrically conductive layer 206 are not necessary the same, and the two layers may take on different values. In addition, likewise, the width B1 of vibration of the wavefront S2 of the first transparent, electrically conductive layer 205 and the width B2 of vibration of the wavefront S4 of the second transparent, electrically conductive layer 206 are not necessary the same, and the two layers may take on different values.

<14. Fourteenth embodiment>

Fig. 64A is a magnified sectional view illustrating a wiring region R1 of an electrically conductive element according to the fourteenth embodiment of the present invention, under magnification. Fig. 64B is a magnified sectional view illustrating a non-wiring region R2 of an electrically conductive element according to the fourteenth embodiment of the present invention, under magnification. In the fourteenth embodiment, the same places as those in the thirteenth embodiment are indicated by the same reference numerals and the explanations will be omitted. A laminate layer 250 composed of the first transparent, electrically conductive layer 205 and a first metal layer 205a is disposed between the first uneven surface S1 and the second uneven surface S2. A laminate layer 260 composed of the second transparent, electrically conductive layer 206 and a second metal layer 206a is disposed between the third uneven surface S3 and the fourth uneven surface S4. Fig. 64A shows a configuration in which both the first metal layer 205a and the second metal layer 206a are disposed. However, a configuration, in which only one of the first metal layer 205a and the second metal layer 206a is disposed, may be employed.

The first laminate layer 250 has a first wavefront S1 and a second wavefront S2 synchronized with each other. In the wiring region R1, the ratio (A1/$\lambda 1$) of the average width A1 of vibration to the average wavelength $\lambda 1$ of the first wavefront S1 is preferably 0.2 or more, and 1.3 or less. If the ratio is less than 0.2, the reflectance tends to increase. If 1.3 is exceeded, the surface resistance tends to become difficult to satisfy a predetermined value. The ratio (B1/$\lambda 1$) of the average width B1 of vibration to the average wavelength $\lambda 1$ of the second wavefront S2 is preferably 0.2 or more, and 1.3 or less. If the ratio is less than 0.2, the reflectance tends to increase. If 1.3 is exceeded, the surface resistance tends to become difficult to satisfy a predetermined value. The average layer thickness of the first transparent, electrically conductive layer 205 is preferably 80 nm or less. If 80 nm is exceeded, the transmittance tends to be degraded.

The second laminate layer 260 has a third wavefront S3 and a fourth wavefront S4 synchronized with each other. The ratio (A2/$\lambda 2$) of the average amplitude A2 to the average wavelength $\lambda 2$ of the third wavefront S3 is 0.2 or more, and 1.3 or less. If the ratio is less than 0.2, the reflectance tends to increase. If 1.3 is exceeded, the surface resistance tends to become difficult to satisfy a predetermined value. The ratio (B2/$\lambda 2$) of the average width B2 of vibration to the average wavelength $\lambda 2$ of the fourth wavefront S4 is preferably 0.2 or more, and 1.3 or less. If the ratio is less than 0.2, the reflectance tends to increase. If 1.3 is exceeded, the surface resistance tends to become difficult to satisfy a predetermined value. The average layer thickness of the second transparent, electrically conductive layer 206 is preferably 80 nm or less. If 80 nm is exceeded, the transmittance tends to be degraded.

In the case where the first metal layer 205a and the second metal layer 206a are disposed, the resistivity can be reduced, and the thicknesses of the first transparent, electrically conductive layer 205 and the second transparent, electrically conductive layer 206 can be reduced. Furthermore, in the case where the electrical conductivity does not reach a sufficient value by only the first transparent, electrically conductive layer 205 or the second transparent, electrically conductive layer 206, the electrical conductivity can be supplemented.

For example, the first metal layer 205a is disposed at the interface between the first structures 202a and the first transparent, electrically conductive layer 205, the interface between the first transparent, electrically conductive layer 205 and the second structures 203a, or both of them. Moreover, the laminate layer is not limited to the two-layer structure. A lamination structure, in which the first transparent, electrically conductive layer 205 and the first metal layer 205a are combined and at least three layers are laminated, may be adopted. For example, a lamination structure, in which two first transparent, electrically conductive layers 205 are laminated with a metal layer 205a therebetween, may be adopted.

For example, the second metal layer 206a is disposed at the interface between the third structures 204a and the second transparent, electrically conductive layer 206, the interface between the second transparent, electrically conductive layer 205 and the fourth structures 202b, or both of them. Moreover, the laminate layer is not limited to the two-layer structure. A lamination structure, in which the second transparent, electrically conductive layer 206 and the second metal layer 206a are combined and at least three layers are laminated, may be adopted. For example, a lamination structure, in which two second transparent, electrically conductive layers 206 are laminated with a metal layer 206a therebetween, may be adopted.

The layer thicknesses of the first metal layer 205a and the second metal layer 206a are not specifically limited and are selected to become, for example, on the order of several nanometers. The first metal layer 205a and the second metal layer 206a have a high electrical conductivity and, therefore, sufficient surface resistance can be obtained with several nanometers of layer thickness. Furthermore, in the case where the layer thickness is on the order of several nanometers, optical influences, e.g., absorption and reflection, due to the first metal layer 205a and the second metal layer 206a are hardly exerted. As for the material constituting the first metal layer 205a and the second metal layer 206a, it is preferable that a metal based material having high electrical conductivity is used. Examples of such materials can include at least one type selected from the group consisting of Ag, Al, Cu, Ti, Au, Pt, and Nb. Among these materials, in consideration of the degree of electrical conductivity, the track record of use, and the like, Ag is preferable. The surface resistance can be ensured by only the first metal layer 205a and the second metal layer 206a. However, in the case where the thickness is very small, the structures of the first metal layer 205a and the second metal layer 206a takes on the shape of islands, and it tends to become difficult to ensure the continuity. In that case, it is preferable that the first metal layer 205a and the second metal layer 206a in the shape of islands are electrically connected by the first transparent, electrically conductive layer 205 and the second transparent, electrically conductive layer 206.

<15. Fifteenth embodiment>

[Configuration of electrically conductive element]

Fig. 65A is a schematic plan view showing an example of the configuration of a first optical layer of an electrically conductive element according to a fifteenth embodiment of the present invention. Fig. 65B is a magnified plan view illustrating a part of the electrically conductive element shown in Fig. 65A. Fig. 65C is a sectional view along a track T1, T3, ⋯ shown in Fig. 65B. Fig. 65D is a sectional view along a track T2, T4, ⋯ shown in Fig. 65B.

An electrically conductive element 211 according to the fifteenth embodiment is different from the electrically conductive element 211 of the thirteenth embodiment in that regarding the adjacent three lines of tracks, the first structures 202a constitute a tetragonal lattice pattern or a quasi-tetragonal lattice pattern. In the present embodiment, the quasi-tetragonal lattice pattern is different from the regular tetragonal lattice pattern and refers to a tetragonal lattice pattern stretched in the extension direction of the track (X direction), so as to distort.

The height or depth of the first structures 202a is not specifically limited and is, for example, about 30 nm to 320 nm. The pitch P2 in a (about) 45 degree direction with respect to the track is, for example, about 100 nm to 300 nm. The aspect ratio (height/arrangement pitch) of the first structures 202a is, for example, about 0.2 to 1.3. Furthermore, the aspect ratios of the first structures 202a are not always the same in all cases. The first structures 202a may be configured to have certain height distribution.

It is preferable that the arrangement pitch p1 of the first structures 202a in the same track is larger than the arrangement pitch p2 of the first structures 202a between adjacent two tracks. Moreover, it is preferable that $p1/p2$ satisfies the relationship represented by $1.4 < p1/p2 \leq 1.5$, where the arrangement pitch of the first structures 202a in the same track is assumed to be $p1$ and the arrangement pitch of the first structures 202a between adjacent two tracks is assumed to be $p2$. In the case where the above-described numerical range is employed, the filling factor of the first structures 202a having the shape of an elliptical cone or an elliptical truncated cone can be improved and, thereby, the antireflection characteristic can be improved. In addition, it is preferable that the height or the depth of the first structures 202a in a 45 degree direction or an about 45 degree direction with respect to the track is smaller than the height or the depth of the first structures 202a in the extension direction of the track.

It is preferable that the height H2 in the arrangement direction of the first structures 202a ($\theta$ direction) slanting with respect to the extension direction of the track is smaller than the height H1 of the first structures 202a in the extension direction of the track. That is, it is preferable that the heights H1 and H2 of the first structures 202a satisfy the relationship represented by H1 > H2. In the case where the first structures 202a are arranged in such a way as to constitute a tetragonal lattice pattern or a quasi-tetragonal lattice pattern, the height H of the first structures 202a is specified to be the height in the extension direction (track direction) of the first structures 202a.

The filling factor of the first structures 202a on the substrate surface is within the range of 65% or more, preferably 73% or more, and more preferably 86% or more, where the upper limit is 100%. In the case where the filling factor is specified to be within the above-described range, the antireflection characteristic can be improved.

The ratio ((2r/p1) $\times$ 100) of the diameter 2r to the arrangement pitch p1 is 64% or more, preferably 69% or more, and more preferably 73% or more. This is because the filling factor of the first structures 202a is improved and the antireflection characteristic can be improved by employing the above-described range. Here, the arrangement pitch p1 is the arrangement pitch of the first structures 202a in the track direction and the diameter 2r is the diameter of the structure bottom in the track direction. In this regard, in the case where the structure bottom is in the shape of a circle, the diameter 2r refers to a diameter and in the case where the structure bottom is in the shape of an ellipse, the diameter 2r refers to a major axis.

<16. Sixteenth embodiment>

Fig. 66A is a schematic plan view showing an example of a first optical layer of an electrically conductive element according to a sixteenth embodiment. Fig. 66B is a magnified plan view illustrating a part of the first optical layer shown in Fig. 66A. In the sixteenth embodiment, the same places as those in the thirteenth embodiment are indicated by the same reference numerals and the explanations will be omitted.

An electrically conductive element according to the sixteenth embodiment is different from the electrically conductive element of the thirteenth embodiment in that a large number of structures 202a having at least two types of sizes and/or shapes are disposed on a substrate surface. The first structures 202a having at least two types of sizes and/or shapes are arranged in such a way that, for example, the first structures 202a having the same shape and/or size are periodically repeated in a track direction or the like. Alternatively, the first structures 202a may be arranged in such a way that the first structures 202a having the same shape and/or size appear on the substrate surface randomly. Alternatively, the shapes of the first structures 202a may be nonuniform. Consequently, diffracted light is suppressed and the visibility is improved.

By the way, in the above-described example, the example in which the first structures 202a are formed having at least two types of sizes and/or shapes is explained. It is also possible that the second structures 203a, the third structures 204a, and the fourth structures 202b are formed having at least two types of sizes and/or shapes. In this regard, all of the first structures 202a, the second structures 203a, the third structures 204a, and the fourth structures 202b are not necessarily formed having at least two types of sizes and/or shapes, but at least one of them can have at least two types of sizes and/or shapes in accordance with desired optical characteristics.

<17. Seventeenth embodiment>

Fig. 67A is a schematic plan view showing an example of the configuration of a first optical layer of an electrically conductive element according to a seventeenth embodiment of the present invention. Fig. 67B is a magnified plan view illustrating a part of the first optical layer shown in Fig. 67A. Fig. 67C is a sectional view along a line C-C shown in Fig. 67B. In the seventeenth embodiment, the same places as those in the thirteenth embodiment are indicated by the same reference numerals and the explanations will be omitted.

An electrically conductive element according to the seventeenth embodiment is different from the electrically conductive element of the thirteenth embodiment in that a large number of first structures 202a are disposed randomly. The first structures 202a arranged on the substrate surface are not limited to have the same size and/or shape, but may have at least two different types of sizes and/or shapes. It is preferable that the first structures 202a are formed at random two-dimensionally or three-dimensionally. Here, the term "being at random two-dimensionally" refers to being at random in an in-plane direction of the electrically conductive layer 211 or the first optical layer 202. Furthermore, the term "being at random three-dimensionally" refers to being at random in an in-plane direction of the electrically conductive layer 211 or the first optical layer 202 and, in addition, being at random in the thickness direction of the electrically conductive layer 211 or the first optical layer 202. In this regard, the shapes of the first structures 202a may be nonuniform. Consequently, diffracted light is suppressed and the visibility is improved.

By the way, in the above-described example, the example in which the first structures 202a are formed at random is explained. It is also possible that the second structures 203a, the third structures 204a, and the fourth structures 202b are formed at random. In this regard, all of the first structures 202a, the second structures 203a, the third structures 204a, and the fourth structures 202b are not necessarily formed at random, but at least one of them can be formed at random in accordance with desired optical characteristics.

<18. Eighteenth embodiment>

Fig. 68 is a sectional view showing an example of the configuration of a touch panel according to an eighteenth embodiment of the present invention. In the eighteenth embodiment, the same places as those in the thirteenth embodiment are indicated by the same reference numerals and the explanations will be omitted. This touch panel (information input device) 400 according to the present eighteenth embodiment is a so-called surface capacitive touch panel and is provided with an electrically conductive element 401. This touch panel 400 is bonded to, for example, the display surface of a display device 212 with a bonding layer 406 formed from an adhesive or the like therebetween. The electrically conductive element 401 is provided with an optical layer 402 and a transparent, electrically conductive layer 403 disposed in this optical layer. The display device 212 is not specifically limited and may be any one of transmissive, transflective, and reflective liquid crystal display devices.
The optical layer 402 is provided with a first optical layer 404 having a first uneven surface S1 and a second optical layer 405 provided with a second uneven surface S2. The first optical layer 404 is provided with, for example, a substrate 202c having both principal surfaces and a large number of structures 202a disposed on one principal surface of the substrate 202b. The second optical layer 405 is a dielectric layer containing a dielectric, e.g., $SiO_2$, as a primary component. For example, the transparent, electrically conductive layer 403 is disposed almost all over the first uneven surface S1 of the first optical layer 404. The transparent, electrically conductive layer 403 has a first wavefront S1 and a second wavefront S2 synchronized with each other. As for the material for the transparent, electrically conductive layer 403, the same materials as those for the first transparent, electrically conductive layer 205 in the first embodiment can be used.

<19. Nineteenth embodiment>

Fig. 69A is a sectional view showing an example of the configuration of a touch panel according to a nineteenth embodiment of the present invention. Fig. 69B is a magnified sectional view illustrating a wiring region shown in Fig. 69A, under magnification. Fig. 69C is a magnified sectional view illustrating a non-wiring region shown in Fig. 69A, under magnification. In the nineteenth embodiment, the same places as those in the eighteenth embodiment are indicated by the same reference numerals and the explanations will be omitted. This touch panel (information input device) 500 is a so-called digital resistive touch panel and is provided with a first electrically conductive element 501, and a second electrically conductive element 502 opposite to this first electrically conductive element 501. The first electrically conductive element 501 and the second electrically conductive element 502 are disposed at a predetermined distance from each other, and an air layer (medium layer) 503 is disposed between the two elements. The first electrically conductive element 501 and the second electrically conductive element 502 are bonded to each other with a bonding portion 504, which is disposed between the perimeter portions thereof, therebetween. As for the bonding portion 504, for example, an adhesive paste and an adhesive tape are used. It is preferable that the touch panel 500 is further provided with a hard coat layer 505 on the surface in the touch side of the first electrically conductive element 501 from the viewpoint of an improvement in scratch resistance. It is preferable that the antifouling property is given to the surface of the hard coat layer 505. It is preferable that the touch panel 500 is further provided with an antireflection layer 507 on the hard coat 505 from the viewpoint of an improvement in display characteristics. Examples of the antireflection layer 507 can include an AR (Anti-Reflection) layer, a LR (Low-reflection) layer, and an AG (Anti-Glare) layer. The configuration to give the antireflection function to the touch panel surface is not limited to this. For example, the antireflection function may be configured to be given to the hard coat layer 505 in itself. This touch panel 500 is bonded to, for example, a display surface of the display device 212 with a bonding layer 506 therebetween. As for the material for the bonding layer 506, for example, adhesives of acryl based, rubber based, silicon based, and the like can be used. From the viewpoint of the transparency, the acrylic adhesives are preferable.
The first electrically conductive element 501 is provided with a first substrate 511 (first optical layer) having a first facing surface S5 opposite to the second electrically conductive element 502 and a first transparent, electrically conductive layer 512 disposed on the facing surface S5 of the first substrate 511. The second electrically conductive element 502 is provided with a second substrate (second optical layer) 521 having a second facing surface S6 opposite to the first electrically conductive element 501 and a second transparent, electrically conductive layer 522 disposed on the facing surface S6 of the second substrate 521. At least one of the facing surface S5 and the facing surface S6 is an uneven surface provided with a large number of first structures with the pitch less than or equal to the wavelength of the visible light. This uneven surface is the same as the first uneven surface S1 or the second uneven surface S4 in the thirteenth embodiment. From the viewpoint of suppression of visual recognition of the wiring patterns, it is preferable that both the facing surface S5 and the facing surface S6 are specified to be uneven surfaces. The first transparent, electrically conductive layer 512 is, for example, an X electrode (first electrode) having a predetermined pattern in the shape of a stripe. The second transparent, electrically conductive layer 522 is, for example, a Y electrode (second electrode) having a predetermined pattern in the shape of a stripe, in the shape of a crosshatch, and the like. These X electrode and Y electrode are arranged in such a way as to become orthogonal to each other, for example.

<20. Twentieth embodiment>

Fig. 70 is a sectional view showing an example of the configuration of a display device according to a twentieth embodiment of the present invention. Fig. 70B is a magnified sectional view illustrating a wiring region shown in Fig. 70A, under magnification. Fig. 70C is a magnified sectional view illustrating a non-wiring region shown in Fig. 70A, under magnification. In the twentieth embodiment, the same places as those in the nineteenth embodiment are indicated by the same reference numerals and the explanations will be omitted. This display device 600 is a so-called microcapsule electrophoretic system electronic paper and is provided with a first electrically conductive element 601, a second electrically conductive element 602 disposed opposite to the first electrically conductive element 601, and a microcapsule layer (medium layer) 603 disposed between the two elements. Here, an example in which the present invention is applied to the microcapsule electrophoretic system electronic paper will be explained. However, the electronic paper is not limited to this example. The present invention can be applied to configurations in which a medium layer is disposed between electrically conductive elements arranged opposite to each other. Here, the medium include gases, e.g., air, besides liquids and solids. Furthermore, the medium may include members, e.g., capsules, pigments, and particles. Examples of electronic paper, to which the present invention can be applied, beside the microcapsule electrophoretic system include twist ball system, thermal rewritable system, toner display system, In-Plane type electrophoretic system, and electronic powder and granular system electronic paper.

The microcapsule layer 603 includes a large number of microcapsules 631. In the microcapsule, a transparent liquid (dispersion medium) in which, for example, black particles and white particles are dispersed, is encapsulated.

The first electrically conductive element 601 is provided with a first substrate 511 (first optical layer) having a first facing surface S5 opposite to the second electrically conductive element 602 and a first transparent, electrically conductive layer 611 disposed on the facing surface S5 of the first substrate 511. Furthermore, as necessary, the first substrate 511 may be bonded to a support 613, e.g., glass, with an bonding layer 612, e.g., an adhesive, therebetween.

The second electrically conductive element 602 is provided with a second substrate (second optical layer) 521 having a second facing surface S6 opposite to the first electrically conductive element 601 and a second transparent, electrically conductive layer 621 disposed on the facing surface S6 of the second substrate 521.

The first transparent, electrically conductive layer 611 and the second transparent, electrically conductive layer 621 are formed into predetermined electrode pattern shapes in accordance with the drive system of the electronic paper 600. Examples of drive systems include a simple matrix drive system, an active matrix drive system, and a segment drive system.

[EXAMPLES]

The present invention will be specifically described below with reference to the examples, although the present invention is not limited to merely these examples.

The examples and test examples according to the present invention will be described in the following order.

1. Optical characteristics of electrically conductive optical sheet
2. Relationship between structure and optical characteristics or surface resistance
3. Relationship between thickness of transparent, electrically conductive layer and optical characteristics or surface resistance
4. Comparisons with low-reflection electrically conductive layers of other systems
5. Relationship between structure and optical characteristics
6. Relationship between shape of transparent, electrically conductive layer and optical characteristics
7. Filling factor and relationship between ratio of diameter and reflection characteristic (simulation)

(Height H, arrangement pitch P, aspect ratio (H/P))

In the following examples, the height H, the arrangement pitch P, and the aspect ratio (H/P) of structures of an electrically conductive optical sheet were determined as described below.

Initially, the surface shape of an optical sheet in the state in which a transparent, electrically conductive layer was not formed was photographed with an atomic force microscope (AFM: Atomic Force Microscope). Subsequently, the arrangement pitch P and the height H of the structures were determined from the resulting AFM image and the cross-sectional profile thereof. Then, the aspect ratio (H/P) was determined by using the resulting arrangement pitch P and height H.

(Average layer thickness of transparent, electrically conductive layer)

In the following examples, the average layer thickness of the transparent, electrically conductive layer was determined as described below.

Initially, the electrically conductive optical sheet was cut in the track extension direction in such a way as to include the top portion of the structure, and the cross-section thereof was photographed with a transmission electron microscope (TEM: Transmission Electron Microscope). The layer thickness D1 of the transparent, electrically conductive layer at the top portion of the structure was measured on the basis of the resulting TEM photograph. These measurements were repeated with respect to 10 places selected from the electrically conductive optical sheet at random, and measurement values were simply averaged (arithmetically averaged), so as to determine the average layer thickness Dm1. The resulting average layer thickness was assumed to be the average layer thickness of the transparent, electrically conductive layer.

Furthermore, the average layer thickness Dm1 of the transparent, electrically conductive layer at the top portion of the structure which was a convex portion, the average layer thickness Dm2 of the transparent, electrically conductive layer at an inclined surface of the structure which was a convex portion, and the average layer thickness Dm3 of the transparent, electrically conductive layer in between the structures, which were convex portions, were determined as described below.

Initially, the electrically conductive optical sheet was cut in the extension direction of the track in such a way as to include the top portion of the structure, and the resulting cross-section was photographed with TEM. Thereafter, on the basis of the resulting TEM photograph, the layer thickness D1 of the transparent, electrically conductive layer at the top portion of the structure was measured. Subsequently, the layer thickness D2 of the position at half the height of the structure (H/2) was measured among the positions of the inclined surface of the structure. Then, the layer thickness D3 of the position, at which the depth of the concave portion was the largest among the positions of the concave portion between the structures, was measured. Next, the measurements of these layer thicknesses D1, D2, and D3 were repeated with respect to 10 places selected from the electrically conductive optical sheet at random, and measurement values D1, D2, and D3 were simply averaged (arithmetically averaged), so as to determine the average layer thicknesses Dm1, Dm2, and Dm3.

Moreover, the average layer thickness Dm1 of the transparent, electrically conductive layer at the top portion of the structure which was a concave portion, the average layer thickness Dm2 of the transparent, electrically conductive layer at an inclined surface of the structure which was a concave portion, and the average layer thickness Dm3 of the transparent, electrically conductive layer in between the structures, which were concave portions, were determined as described below.

Initially, the electrically conductive optical sheet was cut in the extension direction of the track in such a way as to include the top portion of the structure, and the resulting cross-section was photographed with TEM. Thereafter, on the basis of the resulting TEM photograph, the layer thickness D1 of the transparent, electrically conductive layer at the top portion of the structure which was an unrealistic space was measured. Subsequently, the layer thickness D2 of the position at half the depth of the structure (H/2) was measured among the positions of the inclined surface of the structure. Then, the layer thickness D3 of the position, at which the height of the convex portion was the largest among the positions of the convex portion between the structures, was measured. Next, the measurements of these layer thicknesses D1, D2, and D3 were repeated with respect to 10 places selected from the electrically conductive optical sheet at random, and measurement values D1, D2, and D3 were simply averaged (arithmetically averaged), so as to determine the average layer thicknesses Dm1, Dm2, and Dm3.

<1. Optical characteristics of electrically conductive optical sheet>

(Comparative example 1)

Initially, a glass roll stamper having an outside diameter of 126 mm was prepared. A resist layer was formed on the surface of this glass roll stamper in a manner as described below. That is, a photoresist was diluted by a factor of 10 with a thinner. A resist layer having a thickness of about 70 nm was formed by applying the resulting diluted resist to a circular column surface of the glass roll stamper through dipping. Subsequently, the glass roll stamper serving as a recording medium was carried to the roll stamper exposing apparatus shown in Fig. 11, the resist layer was exposed and, thereby, latent images, which were aligned in the shape of a spiral and which constituted a hexagonal lattice pattern between adjacent three lines of tracks, were patterned on the resist layer.

Specifically, laser light with a power of 0.50 mW/m to expose up to the surface of the above-described glass roll stamper was applied to a region to be provided with a hexagonal lattice pattern, so that a hexagonal lattice pattern in the concave shape was formed. In this regard, the thickness of the resist layer in the direction of lines of the tracks was about 100 nm and the resist thickness in the extension direction of the track was about 100 nm.

Subsequently, the resist layer on the glass roll stamper was subjected to a developing treatment, in which development was performed by dissolving the exposed portion of the resist layer. Specifically, an undeveloped glass roll stamper was placed on a turn table of a developing machine, although not shown in the drawing, a developing solution was dropped on the surface of the glass roll stamper while rotation was performed on a turn table basis, so as to develop the resist layer on the surface. In this manner, a resist glass stamper, in which the resist layer had openings in the hexagonal lattice pattern, was obtained.

Then, an etching apparatus was used and plasma etching was performed in a $CHF_3$ gas atmosphere. Consequently, on the surface of the glass roll stamper, etching of only a portion of the hexagonal lattice pattern exposed at the resist layer proceeded, and the other regions were not etched because the resist layer served as a mask, so that concave portions in the shape of an elliptical cone were obtained. The amount of etching (depth) with the pattern at this time was changed on the basis of the etching time. Finally, the resist layer was removed completely through $O_2$ ashing and, thereby, a motheye glass roll master with a hexagonal lattice in the concave shape was obtained. The depth of the concave portion in the direction of lines was larger than the depth of the concave portion in the extension direction of the track.

Next, the above-described motheye glass roll master and an acryl sheet coated with an ultraviolet curable resin were closely adhered, and peeling was performed while ultraviolet rays were applied, so as to cure. In this manner, an optical sheet which had a plurality of structures arranged on one principal surface was obtained. Subsequently, an IZO layer having an average layer thickness of 30 nm was formed on the structures by a sputtering method.

In this manner, a desired electrically conductive optical sheet was produced.

(Comparative example 2)

An electrically conductive optical sheet was produced as in Comparative example 1 except that an IZO layer having an average layer thickness of 160 nm was formed on the structures.

(Comparative example 3)

Initially, an optical sheet which had a plurality of structures arranged on one principal surface was produced as in Comparative example 1. Subsequently, a plurality of structures were formed on the other principal surface of the optical sheet in a manner similar to that of formation of the plurality of structures on the one principal surface. In this manner, an optical sheet which had the plurality of structures arranged on both principal surfaces was produced. Then, an IZO layer having an average layer thickness of 30 nm was formed on the structures of the one principal surface by a sputtering method, so that an optical sheet which had the plurality of structures arranged on both principal surfaces was produced.

(Comparative example 4)

An optical sheet was produced as in Comparative example 1 except that an IZO layer formation step was omitted.

(Comparative example 5)

An IZO layer having an average layer thickness of 30 nm was formed on a smooth acryl sheet surface by a sputtering method and, thereby, an electrically conductive optical sheet was produced.

(Evaluation of shape)

The surface shape of an optical sheet in the state in which an IZO layer was not formed was observed with an atomic force microscope (AFM: Atomic Force Microscope). Subsequently, the height and the like of the structure in each Comparative example were determined on the basis of the cross-sectional profile of AFM. The results thereof are shown in Table 1.

(Evaluation of surface resistance)

The surface resistance of the electrically conductive optical sheet produced as described above was measured by a four-terminal method (JIS K 7194). The results thereof are shown in Table 1.

(Evaluation of reflectance/transmittance)

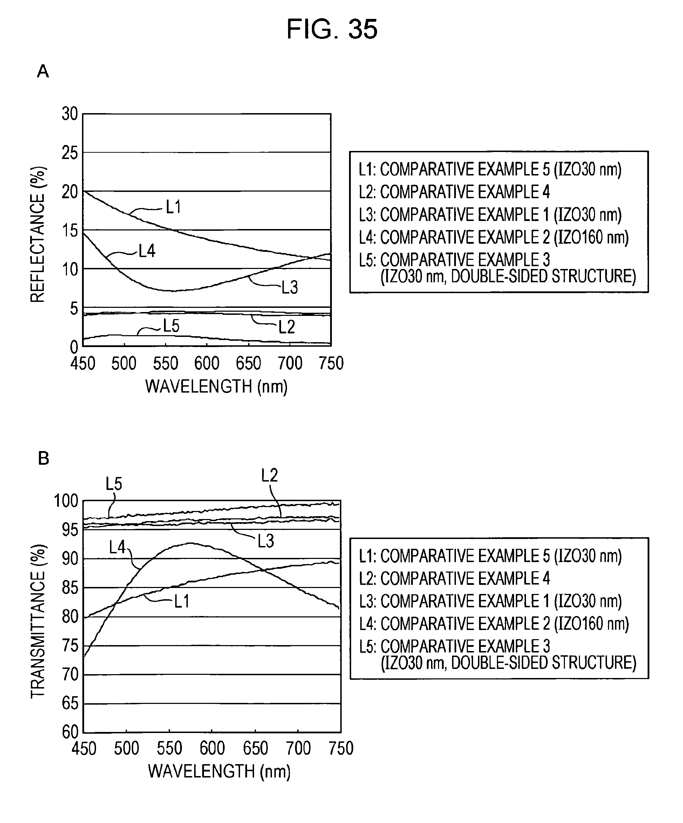

The reflectance and the transmittance of the electrically conductive optical sheet produced as described above were evaluated by using an evaluation apparatus (V-550) of JASCO Corporation. The results thereof are shown in Fig. 35A and Fig. 35B.

[Table 1]

| | Comparative example 1 | Comparative example 2 | Comparative example 3 | Comparative example 4 | Comparative example 5 |
|---|---|---|---|---|---|
| Arrangement pattern | hexagonal lattice | hexagonal lattice | hexagonal lattice | hexagonal lattice | - |
| Shape of structure | circular cone shape | circular cone shape | circular cone shape | circular cone shape | - |
| Unevenness of structure | convex shape | convex shape | convex shape | convex shape | - |
| Formation surface of structure | one surface | one surface | both surfaces | one surface | - |
| Pitch (nm) | 250 | 250 | 250 | 250 | - |
| Height (nm) | 300 | 300 | 300 | 300 | - |
| Aspect ratio | 1.2 | 1.2 | 1.2 | 1.2 | - |
| Average layer thickness (nm) | 30 | 160 | 30 | - | 30 |
| Surface resistance ($\Omega$/□) | 4000 | 2000 | 2000 | _ | 270 |

In this regard, in Table 1, the circular cone shape refers to an elliptical cone shape having a curved surface at the top portion.

The following are clear from the above-described evaluation results.

Regarding Comparative example 2, the surface resistance measured by the four-terminal method (JIS K 7194) resulted in 270 $\Omega$/□. Meanwhile, regarding Comparative example 1 in which the motheye structure was disposed on the surface, when the transparent, electrically conductive layer (IZO layer) having a resistivity of $2.0 \times 10^{-4}$ $\Omega$·cm was formed by 30 nm in terms of a flat plate, the average layer thickness resulted in about 30 nm. The surface resistance at this time was 4,000 $\Omega$/□ even when an increase in surface area was converted, and was at a level that caused no problem in the use as a resistive touch panel.

As shown in Fig. 35A and Fig. 35B, Comparative example 1 holds characteristics standing comparison with the characteristics of Comparative example 4 in which a transparent, electrically conductive layer is not disposed and only the motheye structure is disposed on the surface. Furthermore, regarding Comparative example 1, excellent optical characteristics is obtained as compared with the optical characteristics in Comparative example 4 in which the transparent, electrically conductive layer having the same level of surface resistance is disposed on the smooth sheet.

Regarding Comparative example 2, the transparent, electrically conductive layer (IZO layer) is formed having a thickness of 160 nm in terms of a flat plate (average layer thickness) and, therefore, the transmittance tends to be degraded. The reason for this is believed to be that the transparent, electrically conductive layer was formed having an excessively large thickness, the shape of the motheye structure was distorted and, thereby, maintenance of a desired shape became difficult. That is, if the transparent, electrically conductive layer has an excessively large thickness, it becomes difficult to grow a thin layer while the shape of the motheye structure is maintained. However, even in the case where the shape is not maintained as described above, the optical characteristic is superior to that in Comparative example 2 in which only the transparent, electrically conductive layer is formed on the smooth sheet.

Regarding Comparative example 3 in which the motheye structures are disposed on both surfaces, the antireflection function is improved as compared with that in Comparative example 1 in which the motheye structure is disposed on one surface. As is clear from Fig. 35B, a characteristic exhibiting a very high transmittance of 97% to 99% was realized.

<2. Relationship between structure and optical characteristics or surface resistance>

(Comparative examples 6 and 7, Example 1)

A hexagonal lattice pattern was recorded on a resist layer by adjusting the frequency of a polarity inversion formatter signal, the number of revolutions of a roll, and a feed pitch on a track basis and patterning the resist layer. An electrically conductive optical sheet was produced as in Comparative example 1 except those described above.

(Example 2)

An electrically conductive optical sheet provided with a plurality of structures having the concave shape (reverse pattern structures) on the surface was produced as in Comparative example 1 except that concave and convection relations in Example 1 was reversed.

(Comparative example 8)

An optical sheet was produced as in Comparative example 6 except that formation of an IZO layer was omitted.

(Comparative example 9)

An optical sheet was produced as in Example 1 except that formation of an IZO layer was omitted.

(Comparative example 10)

An IZO layer having an average layer thickness of 40 nm was formed on a smooth acryl sheet surface by a sputtering method and, thereby, an electrically conductive optical sheet was produced.

(Evaluation of shape)

The surface shape of an optical sheet in the state in which an IZO layer was not formed was observed with an atomic force microscope (AFM: Atomic Force Microscope). Subsequently, the height and the like of the structure in each Example and each Comparative example were determined on the basis of the cross-sectional profile of AFM. The results thereof are shown in Table 2.

(Evaluation of surface resistance)

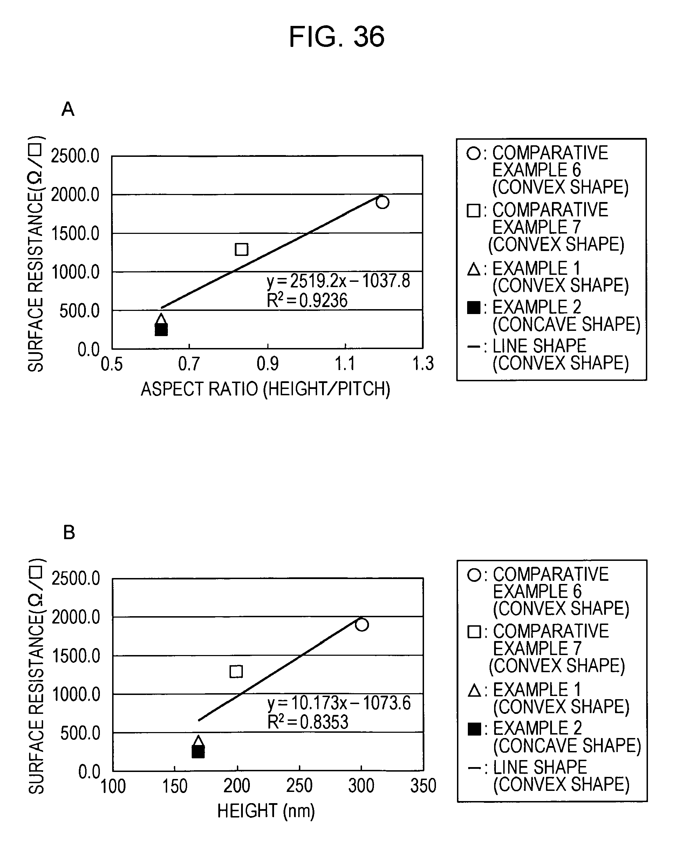

The surface resistance of the electrically conductive optical sheet produced as described above was measured by a four-terminal method. The results thereof are shown in Table 2. Furthermore, Fig. 36A shows the relationship between the aspect ratio and the surface resistance. Fig. 36B shows the relationship between the height of the structure and the surface resistance.

(Evaluation of reflectance/transmittance)

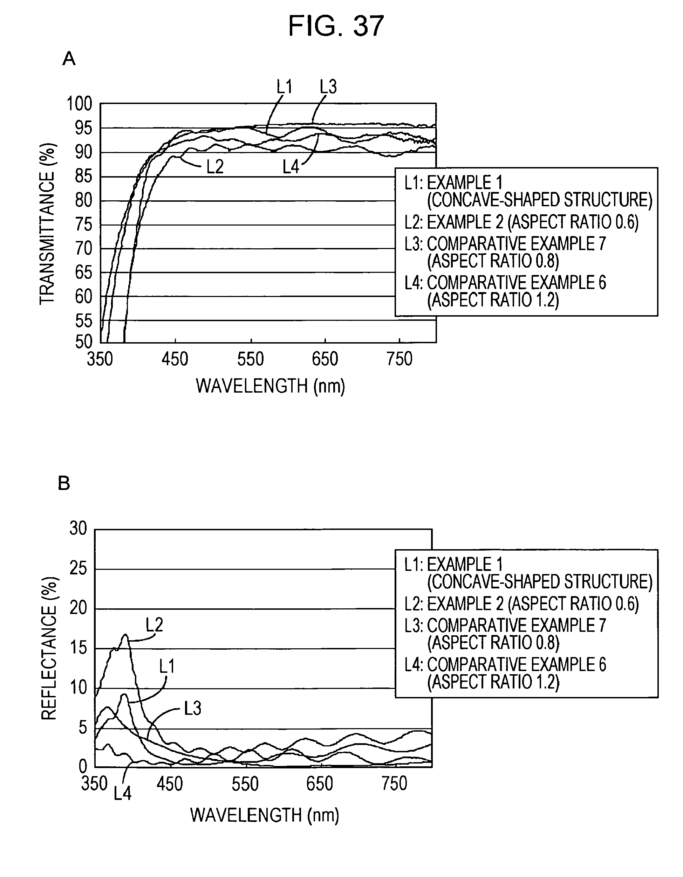

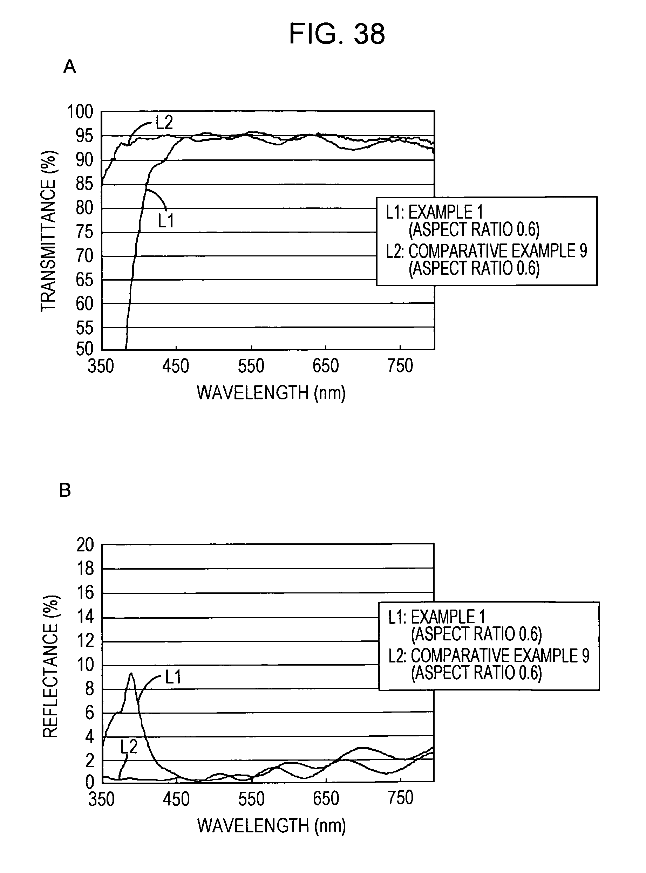

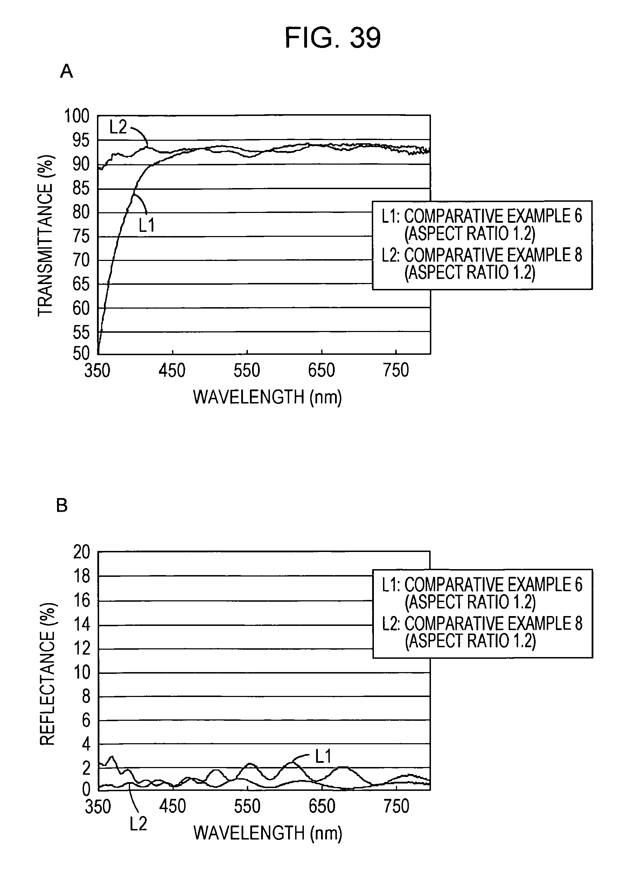

The reflectance and the transmittance of the electrically conductive optical sheet produced as described above were evaluated by using an evaluation apparatus (V-550) of JASCO Corporation. The results thereof are shown in Fig. 37A and Fig. 37B. Moreover, Fig. 38A and Fig. 38B show the transmission characteristics and the reflection characteristics in Example 1 and Comparative example 9. Fig. 39A and Fig. 39B show the transmission characteristics and the reflection characteristics in Comparative example 6 and Comparative example 8.

[Table 2]

| | Comparative example 6 | Comparative example 7 | Example 1 | Example 2 | Comparative example 8 | Comparative example 9 | Comparative example 10 |
|---|---|---|---|---|---|---|---|
| Arrangement pattern | hexagonal lattice | hexagonal lattice | hexagonal lattice | hexagonal lattice | hexagonal lattice | hexagonal lattice | - |
| Shape of structure | circular cone shape | circular cone shape | circular cone shape | circular cone shape | circular cone shape | circular cone shape | - |
| Unevenness of structure | convex shape | convex shape | convex shape | concave shape | convex shape | convex shape | - |
| Formation surface of structure | one surface | one surface | one surface | one surface | one surface | one surface | - |
| Pitch (nm) | 250 | 240 | 270 | 270 | 250 | 270 | - |
| Height (nm) | 300 | 200 | 170 | 170 | 300 | 170 | - |
| Aspect ratio | 1.2 | 0.8 | 0.6 | 0.6 | 1.2 | 0.6 | - |
| Average layer thickness (nm) | 40 | 40 | 40 | 40 | - | - | 40 |
| Surface resistance ($\Omega/\square$) | 1900.0 | 1300.0 | 395.0 | 269.0 | - | - | 122.0 |

In this regard, in Table 2, the circular cone shape refers to an elliptical cone shape having a curved surface at the top portion.

The following are clear from Fig. 36A and Fig. 36B.

There is a correlation between the aspect ratio and the surface resistance of the structure, and there is a tendency of the surface resistance to increase nearly in proportion to the value of the aspect ratio. The reason for this is believed to be that as the slope of the structure becomes steep, the average layer thickness of the transparent, electrically conductive layer is reduced or as the height of the structure increases or the depth increases, the surface area increases and, thereby, the resistance increases.

In general, the touch panel is required to have a surface resistance of 500 to 300 $\Omega/\square$. Therefore, in the case where the present invention is applied to the touch panel, it is preferable that a desired resistance value is obtained by adjusting the aspect ratio appropriately.

The following are clear from Fig. 37A, Fig. 37B, Fig. 38A, and Fig. 38B.

The transmittance tends to be reduced in the side of wavelength smaller than the wavelength of 450 nm, but excellent transmission characteristic is obtained within the range of wavelength of 450 nm to 800 nm. Furthermore, as the structure has a higher aspect ratio, a reduction in transmittance in the smaller wavelength side can be suppressed.

The reflectance also tends to be reduced in the side of wavelength smaller than the wavelength of 450 nm, but excellent reflection characteristic is obtained within the range of wavelength of 450 nm to 800 nm. Furthermore, as the structure has a higher aspect ratio, an increase in reflectance in the smaller wavelength side can be suppressed.

Regarding Example 1 in which the convex-shaped structures are disposed, the optical characteristic is superior to that in Example 2 in which the concave-shaped structures are disposed.

The following are clear from Fig. 39A and Fig. 39B.

Regarding Comparative example 6 in which the aspect ratio is 1.2, changes in optical characteristics are reduced to low levels as compared with those in Example 1 in which the aspect ratio is 0.6. The reason for this is believed to be that regarding Comparative example 6 in which the aspect ratio is 1.2, the surface area is large and the average layer thickness of the transparent, electrically conductive layer on the structures is small as compared with those in Example 1 in which the aspect ratio is 0.6.

<3. Relationship between thickness of transparent, electrically conductive layer and optical characteristics or surface resistance>

(Example 3)

An electrically conductive optical sheet was produced as in Example 1 except that the average layer thickness of an IZO layer was specified to be 50 nm.

(Example 4)

An electrically conductive optical sheet was produced as in Example 1.

(Comparative example 11)

An electrically conductive optical sheet was produced as in Example 1 except that the average layer thickness of an IZO layer was specified to be 30 nm.

(Comparative example 12)

An electrically conductive optical sheet was produced as in Example 1 except that formation of an IZO layer was omitted.

(Evaluation of shape)

The surface shape of an optical sheet in the state in which an IZO layer was not formed was observed with an atomic force microscope (AFM: Atomic Force Microscope). Subsequently, the height and the like of the structure in each Example and each Comparative example were determined on the basis of the cross-sectional profile of AFM. The results thereof are shown in Table 3.

(Evaluation of surface resistance)

The surface resistance of the electrically conductive optical sheet produced as described above was measured by a four-terminal method (JIS K 7194). The results thereof are shown in Table 3.

(Evaluation of reflectance/transmittance)

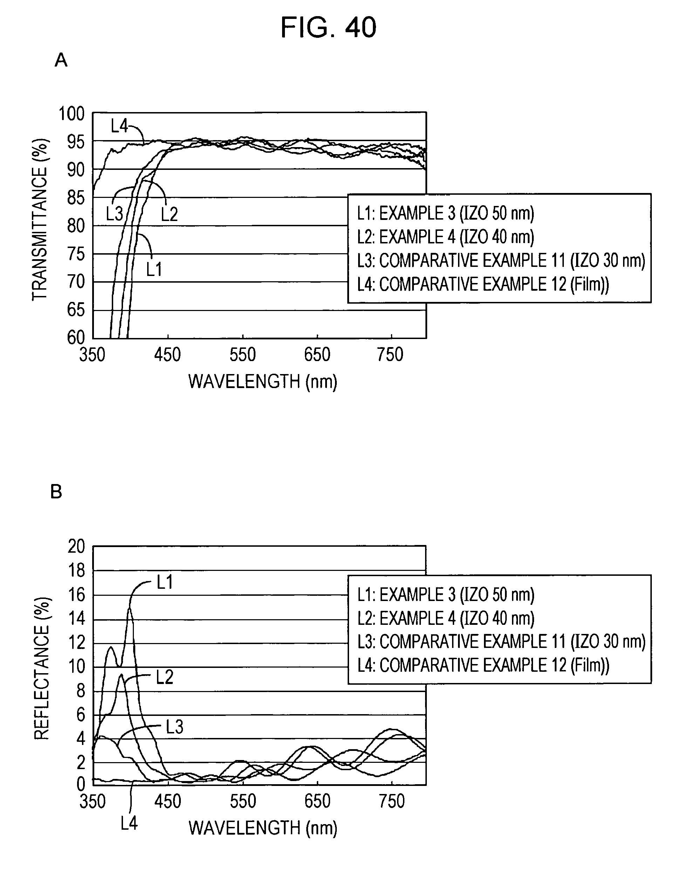

The reflectance and the transmittance of the electrically conductive optical sheet produced as described above were evaluated by using an evaluation apparatus (V-550) of JASCO Corporation. The results thereof are shown in Fig. 40A and Fig. 40B.

[Table 3]

|  | Example 3 | Example 4 | Comparative example 11 | Comparative example 12 |
|---|---|---|---|---|
| Arrangement pattern | hexagonal lattice | hexagonal lattice | hexagonal lattice | hexagonal lattice |
| Shape of structure | circular cone shape | circular cone shape | circular cone shape | circular cone shape |
| Unevenness of structure | convex shape | convex shape | convex shape | convex shape |
| Formation surface of structure | one surface | one surface | one surface | one surface |
| Pitch (nm) | 270 | 270 | 270 | 270 |
| Height (nm) | 170 | 170 | 170 | 170 |
| Aspect ratio | 0.6 | 0.6 | 0.6 | 0.6 |
| Average layer thickness (nm) | 50 | 40 | 30 | - |
| Surface resistance ($\Omega/\square$) | 270(77) | 395(122) | 590(169) | - |

In this regard, in Table 3, the circular cone shape refers to an elliptical cone shape having a curved surface at the top portion.

By the way, the resistance value described in "()" is a value obtained by forming an IZO layer on a smooth sheet under the same layer formation condition and measuring the resistance value of the resulting IZO layer.

The following are clear from Fig. 40A and Fig. 40B.

As the average layer thickness increases, the reflectance and the transmittance tend to be reduced in the side of wavelength smaller than the wavelength of 450 nm.

The following are clear after considering all the evaluation results in the items <2. Relationship between structure and optical characteristics or surface resistance> and <3. Relationship between thickness of transparent, electrically conductive layer and optical characteristics or surface resistance>.

The optical characteristics in the long wavelength side are hardly changed between before and after the formation of the transparent, electrically conductive layer on the structures, whereas the optical characteristics in the small wavelength side tend to be changed.

In the case where the structures are specified to be in the shape having a high aspect ratio, the optical characteristics are good, but the surface resistance tends to increase.

If the thickness of the transparent, electrically conductive layer increases, the reflectance in the small wavelength side tends to increase.

The surface resistance and the optical characteristics are in the relationship of being traded off with each other.

<4. Comparisons with low-reflection electrically conductive layers of other systems>

(Comparative example 13)

An electrically conductive optical sheet was produced as in Comparative example 7.

(Example 5)

An electrically conductive optical sheet was produced as in Example 1 except that the average layer thickness of an IZO layer was specified to be 30 nm.

(Comparative example 14)

An IZO layer having an average layer thickness of 30 nm was formed on a smooth acryl sheet surface by a sputtering method and, thereby, an electrically conductive optical sheet was produced.

(Comparative example 15)

An optical layer having N = about 2.0 was formed on a film, an optical layer having about 1.5 was formed thereon, and an electrically conductive layer was further formed thereon sequentially by a PVD method.

(Comparative example 16)

An optical layer having N = about 2.0 and four layers of optical layers having N = about 1.5 were laminated on a film, and an electrically conductive layer was formed thereon sequentially by a PVD method.

(Evaluation of shape)

The surface shape of an optical sheet in the state in which an IZO layer was not formed was observed with an atomic force microscope (AFM: Atomic Force Microscope). Subsequently, the height and the like of the structure in each Example and each Comparative example were determined on the basis of the cross-sectional profile of AFM. The results thereof are shown in Table 4.

(Evaluation of reflectance/transmittance)

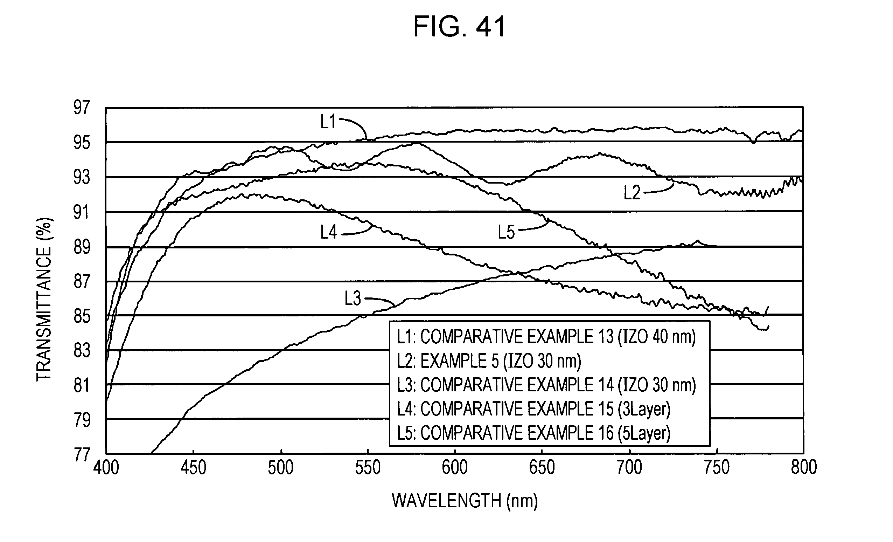

The transmittance of the electrically conductive optical sheet produced as described above were evaluated by using an evaluation apparatus (V-550) of JASCO Corporation. The results thereof are shown in Fig. 41.

[Table 4]

|  | Comparative example 13 | Example 5 | Comparative example 14 | Comparative example 15 | Comparative example 16 |
|---|---|---|---|---|---|
| Arrangement pattern | hexagonal lattice | hexagonal lattice | - | - | - |
| Shape of structure | circular cone shape | circular cone shape | - | - | - |
| Unevenness of structure | convex shape | convex shape | - | - | - |
| Formation surface of structure | one surface | one surface | - | - | - |
| Pitch (nm) | 240 | 270 | - | - | - |
| Height (nm) | 200 | 170 | - | - | - |
| Aspect ratio | 0.8 | 0.6 | - | - | - |
| Average layer thickness (nm) | 40 | 30 | - | - | - |
| Surface resistance (Ω/□) | 1300.0 | 300 | 250 | 400 | 500 |

In this regard, in Table 4, the circular cone shape refers to an elliptical cone shape having a curved surface at the top portion.

The following are clear from Fig. 41.

Comparative example 13 and Example 5, in which the transparent, electrically conductive layer was disposed on the structures, had excellent transmission characteristics in the wavelength band of 400 nm to 800 nm as compared with that in Comparative example 14 in which the transparent, electrically conductive layer was disposed on the smooth sheet.

Regarding Comparative examples 15 and 16, in which multilayers were laminated, excellent transmission characteristics were exhibited at a wavelength of up to about 500 nm. However, in the whole wavelength band of 400 nm to 800 nm, Comparative example 13 and Example 5, in which the transparent, electrically conductive layer was disposed on the structures, were superior to Comparative examples 15 and 16 in which multilayers were laminated.

<5. Relationship between structure and optical characteristics>

(Comparative example 17)

A hexagonal lattice pattern was recorded on a resist layer by adjusting the frequency of a polarity inversion formatter signal, the number of revolutions of a roll, and a feed pitch on a track basis and patterning the resist layer. An IZO layer having an average layer thickness of 20 nm was formed on structures. An optical sheet was produced as in Comparative example 1 except those described above.

(Comparative example 18)

A hexagonal lattice pattern was recorded on a resist layer by adjusting the frequency of a polarity inversion formatter signal, the number of revolutions of a roll, and a feed pitch on a track basis and patterning the resist layer. An optical sheet was produced as in Comparative example 1 except those described above.

(Evaluation of shape)

The surface shape of an optical sheet in the state in which an IZO layer was not formed was observed with an atomic force microscope (AFM: Atomic Force Microscope). Subsequently, the height and the like of the structure in each Example and each Comparative example were determined on the basis of the cross-sectional profile of AFM. The results thereof are shown in Table 5.

(Evaluation of surface resistance)

The surface resistance of the electrically conductive optical sheet produced as described above was measured by a four-terminal method (JIS K 7194). The results thereof are shown in Table 5.

(Evaluation of reflectance/transmittance)

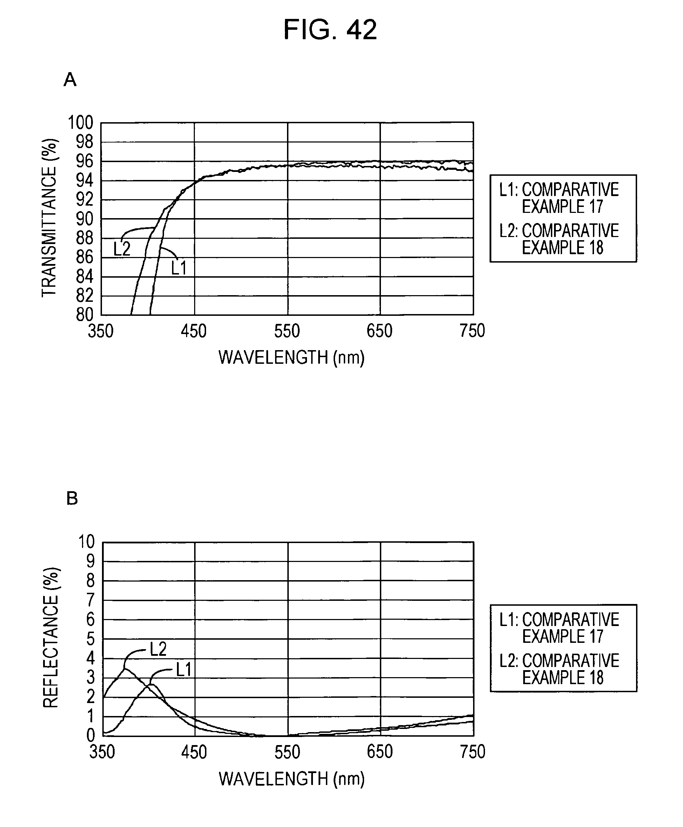

The reflectance and the transmittance of the electrically conductive optical sheet produced as described above were evaluated by using an evaluation apparatus (V-550) of JASCO Corporation. The results thereof are shown in Fig. 42A and Fig. 42B.

[Table 5]

| | Comparative example 17 | Comparative example 18 |
|---|---|---|
| Arrangement pattern | hexagonal lattice | hexagonal lattice |
| Shape of structure | circular cone shape | circular cone shape |
| Unevenness of structure | convex shape | convex shape |
| Formation surface of structure | one surface | one surface |
| Pitch (nm) | 300 | 240 |
| Height (nm) | 200 | 200 |
| Aspect ratio | 0.67 | 0.83 |

(continued)

|  | Comparative example 17 | Comparative example 18 |
| --- | --- | --- |
| Average layer thickness (nm) | 20 | 30 |
| Surface resistance ($\Omega/\square$) | 550 | 550 |

In this regard, in Table 5, the circular cone shape refers to an elliptical cone shape having a curved surface at the top portion.

The following are clear from Fig. 42A and Fig. 42B.

Degradation in optical characteristics in the side of the wavelength smaller than 450 nm can be improved by reducing the aspect ratio. It is estimated that the absorption characteristic is improved because the transmission characteristic is improved to a greater extent.

<6. Relationship between shape of transparent, electrically conductive layer and optical characteristics>

(Comparative example 19)

An electrically conductive optical sheet was produced as in Comparative example 18 except that the average layer thickness of an IZO layer was specified to be 30 nm.

(Comparative example 20)

An optical sheet was produced as in Comparative example 19 except that formation of an IZO layer was omitted.

(Example 6)

An electrically conductive optical sheet was produced as in Example 5 except that the average layer thickness of an IZO layer was specified to be 20 nm.

(Comparative example 21)

An optical sheet was produced as in Example 6 except that formation of an IZO layer was omitted.

(Example 7)

The concave and convection relations in Comparative example 6 were reversed. An electrically conductive optical sheet was produced in such a way that the average layer thickness of an IZO layer was specified to be 30 nm. The electrically conductive optical sheet provided with a plurality of structures having the concave shape (reverse pattern structures) on the surface was produced as in Comparative example 6 except those described above.

(Comparative example 22)

An optical sheet was produced as in Example 7 except that formation of an IZO layer was omitted.

(Example 8)

An optical sheet provided with an IZO layer having an average layer thickness of 30 nm on structures was produced, where the rate of change in curve of the cross-sectional profile of the structure was varied.

(Comparative example 23)

An optical sheet was produced as in Example 8 except that formation of an IZO layer was omitted.

(Evaluation of shape)

The surface shape of an optical sheet in the state in which an IZO layer was not formed was observed with an atomic force microscope (AFM: Atomic Force Microscope). Subsequently, the height and the like of the structure in each Example and each Comparative example were determined on the basis of the cross-sectional profile of AFM. The results thereof are shown in Table 6.

(Evaluation of surface resistance)

The surface resistance of the electrically conductive optical sheet produced as described above was measured by a four-terminal method (JIS K 7194). The results thereof are shown in Table 6.

(Evaluation of transparent, electrically conductive layer)

Cutting was performed in the sectional direction of the electrically conductive layer formed on the structures. Regarding the cross-section, the structures and the image of the electrically conductive layer adhered thereto was observed with a transmission electron microscope (TEM).

(Evaluation of reflectance)

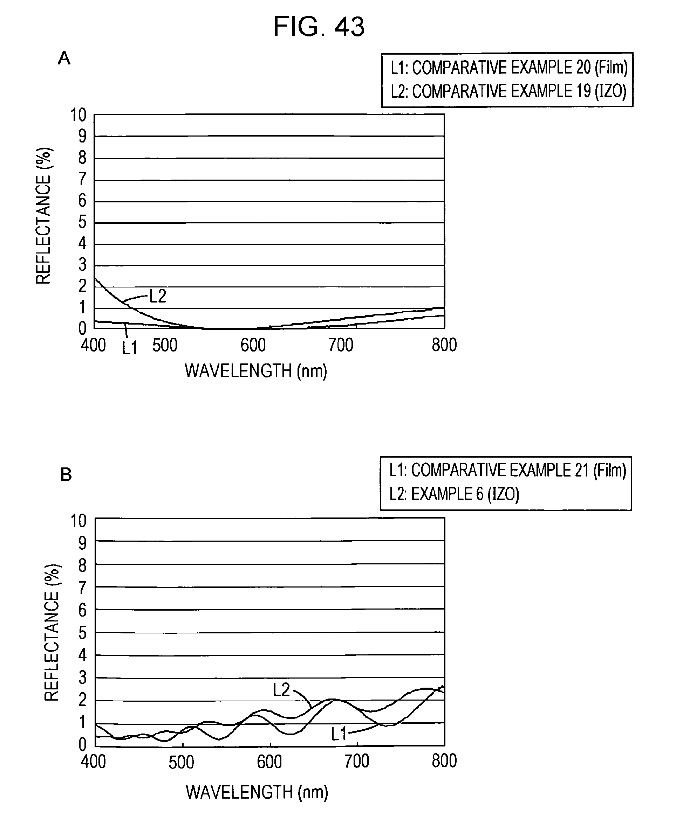

The reflectance of the electrically conductive optical sheet produced as described above were evaluated by using an evaluation apparatus (V-550) of JASCO Corporation. The results thereof are shown in Fig. 43A to Fig. 44B.

[Table 6]

| | Comparative example 19 | Comparative example 20 | Example 6 | Comparative example 21 | Example 7 | Comparative example 22 | Example 8 | Comparative example 23 |
|---|---|---|---|---|---|---|---|---|
| Arrangement pattern | hexagonal lattice | hexagonal lattice | hexagonal lattice | hexagonal lattice | hexagonal lattice | hexagonal lattice | hexagonal lattice | hexagonal lattice |
| Shape of structure | circular cone shape | circular cone shape | circular cone shape | circular cone shape | circular cone shape | circular cone shape | S-shaped refractive index profile | S-shaped refractive index profile |
| Unevenness of structure | convex shape | convex shape | convex shape | convex shape | concave shape | concave shape | convex shape | convex shape |
| Formation surface of structure | one surface | one surface | one surface | one surface | one surface | one surface | one surface | one surface |
| Pitch (nm) | 240 | 240 | 270 | 270 | 250 | 250 | 250 | 250 |
| Height (nm) | 200 | 200 | 170 | 170 | 300 | 300 | 200 | 200 |
| Aspect ratio | 0.83 | 0.83 | 0.6 | 0.6 | 1.2 | 1.2 | 0.8 | 0.8 |
| Average layer thickness (nm) | 30 | - | 20 | - | 30 | - | 30 | - |
| Surface resistance ($\Omega$/$\square$) | 550 | - | 400 | - | 500 | - | 500 | - |

In this regard, in Table 6, the circular cone shape refers to an elliptical cone shape having a curved surface at the top portion.

The following is clear from the evaluation of the shape of the transparent, electrically conductive layer and the evaluation of the reflectance.

Regarding Comparative example 19, it was made clear that the average layer thickness D1 at the top portion of the structure, the average layer thickness D2 of the slope of the structure, and the average layer thickness of the bottom portion D3 between the structures satisfied the following relationship.

$$D1\ (=\ 38\ nm)\ >\ D3\ (=\ 21\ nm)\ >\ D2\ (=\ 14\ nm\ to\ 17\ nm)$$

The refractive index of IZO is about 2.0 and, therefore, the effective refractive index increases only at the top portion of the structure. Consequently, as shown in Fig. 43A, the reflectance increases through formation of the IZO layer.

Regarding Example 6, it was made clear that the layer was formed on the structures almost uniformly. Consequently, as shown in Fig. 43B, changes in reflectance between before and after the layer formation were small.

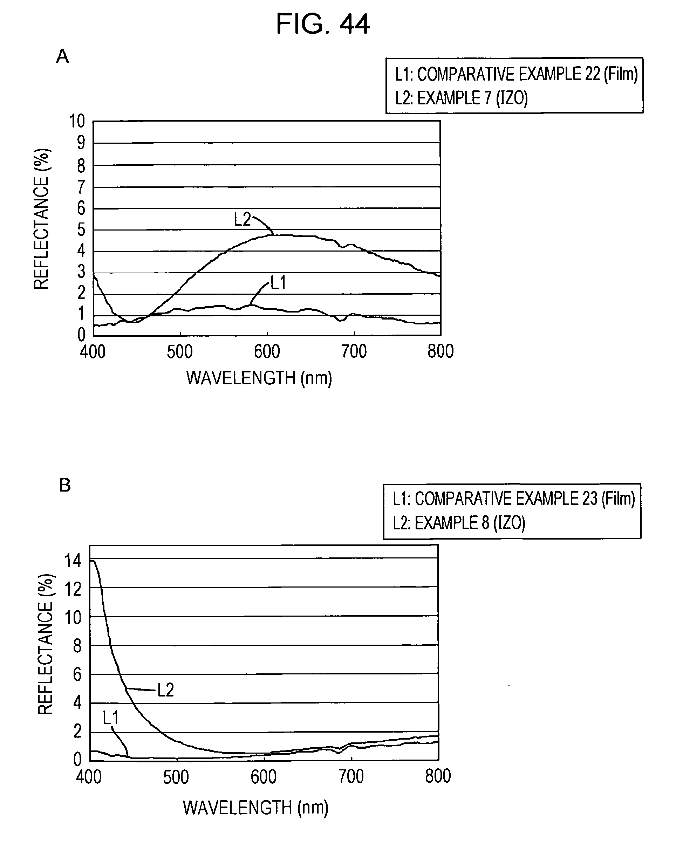

Regarding Example 6, it was made clear that the average layer thicknesses of the IZO layer on the bottom portion of the structure in the concave shape and the top portion between the structures in the concave shape are very large as compared with the average layer thicknesses of other portions. In particular, it was made clear that the average layer thickness was large at the top portion significantly. The state of layer formation is as described above and, therefore, as shown in Fig. 44A, changes in the reflectance tends to exhibit a complicated behavior and, in addition, increase.

Regarding Example 7, as in Comparative example 19, it was made clear that the average layer thickness D1 at the top portion of the structure, the average layer thickness D2 of the slope of the structure, and the average layer thickness of the bottom portion D3 between the structures satisfied the following relationship.

$$D1\ (=\ 36\ nm)\ >\ D2\ (=\ 20\ nm)\ >\ D3\ (=\ 18\ nm)$$

However, the reflectance tends to increase sharply in the side of the wavelength smaller than about 500 nm. The reason for this is believed to be that the top portion of the structure is in the shape of a flat surface and, thereby, the area of the top portion is large.

Consequently, the transparent, electrically conductive layer tends to adhere to a steep slope thin, and as the surface becomes close to flat, the transparent, electrically conductive layer tends to adhere thick.

Furthermore, in the case where the layer is formed all over the structures uniformly, changes in optical characteristics between before and after layer formation tend to become small.

Moreover, as the shape of the structure becomes close to a free-form surface, the transparent, electrically conductive layer tends to adhere all over the surfaces uniformly.

<7. Filling factor and relationship between ratio of diameter and reflection characteristic>

Next, the relationship between the ratio (($2r/P1$) $\times$ 100) and the antireflection characteristic was examined by RCWA (Rigorous Coupled Wave Analysis) simulation.

(Test example 1)

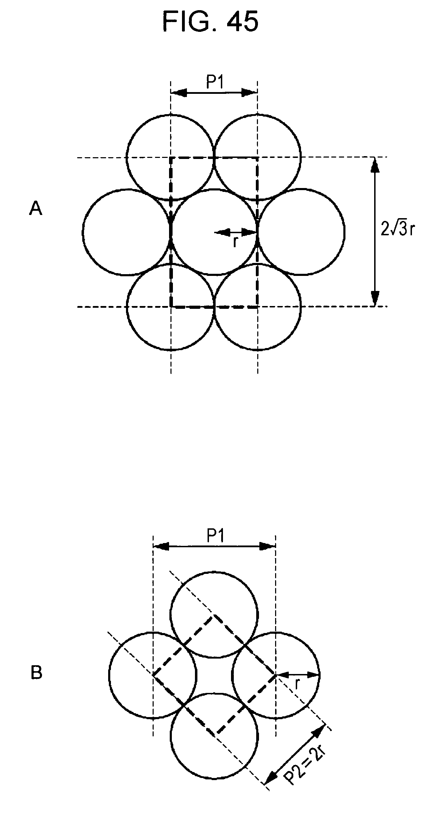

Fig. 45A is a diagram for explaining the filling factor in the case where structures are arranged in the shape of a hexagonal lattice. As shown in Fig. 45A, in the case where structures are arranged in the shape of a hexagonal lattice, the filling factor was determined on the basis of the following formula (2), while the ratio (($2r/P1$) $\times$ 100) (where, P1: the arrangement pitch of structures in the same track, r: the radius of the structure bottom) was changed.

$$filling\ factor\ =\ (S(hex.)/S(unit))\ \times\ 100 \qquad (2)$$

$$unit\ lattice\ area:\ S(unit)\ =\ 2r\ \times\ (2\sqrt{3})r$$

area of bottom of structure present in unit lattice:

$$S(hex.) = 2 \times \pi r^2$$

(where in the case of 2r > P1, determination is performed on the basis of the construction.)

For example, in the case where arrangement pitch P1 = 2 and structure bottom radius r = 1, S(unit), S(hex.), the ratio ((2r/P1) $\times$ 100), and the filling factor become the values as described below.

$$S(unit) = 6.9282$$

$$S(hex.) = 6.28319$$

$$(2r/P1) \times 100 = 100.0\%$$

$$filling\ factor = (S(hex.)/S(unit)) \times 100 = 90.7\%$$

The relationship between the filling factor determined on the basis of the above-described formula (2) and the ratio ((2r/P1) $\times$ 100) is shown in Table 7.

[Table 7]

| (2r/P1)x100 | Filling factor |
| --- | --- |
| 115.4% | 100.0% |
| 100.0% | 90.7% |
| 99.0% | 88.9% |
| 95.0% | 81.8% |
| 90.0% | 73.5% |
| 85.0% | 65.5% |
| 80.0% | 58.0% |
| 75.0% | 51.0% |

(Test example 2)

Fig. 45B is a diagram for explaining the filling factor in the case where structures are arranged in the shape of a tetragonal lattice. As shown in Fig. 45B, in the case where structures are arranged in the shape of a tetragonal lattice, the filling factor was determined on the basis of the following formula (3) while the ratio ((2r/P1) $\times$ 100) and the ratio ((2r/P2) $\times$ 100) (where, P1: the arrangement pitch of structures in the same track, P2: the arrangement pitch in a 45-degree direction relative to the track, r: the radius of the structure bottom) were changed.

$$filling\ factor = (S(tetra)/S(unit)) \times 100 \qquad (3)$$

$$unit\ lattice\ area:\ S(unit) = 2r \times 2r$$

area of bottom of structure present in unit lattice: S (tetra) = $\pi r^2$
(where in the case of 2r > P1, determination is performed on the basis of the construction.)

For example, in the case where arrangement pitch P2 = 2 and structure bottom radius r = 1, S(unit), S(tetra), the ratio ((2r/P1) × 100), the ratio ((2r/P2) × 100), and the filling factor become the values as described below.

$$S(unit) = 4$$

$$S(tetra) = 3.14159$$

$$(2r/P1) \times 100 = 70.7\%$$

$$(2r/P2) \times 100 = 100.0\%$$

$$filling\ factor = (S(tetra)/S(unit)) \times 100 = 78.5\%$$

The relationship between the filling factor determined on the basis of the above-described formula (3), the ratio ((2r/P1) × 100), and the ratio ((2r/P2) × 100) is shown in Table 8.

Furthermore, the relationship between the arrangement pitches P1 and P2 of the tetragonal lattice is represented by P1 = $\sqrt{2} \times$ P2.

[Table 8]

| (2r/P1)×100 | (2r/P2)×100 | Filling factor |
|---|---|---|
| 100.0% | 141.4% | 100.0% |
| 84.9% | 120.0% | 95.1% |
| 81.3% | 115.0% | 92.4% |
| 77.8% | 110.0% | 88.9% |
| 74.2% | 105.0% | 84.4% |
| 70.7% | 100.0% | 78.5% |
| 70.0% | 99.0% | 77.0% |
| 67.2% | 95.0% | 70.9% |
| 63.6% | 90.0% | 63.6% |
| 60.1 % | 85.0% | 56.7% |
| 56.6% | 80.0% | 50.3% |
| 53.0% | 75.0% | 44.2% |

(Test example 3)

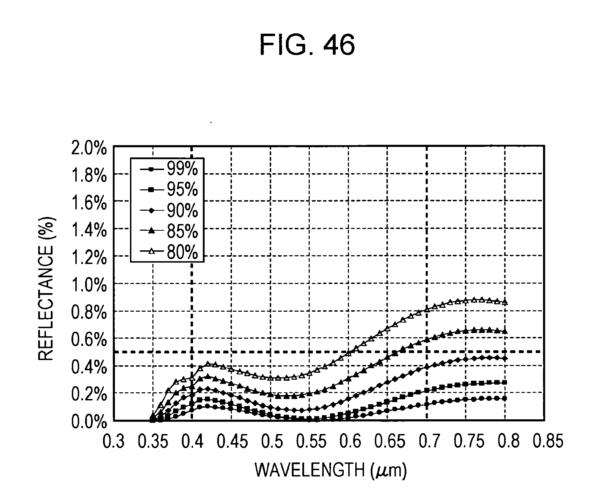

The magnitude of the ratio ((2r/P1) × 100) of the diameter 2r of the structure bottom to the arrangement pitch P1 was specified to be 80%, 85%, 90%, 95%, and 99% and the reflectance was determined on the basis of the simulation under the following condition. Fig. 46 shows a graph of the results thereof.
Structure shape: temple bell type
Polarization: unpolarized
Reflectance: 1.48
Arrangement pitch P1: 320 nm
Height of structure: 415 nm
Aspect ratio: 1.30

Arrangement of structures: hexagonal lattice

As is clear from Fig. 46, in the case where the ratio ((2r/P1) $\times$ 100) is 85% or more, nearly in the wavelength range (0.4 to 0.7 $\mu$m) of the visible range, the average reflectance R becomes R < 0.5%, and a sufficient antireflection effect is obtained. The filling factor of the bottom at this time is 65% or more. Furthermore, in the case where the ratio ((2r/P1) $\times$ 100) is 90% or more, in the wavelength range of the visible range, the average reflectance R becomes R < 0.3%, and a higher-performance antireflection effect is obtained. The filling factor of the bottom at this time is 73% or more, and the performance becomes higher as the filling factor becomes higher, where the upper limit is 100%. In the case where the structures are mutually overlapped, the height of the structure is assumed to be the height from the lowest position. In this regard, it was ascertained that there was the same tendency regarding the filling factor and the reflectance of the tetragonal lattice.

(Average height H, average arrangement pitch P, average aspect ratio)

In the following examples, the average height H, the average arrangement pitch P, and the average aspect ratio of an electrically conductive sheet were determined as described below.

The average arrangement pitch P, the average height H, and the aspect ratio (H/P) were determined as described below. Initially, the electrically conductive sheet was cut in such a way as to include the top portion of the structure, and the cross-section thereof was photographed with a transmission electron microscope (TEM). Subsequently, the arrangement pitch P of the structures and the height H of structures were determined from the resulting TEM photograph. These measurements were repeated with respect to 10 places selected from the electrically conductive sheet at random, and measurement values are simply averaged (arithmetically averaged), so as to determine an average arrangement pitch P and an average height H. Then, the aspect ratio (H/P) was determined by using the resulting average arrangement pitch P and average height H.

(Average layer thickness of ITO layer)

In the following examples, the layer thickness of an ITO layer was determined as described below. Initially, the electrically conductive sheet was cut in such a way as to include the top portion of the structure, and the cross-section thereof was photographed with a transmission electron microscope (TEM). The layer thickness of the ITO layer at the top portion of the structure was measured on the basis of the resulting TEM photograph. These measurements were repeated with respect to 10 places selected from the electrically conductive sheet at random, and measurement values are simply averaged (arithmetically averaged), so as to determine the average layer thickness.

(Average wavelength $\lambda$, average width A of vibration, average ratio (A/X))

In the following examples, the average wavelength $\lambda$ of a first wavefront and a second wavefront, the average width A of vibration of the first wavefront, the average width B of vibration of the second wavefront, the average ratio (A/$\lambda$), and the average ratio (B/$\lambda$) were determined as described below. Initially, the electrically conductive sheet was cut in one direction in such a way that the position, at which the width of vibration of the first wavefront or the second wavefront of the ITO layer became maximum, was included. The resulting cross-section was photographed with a transmission electron microscope (TEM). Subsequently, the wavelength $\lambda$ of the first wavefront or the second wavefront, the width A of vibration of the first wavefront, and the width B of vibration of the second wavefront were determined from the resulting TEM photograph. These measurements were repeated with respect to 10 places selected from the ITO layer at random. Then, measured wavelengths $\lambda$ of the first wavefront or the second wavefront, the widths A of vibration of the first wavefront, and the widths B of vibration of the second wavefront were individually simply averaged (arithmetically averaged), so as to determine the average wavelength $\lambda$ of the first wavefront and the second wavefront, the average width A of vibration of the first wavefront, and the average width B of vibration of the second wavefront. Next, the average ratio (A/$\lambda$) and the average ratio (B/$\lambda$) were determined by using these average wavelength $\lambda$, average width A of vibration, and average width B of vibration.

The examples according to the present invention will be described in the following order.

    8. Examination of reflection characteristic by simulation
    9. Examination of reflection characteristic by sample production
    10. Examination of resistance characteristic by sample production

<8. Examination of reflection characteristic by simulation>

(Example 1-1)

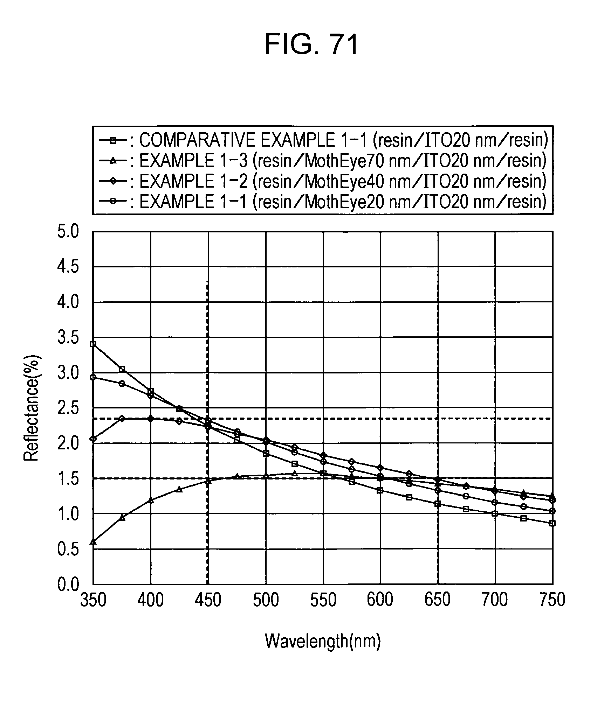

The wavelength dependence of reflectance of the electrically conductive element was determined by RCWA (Rigorous Coupled Wave Analysis) simulation. The results thereof are shown in Fig. 71.
The condition of the simulation will be described below.

(Layer configuration of electrically conductive element)

(Emitting surface side) resin layer/Motheye structure/ITO layer/resin layer (inlet surface side)

(Resin layer)

Refractive index n: 1.52

(ITO layer)

Layer thickness d: 20 nm, refractive index n: 2.0
Cross-sectional shape of first wavefront: the shape of periodical repetition of a parabola
Wavelength $\lambda$ of first wavefront: 400 nm, width A of vibration of first wavefront: 20 nm, ratio (A/$\lambda$) of width A of vibration to wavelength $\lambda$ of first wavefront: 0.05
Cross-sectional shape of second wavefront: the shape of periodical repetition of a parabola
Wavelength $\lambda$ of second wavefront: 400 nm, width B of vibration of second wavefront: 20 nm, ratio (B/$\lambda$) of width B of vibration to wavelength $\lambda$ of second wavefront: 0.05
In the present example, the cross-sectional shape of the first wavefront is a cross-sectional shape when an electrically conductive element is cut in one direction in such a way as to include the position at which the width of vibration of the first wavefront of the ITO layer becomes maximum. Furthermore, the cross-sectional shape of the second wavefront is a cross-sectional shape when the electrically conductive element is cut in one direction in such a way as to include the position at which the width of vibration of the second wavefront of the ITO layer becomes maximum.

(Motheye structure)

Structure shape: shape of paraboloid, arrangement pattern: hexagonal lattice pattern, arrangement pitch P between structures: 400 nm, structure height H: 20 nm, aspect ratio (H/P): 0.05, refractive index n: 1.52

(Resin layer)

Refractive index n = 1.52

(Example 1-2)

The wavelength dependence of reflectance was determined by performing simulation as in Example 1-1 except that the following simulation condition was changed. The results thereof are shown in Fig. 71.

(Motheye structure)

Structure height H: 40 nm, aspect ratio (H/P): 0.1

(ITO layer)

widths of vibration of first and second wavefronts: 40 nm, ratio (A/X) and ratio (B/$\lambda$): 0.1

(Example 1-3)

The wavelength dependence of reflectance was determined by performing simulation as in Example 1-1 except that the following simulation condition was changed. The results thereof are shown in Fig. 71.

(Motheye structure)

Structure height H: 70 nm, aspect ratio (H/P): 0.175

(ITO layer)

widths of vibration of first and second wavefronts: 70 nm, ratio (A/X) and ratio (B/k): 0.175

(Comparative example 1-1)

The wavelength dependence of reflectance was determined by performing simulation as in Example 1-1 except that in the layer configuration, a resin layer was provided with no structure thereon and was specified to be a flat surface, and an ITO layer was disposed on this flat surface. The results thereof are shown in Fig. 71.
The following are clear from Fig. 71.
In the case where the structure having a height of 40 nm (aspect 0.1) or more is disposed on the surface, nearly the same spectrum as that in the case where the structure is not disposed on the surface can be obtained.
In the case where the height (aspect 0.1) of the structure is 40 nm or more, the displacement $\Delta R$ of the reflectance in the visible region (450 nm to 650 nm) can satisfy $\Delta R < 1\%$. That is, the reflectance becomes nearly flat in the visible region.

(Example 2-1)

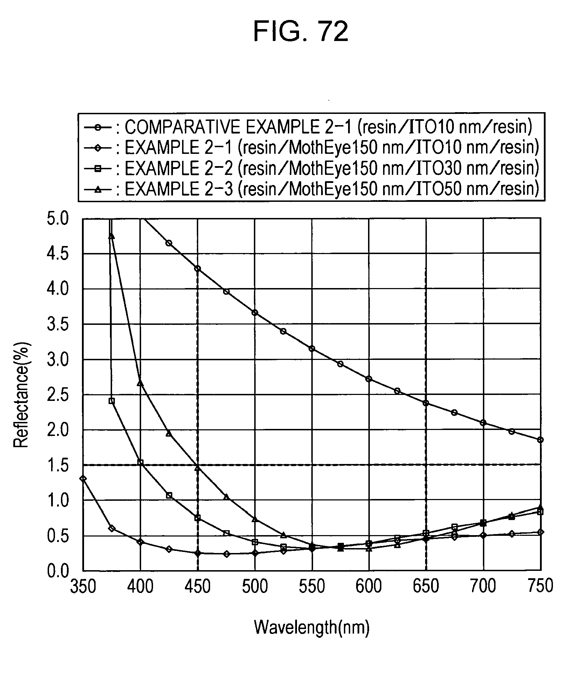

The wavelength dependence of reflectance of the electrically conductive element was determined by RCWA simulation. The results thereof are shown in Fig. 72.
The condition of the simulation will be described below.

(Layer configuration of electrically conductive element)

(Emitting surface side) resin layer/Motheye structure/ITO layer/resin layer (inlet surface side)

(Resin layer)

Refractive index n: 1.52

(ITO layer)

Layer thickness d: 10 nm, refractive index n: 2.0
Cross-sectional shape of first wavefront: the shape of periodical repetition of a parabola
Wavelength $\lambda$ of first wavefront: 250 nm, width A of vibration of first wavefront: 150 nm, ratio (A/$\lambda$) of width A of vibration to wavelength $\lambda$ of first wavefront: 0.6
Cross-sectional shape of second wavefront: the shape of periodical repetition of a parabola
Wavelength $\lambda$ of second wavefront: 250 nm, width B of vibration of second wavefront: 150 nm, ratio (B/$\lambda$) of width B of vibration to wavelength $\lambda$ of second wavefront: 0.6

(Motheye structure)

Structure shape: shape of paraboloid, arrangement pattern: hexagonal lattice pattern, arrangement pitch P: 250 nm, structure height H: 150 nm, aspect ratio (H/P): 0.6, refractive index n: 1.52

(Resin layer)

Refractive index n: 1.52

(Example 2-2)

The wavelength dependence of reflectance was determined by performing simulation under the same condition as in Example 2-1 except that the layer thickness d of the ITO layer was specified to be 30 nm. The results thereof are shown in Fig. 72.

(Example 2-3)

The wavelength dependence of reflectance was determined by performing simulation under the same condition as in Example 2-1 except that the layer thickness d of the ITO layer was specified to be 50 nm. The results thereof are shown in Fig. 72.

(Comparative example 2-1)

The wavelength dependence of reflectance was determined by performing simulation under the same condition as in Example 2-1 except that in the layer configuration, a resin layer was provided with no structure thereon and was specified to be a flat surface, and an ITO layer was disposed on this flat surface. The results thereof are shown in Fig. 72.
The following are clear from Fig. 72.
In the case where the layer thickness of the ITO layer is within the range of 10 nm to 50 nm, sufficient antireflection is obtained in the range of visible region. Specifically, the reflectance can be reduced to 1.5% or less in the visible region (450 nm to 750 nm).
In the case where the configuration in which the ITO layer is sandwiched between uneven surfaces of the resin layer is employed, the reflectance can be reduced significantly as compared with that in the case where the layer configuration in which the ITO layer is sandwiched between flat surfaces of the resin layer is employed. In particular, the reflectance in the small wavelength side of the visible region can be reduced.

(Example 3-1)

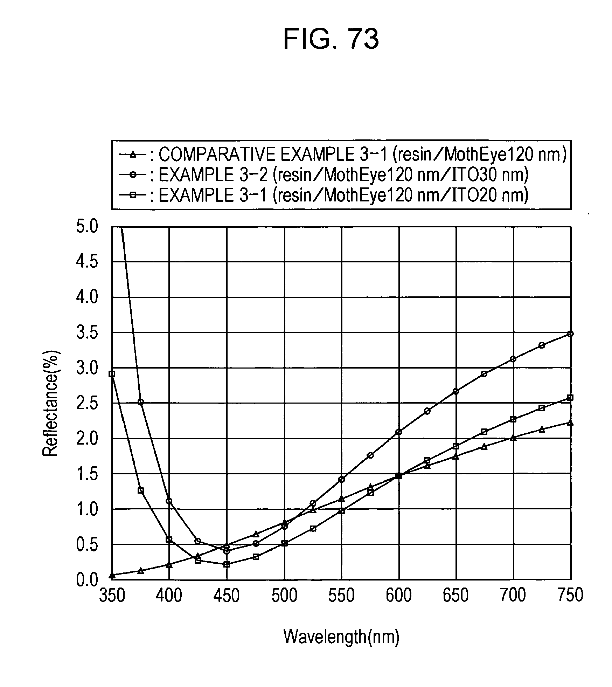

The wavelength dependence of reflectance of the electrically conductive element was determined by RCWA simulation. The results thereof are shown in Fig. 73.
The condition of the simulation will be described below.

(Layer configuration of electrically conductive element)

resin layer/Motheye structure/ITO layer/air

(Resin layer)

Refractive index n = 1.52

(Motheye structure)

Structure shape: shape of paraboloid, arrangement pattern: hexagonal lattice pattern, arrangement pitch P: 250 nm, structure height H: 120 nm, aspect ratio (H/P): 0.48, refractive index n: 1.52

(ITO layer)

Layer thickness d: 20 nm, refractive index n: 2.0
Cross-sectional shape of first wavefront: the shape of periodical repetition of a parabola
Wavelength $\lambda$ of first wavefront: 250 nm, width A of vibration of first wavefront: 120 nm, ratio (A/$\lambda$) of width A of vibration to wavelength X of first wavefront: 0.48
Cross-sectional shape of second wavefront: the shape of periodical repetition of a parabola
Wavelength $\lambda$ of second wavefront: 250 nm, width B of vibration of second wavefront: 120 nm, ratio (B/$\lambda$) of width B of vibration to wavelength $\lambda$ of second wavefront: 0.48

(Example 3-2)

The wavelength dependence of reflectance was determined by performing simulation under the same condition as in Example 3-1 except that the layer thickness d of the ITO layer was specified to be 30 nm. The results thereof are shown in Fig. 73.

(Comparative example 3-1)

The wavelength dependence of reflectance was determined by performing simulation under the same condition as in Example 3-1 except that the layer thickness d of the ITO layer was specified to be 0 nm. The results thereof are shown in Fig. 73.

The following are clear from Fig. 73.

In the case where structures are disposed in large numbers on the surface of the resin layer, in the range of wavelength of about 450 to 700 nm, a difference in reflectance between the case where the ITO layer is disposed on the structures and the case where the ITO layer is not disposed on the structures tends to become not large. Therefore, a difference in reflectance between the portion provided with an electrode pattern of ITO layer and a portion provided with no electrode pattern of ITO layer can be reduced. That is, visual recognition of the wiring patterns can be suppressed regarding a digital resistive touch panel and the like.

(Reference example 1-1)

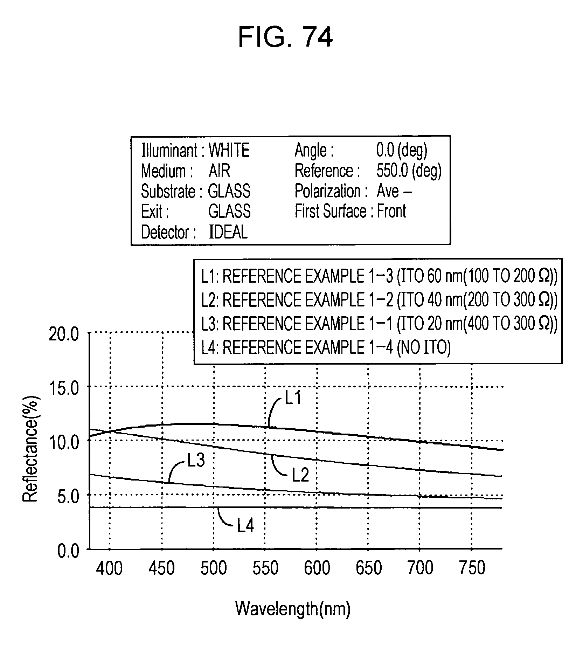

The wavelength dependence of reflectance of an electrically conductive element was determined by simulation. The results thereof are shown in Fig. 74.

The condition of the simulation will be described below.

(Layer configuration of electrically conductive element)

base member/ITO layer/medium

(Base member)

Base member: glass base member, layer formation surface: flat surface, refractive index n = 1.5

(ITO layer)

layer thickness d = 20 nm, refractive index n = 2.0

(Medium)

Type of medium: air

(Reference example 1-2)

The wavelength dependence of reflectance was determined by performing simulation under the same condition as in Reference example 1-1 except that the layer thickness of the ITO layer was specified to be 40 nm. The results thereof are shown in Fig. 74.

(Reference example 1-3)

The wavelength dependence of reflectance was determined by performing simulation under the same condition as in Reference example 1-1 except that the layer thickness of the ITO layer was specified to be 60 nm. The results thereof are shown in Fig. 74.

(Reference example 1-4)

The wavelength dependence of reflectance was determined by performing simulation under the same condition as in Reference example 1-1 except that the layer thickness of the ITO layer was specified to be 0 nm. The results thereof are shown in Fig. 74.

The following are clear from Fig. 74.

In the case where a motheye structure is not disposed on a base member surface and the ITO layer is disposed on the flat surface of the base member, the reflectance tends to increase as compared with the case where an ITO layer is not disposed on the flat surface of the base member. The degree of increase in reflectance tends to become large as the layer thickness of the ITO layer increases.

<9. Examination of reflection characteristic by sample production>

(Example 4-1)

Initially, a glass roll stamper having an outside diameter of 126 mm was prepared. A resist layer was formed on the surface of this glass roll stamper in a manner as described below. That is, a photoresist was diluted by a factor of 10 with a thinner. A resist layer having a thickness of about 70 nm was formed by applying the resulting diluted resist to a circular column surface of the glass roll stamper through dipping. Subsequently, the glass roll stamper serving as a recording medium was carried to the roll stamper exposing apparatus shown in Fig. 58, the resist layer was exposed and, thereby, latent images, which were aligned in the shape of a spiral and which constituted a hexagonal lattice pattern between adjacent three lines of tracks, were patterned on the resist layer.

Specifically, laser light with a power of 0.50 mW/m to expose up to the surface of the above-described glass roll stamper was applied to a region to be provided with an exposure pattern in the shape of a hexagonal lattice, so that an exposure pattern in the shape of a concave-shaped hexagonal lattice was formed. In this regard, the thickness of the resist layer in the direction of lines of the tracks was about 60 nm and the resist thickness in the extension direction of the track was about 50 nm.

Subsequently, the resist layer on the glass roll stamper was subjected to a developing treatment, in which development was performed by dissolving the exposed portion of the resist layer. Specifically, an undeveloped glass roll stamper was placed on a turn table of a developing machine, although not shown in the drawing, a developing solution was dropped on the surface of the glass roll stamper while rotation was performed on a turn table basis, so as to develop the resist layer on the surface. In this manner, a resist glass stamper, in which the resist layer had openings in the hexagonal lattice pattern, was obtained.

Then, a roll etching apparatus was used and plasma etching was performed in a $CHF_3$ gas atmosphere. Consequently, on the surface of the glass roll stamper, etching of only a portion of the hexagonal lattice pattern exposed at the resist layer proceeded, and the other regions were not etched because the resist layer served as a mask, so that concave portions in the shape of an elliptical cone were formed on the glass roll stamper. The amount of etching (depth) at this time was adjusted on the basis of the etching time. Finally, the resist layer was removed completely through $O_2$ ashing and, thereby, a motheye glass roll master with a hexagonal lattice pattern in the concave shape was obtained. The depth of the concave portion in the direction of lines was larger than the depth of the concave portion in the extension direction of the track.

Next, the above-described motheye glass roll master and a TAC (triacetyl cellulose) sheet coated with an ultraviolet curable resin were closely adhered, and peeling was performed while ultraviolet rays were applied, so as to cure. In this manner, an optical sheet which had a plurality of structures arranged on one principal surface was obtained.

Subsequently, an ITO layer having an average layer thickness at the top portion of the structure of 30 nm was formed all over the surface of the TAC sheet provided with a large number of structures by a sputtering method. Then, the TAC sheet was bonded to the ITO layer with an adhesive therebetween.

The average arrangement pitch P of the structures of the optical sheet obtained as described above was 270 nm, the average height H was 170 nm, and the average aspect ratio was 0.63. Furthermore, the wavelength X of the ITO layer was 270 nm, the width A of vibration of the first wavefront of the ITO layer was 170 nm, the width B of vibration of the second wavefront of the ITO layer was 170 to 180 nm, the ratio (A/X) was 0.63, and the ratio (B/X) was 0.63 to 0.67.

In this manner, a desired electrically conductive sheet was produced.

(Comparative example 4-1)

An electrically conductive sheet was produced as in Example 4-1 except that the average layer thickness of the ITO layer was specified to be 20 nm.

(Comparative example 4-2)

An optical sheet was produced as in Example 4-1 except that formation of an ITO layer was omitted.

(Comparative example 4-3)

An electrically conductive sheet was produced as in Example 4-1 except that the step of forming structures by application of an ultraviolet curable resin was omitted and the ITO layer was formed directly on the flat surface of the TAC film.

(Evaluation of surface resistance)

The surface resistances of the electrically conductive sheets and the optical sheet produced as described above were measured by a four-terminal method. The results thereof are shown in Table 9.

(Evaluation of spectral reflection characteristic)

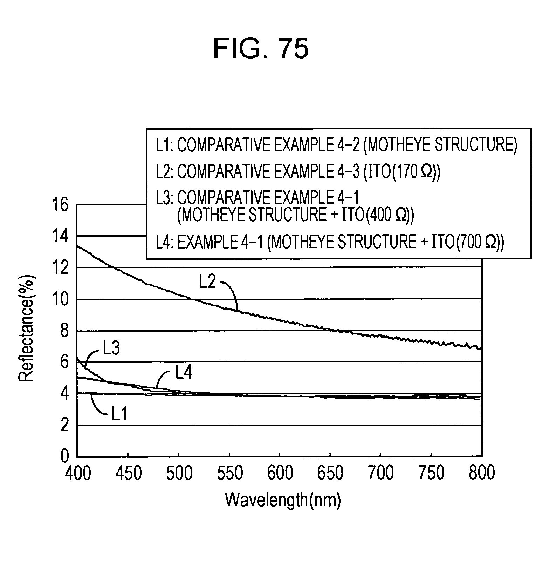

The spectral reflection characteristics of the electrically conductive sheets and the optical sheet produced as described above were measured as described below. Initially, a black tape was bonded to the backside of the TAC sheet provided with a large number of structures or the ITO layer. Subsequently, the spectral reflection characteristic of the electrically conductive sheet when light was incident from the surface opposite to the side bonded to the black tape was determined by using an evaluation apparatus (V-550) produced by JASCO Corporation. The results thereof are shown in Fig. 75.

[Table 9]

| | Configuration | Arrangement pattern | Shape of structure | Uneven shape of structure | Pitch (nm) | Height (nm) | Aspect ratio | Layer thickness (nm) | Surface resistance ($\Omega/\square$) |
|---|---|---|---|---|---|---|---|---|---|
| Example 4-1 | (a) | | | | | | | 30 | 400 |
| Comparative example 4-1 | (a) | hexagonal lattice | paraboloidal shape | convex shape | 270 | 170 | 0.6 | 20 | 700 |
| Comparative example 4-2 | (b) | | | | | | | 0 | - |
| Comparative example 4-3 | (c) | - | - | - | - | - | - | 30 | 170 |
| Configuration (a): resin layer (with motheye structure)/ITO layer/resin layer (with motheye structure) | | | | | | | | | |
| Configuration (b): resin layer (with motheye structure)/resin layer (with motheye structure) | | | | | | | | | |
| Configuration (c): resin layer (no motheye structure)/ITO layer/resin layer (no motheye structure) | | | | | | | | | |

The following are clear from Fig. 75.

Regarding Example 4-1 and Comparative example 4-1 in which the ITO layer is disposed on the structures, the reflectance can be reduced within the range of visible region of 400 nm to 800 nm as compared with that in Comparative example 4-2 in which the ITO layer is disposed on the flat surface of the TAC sheet.

Regarding Example 4-1 and Comparative example 4-1 in which the ITO layer is disposed on the structures, nearly the same reflectance as that in Comparative example 4-1 in which an ITO layer is not disposed on the structures is obtained within the range of visible region of 400 nm to 800 nm. According to this result, in the case where the ITO layer is formed into the shape of a predetermined wiring pattern, a difference in reflectance between a portion with the wiring pattern and a portion with no wiring pattern can be almost eliminated by forming a structure-shaped ITO layer. Consequently, the wiring patterns become hardly recognized visually.

(Example 5-1)

Initially, a TAC sheet provided with a motheye structure was obtained as in Example 4-1 except that the configuration of the structure was specified to be as shown in Table 10 by adjusting the conditions of the exposure step and the etching step. Subsequently, an ITO layer having an average layer thickness of 30 nm was formed all over the TAC sheet provided with a large number of structures by a sputtering method. In this manner, an electrically conductive sheet in which the surface provided with the motheye structure was exposed without being covered with a resin layer was produced.

(Example 5-2)

An electrically conductive sheet was produced as in Example 5-1 except that the average layer thickness of the ITO layer was specified to be 40 nm.

(Example 5-3)

An electrically conductive sheet was produced as in Example 5-1 except that the average layer thickness of the ITO layer was specified to be 50 nm.

(Example 5-4)

An electrically conductive sheet was produced as in Example 5-1 except that the average layer thickness of the ITO layer was specified to be 60 nm.

(Comparative example 5-1)

An optical sheet was produced as in Example 5-1 except that formation of the ITO layer was omitted.

(Example 6-1)

An electrically conductive sheet was produced as in Example 5-1 except that the configuration of the structure was specified to be as shown in Table 2 by adjusting the conditions of the exposure step and the etching step and, in addition, the average layer thickness of the ITO layer was specified to be 30 nm.

(Example 6-2)

An electrically conductive sheet was produced as in Example 6-1 except that the average layer thickness of the ITO layer was specified to be 40 nm.

(Example 6-3)

An electrically conductive sheet was produced as in Example 6-1 except that the average layer thickness of the ITO layer was specified to be 50 nm.

(Example 6-4)

An electrically conductive sheet was produced as in Example 6-1 except that the average layer thickness of the ITO layer was specified to be 60 nm.

(Comparative example 6-1)

An optical sheet was produced as in Example 6-1 except that formation of the ITO layer was omitted.

(Example 7-1)

An electrically conductive sheet was produced as in Example 5-1 except that the configuration of the structure was specified to be as shown in Table 10 by adjusting the conditions of the exposure step and the etching step and, in addition, the average layer thickness of the ITO layer was specified to be 30 nm.

(Example 7-2)

An electrically conductive sheet was produced as in Example 7-1 except that the average layer thickness of the ITO layer was specified to be 40 nm.

(Example 7-3)

An electrically conductive sheet was produced as in Example 7-1 except that the average layer thickness of the ITO layer was specified to be 50 nm.

(Example 7-4)

An electrically conductive sheet was produced as in Example 7-1 except that the average layer thickness of the ITO layer was specified to be 60 nm.

(Comparative example 7-1)

An optical sheet was produced as in Example 7-1 except that formation of the ITO layer was omitted.

(Comparative example 8-1)

An electrically conductive sheet was produced as in Example 5-1 except that the configuration of the structure was specified to be as shown in Table 10 by adjusting the conditions of the exposure step and the etching step and, in addition, the average layer thickness of the ITO layer was specified to be 30 nm.

(Example 8-1)

An electrically conductive sheet was produced as in Comparative example 8-1 except that the average layer thickness of the ITO layer was specified to be 40 nm.

(Example 8-2)

An electrically conductive sheet was produced as in Comparative example 8-1 except that the average layer thickness of the ITO layer was specified to be 50 nm.

(Example 8-3)

An electrically conductive sheet was produced as in Comparative example 8-1 except that the average layer thickness of the ITO layer was specified to be 60 nm.

(Comparative example 8-2)

An optical sheet was produced as in Comparative example 8-1 except that formation of the ITO layer was omitted.

(Comparative example 9-1)

An electrically conductive sheet was produced as in Example 5-1 except that the configuration of the structure was specified to be as shown in Table 10 by adjusting the conditions of the exposure step and the etching step and, in addition, the average layer thickness of the ITO layer was specified to be 30 nm.

(Example 9-1)

An electrically conductive sheet was produced as in Comparative example 9-1 except that the average layer thickness of the ITO layer was specified to be 40 nm.

(Example 9-2)

An electrically conductive sheet was produced as in Comparative example 9-1 except that the average layer thickness of the ITO layer was specified to be 50 nm.

(Example 9-3)

An electrically conductive sheet was produced as in Comparative example 9-1 except that the average layer thickness of the ITO layer was specified to be 60 nm.

(Comparative example 9-2)

An optical sheet was produced as in Comparative example 9-1 except that formation of the ITO layer was omitted.

(Comparative example 10-1)

An electrically conductive sheet was produced as in Example 5-1 except that the configuration of the structure was specified to be as shown in Table 10 by adjusting the conditions of the exposure step and the etching step and, in addition, the average layer thickness of the ITO layer was specified to be 30 nm.

(Example 10-1)

An electrically conductive sheet was produced as in Comparative example 10-1 except that the average layer thickness of the ITO layer was specified to be 40 nm.

(Example 10-2)

An electrically conductive sheet was produced as in Comparative example 10-1 except that the average layer thickness of the ITO layer was specified to be 50 nm.

(Example 10-3)

An electrically conductive sheet was produced as in Comparative example 10-1 except that the average layer thickness of the ITO layer was specified to be 60 nm.

(Comparative example 10-2)

An optical sheet was produced as in Comparative example 10-1 except that formation of the ITO layer was omitted.

(Example 11-1)

An electrically conductive sheet was produced as in Example 5-1 except that the structures shown in Table 10 were formed by adjusting the conditions of the exposure step and the etching step and, in addition, the average layer thickness of the ITO layer was specified to be 30 nm.

(Comparative example 11-1)

An electrically conductive sheet was produced as in Example 11-1 except that the structures shown in Table 12 were formed.

(Example 11-2)

An electrically conductive sheet was produced as in Example 11-1 except that the average layer thickness of the ITO layer was specified to be 50 nm.

(Comparative example 11-3)

An electrically conductive sheet was produced as in Example 11-2 except that the structures shown in Table 10 were formed.

(Comparative example 11-2)

Single-layer glass was prepared.
Table 10 shows the configurations of the electrically conductive sheets and the optical sheets in Examples and Comparative examples described above.

[Table 10]

| | Configuration | Arrangement pattern | Shape of structure | Uneven shape of structure | Pitch (nm) | Height (nm) | Aspect ratio | Layer thickness (nm) | Surface resistance ($\Omega/\square$) |
|---|---|---|---|---|---|---|---|---|---|
| Example 5-1 | Configuration (d) | hexagonal lattice | paraboloidal shape | convex shape | 270 | 156 | 0.56 | 30 | 405 |
| Example 5-2 | | | | | | | | 40 | 265 |
| Example 5-3 | | | | | | | | 50 | 214 |
| Example 5-4 | | | | | | | | 60 | 173 |
| Comparative example 5-1 | | | | | | | | 0 | - |
| Example 6-1 | Configuration (d) | hexagonal lattice | paraboloidal shape | convex shape | 240 | 160 | 0.68 | 30 | 383 |
| Example 6-2 | | | | | | | | 40 | 250 |
| Example 6-3 | | | | | | | | 50 | 193 |
| Example 6-4 | | | | | | | | 60 | 157 |
| Comparative example 6-1 | | | | | | | | 0 | - |
| Example 7-1 | Configuration (d) | hexagonal lattice | paraboloidal shape | convex shape | 240 | 179 | 0.75 | 30 | 486 |
| Example 7-2 | | | | | | | | 40 | 306 |
| Example 7-3 | | | | | | | | 50 | 215 |
| Example 7-4 | | | | | | | | 60 | 185 |
| Comparative example 7-1 | | | | | | | | 0 | - |
| Comparative example 8-1 | Configuration (d) | hexagonal lattice | paraboloidal shape | convex shape | 240 | 190 | 0.8 | 30 | 591 |
| Example 8-1 | | | | | | | | 40 | 361 |
| Example 8-2 | | | | | | | | 50 | 263 |
| Example 8-3 | | | | | | | | 60 | 241 |
| Comparative example 8-2 | | | | | | | | 0 | - |

EP 2 474 843 A1

| | Configuration | Arrangement pattern | Shape of structure | Uneven shape of structure | Pitch (nm) | Height (nm) | Aspect ratio | Layer thickness (nm) | Surface resistance ($\Omega$/$\square$) |
|---|---|---|---|---|---|---|---|---|---|
| Comparative example 9-1 | Configuration (d) | hexagonal lattice | paraboloidal shape | convex shape | 250 | 183 | 0.73 | 30 | 575 |
| Example 9-1 | | | | | | | | 40 | 362 |
| Example9-2 | | | | | | | | 50 | 328 |
| Example 9-3 | | | | | | | | 60 | 270 |
| Comparative example 9-2 | | | | | | | | 0 | - |
| Comparative example 10-1 | Configuration (d) | hexagonal lattice | paraboloidal shape | convex shape | 230 | 178 | 0.77 | 30 | 585 |
| Example 10-1 | | | | | | | | 40 | 374 |
| Example 10-2 | | | | | | | | 50 | 214 |
| Example 10-3 | | | | | | | | 60 | 282 |
| Comparative example 10-2 | | | | | | | | 0 | - |
| Example 11-1 | Configuration (a) | hexagonal lattice | paraboloidal shape | convex shape | 270 | 156 | 0.56 | 30 | 350 |
| Comparative example 11-1 | | | | | 240 | 190 | 0.8 | 30 | 650 |
| Example 11-2 | | | | | 270 | 156 | 0.56 | 50 | 170 |
| Example 11-3 | | | | | 240 | 190 | 0.8 | 50 | 275 |
| Comparative example 11-2 | Configuration (e) | | - | - | - | - | - | - | - |
| Configuration (a): resin layer (with motheye structure)/ITO layer/resin layer (with motheye structure)<br>Configuration (d): resin layer (with motheye structure)/ITO layer/air layer<br>Configuration (e): single-layer glass | | | | | | | | | |

<10. Examination of resistance characteristic by sample production>

(Examples 12-1 to 12-3, Comparative examples 12-1 to 12-3)

An electrically conductive sheet was produced as in Example 4-1 except that the structures shown in Table 11 were formed by adjusting the conditions of the exposure step and the etching step and, in addition, the average layer thickness of the ITO layer was specified to be 30 nm.

(Examples 13-1 to 13-4)

An electrically conductive sheet was produced as in Example 12-1 except that the average layer thickness of the ITO layer was specified to be 30 nm, 40 nm, 50 nm, or 60 nm.

(Examples 14-1 to 14-4)

An electrically conductive sheet was produced as in Example 12-2 except that the average layer thickness of the ITO layer was specified to be 30 nm, 40 nm, 50 nm, or 60 nm.

(Examples 15-1 to 15-4)

An electrically conductive sheet was produced as in Example 12-3 except that the average layer thickness of the ITO layer was specified to be 30 nm, 40 nm, 50 nm, or 60 nm.

(Examples 16-1 to 16-3, Comparative example 16-1)

An electrically conductive sheet was produced as in Comparative example 12-1 except that the average layer thickness of the ITO layer was specified to be 30 nm, 40 nm, 50 nm, or 60 nm.

(Examples 17-1 to 17-3, Comparative example 17-1)

An electrically conductive sheet was produced as in Comparative example 12-3 except that the average layer thickness of the ITO layer was specified to be 30 nm, 40 nm, 50 nm, or 60 nm.

(Examples 18-1 to 18-3, Comparative example 18-1)

An electrically conductive sheet was produced as in Comparative example 12-2 except that the average layer thickness of the ITO layer was specified to be 30 nm, 40 nm, 50 nm, or 60 nm.

(Examples 19-1 to 19-4)

An electrically conductive sheet was produced as in Example 12-2 except that the average layer thickness of the ITO layer was specified to be 30 nm, 40 nm, 50 nm, or 60 nm.
Table 11 shows the configurations of the electrically conductive sheets in Examples 12-1 to 19-4.

[Table 11]

| | Arrangement pattern | Shape of structure | Uneven shape of structure | Pitch (nm) | Height (nm) | Aspect ratio | Layer thickness (nm) | Surface resistance (Ω/□) |
|---|---|---|---|---|---|---|---|---|
| Example12-1 | hexagonal lattice | paraboloidal shape | convex shape | 270 | 156 | 0.58 | 30 | 405 |
| Example 12-2 | | | | 240 | 162 | 0.68 | 30 | 383 |
| Example 12-3 | | | | 240 | 179 | 0.75 | 30 | 486 |
| Comparative example 12-1 | | | | 240 | 191 | 0.8 | 30 | 591 |
| Comparative example 12-2 | | | | 230 | 178 | 0.77 | 30 | 585 |
| Comparative example 12-3 | | | | 250 | 183 | 0.73 | 30 | 575 |
| Example 13-1 | hexagonal lattice | paraboloidal shape | convex shape | 270 | 156 | 0.58 | 30 | 405 |
| Example 13-2 | | | | | | | 40 | 265 |
| Example 13-3 | | | | | | | 50 | 214 |
| Example 13-4 | | | | | | | 60 | 173 |
| Example 14-1 | hexagonal lattice | paraboloidal shape | convex shape | 240 | 162 | 0.68 | 30 | 383 |
| Example 14-2 | | | | | | | 40 | 250 |
| Example 14-3 | | | | | | | 50 | 193 |
| Example 14-4 | | | | | | | 60 | 157 |
| Example 15-1 | hexagonal lattice | paraboloidal shape | convex shape | 240 | 179 | 0.75 | 30 | 486 |
| Example 15-2 | | | | | | | 40 | 306 |
| Example 15-3 | | | | | | | 50 | 215 |
| Example 15-4 | | | | | | | 60 | 185 |
| Comparative example 16-1 | hexagonal lattice | paraboloidal shape | convex shape | 240 | 191 | 0.8 | 30 | 591 |
| Example 16-1 | | | | | | | 40 | 361 |
| Example 16-2 | | | | | | | 50 | 263 |
| Example 16-3 | | | | | | | 60 | 241 |
| Comparative example 17-1 | hexagonal lattice | paraboloidal shape | convex shape | 250 | 183 | 0.73 | 30 | 575 |
| Example 17-1 | | | | | | | 40 | 362 |
| Example 17-2 | | | | | | | 50 | 328 |
| Example 17-3 | | | | | | | 60 | 275 |
| Comparative example 18-1 | hexagonal lattice | paraboloidal shape | convex shape | 230 | 178 | 0.77 | 30 | 585 |
| Example 18-1 | | | | | | | 40 | 374 |
| Example 18-2 | | | | | | | 50 | 334 |
| Example 18-3 | | | | | | | 60 | 282 |

(continued)

| | Arrangement pattern | Shape of structure | Uneven shape of structure | Pitch (nm) | Height (nm) | Aspect ratio | Layer thickness (nm) | Surface resistance (Ω/□) |
|---|---|---|---|---|---|---|---|---|
| Example 19-1 | hexagonal lattice | paraboloidal shape | convex shape | 240 | 162 | 0.68 | 30 | 383 |
| Example 19-2 | | | | | | | 40 | 250 |
| Example 19-3 | | | | | | | 50 | 193 |
| Example 19-4 | | | | | | | 60 | 157 |

(Example 20-1)

Initially, a PET sheet provided with a motheye structure was obtained as in Example 1-1 except that the design of the structure was changed as shown in Table 12 by adjusting the conditions of the exposure step and the etching step and a PET sheet with a clear hard coat having a thickness of 127 $\mu$m was used as the base member. Subsequently, an ITO layer having an average layer thickness of 36 nm was formed on an uneven surface, which is composed of structures, of the resulting sheet by a sputtering method. The layer formation condition of the ITO layer will be described below.

Sputtering species: AC magnetron sputtering (Dual cathode)
Gas species: mixed gas of Ar and $O_2$
Gas flow rate ratio (volume flow rate ratio: Ar:$O_2$ = 20:1
Pressure in layer formation: 0.24 Pa
Input power: 4 kW
Then, the ITO layer was annealed at 150 degrees for 1 hour so as to come into a crystallized state.
In this manner, a desired electrically conductive sheet was obtained.

(Example 20-2)

Next, an electrically conductive sheet was obtained as in Example 20-1 except that the average layer thickness of the ITO layer was specified to be 75 nm.

(Example 20-3)

An electrically conductive sheet was obtained as in Example 20-1 except that the design of the structure was changed as shown in Table 12 by adjusting the conditions of the exposure step and the etching step.

(Example 20-4)

Next, an electrically conductive sheet was obtained as in Example 20-3 except that the average layer thickness of the ITO layer was specified to be 75 nm.

(Example 20-5)

An electrically conductive sheet was obtained as in Example 20-1 except that the design of the structure was changed as shown in Table 12 by adjusting the conditions of the exposure step and the etching step.

(Example 20-6)

Next, an electrically conductive sheet was obtained as in Example 20-5 except that the average layer thickness of the ITO layer was specified to be 75 nm.

(Example 20-7)

An electrically conductive sheet was obtained as in Example 20-1 except that the design of the structure was changed as shown in Table 12 by adjusting the conditions of the exposure step and the etching step.

(Example 20-8)

An electrically conductive sheet was obtained as in Example 20-7 except that structures were formed through thermal transfer to ZeonorFilm (registered trade mark) having a thickness of 100 $\mu$m and the average layer thickness of the ITO layer was specified to be 80 nm.

(Example 20-9)

An electrically conductive sheet was obtained as in Example 20-1 except that the design of the structure was changed as shown in Table 12 by adjusting the conditions of the exposure step and the etching step, a PET sheet having a thickness of 100 $\mu$m was used as the base member, and an IZO layer having an average layer thickness of 30 nm was formed as a transparent, electrically conductive layer.

(Comparative example 20-1)

An electrically conductive sheet was produced as in Example 20-1 except that the step of forming structures by application of an ultraviolet curable resin was omitted and the ITO layer was formed directly on the flat surface of the PET sheet.

(Comparative example 20-2)

An electrically conductive sheet was produced as in Example 20-2 except that the step of forming structures by application of an ultraviolet curable resin was omitted and the ITO layer was formed directly on the flat surface of the PET sheet.

(Evaluation of spectral reflection/transmission characteristic)

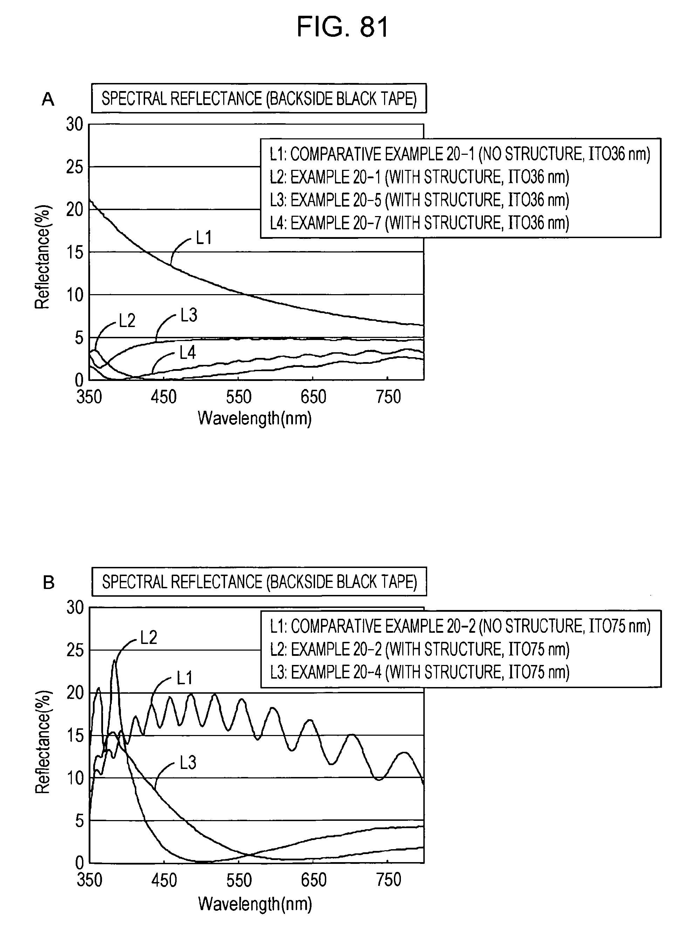

The spectral reflection characteristic of the electrically conductive sheet produced as described above was measured as described below. Initially, a black tape was bonded to the backside of the electrically conductive sheet provided with a large number of structures or the ITO layer. Subsequently, the spectral reflection characteristic and the spectral transmission characteristic of the electrically conductive sheet when light was incident from the surface opposite to the side bonded to the black tape were determined by using an evaluation apparatus (V-550) produced by JASCO Corporation. The results thereof are shown in Fig. 81A to Fig. 82B.

(Evaluation of crystallinity)

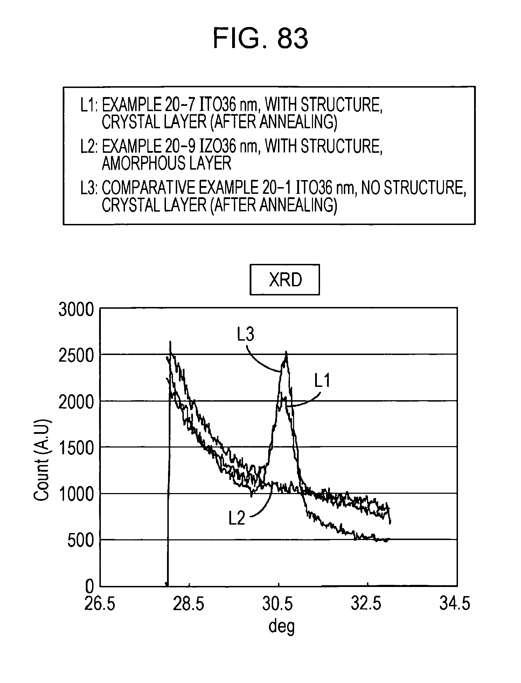

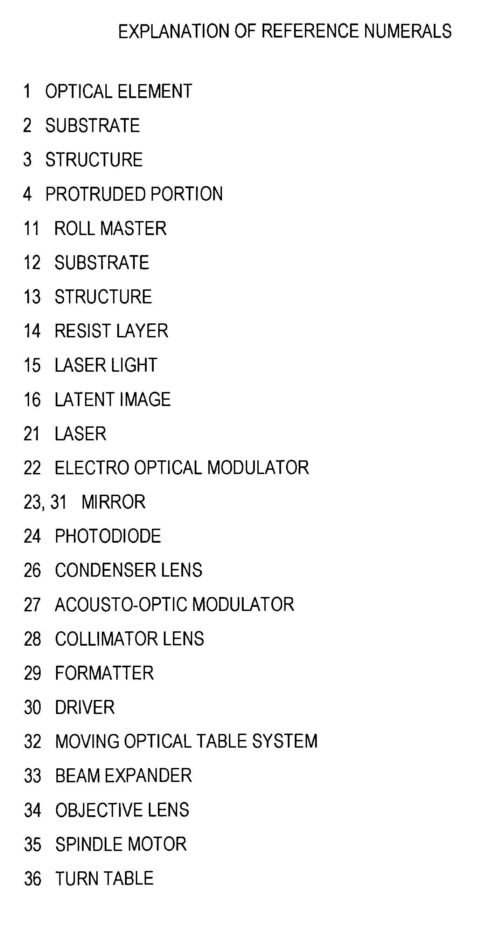

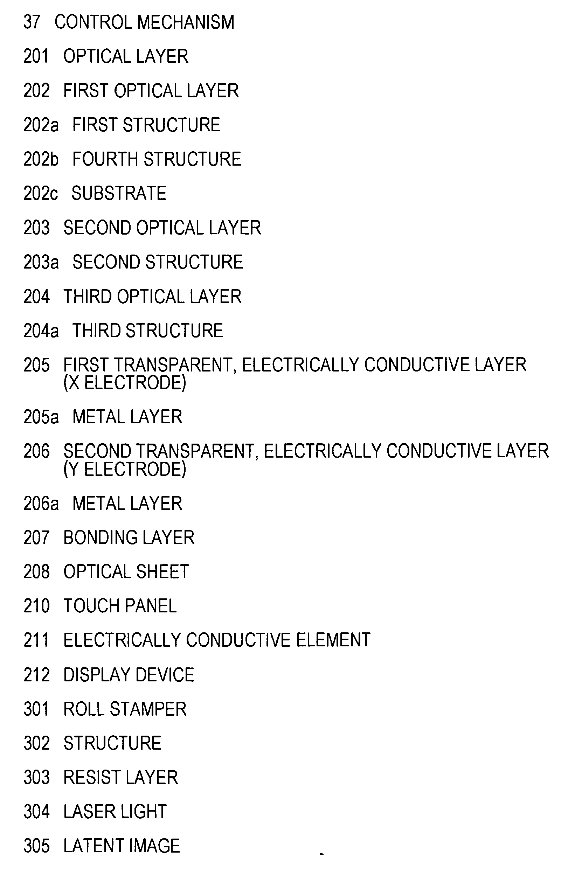

The crystallinity of the electrically conductive sheets in Comparative examples 20-7, 20-9, and 20-1 were evaluated by an X-ray diffraction method (X-ray diffraction: XRD). The results thereof are shown in Fig. 83.

(Evaluation of surface resistance)

The surface resistance of the electrically conductive optical sheet produced as described above was measured by a four-terminal method (JIS K 7194). The apparatus and the condition thereof used in this measurement will be described below.

·Measurement unit
Maker: NAPSON
Model name: RT-70
·Probe unit
Maker: NAPSON
Model name: TS-7D
-Four-point probe
Maker: JADEL
R of end: 150 $\mu$m
Distance 1 mm

(Evaluation of resistivity)

The resistivity of the transparent, electrically conductive layer of the electrically conductive sheet obtained as described above was measured as described below.

Calculation was performed by forming a layer from the same sputter lot on a flat plate and measuring the resistivity of the resulting flat plate. Regarding the calculation method, the surface resistance and the layer thickness were measured and calculation was performed on the basis of the following formula.

$$R \text{ (surface resistance)} = \rho \text{ (resistivity)}/d \text{ (thickness)}$$

In this regard, the layer thickness on the flat plate was measured with a stylus profiler or AFM and conversion was performed on the basis of a dynamic rate. As for the profiler, $\alpha$-Step produced by KLA-Tencor Corporation was used.

In the case where a transparent, electrically conductive layer is formed on structures, the resistivity can be estimated roughly as described below.

Initially, the profile of the structure is examined with cross-sectional TEM, cross-sectional SEM, or AFM, and the surface area is calculated therefrom. Furthermore, regarding the thickness of the electrically conductive layer, the average layer thickness is converted from the cross-sectional observation image. The surface resistance is measured and conversion from the above-described values is performed on the basis of the Ohm's law (the resistance is in proportion to the cross-sectional area and is in reverse proportion to the layer thickness with respect to the resistivity).

Table 12 and Table 13 show the configurations of the electrically conductive sheets in Examples 20-1 to 20-9 and Comparative examples 20-1 and 20-2.

[Table 12]

| | | Base member | | Structure design | | | | | |
| --- | --- | --- | --- | --- | --- | --- | --- | --- | --- |
| | | Type of base member | Base member thickness (um) | Structure material | Arrangement | Uneven shape | Pitch (nm) | Depth (nm) | Aspect |
| | Example 20-1 | PET with clear hard coat | 127 | UV resin | hexagonal closest | convex | 250 | 130 | 0.52 |
| | Example 20-2 | PET with clear hard coat | 127 | UV resin | hexagonal closest | convex | 250 | 130 | 0.52 |
| | Example 20-3 | PET with clear hard coat | 127 | UV resin | hexagonal closest | convex | 250 | 160 | 0.64 |
| | Example 20-4 | PET with clear hard coat | 127 | UV resin | hexagonal closest | convex | 250 | 160 | 0.64 |
| | Example 20-5 | PET with clear hard coat | 127 | UV resin | hexagonal closest | convex | 250 | 90 | 0.36 |
| | Example 20-6 | PET with clear hard coat | 127 | UV resin | hexagonal closest | convex | 250 | 90 | 0.36 |
| | Example 20-7 | PET with clear hard coat | 127 | UV resin | hexagonal closest | convex | 250 | 120 | 0.48 |
| | Example 20-8 | ZEONOR thermal transfer | 100 | ZEONOR | hexagonal closest | concave | 250 | 120 | 0.48 |
| | Example 20-9 | PET | 100 | UV resin | hexagonal closest | convex | 270 | 160 | 0.6 |

(continued)

|  | Base member | | Structure design | | | | | |
|  | Type of base member | Base member thickness (um) | Structure material | Arrangement | Uneven shape | Pitch (nm) | Depth (nm) | Aspect |
|---|---|---|---|---|---|---|---|---|
| Comparative example 20-1 | PET with clear hard coat | 127 | UV resin | - | - | - | - | 0 |
| Comparative example 20-2 | PET with clear hard coat | 127 | UV resin | - | - | - | - | 0 |

[Table 13]

|  | Electrically conductive layer | | | | | | |
|  | Type of electrically conductive layer | Phase state | Resistivity (in terms of flat) ($\Omega$-cm) | Surface resistance ($\Omega/\square$) | | | |
|  |  |  |  | Layer thickness 30nm | Layer thickness 36nm | Layer thickness 40nm | Layer thickness 75nm |
|---|---|---|---|---|---|---|---|
| Example 20-1 | ITO | crystal | $5.4\times10^{-4}$ | - | 215 | - | - |
| Example 20-2 | ITO | crystal | $5.4\times10^{-4}$ | - | - | - | 103 |
| Example 20-3 | ITO | crystal | $5.4\times10^{-4}$ | - | 270 | - | - |
| Example 20-4 | ITO | crystal | $5.4\times10^{-4}$ | - | - | - | 151 |
| Example 20-5 | ITO | crystal | $5.4\times10^{-4}$ | - | 176 | - | - |
| Example 20-6 | ITO | crystal | $5.4\times10^{-4}$ | - | - | - | 85 |
| Example 20-7 | ITO | crystal | $5.4\times10^{-4}$ | - | 206 | - | - |
| Example 20-8 | ITO | crystal | $5.4\times10^{-4}$ | - | - | 180 | - |
| Example 20-9 | IZO | amorphous | $4.3\times10^{-4}$ | 265 | - | - | - |
| Comparative example 20-1 | ITO | crystal | $5.4\times10^{-4}$ | - | 150 | - | - |
| Comparative example 20-2 | ITO | crystal | $5.4\times10^{-4}$ | - | - | - | 70 |

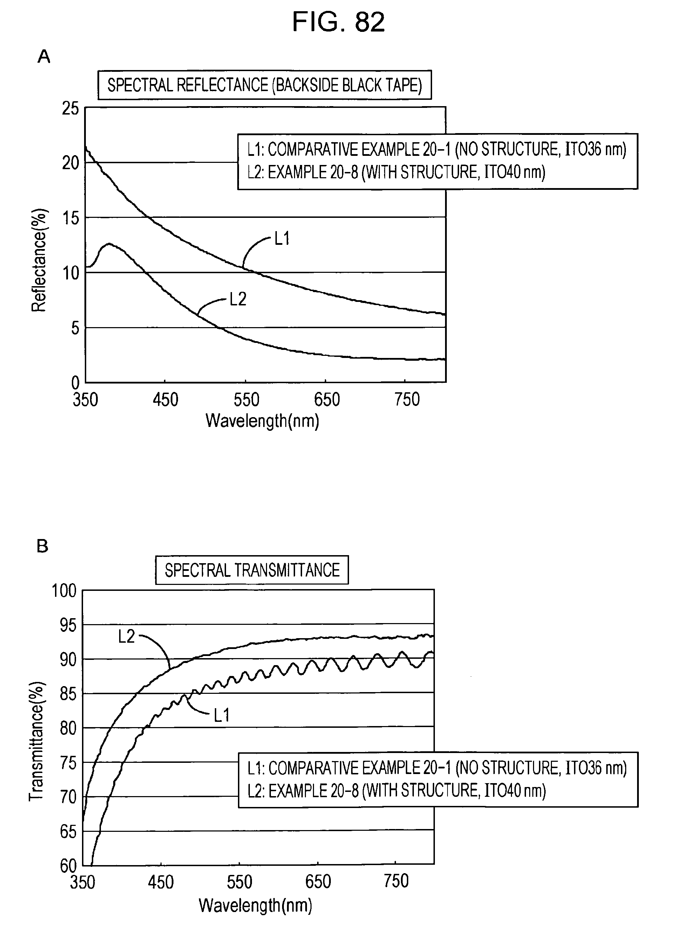

As is clear from Fig. 81A and Fig. 81B, in the case where the transparent, electrically conductive layer is formed on the unevenness composed of structures, an excellent antireflection characteristic is obtained as compared with that in the case where the transparent, electrically conductive layer is formed on the flat surface of the sheet.
As is clear from Fig. 82A and Fig. 82B, in the case where the structures are formed integrally with the sheet as well, excellent reflectance can be obtained as compared with that in the case where the transparent, electrically conductive layer is formed on the flat surface of the sheet. Moreover, it is clear that in the case where the structures are formed integrally, the transmittance is high and ripple (waviness) is suppressed. The visibility increases because ripple is suppressed as described above. In addition, it is clear that the transmission characteristic in the small wavelength side is good and the color tone becomes neutral (colorless and transparent).

As is clear from Fig. 83, regarding the sample before annealing, a peak resulting from the crystallinity of ITO is not observed in the XRD spectrum, whereas regarding the sample after annealing, a peak resulting from the crystallinity of ITO is observed in the XRD spectrum.

Up to this point, the embodiments according to the present invention have been specifically explained. However, the present invention is not limited to the above-described embodiments, and various modification on the basis of the technical idea of the present invention can be made.

For example, the configurations, the methods, the shapes, the materials, the numerical values, and the like mentioned in the above-described embodiments are no more than examples, and as necessary, configurations, methods, shapes, materials, numerical values, and the like different from them may be employed.

Furthermore, the individual configurations of the above-described embodiments can be combined with each other within the bounds of not departing from the gist of the present invention. Specifically, the configurations, the shapes, the materials, the numerical values, the methods, and the like of the above-described first to twentieth embodiments can be combined with each other within the bounds of not departing from the gist of the present invention.

Moreover, in the above-described embodiments, the electrically conductive elements may be produced through thermal transfer. Specifically, a method, in which a substrate containing a thermoplastic resin as a primary component is heated, and a seal (mold), e.g., a roll-shaped stamper or a disk-shaped stamper, is pressed against the substrate softened sufficiently through this heating, so as to produce an electrically conductive element, may be employed.

## Claims

1. An electrically conductive optical element comprising:

   a substrate having a surface;
   structures which are convex portions or concave portions in the shape of a cone and which are arranged in large numbers on the surface of the substrate with a minute pitch less than or equal to the wavelength of the visible light; and
   a transparent, electrically conductive layer disposed on the structures,
   wherein the aspect ratio of the structure is 0.2 or more, and 1.3 or less,
   the transparent, electrically conductive layer has a surface following the structures,
   the average layer thickness $D_m1$ of the transparent, electrically conductive layer at the top portion of the structure is 80 nm or less, and
   the surface resistance of the transparent, electrically conductive layer is within the range of 50 $\Omega/\square$ or more, and 500 $\Omega/\square$ or less.

2. The electrically conductive optical element according to Claim 1, wherein the transparent, electrically conductive layer has the crystallinity.

3. The electrically conductive optical element according to Claim 1, wherein the transparent, electrically conductive layer contains indium tin oxide or indium zinc oxide.

4. The electrically conductive optical element according to Claim 1, wherein the electrically conductive optical element is used for an electrode.

5. The electrically conductive optical element according to Claim 1, wherein the average layer thickness $D_m1$ of the transparent, electrically conductive layer at the top portion of the structure is 10 nm or more, and 80 nm or less.

6. The electrically conductive optical element according to Claim 1, wherein the aspect ratio of the structure is 0.2 or more, and 1.0 or less.

7. The electrically conductive optical element according to Claim 1, wherein the resistivity of the transparent, electrically conductive layer is $1 \times 10^{-3}$ $\Omega\cdot$cm or less.

8. The electrically conductive optical element according to Claim 7, wherein the resistivity of the transparent, electrically conductive layer is $6 \times 10^{-4}$ Ω·cm or less.

9. The electrically conductive optical element according to Claim 1, wherein the structure is in the shape of a cone having a curved surface at the top portion.

10. The electrically conductive optical element according to Claim 1, wherein the structure is in the shape of an elliptical cone or an elliptical truncated cone.

11. The electrically conductive optical element according to Claim 1,
wherein the structures are arranged in such a way as to constitute a plurality of lines of tracks on the surface of the substrate, and
the track has the shape of a straight line or the shape of an arc.

12. The electrically conductive optical element according to Claim 1,
wherein the structures are arranged in such a way as to constitute a plurality of lines of tracks on the surface of the substrate, and
the track meanders.

13. The electrically conductive optical element according to Claim 1,
wherein the substrate has the other surface opposite to the surface, and
structures, which are convex portions or concave portions in the shape of a cone and which are arranged in large numbers on the other surface of the substrate with a minute pitch less than or equal to the wavelength of the visible light, are further included.

14. The electrically conductive optical element according to Claim 1,
wherein the structures are arranged in such a way as to constitute a plurality of lines of tracks on the surface of the substrate and
the structure is in the shape of an elliptical cone or an elliptical truncated cone, which has a major axis direction in the extension direction of the tracks.

15. The electrically conductive optical element according to Claim 1,
wherein the structures are arranged in such a way as to constitute a plurality of lines of tracks on the surface of the substrate and
form a hexagonal lattice pattern, a quasi-hexagonal lattice pattern, a tetragonal lattice pattern, or a quasi-tetragonal lattice pattern.

16. The electrically conductive optical element according to Claim 1, wherein the filling factor of the structures with respect to the surface of the substrate is 65% or more.

17. The electrically conductive optical element according to Claim 16, wherein the filling factor of the structures with respect to the surface of the substrate is 73% or more.

18. The electrically conductive optical element according to Claim 1, wherein the ratio $((2r/P1) \times 100)$ of the diameter 2r to the arrangement pitch P1 is 85% or more.

19. The electrically conductive optical element according to Claim 18, wherein the ratio $((2r/P1) \times 100)$ of the diameter 2r to the arrangement pitch P1 is 90% or more.

20. A touch panel comprising the electrically conductive optical element according to any one of Claims 1 to 19.

21. An information input device comprising the electrically conductive optical element according to any one of Claims 1 to 19.

22. A display device comprising the electrically conductive optical element according to any one of Claims 1 to 19.

23. A solar cell comprising the electrically conductive optical element according to any one of Claims 1 to 19.

**24.** A stamper for producing an electrically conductive optical element to produce the electrically conductive optical element according to any one of Claims 1 to 19, the stamper comprising:

transfer structures which are convex portions or concave portions in the shape of a cone and which are arranged in large numbers on the surface with a minute pitch less than or equal to the wavelength of the visible light, wherein the aspect ratio of the transfer structure is 0.2 or more, and 1.3 or less.

FIG. 1

A

B

C

D

E

F

# FIG. 2

# FIG. 3

FIG. 4

# FIG. 5

FIG. 6

EP 2 474 843 A1

# FIG. 7

# FIG. 8

# FIG. 9

# FIG. 10

FIG. 11

# FIG. 12

A

12

B

14

12

C

16

15

14

12

# FIG. 13

EP 2 474 843 A1

| $\begin{bmatrix}\text{DIRECTION OF LINES} \\ \text{(Y AXIS DIRECTION)}\end{bmatrix}$ | $\begin{bmatrix}\text{EXTENSION DIRECTION OF TRACK} \\ \text{(X AXIS DIRECTION)}\end{bmatrix}$ |

A

B

C

# FIG. 14

EP 2 474 843 A1

FIG. 15

# FIG. 16

# FIG. 17

# FIG. 18

# FIG. 19

# FIG. 20

EP 2 474 843 A1

102

# FIG. 21

# FIG. 22

A

B

C

D

# FIG. 23

# FIG. 24

FIG. 25

# FIG. 26

# FIG. 27

3t TOP PORTION

3

Pa FIRST TURNING POINT

St STEP

Pb SECOND TURNING POINT

3b LOWER PORTION

## FIG. 28

A

B

C

St

: INFLECTION POINT

: TURNING POINT

# FIG. 29

# FIG. 30

# FIG. 31

# FIG. 32

A

B

## FIG. 33

# FIG. 34

A

50

9
4
3

2
53
54

B

50

3

9

2
53
54

## FIG. 35

A

L1: COMPARATIVE EXAMPLE 5 (IZO30 nm)
L2: COMPARATIVE EXAMPLE 4
L3: COMPARATIVE EXAMPLE 1 (IZO30 nm)
L4: COMPARATIVE EXAMPLE 2 (IZO160 nm)
L5: COMPARATIVE EXAMPLE 3
(IZO30 nm, DOUBLE-SIDED STRUCTURE)

B

L1: COMPARATIVE EXAMPLE 5 (IZO30 nm)
L2: COMPARATIVE EXAMPLE 4
L3: COMPARATIVE EXAMPLE 1 (IZO30 nm)
L4: COMPARATIVE EXAMPLE 2 (IZO160 nm)
L5: COMPARATIVE EXAMPLE 3
(IZO30 nm, DOUBLE-SIDED STRUCTURE)

# FIG. 36

# FIG. 37

A

B

# FIG. 38

A

B

# FIG. 39

A

L1: COMPARATIVE EXAMPLE 6
(ASPECT RATIO 1.2)
L2: COMPARATIVE EXAMPLE 8
(ASPECT RATIO 1.2)

B

L1: COMPARATIVE EXAMPLE 6
(ASPECT RATIO 1.2)
L2: COMPARATIVE EXAMPLE 8
(ASPECT RATIO 1.2)

# FIG. 40

A

L1: EXAMPLE 3 (IZO 50 nm)
L2: EXAMPLE 4 (IZO 40 nm)
L3: COMPARATIVE EXAMPLE 11 (IZO 30 nm)
L4: COMPARATIVE EXAMPLE 12 (Film))

B

L1: EXAMPLE 3 (IZO 50 nm)
L2: EXAMPLE 4 (IZO 40 nm)
L3: COMPARATIVE EXAMPLE 11 (IZO 30 nm)
L4: COMPARATIVE EXAMPLE 12 (Film))

## FIG. 41

L1: COMPARATIVE EXAMPLE 13 (IZO 40 nm)
L2: EXAMPLE 5 (IZO 30 nm)
L3: COMPARATIVE EXAMPLE 14 (IZO 30 nm)
L4: COMPARATIVE EXAMPLE 15 (3Layer)
L5: COMPARATIVE EXAMPLE 16 (5Layer)

EP 2 474 843 A1

# FIG. 42

A

Transmittance (%) vs Wavelength (nm) graph. L1: COMPARATIVE EXAMPLE 17. L2: COMPARATIVE EXAMPLE 18

B

Reflectance (%) vs Wavelength (nm) graph. L1: COMPARATIVE EXAMPLE 17. L2: COMPARATIVE EXAMPLE 18

# FIG. 43

A

L1: COMPARATIVE EXAMPLE 20 (Film)
L2: COMPARATIVE EXAMPLE 19 (IZO)

B

L1: COMPARATIVE EXAMPLE 21 (Film)
L2: EXAMPLE 6 (IZO)

# FIG. 44

A

L1: COMPARATIVE EXAMPLE 22 (Film)
L2: EXAMPLE 7 (IZO)

B

L1: COMPARATIVE EXAMPLE 23 (Film)
L2: EXAMPLE 8 (IZO)

# FIG. 45

A

B

## FIG. 46

# FIG. 47

# FIG. 48

# FIG. 49

A

B

# FIG. 50

# FIG. 51

EP 2 474 843 A1

# FIG. 52

A

202d

202a

H1

H2

Z
Y
X

202e

B

202a

H1

H2

Z
Y
X

202e

# FIG. 53

A

B

# FIG. 54

# FIG. 55

# FIG. 56

# FIG. 57

# FIG. 58

EP 2 474 843 A1

# FIG. 59

A
301

B
303
301

C
305
304
303
301

# FIG. 60

A

303

301

B

302

301

C

202a

202c

D

202 {
202a
202c
202b

# FIG. 61

A 205 202 { 202a 202c 202b }

B 205 202 { 202a 202c 202b } 206

C 203 { 208 207 } 205 202 { 202a 202c 202b } 206

D 203 { 208 207 } 205 202 { 202a 202c 202b } 206 204 212

# FIG. 62

EP 2 474 843 A1

# FIG. 63

FIG. 64

# FIG. 65

# FIG. 66

A

B

# FIG. 67

A

202

202c

202a

Y

Z

X

B

C

202a

Y

Z

X

P1

C

C

Z

X

λ1, P1

FIG. 68

# FIG. 69

# FIG. 70

# FIG. 71

# FIG. 72

Legend:
- —⊖— : COMPARATIVE EXAMPLE 2-1 (resin/ITO10 nm/resin)
- —◇— : EXAMPLE 2-1 (resin/MothEye150 nm/ITO10 nm/resin)
- —□— : EXAMPLE 2-2 (resin/MothEye150 nm/ITO30 nm/resin)
- —△— : EXAMPLE 2-3 (resin/MothEye150 nm/ITO50 nm/resin)

X-axis: Wavelength(nm)
Y-axis: Reflectance(%)

# FIG. 73

# FIG. 74

| | |
|---|---|
| Illuminant : WHITE | Angle : 0.0 (deg) |
| Medium : AIR | Reference : 550.0 (deg) |
| Substrate : GLASS | Polarization : Ave – |
| Exit : GLASS | First Surface : Front |
| Detector : IDEAL | |

L1: REFERENCE EXAMPLE 1−3 (ITO 60 nm(100 TO 200 Ω))
L2: REFERENCE EXAMPLE 1−2 (ITO 40 nm(200 TO 300 Ω))
L3: REFERENCE EXAMPLE 1−1 (ITO 20 nm(400 TO 300 Ω))
L4: REFERENCE EXAMPLE 1−4 (NO ITO)

# FIG. 75

L1: COMPARATIVE EXAMPLE 4-2 (MOTHEYE STRUCTURE)
L2: COMPARATIVE EXAMPLE 4-3 (ITO(170 Ω))
L3: COMPARATIVE EXAMPLE 4-1
    (MOTHEYE STRUCTURE + ITO(400 Ω))
L4: EXAMPLE 4-1 (MOTHEYE STRUCTURE + ITO(700 Ω))

# FIG. 76

A

L1: COMPARATIVE EXAMPLE 5-1 (MOTHEYE STRUCTURE)
L2: EXAMPLE 5-1 (MOTHEYE STRUCTURE + ITO30 nm)
L3: EXAMPLE 5-2 (MOTHEYE STRUCTURE + ITO40 nm)
L4: EXAMPLE 5-3 (MOTHEYE STRUCTURE + ITO50 nm)
L5: EXAMPLE 5-4 (MOTHEYE STRUCTURE + ITO60 nm)

B

L1: COMPARATIVE EXAMPLE 6-1 (MOTHEYE STRUCTURE)
L2: EXAMPLE 6-1 (MOTHEYE STRUCTURE + ITO30 nm)
L3: EXAMPLE 6-2 (MOTHEYE STRUCTURE + ITO40 nm)
L4: EXAMPLE 6-3 (MOTHEYE STRUCTURE + ITO50 nm)
L5: EXAMPLE 6-4 (MOTHEYE STRUCTURE + ITO60 nm)

# FIG. 77

A

L1: COMPARATIVE EXAMPLE 7-1 (MOTHEYE STRUCTURE)
L2: EXAMPLE 7-1 (MOTHEYE STRUCTURE + ITO30 nm)
L3: EXAMPLE 7-2 (MOTHEYE STRUCTURE + ITO40 nm)
L4: EXAMPLE 7-3 (MOTHEYE STRUCTURE + ITO50 nm)
L5: EXAMPLE 7-4 (MOTHEYE STRUCTURE + ITO60 nm)

B

L1: COMPARATIVE EXAMPLE 8-2 (MOTHEYE STRUCTURE)
L2: COMPARATIVE EXAMPLE 8-1
    (MOTHEYE STRUCTURE + ITO30 nm)
L3: EXAMPLE 8-1 (MOTHEYE STRUCTURE + ITO40 nm)
L4: EXAMPLE 8-2 (MOTHEYE STRUCTURE + ITO50 nm)
L5: EXAMPLE 8-3 (MOTHEYE STRUCTURE + ITO60 nm)

# FIG. 78

A

L1: COMPARATIVE EXAMPLE 9-2 (MOTHEYE STRUCTURE)
L2: COMPARATIVE EXAMPLE 9-1
(MOTHEYE STRUCTURE + ITO30 nm)
L3: EXAMPLE 9-1 (MOTHEYE STRUCTURE + ITO40 nm)
L4: EXAMPLE 9-2 (MOTHEYE STRUCTURE + ITO50 nm)
L5: EXAMPLE 9-3 (MOTHEYE STRUCTURE + ITO60 nm)

B

L1: COMPARATIVE EXAMPLE 10-2 (MOTHEYE STRUCTURE)
L2: COMPARATIVE EXAMPLE 10-1
(MOTHEYE STRUCTURE + ITO30 nm)
L3: EXAMPLE 10-1 (MOTHEYE STRUCTURE + ITO40 nm)
L4: EXAMPLE 10-2 (MOTHEYE STRUCTURE + ITO50 nm)

## FIG. 79

L1: COMPARATIVE EXAMPLE 11-2
L2: EXAMPLE 11-1 (MOTHEYE STRUCTURE + Aspect0.6/ITO30 nm/350 $\Omega$/□)
L3: COMPARATIVE EXAMPLE 11-1 (MOTHEYE STRUCTURE + Aspect0.8/ITO30 nm/650 $\Omega$/□)
L4: EXAMPLE 11-2 (MOTHEYE STRUCTURE + Aspect0.6/ITO50 nm/170 $\Omega$/□)
L5: EXAMPLE 11-3 (MOTHEYE STRUCTURE + Aspect0.8/ITO50 nm/275 $\Omega$/□)

# FIG. 80

A

◇ : EXAMPLE 12-1 TO 12-3
COMPARATIVE EXAMPLE
12-1 TO 12-3

B

◇ : EXAMPLE 13-1 TO 13-4
□ : EXAMPLE 14-1 TO 14-4
▲ : EXAMPLE 15-1 TO 15-4
× : EXAMPLE 16-1 TO 16-3
COMPARATIVE EXAMPLE
16-1
＊ : EXAMPLE 17-1 TO 17-3
COMPARATIVE EXAMPLE
17-1
○ : EXAMPLE 18-1 TO 18-3
COMPARATIVE EXAMPLE
18-1

C

◇ : EXAMPLE 19-1 TO 19-4

# FIG. 81

A

SPECTRAL REFLECTANCE (BACKSIDE BLACK TAPE)

L1: COMPARATIVE EXAMPLE 20-1 (NO STRUCTURE, ITO36 nm)
L2: EXAMPLE 20-1 (WITH STRUCTURE, ITO36 nm)
L3: EXAMPLE 20-5 (WITH STRUCTURE, ITO36 nm)
L4: EXAMPLE 20-7 (WITH STRUCTURE, ITO36 nm)

B

SPECTRAL REFLECTANCE (BACKSIDE BLACK TAPE)

L1: COMPARATIVE EXAMPLE 20-2 (NO STRUCTURE, ITO75 nm)
L2: EXAMPLE 20-2 (WITH STRUCTURE, ITO75 nm)
L3: EXAMPLE 20-4 (WITH STRUCTURE, ITO75 nm)

## FIG. 82

A

SPECTRAL REFLECTANCE (BACKSIDE BLACK TAPE)

L1: COMPARATIVE EXAMPLE 20-1 (NO STRUCTURE, ITO36 nm)
L2: EXAMPLE 20-8 (WITH STRUCTURE, ITO40 nm)

B

SPECTRAL TRANSMITTANCE

L1: COMPARATIVE EXAMPLE 20-1 (NO STRUCTURE, ITO36 nm)
L2: EXAMPLE 20-8 (WITH STRUCTURE, ITO40 nm)

# FIG. 83

L1: EXAMPLE 20-7 ITO36 nm, WITH STRUCTURE, CRYSTAL LAYER (AFTER ANNEALING)

L2: EXAMPLE 20-9 IZO36 nm, WITH STRUCTURE, AMORPHOUS LAYER

L3: COMPARATIVE EXAMPLE 20-1 ITO36 nm, NO STRUCTURE, CRYSTAL LAYER (AFTER ANNEALING)

XRD

## EXPLANATION OF REFERENCE NUMERALS

1  OPTICAL ELEMENT

2  SUBSTRATE

3  STRUCTURE

4  PROTRUDED PORTION

11  ROLL MASTER

12  SUBSTRATE

13  STRUCTURE

14  RESIST LAYER

15  LASER LIGHT

16  LATENT IMAGE

21  LASER

22  ELECTRO OPTICAL MODULATOR

23, 31  MIRROR

24  PHOTODIODE

26  CONDENSER LENS

27  ACOUSTO-OPTIC MODULATOR

28  COLLIMATOR LENS

29  FORMATTER

30  DRIVER

32  MOVING OPTICAL TABLE SYSTEM

33  BEAM EXPANDER

34  OBJECTIVE LENS

35  SPINDLE MOTOR

36  TURN TABLE

37  CONTROL MECHANISM

201  OPTICAL LAYER

202  FIRST OPTICAL LAYER

202a  FIRST STRUCTURE

202b  FOURTH STRUCTURE

202c  SUBSTRATE

203  SECOND OPTICAL LAYER

203a  SECOND STRUCTURE

204  THIRD OPTICAL LAYER

204a  THIRD STRUCTURE

205  FIRST TRANSPARENT, ELECTRICALLY CONDUCTIVE LAYER (X ELECTRODE)

205a  METAL LAYER

206  SECOND TRANSPARENT, ELECTRICALLY CONDUCTIVE LAYER (Y ELECTRODE)

206a  METAL LAYER

207  BONDING LAYER

208  OPTICAL SHEET

210  TOUCH PANEL

211  ELECTRICALLY CONDUCTIVE ELEMENT

212  DISPLAY DEVICE

301  ROLL STAMPER

302  STRUCTURE

303  RESIST LAYER

304  LASER LIGHT

305  LATENT IMAGE

<table>
<tr><td colspan="2" align="center">**INTERNATIONAL SEARCH REPORT**</td><td>International application No.<br>PCT/JP2010/065454</td></tr>
</table>

**A. CLASSIFICATION OF SUBJECT MATTER**
*G02B1/11*(2006.01)i, *B32B3/30*(2006.01)i, *G02B1/10*(2006.01)i, *G06F3/041*
(2006.01)i, *G06F3/045*(2006.01)i, *H01B5/14*(2006.01)n

According to International Patent Classification (IPC) or to both national classification and IPC

**B. FIELDS SEARCHED**

Minimum documentation searched (classification system followed by classification symbols)
G02B1/11, B32B3/30, G02B1/10, G06F3/041, G06F3/045, H01B5/14

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2008-165213 A (Semiconductor Energy Laboratory Co., Ltd.), 17 July 2008 (17.07.2008), claims 1, 4 to 5; paragraphs [0013] to [0015], [0052] to [0053], [0057] to [0059], [0087], [0091] to [0093], [0430]; fig. 2 to 3 & US 2008/0158682 A1 & WO 2008/069164 A1 | 1-24 |
| Y | JP 09-197559 A (Matsushita Electric Industrial Co., Ltd.), 31 July 1997 (31.07.1997), claim 29 (Family: none) | 1-24 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| | | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>18 October, 2010 (18.10.10) | Date of mailing of the international search report<br>26 October, 2010 (26.10.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/065454

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2009-109755 A (Sony Corp.), 21 May 2009 (21.05.2009), claims 1 to 3, 7; paragraphs [0020], [0024] & US 2009/0135491 A1 & CN 101424751 A | 1-24 |
| Y | JP 2008-304637 A (Sony Corp.), 18 December 2008 (18.12.2008), claims 1, 3; paragraphs [0028] to [0029] & US 2008/0304155 A1 & CN 101320104 A & KR 10-2008-0107276 A | 1-24 |
| Y | JP 2004-043851 A (Sumitomo Metal Mining Co., Ltd.), 12 February 2004 (12.02.2004), claims 5, 7, 9, 11 to 12; paragraphs [0001] to [0002], [0009], [0040] (Family: none) | 2-4,7-8,23 |
| Y | JP 2004-348686 A (Fujitsu Component Ltd.), 09 December 2004 (09.12.2004), claims 9, 11; paragraph [0038] & US 2004/0239647 A1 | 13,20-21 |
| Y | JP 2005-028821 A (Sony Corp.), 03 February 2005 (03.02.2005), claim 8; paragraphs [0001] to [0002] (Family: none) | 13,20-21 |

Form PCT/ISA/210 (continuation of second sheet) (July 2009)

## REFERENCES CITED IN THE DESCRIPTION

**Patent documents cited in the description**

- JP 2003136625 A

**Non-patent literature cited in the description**

- Kagaku Binran. CHEMICAL SOCIETY OF JAPAN